(19) Europäisches Patentamt
European Patent Office
Office européen des brevets

(11) EP 4 512 865 B1

# (12) EUROPEAN PATENT SPECIFICATION

(45) Date of publication and mention of the grant of the patent:
**10.06.2026 Bulletin 2026/24**

(21) Application number: **23868647.1**

(22) Date of filing: **22.09.2023**

(51) International Patent Classification (IPC):
***C09D 11/03*** (2014.01) ***C09D 11/033*** (2014.01)
***H10K 50/155*** (2023.01) ***H10K 50/17*** (2023.01)
***H10K 50/18*** (2023.01) ***H10K 85/60*** (2023.01)
***H10K 85/40*** (2023.01) ***H10K 85/30*** (2023.01)
***C09D 11/101*** (2014.01) ***C09D 11/36*** (2014.01)
***C09D 11/38*** (2014.01) ***H10K 71/15*** (2023.01)
***C09D 11/50*** (2014.01) ***H10K 50/11*** (2023.01)

(52) Cooperative Patent Classification (CPC):
**H10K 85/633; C09D 11/03; C09D 11/033; C09D 11/36; C09D 11/38; C09D 11/50; H10K 50/11; H10K 50/155; H10K 50/171; H10K 50/18; H10K 71/15; H10K 85/322; H10K 85/40; H10K 85/615; H10K 85/636;** (Cont.)

(86) International application number:
**PCT/KR2023/014482**

(87) International publication number:
**WO 2024/063595 (28.03.2024 Gazette 2024/13)**

## (54) INK COMPOSITION, ORGANIC MATERIAL LAYER COMPRISING SAME, AND ORGANIC LIGHT-EMITTING DEVICE COMPRISING SAME

TINTENZUSAMMENSETZUNG, ORGANISCHE MATERIALSCHICHT DAMIT UND ORGANISCHE LICHTEMITTIERENDE VORRICHTUNG DAMIT

COMPOSITION D’ENCRE, COUCHE DE MATÉRIAU ORGANIQUE LA COMPRENANT, ET DISPOSITIF ÉLECTROLUMINESCENT ORGANIQUE LA COMPRENANT

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **23.09.2022 KR 20220120824**

(43) Date of publication of application:
**26.02.2025 Bulletin 2025/09**

(73) Proprietor: **LG Chem, Ltd.**
**Yeongdeungpo-gu**
**Seoul 07336 (KR)**

(72) Inventors:
- **SHIN, Jiyeon**
  **Daejeon 34122 (KR)**
- **KANG, Eunhye**
  **Daejeon 34122 (KR)**
- **LEE, Keunsoo**
  **Daejeon 34122 (KR)**
- **KIM, Byungjae**
  **Daejeon 34122 (KR)**
- **PARK, Youngju**
  **Daejeon 34122 (KR)**
- **LEE, Ho Gyu**
  **Daejeon 34122 (KR)**

(74) Representative: **Hoffmann Eitle**
**Patent- und Rechtsanwälte PartmbB**
**Arabellastraße 30**
**81925 München (DE)**

(56) References cited:
**WO-A1-2022/035284**
**CN-A- 110 407 829**
**KR-A- 20170 094 020**
**KR-A- 20190 109 295**
**KR-A- 20190 136 999**
**KR-A- 20200 083 200**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

(52) Cooperative Patent Classification (CPC): (Cont.)
**H10K 85/6574; H10K 85/6576;** H10K 50/15;
H10K 50/17; H10K 50/181; H10K 71/135;
H10K 85/111; H10K 85/113

## Description

[Technical Field]

This application claims priority to and the benefit of Korean Patent ApplicationNo. 10-2022-0120824 filed in the Korean Intellectual Property Office on September 23, 2022.

The present invention relates to an ink composition, an organic material layer including the same and an organic light emitting device including the same.

[Background Art]

An organic light emission phenomenon is one of the examples of converting an electric current into visible rays through an internal process of a specific organic molecule. The principle of the organic light emission phenomenon is as follows. When an organic material layer is disposed between an anode and a cathode and an electric current is applied between the two electrodes, electrons and holes are injected into the organic material layer from the cathode and the anode, respectively. The electrons and the holes which are injected into the organic material layer are recombined to form an exciton, and the exciton falls down again to the ground state to emit light. An organic light emitting device using the principle may be generally composed of a cathode, an anode, and an organic material layer disposed therebetween, for example, a hole injection layer, a hole transport layer, a light emitting layer, an electron injection layer, an electron transport layer, an electron blocking layer, a hole blocking layer, and the like.

In order to manufacture an organic light emitting device in the related art, a deposition process has been usually used. However, there are problems in that the loss of materials occurs frequently when an organic light emitting device is manufactured by a deposition process and in that it is difficult to manufacture a device having a large area, and to solve these problems, a device using a solution process has been developed.

Therefore, there is a need for the development of a material for a solution Document WO 2022/035284 A1 represents relevant prior art.

[Detailed Description of the Invention]

[Technical Problem]

The present invention relates to an ink composition, an organic material layer including the same and an organic light emitting device including the same.

[Technical Solution]

An exemplary embodiment of the present invention provides an ink composition including a compound represented by the following Chemical Formula 1 and a first solvent represented by the following Chemical Formula A.

[Chemical Formula 1]

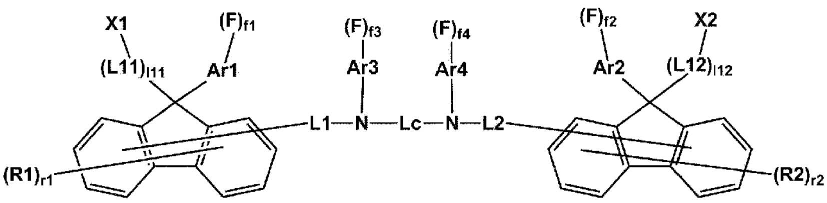

[Chemical Formula A]

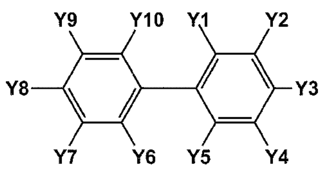

In Chemical Formulae 1 and A,

Y1 to Y10 are the same as or different from each other, and are each independently hydrogen; deuterium; ahydroxylgroup; an ether group; a carbonyl group; an ester group; a substituted or unsubstituted alkyl group; a substituted or unsubstituted cycloalkyl group; a substituted or unsubstituted cycloalkenyl group; a substituted or unsubstituted alkoxy group; a substituted or unsubstituted aryl group; or a substituted or unsubstituted amine group,
Lc is a substituted or unsubstituted heteroarylene group including O, S or Si,
L1 and L2 are the same as or different from each other, and are each independently a direct bond; or a substituted or unsubstituted arylene group,
L11 and L12 are the same as or different from each other, and are each independently a direct bond; -O-; a substituted or unsubstituted alkylene group; or a substituted or unsubstituted arylene group,
Ar1 to Ar4 are the same as or different from each other, and are each independently a substituted or unsubstituted aryl group; or a substituted or unsubstituted heteroaryl group,
R1 and R2 are the same as or different from each other, and are each independently hydrogen; deuterium; a halogen group; or a substituted or unsubstituted alkyl group,
X1 and X2 are the same as or different from each other, and are each independently a curable group,
r1 and r2 are each an integer from 0 to 7, and when r1 and r2 are each 2 or higher, two or more substituents in the parenthesis are the same as or different from each other,
111 and 112 are each an integer from 1 to 3, and when 111 and 112 are each 2 or higher, two or more substituents in the parenthesis are the same as or different from each other,
f1 is 0 to the maximum bondable number of substituents capable of being bonded to Ar1,
f2 is 0 to the maximum bondable number of substituents capable of being bonded to Ar2,
f3 is 0 to the maximum bondable number of substituents capable of being bonded to Ar3, and
f4 is 0 to the maximum bondable number of substituents capable of being bonded to Ar4.

Another exemplary embodiment of the present invention provides a pixel including the above-described ink composition or a cured product thereof.

Still another exemplary embodiment of the present invention provides an organic material layer including the above-described pixel.

Yet another exemplary embodiment of the present invention provides an organic light emitting device including: a first electrode; a second electrode; and an organic material layer having one or more layers provided between the first electrode and the second electrode, in which one or more layers of the organic material layer are the above-described organic material layer.

[Advantageous Effects]

When a number of pixels are coated with the ink composition according to an exemplary embodiment of the present invention, there is an effect in which the thickness between pixels is uniformly coated.

Further, the ink composition according to an exemplary embodiment of the present invention has an advantage of forming a stable thin film that is not damaged by subsequent solution processes by forming thin films formed by a heat treatment or a light treatment.

In addition, since the ink composition according to an exemplary embodiment of the present invention shows resistance to a specific solvent after curing, a solution process can be performed when a device is manufactured, and accordingly, the device can be made to have a large area.

Furthermore, the ink composition according to an exemplary embodiment of the present invention can be used as a material for an organic material layer of an organic light emitting device, and it is possible to obtain a device having low driving voltage, excellent efficiency characteristics, and/or excellent service life characteristics when the ink composition is applied to an organic light emitting device.

[Brief Description of Drawings]

FIG. 1 illustrates an organic light emitting device according to an exemplary embodiment of the present invention.
FIG. 2 shows the NMR measurement results of Compound D-A.
FIG. 3 shows the NMR measurement results of Compound D-B.
FIG. 4 illustrates a line bank inkjet substrate to which the ink composition is applied.
FIG. 5 illustrates that the ink composition is applied to a line bank inkjet substrate.

FIG. 6 illustrates that the ink composition is formed as a thin film on a line bank inkjet substrate.
FIG. 7 is a view illustrating a plan view of an organic material layer in which line banks are formed.
FIG. 8 is a view illustrating a plan view of an organic material layer in which separated banks are formed.
FIG. 9 is a view illustrating the thickness of a pixel according to Example 1-1.
FIG. 10 is a view illustrating the thickness of a pixel according to Comparative Example 1-1.

1': Pixel
101: Substrate
201: First electrode
301: Hole injection layer
401: Hole transport layer
501: Light emitting layer
601: Electron injection and transport layer
701: Second electrode

[Best Mode]

Hereinafter, the present invention will be described in detail.

An exemplary embodiment of the present invention provides an ink composition including a compound represented by the following Chemical Formula 1 and a first solvent represented by the following Chemical Formula A.

[Chemical Formula 1]

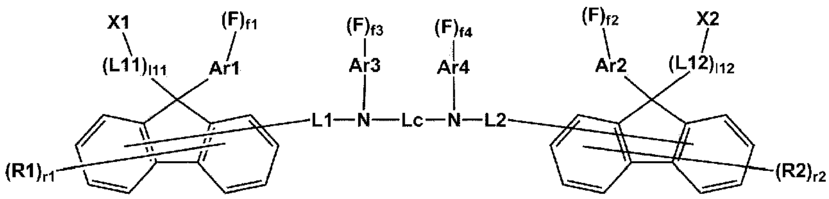

[Chemical Formula A]

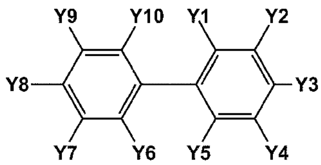

In Chemical Formulae 1 and A,

Y1 to Y10 are the same as or different from each other, and are each independently hydrogen; deuterium; ahydroxylgroup; an ether group; a carbonyl group; an ester group; a substituted or unsubstituted alkyl group; a substituted or unsubstituted cycloalkyl group; a substituted or unsubstituted cycloalkenyl group; a substituted or unsubstituted alkoxy group; a substituted or unsubstituted aryl group; or a substituted or unsubstituted amine group,
Lc is a substituted or unsubstituted heteroarylene group including O, S or Si,
L1 and L2 are the same as or different from each other, and are each independently a direct bond; or a substituted or unsubstituted arylene group,
L11 and L12 are the same as or different from each other, and are each independently a direct bond; -O-; a substituted or unsubstituted alkylene group; or a substituted or unsubstituted arylene group,
Ar1 to Ar4 are the same as or different from each other, and are each independently a substituted or unsubstituted aryl group; or a substituted or unsubstituted heteroaryl group,
R1 and R2 are the same as or different from each other, and are each independently hydrogen; deuterium; a halogen group; or a substituted or unsubstituted alkyl group,
X1 and X2 are the same as or different from each other, and are each independently a curable group,
r1 and r2 are each an integer from 0 to 7, and when r1 and r2 are each 2 or higher, two or more substituents in the parenthesis are the same as or different from each other,
111 and 112 are each an integer from 1 to 3, and when 111 and 112 are each 2 or higher, two or more substituents in the

parenthesis are the same as or different from each other,
f1 is 0 to the maximum bondable number of substituents capable of being bonded to Ar1,
f2 is 0 to the maximum bondable number of substituents capable of being bonded to Ar2,
f3 is 0 to the maximum bondable number of substituents capable of being bonded to Ar3, and
f4 is 0 to the maximum bondable number of substituents capable of being bonded to Ar4.

The compound of Chemical Formula 1 according to an exemplary embodiment of the present invention has a high highest occupied molecular orbital (HOMO) energy level value and excellent hole-mobility by including both a heteroarylene group (Lc) including O, S or Si and two fluorene derivatives. In addition, a curable group is introduced into the two fluorene derivatives to suppress the formation of radicals at the corresponding positions, thereby enhancing the stability of the compound. For this reason, the case where the compound of Chemical Formula 1 is applied to an organic material layer in an organic light emitting device shows an effect in which the performance of the organic light emitting device is improved. In particular, when the compound of Chemical Formula 1 is applied to a hole injection layer, this facilitates the transport or injection of holes to provide an organic light emitting device having high light emitting efficiency and long service life characteristics.

As the solvent represented by Chemical Formula A according to an exemplary embodiment of the present invention includes biphenyl as a core structure, the solvent has excellent solubility in a solute (a compound represented by Chemical Formula 1) included in the ink composition. Furthermore, there is an advantage in that the uniformity of an organic material layer can be improved by reducing the thickness deviation between pixels due to the good leveling effect. Specifically, the ink composition may reduce the deviation in thickness between pixels applied and dried (or heat-treated). Accordingly, it is possible to expect excellent light emitting and/or coloring effects by reducing factors that affect the interference condition of light emitted from the light emitting device according to the thickness.

When one member (layer) is disposed "on" another member (layer) in the present invention, this includes not only a case where the one member (layer) is brought into contact with another member, but also a case where still another member (layer) is present between the two members (layers).

When one part "includes" one constituent element in the present invention, unless otherwise specifically described, this does not mean that another constituent element is excluded, but means that another constituent element may be further included.

In the present invention, the "layer" has a meaning compatible with a "film" usually used in the art, and means a coating covering a target region. The size of the "layer" is not limited, and the sizes of the respective "layers" may be the same as or different from one another. In an exemplary embodiment, the size of the "layer" may be the same as that of the entire device, may correspond to the size of a specific functional region, and may also be as small as a single sub-pixel.

Unless otherwise defined in the present invention, all technical and scientific terms used in the present invention have the same meaning as commonly understood by one with ordinary skill in the art to which the present invention pertains. Although methods and materials similar to or equivalent to those described in the present invention may be used in the practice or in the test of exemplary embodiments of the present invention, suitable methods and materials will be described below. In addition, the materials, methods, and examples are illustrative only and are not intended to be limiting.

In the present invention, "------" and "

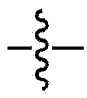

" each mean a moiety bonded to another substituent or a bonding portion.

In the present invention, the term "substitution" means that a hydrogen atom bonded to a carbon atom of a compound is changed into another substituent, and a position to be substituted is not limited as long as the position is a position at which the hydrogen atom is substituted, that is, a position at which the substituent may be substituted, and when two or more substituents are substituted, the two or more substituents may be the same as or different from each other.

In the present invention, the term "substituted or unsubstituted" means being substituted with one or more substituents selected from the group consisting of hydrogen; deuterium; a halogen group; an amine group; an alkyl group; an aryl group; and a heteroaryl group, being substituted with a substituent to which two or more substituents among the exemplified substituents are linked, or having no substituent.

In the present invention, the fact that two or more substituents are linked indicates that hydrogen of any one substituent is linked to another substituent. For example, an isopropyl group and a phenyl group may be linked to each other to become a substituent of

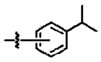 or 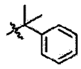.

In the present invention, there is no limitation in the bonding direction of -COO-. For example, the -COO- means both

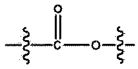 and 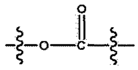.

In the present invention, a halogen group is a fluoro group (-F), a chloro group (-Cl), a bromo group (-Br), or an iodo group (-I).

In the present invention, an alkyl group may be straight-chained or branched, and the number of carbon atoms thereof is not particularly limited, but is preferably 1 to 30; 1 to 20; 1 to 10; or 1 to 5. Specific examples thereof include methyl, ethyl, propyl, n-propyl, isopropyl, butyl, n-butyl, isobutyl, t-butyl, sec-butyl, 1-methylbutyl, 1-ethylbutyl, pentyl, n-pentyl, isopentyl, neopentyl, t-pentyl, hexyl, n-hexyl, 1-methylpentyl, 2-methylpentyl, 3,3-dimethylbutyl, 2-ethylbutyl, heptyl, n-heptyl, 1-methylhexyl, cyclopentylmethyl, cyclohexylmethyl, octyl, n-octyl, t-octyl, 1-methylheptyl, 2-ethylhexyl, 2-propylpentyl, n-nonyl, 2,2-dimethylheptyl, 1-ethylpropyl, 1,1-dimethylpropyl, isohexyl, 4-methylhexyl, 5-methylhexyl, and the like, but are not limited thereto.

In the present invention, an alkylene group means a group having two bonding positions in an alkyl group, that is, a divalent group. The above-described description on the alkyl group may be applied to the alkylene group, except for a divalent alkylene group.

In the present invention, the number of carbon atoms of the cycloalkyl group is not particularly limited, but is preferably 3 to 60. In an exemplary embodiment, the number of carbon atoms of the cycloalkyl group is 3 to 30. Specific examples of the cycloalkyl group include a cyclopropyl group, a cyclobutyl group, a cyclopentyl group, a cyclohexyl group, a cycloheptyl group, a cyclooctyl group, and the like, but are not limited thereto.

In the present invention, an aryl group means a monovalent aromatic hydrocarbon or a monovalent group of an aromatic hydrocarbon derivative. In the present invention, an aromatic hydrocarbon means a compound in which pi electrons are completely conjugated and which contains a planar ring, and an aromatic hydrocarbon derivative means a structure in which an aromatic hydrocarbon or a cyclic aliphatic hydrocarbon is fused with an aromatic hydrocarbon. Further, in the present invention, an aryl group intends to include a monovalent group in which two or more aromatic hydrocarbons or derivatives of an aromatic hydrocarbon are linked to each other. The aryl group is not particularly limited, but preferably has 6 to 60 carbon atoms; 6 to 50 carbon atoms; 6 to 30 carbon atoms; 6 to 25 carbon atoms; 6 to 20 carbon atoms; 6 to 18 carbon atoms; 6 to 15 carbon atoms; 6 to 13 carbon atoms; or 6 to 12 carbon atoms, and may be a monocyclic aryl group or a polycyclic aryl group.

The monocyclic aryl group is not particularly limited, but preferably has 6 to 60 carbon atoms; 6 to 54 carbon atoms; 6 to 48 carbon atoms; 6 to 42 carbon atoms; 6 to 36 carbon atoms; 6 to 30 carbon atoms; 6 to 24 carbon atoms; 6 to 18 carbon atoms; or 6 to 12 carbon atoms, and may be specifically a phenyl group, a biphenyl group, a terphenyl group, and the like, but is not limited thereto.

The polycyclic aryl group is not particularly limited, but preferably has 6 to 60 carbon atoms; 6 to 45 carbon atoms; 6 to 30 carbon atoms; 6 to 22 carbon atoms; 6 to 22 carbon atoms; 6 to 20 carbon atoms; 6 to 18 carbon atoms; 6 to 16 carbon atoms; 6 to 15 carbon atoms; 6 to 14 carbon atoms; 6 to 13 carbon atoms; 6 to 12 carbon atoms; or 6 to 10 carbon atoms, and may be a naphthyl group, an anthracenyl group, a phenanthrenyl group, a pyrenyl group, a perylenyl group, a triphenylenyl group, a chrysenyl group, a fluorenyl group, and the like, but is not limited thereto.

In the present invention, the arylene group means an aryl group having two bonding sites, that is, a divalent group. The above-described description on the aryl group may be applied to the arylene group, except for a divalent group.

In the present invention, a heterocyclic group is an aromatic group, an aliphatic group, including one or more of N, O, P, S, Si and Se as a heteroatom, or a fused ring group of the aromatic group and the aliphatic group. The number of carbon atoms of the heterocyclic group is not particularly limited, but may be 2 to 60.

In the present invention, a heteroaryl group means a monovalent aromatic hetero ring. Here, the aromatic hetero ring is a monovalent group of an aromatic ring or a derivative of the aromatic ring, and means a group including one or more selected from the group consisting of N, O, P, S, Si and Se as a heteroatom. The derivative of the aromatic ring includes all structures in which an aromatic ring or an aliphatic ring is fused with an aromatic ring. Further, in the present specification, the heteroaryl group intends to include a monovalent group in which two or more aromatic rings including a heteroatom or two or more derivatives of an aromatic ring including a heteroatom are linked to each other. The number of carbon atoms of the heteroaryl group is preferably 2 to 60; 2 to 50; 2 to 30; 2 to 20; 2 to 18; or 2 to 13. Examples of the heteroaryl group include a thiophene group, a furanyl group, a pyrrole group, an imidazole group, a thiazole group, an oxazole group, a pyridine group, a pyrimidine group, a triazine group, a triazole group, an acridine group, a pyridazine group, a pyrazine

group, a quinoline group, a quinazoline group, a quinoxaline group, an isoquinoline group, an indole group, a carbazole group, a benzoxazole group, a benzimidazole group, a benzothiazole group, a benzocarbazole group, a benzothiophene group, a dibenzothiophene group, a benzofuran group, a phenanthrolinyl group, a dibenzofuran group, and the like, but are not limited thereto.

In the present invention, a heteroarylene group means a group having two bonding positions in a heteroaryl group, that is, a divalent group. The above-described description on the heteroaryl group may be applied to the heteroarylene group, except for a divalent heteroarylene group.

In the present invention, the above-described description on the aryl group may be applied to an aromatic ring.

In the present invention, the aliphatic ring is not an aromatic but a hydrocarbon ring, and examples thereof include examples of the above-described cycloalkyl group, an adamantyl group, and the like.

In the present invention, a curable group may be subjected to polymerization or cross-linking reaction, and through this, a reaction to increase the molecular weight may be performed, and examples of the curable group include a thermosetting group that is cured by heat, a photocurable group that is cured by light, or the like.

In an exemplary embodiment of the present invention, the curable group is any one of the following structures.

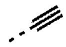 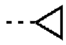 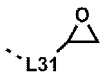 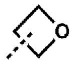 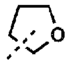 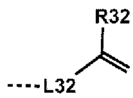 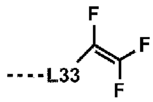

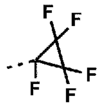 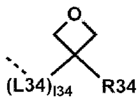 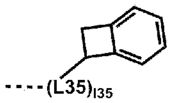 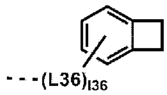 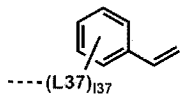

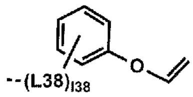 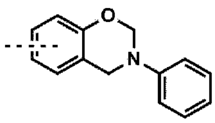 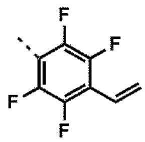 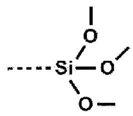

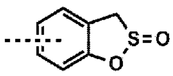 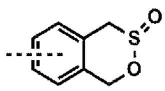

In the structures,

R32 and R34 are the same as or different from each other, and are each independently hydrogen; deuterium; or a substituted or unsubstituted alkyl group,

L31 to L38 are the same as or different from each other, and are each independently a direct bond; -O-; a substituted or unsubstituted alkylene group; or a substituted or unsubstituted arylene group,

134 to 138 are each an integer from 1 to 10, and when 134 to 138 are each 2 or higher, two or more substituents in the parenthesis are the same as or different from each other, and

------ is a moiety bonded to Chemical Formula 1.

Hereinafter, the compound represented by Chemical Formula 1 will be specifically described.

The ink composition of the present invention includes a compound represented by Chemical Formula 1.

In an exemplary embodiment of the present invention, Chemical Formula 1 is represented by the following Chemical Formula 1-A.

[Chemical Formula 1-A]

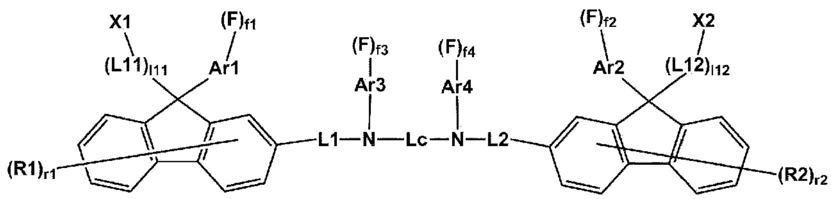

In Chemical Formula 1-A,
the definitions of Lc, L1, L2, L11, L12, Ar1 to Ar4, R1, R2, X1, X2, r1, r2, 111, 112 and f1 to f4 are the same as those in Chemical Formula 1.

In an exemplary embodiment of the present invention, Chemical Formula 1 is represented by the following Chemical Formula 1-1.

[Chemical Formula 1-1]

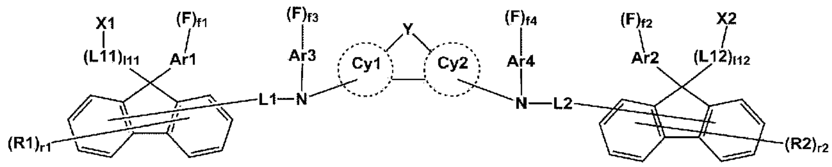

In Chemical Formula 1-1,

Cy1 and Cy2 are the same as or different from each other, and are each independently a substituted or unsubstituted aromatic ring having 6 to 20 carbon atoms,
Y is O, S or SiRy1Ry2,
Ry1 and Ry2 are the same as or different from each other, and are each independently hydrogen; deuterium; a substituted or unsubstituted alkyl group; or a substituted or unsubstituted aryl group, and
L1, L2, L11, L12, Ar1 to Ar4, R1, R2, X1, X2, r1, r2, 111, 112 and f1 to f4 are the same as those defined in Chemical Formula 1.

In an exemplary embodiment of the present invention, Cy1 and Cy2 are the same as or different from each other, and are each independently a substituted or unsubstituted aromatic ring having 6 to 18 carbon atoms.

In an exemplary embodiment of the present invention, Cy1 and Cy2 are the same as or different from each other, and are each independently a substituted or unsubstituted aromatic ring having 6 to 10 carbon atoms.

In an exemplary embodiment of the present invention, Cy1 and Cy2 are the same as or different from each other, and are each independently a substituted or unsubstituted benzene ring; or a substituted or unsubstituted naphthalene ring.

In an exemplary embodiment of the present invention, Cy1 and Cy2 are the same as or different from each other, and are each independently a benzene ring; or a naphthalene ring.

In an exemplary embodiment of the present invention, Lc is a substituted or unsubstituted tricyclic to decacyclic heteroarylene group including O, S or Si.

In an exemplary embodiment of the present invention, Lc is a substituted or unsubstituted tricyclic to octacyclic heteroarylene group including O, S or Si.

In an exemplary embodiment of the present invention, Lc is a substituted or unsubstituted tricyclic to hexacyclic heteroarylene group including O, S or Si.

In an exemplary embodiment of the present invention, Lc is a substituted or unsubstituted divalent dibenzofuran group; a substituted or unsubstituted divalent naphthobenzofuran group; a substituted or unsubstituted divalent dinaphthofuran group; a substituted or unsubstituted divalent dibenzothiophene group; a substituted or unsubstituted divalent naphthobenzothiophene group; a substituted or unsubstituted divalent dinaphthothiophene group; or a substituted or unsubstituted divalent dibenzosilolyl group.

In an exemplary embodiment of the present invention, Lc is a divalent dibenzofuran group unsubstituted or substituted with a halogen group, an alkyl group or an aryl group; a divalent naphthobenzofuran group unsubstituted or substituted with a halogen group, an alkyl group or an aryl group; a divalent dinaphthofuran group unsubstituted or substituted with a halogen group, an alkyl group or an aryl group; a divalent dibenzothiophene group unsubstituted or substituted with a halogen group, an alkyl group or an aryl group; a divalent naphthobenzothiophene group unsubstituted or substituted with a halogen group, an alkyl group or an aryl group; a divalent dinaphthothiophene group unsubstituted or substituted with a halogen group, an alkyl group or an aryl group; or a divalent dibenzosilolyl group unsubstituted or substituted with a halogen group, an alkyl group or an aryl group.

In an exemplary embodiment of the present invention, Lc is a divalent dibenzofuran group; a divalent naphthobenzofuran group; a divalent dinaphthofuran group; a divalent dibenzothiophene group; a divalent naphthobenzothiophene group; a divalent dinaphthothiophene group; or a divalent dibenzosilolyl group unsubstituted or substituted with an alkyl group or an aryl group.

In an exemplary embodiment of the present invention, Lc is any one of the following structures, and the following

structures are unsubstituted or substituted with an additional substituent.

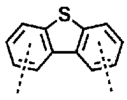
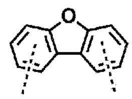
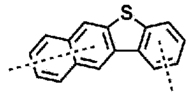
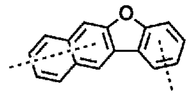
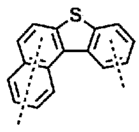
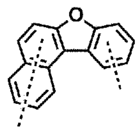
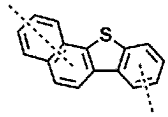
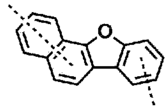
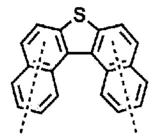
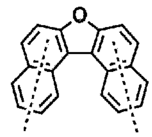
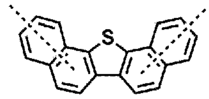
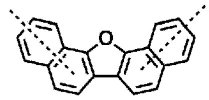
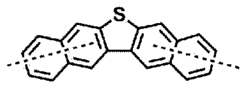
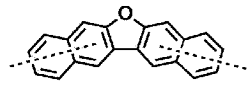
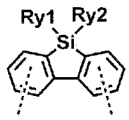

In the structures,

Ry1 and Ry2 are the same as or different from each other, and are each independently a substituted or unsubstituted alkyl group; or a substituted or unsubstituted aryl group, and
------ is a moiety linked to Chemical Formula 1.

In an exemplary embodiment of the present invention, an additional substituent to be substituted for the structure is one or more selected from the group consisting of deuterium; a halogen group; an alkyl group; an alkoxy group; an aryl group; and a heterocyclic group.

In an exemplary embodiment of the present invention, the structure is unsubstituted or substituted with deuterium; a halogen group; an alkyl group; an alkoxy group; an aryl group; or a heterocyclic group.

In an exemplary embodiment of the present invention, Lc is anyone of the structures, and the structure is not substituted.

In an exemplary embodiment of the present invention, Ry1 and Ry2 are the same as or different from each other, and are each independently a substituted or unsubstituted alkyl group having 1 to 30 carbon atoms; or a substituted or unsubstituted aryl group having 6 to 30 carbon atoms.

In an exemplary embodiment of the present invention, Ry1 and Ry2 are the same as or different from each other, and are each independently an alkyl group; or an aryl group.

In an exemplary embodiment of the present invention, Ry1 and Ry2 are the same as or different from each other, and are each independently an alkyl group having 1 to 30 carbon atoms; or an aryl group having 6 to 30 carbon atoms.

In an exemplary embodiment of the present invention, Ry1 and Ry2 are the same as or different from each other, and are each independently a methyl group; an ethyl group; a butyl group; or a phenyl group.

In an exemplary embodiment of the present invention, R1 and R2 are the same as or different from each other, and are each independently hydrogen; deuterium; a halogen group; or a substituted or unsubstituted alkyl group having 1 to 30 carbon atoms.

In an exemplary embodiment of the present invention, R1 and R2 are the same as or different from each other, and are each independently hydrogen; deuterium; a halogen group; or an alkyl group having 1 to 30 carbon atoms.

In an exemplary embodiment of the present invention, R1 and R2 are the same as or different from each other, and are each independently hydrogen or deuterium.

In an exemplary embodiment of the present invention, L1 and L2 are the same as or different from each other, and are each independently a direct bond; or a substituted or unsubstituted arylene group having 6 to 30 carbon atoms.

In an exemplary embodiment of the present invention, L1 and L2 are the same as or different from each other, and are each independently a direct bond; or a substituted or unsubstituted arylene group having 6 to 20 carbon atoms.

In an exemplary embodiment of the present invention, L1 and L2 are the same as or different from each other, and are each independently a direct bond; or a substituted or unsubstituted arylene group having 6 to 12 carbon atoms.

In an exemplary embodiment of the present invention, L1 and L2 are the same as or different from each other, and are each independently a direct bond; or an arylene group unsubstituted or substituted with an alkyl group.

In an exemplary embodiment of the present invention, L1 and L2 are the same as or different from each other, and are each independently a direct bond; or a substituted or unsubstituted phenylene group.

In an exemplary embodiment of the present invention, L1 and L2 are the same as or different from each other, and are each independently a direct bond; or a phenylene group unsubstituted or substituted with an alkyl group.

In an exemplary embodiment of the present invention, L1 and L2 are the same as or different from each other, and are each independently a direct bond; or a phenylene group unsubstituted or substituted with an alkyl group having 1 to 10 carbon atoms.

In an exemplary embodiment of the present invention, L1 and L2 are each a direct bond.

In an exemplary embodiment of the present invention, L11 and L12 are the same as or different from each other, and are each independently a direct bond; -O-; a substituted or unsubstituted alkylene group having 1 to 30 carbon atoms; or a substituted or unsubstituted arylene group having 6 to 30 carbon atoms.

In an exemplary embodiment of the present invention, L11 and L12 are the same as or different from each other, and are each independently a direct bond; -O-; a methylene group; an ethylene group; a propylene group; a substituted or unsubstituted phenylene group; or a substituted or unsubstituted biphenylene group.

In an exemplary embodiment of the present invention, Ar1 to Ar4 are the same as or different from each other, and are each independently a substituted or unsubstituted aryl group having 6 to 30 carbon atoms; or a substituted or unsubstituted heteroaryl group having 2 to 30 carbon atoms.

In an exemplary embodiment of the present invention, Ar1 to Ar4 are the same as or different from each other, and are each independently a substituted or unsubstituted aryl group having 6 to 20 carbon atoms; or a substituted or unsubstituted heteroaryl group having 2 to 20 carbon atoms.

In an exemplary embodiment of the present invention, Ar1 to Ar4 are the same as or different from each other, and are each independently an aryl group having 6 to 30 carbon atoms, which is unsubstituted or substituted with an alkyl group or a heteroaryl group; or a heteroaryl group having 2 to 30 carbon atoms, which is unsubstituted or substituted with an alkyl group.

In an exemplary embodiment of the present invention, Ar1 to Ar4 are the same as or different from each other, and are each independently a substituted or unsubstituted phenyl group; a substituted or unsubstituted biphenyl group; a substituted or unsubstituted naphthyl group; a substituted or unsubstituted fluorenyl group; a substituted or unsubstituted dibenzofuran group; or a substituted or unsubstituted dibenzothiophene group.

In an exemplary embodiment of the present invention, Ar1 to Ar4 are the same as or different from each other, and are each independently a substituted or unsubstituted phenyl group; a substituted or unsubstituted biphenyl group; a substituted or unsubstituted dibenzofuran group; or a substituted or unsubstituted dibenzothiophene group.

In an exemplary embodiment of the present invention, Ar1 to Ar4 are the same as or different from each other, and are each independently a phenyl group unsubstituted or substituted with an alkyl group or a heteroaryl group; a biphenyl group unsubstituted or substituted with an alkyl group or a heteroaryl group; a dibenzofuran group unsubstituted or substituted with an alkyl group; or a dibenzothiophene group unsubstituted or substituted with an alkyl group.

In an exemplary embodiment of the present invention, Ar1 to Ar4 are the same as or different from each other, and are each independently a phenyl group unsubstituted or substituted with an alkyl group; a biphenyl group unsubstituted or substituted with an alkyl group; a dibenzofuran group unsubstituted or substituted with an alkyl group; or a dibenzothiophene group unsubstituted or substituted with an alkyl group.

In an exemplary embodiment of the present invention, Ar1 to Ar4 are the same as or different from each other, and are each independently a group to which any one or two or more of the following structures is or are linked, and the following structures are unsubstituted or substituted with an additional substituent.

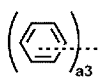 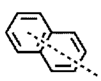 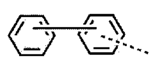 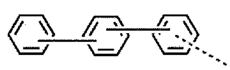 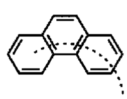

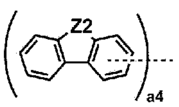 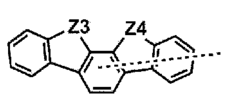 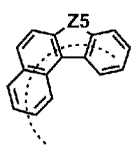 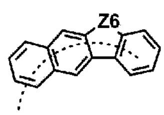

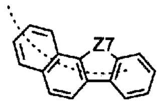 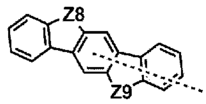 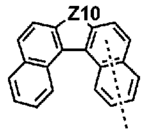 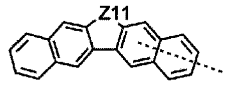

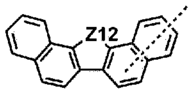 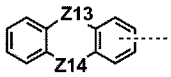 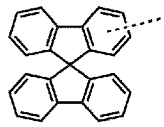 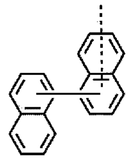

In the structures,

Z2 to Z14 are the same as or different from each other, and are each independently S; O; CRjRk; SiRlRm; or NRn,
Rj to Rn are the same as or different from each other, and are each independently hydrogen; deuterium; a substituted or unsubstituted alkyl group; a substituted or unsubstituted aryl group; or a substituted or unsubstituted heterocyclic group,
a3 and a4 are each an integer from 1 to 5, and when a3 and a4 are each 2 or higher, two or more structures in the parenthesis are the same as or different from each other, and
------ is a moiety bonded to Chemical Formula 1.

In an exemplary embodiment of the present invention, an additional substituent to be substituted for the structure is one or more selected from the group consisting of deuterium; a halogen group; an alkyl group; an alkoxy group; an aryl group; and a heterocyclic group.

In an exemplary embodiment of the present invention, Ar1 to Ar4 are the same as or different from each other, and are each independently a group to which any one or two or more of the following structures is or are linked, and the following structures are unsubstituted or substituted with an additional substituent.

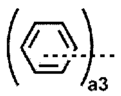 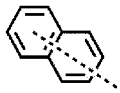 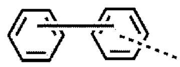 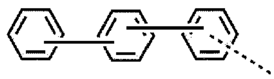

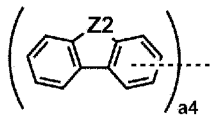 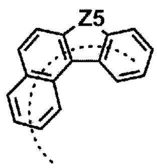 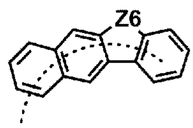 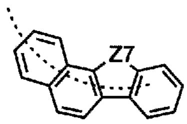

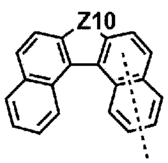 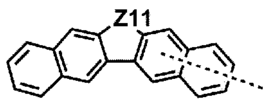 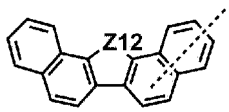

In the structures,
Z2, Z5 to Z7, Z10 to Z12, a3, a4 and ------ are the same as those described above.

In an exemplary embodiment of the present invention, the additional substituent is an alkyl group or a heteroaryl group.

In an exemplary embodiment of the present invention, Ar1 to Ar4 are any one of the following structures, and the following structures are unsubstituted or substituted with an additional substituent.

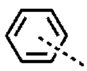 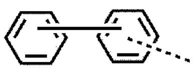 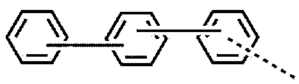

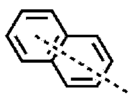 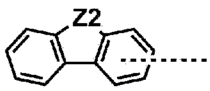 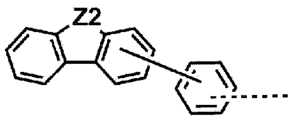

In the structures, Z2 and ------ are the same as those described above.
In an exemplary embodiment of the present invention, the additional substituent is an alkyl group or a heteroaryl group.
In an exemplary embodiment of the present invention, Ar1 to Ar4 are the same as or different from each other, and are each independently a substituted or unsubstituted aryl group.
In an exemplary embodiment of the present invention, Ar1 to Ar4 are the same as or different from each other, and are each independently an aryl group unsubstituted or substituted with an alkyl group.
In an exemplary embodiment of the present invention, Ar1 to Ar4 are the same as or different from each other, and are each independently an aryl group unsubstituted or substituted with an alkyl group having 1 to 30 carbon atoms.
In an exemplary embodiment of the present invention, Ar1 to Ar4 are the same as or different from each other, and are each independently an aryl group unsubstituted or substituted with an alkyl group having 1 to 10 carbon atoms.
In an exemplary embodiment of the present invention, Ar1 to Ar4 are the same as or different from each other, and are each independently a phenyl group unsubstituted or substituted with an alkyl group; a biphenyl group unsubstituted or substituted with an alkyl group; a terphenyl group unsubstituted or substituted with an alkyl group; or a naphthyl group unsubstituted or substituted with an alkyl group.
In an exemplary embodiment of the present invention, Ar1 to Ar4 are the same as or different from each other, and are each independently any one of the following structures, and the following structures are unsubstituted or substituted with an additional substituent.

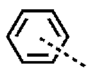 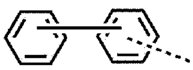 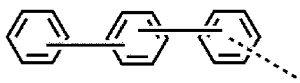 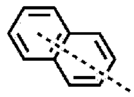

In the structures, ------ is the same as that described above.
In an exemplary embodiment of the present invention, the additional substituent is an alkyl group or a heteroaryl group.
In an exemplary embodiment of the present invention, the structure is unsubstituted or substituted with an alkyl group.
In an exemplary embodiment of the present invention, the structure is unsubstituted or substituted with at least one substituent selected from the group consisting of a methyl group, a dimethyl group and a tert-butyl group.
In an exemplary embodiment of the present invention, Ar1 and Ar2 are the same as or different from each other, and are each independently a phenyl group unsubstituted or substituted with at least one substituent selected from the group consisting of a methyl group, a dimethyl group and a tert-butyl group; a biphenyl group unsubstituted or substituted with at least one substituent selected from the group consisting of a methyl group, a dimethyl group and a tert-butyl group; a terphenyl group unsubstituted or substituted with at least one substituent selected from the group consisting of a methyl group, a dimethyl group and a tert-butyl group; or a naphthyl group unsubstituted or substituted with at least one substituent selected from the group consisting of a methyl group, a dimethyl group and a tert-butyl group.
In an exemplary embodiment of the present invention, Ar1 and Ar2 are the same as or different from each other, and are each independently a phenyl group; a phenyl group substituted with a methyl group; a phenyl group substituted with a dimethyl group; a phenyl group substituted with a tert-butyl group; or a biphenyl group.
In an exemplary embodiment of the present invention, Ar3 and Ar4 are the same as or different from each other, and are each independently a phenyl group unsubstituted or substituted with at least one substituent selected from the group consisting of a methyl group, a dimethyl group and a tert-butyl group; a biphenyl group unsubstituted or substituted with at least one substituent selected from the group consisting of a methyl group, a dimethyl group and a tert-butyl group; a terphenyl group unsubstituted or substituted with at least one substituent selected from the group consisting of a methyl group, a dimethyl group and a tert-butyl group; or a naphthyl group unsubstituted or substituted with at least one substituent selected from the group consisting of a methyl group, a dimethyl group and a tert-butyl group.
In an exemplary embodiment of the present invention, Ar3 and Ar4 are the same as or different from each other, and are each independently a phenyl group; a phenyl group substituted with a methyl group; a phenyl group substituted with a dimethyl group; a phenyl group substituted with a tert-butyl group; a biphenyl group; a biphenyl group substituted with a methyl group; a biphenyl group substituted with a dimethyl group; a biphenyl group substituted with a tert-butyl group; a biphenyl group substituted with a dimethyl group and a tert-butyl group; or a terphenyl group.
In an exemplary embodiment of the present invention, f1 is 0 to the maximum bondable number of substituents

capable of being bonded to Ar1, f2 is 0 to the maximum bondable number of substituents capable of being bonded to Ar2, f3 is 0 to the maximum bondable number of substituents capable of being bonded to Ar3, and f4 is 0 to the maximum bondable number of substituents capable of being bonded to Ar4. In this case, the maximum bondable number of substituents capable of being bonded is the number of hydrogens bonded to Ar1 to Ar4. For example, when Ar1 is a phenyl group, f1 is an integer from 0 to 5, and when Ar1 is a biphenyl group, f1 is an integer from 0 to 9.

In an exemplary embodiment of the present invention, f1 to f4 are each an integer from 0 to 11.

In an exemplary embodiment of the present invention, f1 to f4 are each an integer from 0 to 9.

In an exemplary embodiment of the present invention, f1 to f4 are each an integer from 0 to 7.

In an exemplary embodiment of the present invention, f1 is an integer from 0 to 5. In another exemplary embodiment of the present invention, f1 is an integer from 0 to 3.

In an exemplary embodiment of the present invention, f2 is an integer from 0 to 5. In another exemplary embodiment of the present invention, f2 is an integer from 0 to 5.

In an exemplary embodiment of the present invention, f3 is an integer from 0 to 5. In another exemplary embodiment of the present invention, f3 is an integer from 0 to 3.

In an exemplary embodiment of the present invention, f4 is an integer from 0 to 5. In another exemplary embodiment of the present invention, f4 is an integer from 0 to 3.

In an exemplary embodiment of the present invention, f1+f2+f3+f4 is an integer of 1 or higher. Specifically, f1+f2+f3+f4 is an integer from 1 to 36. More specifically, f1+f2+f3+f4 is an integer from 1 to 20. That is, one or more of f1 to f4 are 1 or higher. That is, the compound represented by Chemical Formula 1 includes one or more F's.

In an exemplary embodiment of the present invention, $-Ar1-(F)_{f1}$, $-Ar2-(F)_{f2}$, $-Ar3-(F)_{f3}$ and $-Ar4-(F)_{f4}$ may be each represented by any one of the following structures, and the following structures are unsubstituted or substituted with an additional substituent.

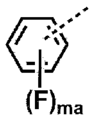
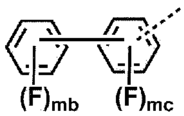
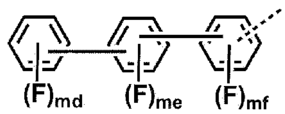

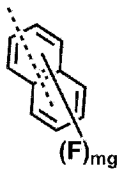
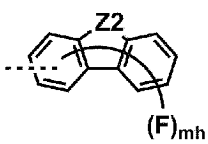
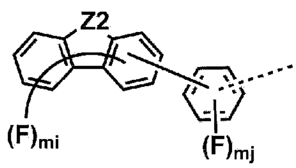

In the structures,

Z2 is S; O; CRjRk; SiRlRm; or NRn,

Rj to Rn are the same as or different from each other, and are each independently hydrogen; deuterium; a substituted or unsubstituted alkyl group; a substituted or unsubstituted aryl group; or a substituted or unsubstituted heterocyclic group,

ma, mb and md are an integer from 0 to 5, mc, me, mf and mj are an integer from 0 to 4, and mg, mh and mi are an integer from 0 to 7, and

------ is a moiety bonded to Chemical Formula 1.

In an exemplary embodiment of the present invention, Z2 is O or S.

In an exemplary embodiment of the present invention, $-Ar1-(F)_{f1}$, $-Ar2-(F)_{f2}$, $-Ar3-(F)_{f3}$ and $-Ar4-(F)_{f4}$ are any one of the following structures, and the following structures are unsubstituted or substituted with an additional substituent.

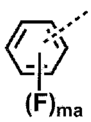
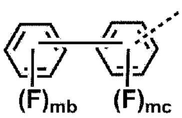
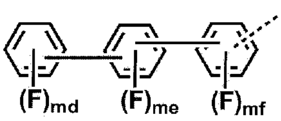
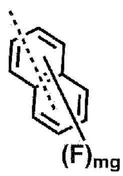

In the structures,
ma to mg and ------ are the same as those described above.

In an exemplary embodiment of the present invention, an additional substituent to be substituted for the structure

is one or more substituents selected from the group consisting of deuterium; a halogen group; an alkyl group; an alkoxy group; an aryl group; and a heteroaryl group.

In an exemplary embodiment of the present invention, the structure is unsubstituted or substituted with one or more substituents selected from the group consisting of deuterium; a halogen group; an alkyl group having 1 to 30 carbon atoms; an alkoxy group having 1 to 30 carbon atoms; an aryl group having 6 to 30 carbon atoms; and a heteroaryl group having 2 to 30 carbon atoms.

In an exemplary embodiment of the present invention, the structure is unsubstituted or substituted with an alkyl group.

In an exemplary embodiment of the present invention, the structure is unsubstituted or substituted with one or more substituents selected from the group consisting of a methyl group, a dimethyl group and a tert-butyl group.

In an exemplary embodiment of the present invention, X1 and X2 are the same as or different from each other, and are each independently selected from the above-described curable group structures.

In an exemplary embodiment of the present invention, X1 and X2 are the same as or different from each other, and are each independently any one of the following structures.

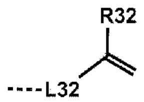 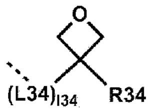 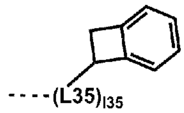

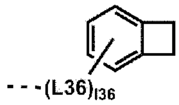 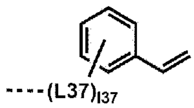 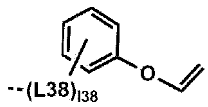

In the structures,

L32 and L34 to L38 are a direct bond; -O-; a substituted or unsubstituted alkylene group; or a substituted or unsubstituted arylene group,
134 to 138 are each an integer from 1 to 10, and when 134 to 138 are each 2 or higher, two or more substituents in the parenthesis are the same as or different from each other, and
------ is a moiety bonded to Chemical Formula 1.

In an exemplary embodiment of the present invention, X1 and X2 are the same as or different from each other, and are each independently any one of the following structures.

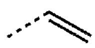 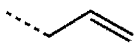 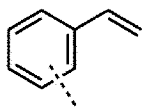 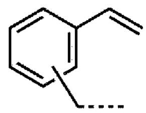 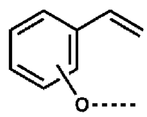

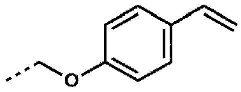 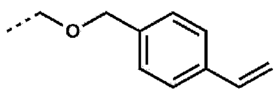 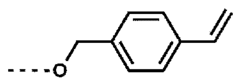

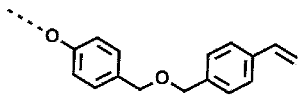 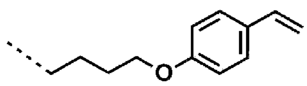

In an exemplary embodiment of the present invention, the compound represented by Chemical Formula 1 is any one of the following structures.

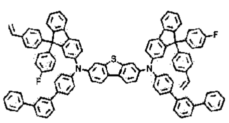 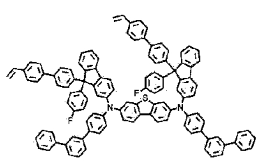 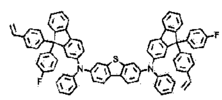 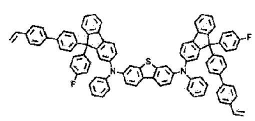

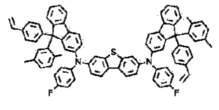
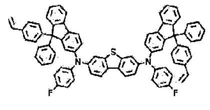
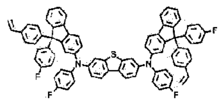
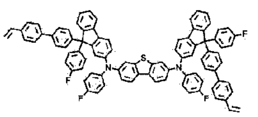
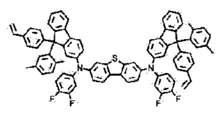
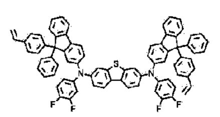
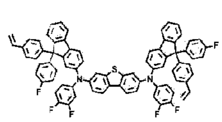
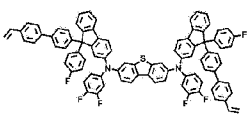
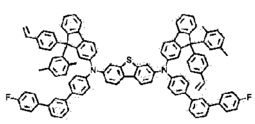
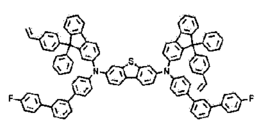
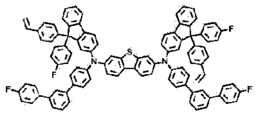
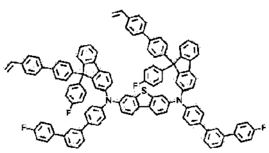
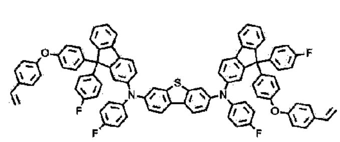
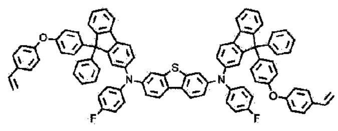
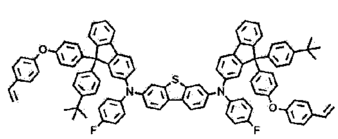
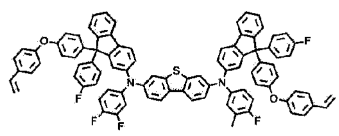
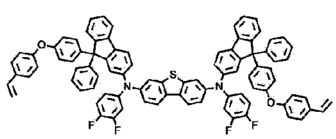
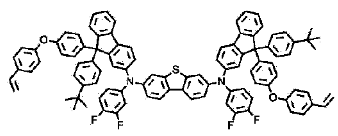
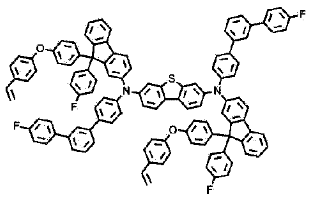
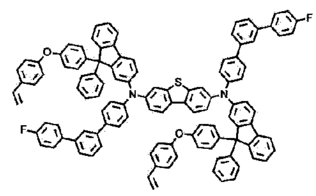
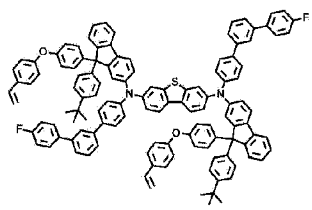
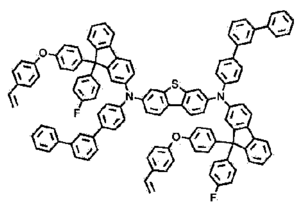
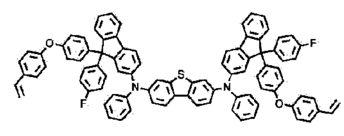
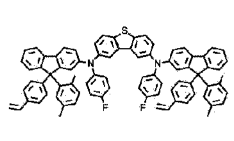
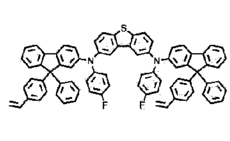
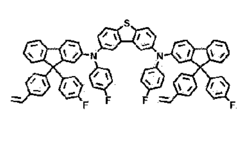
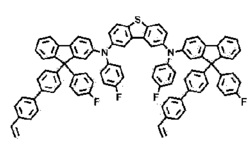
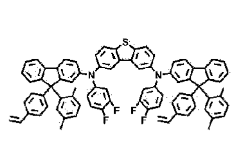
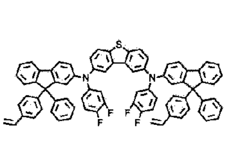
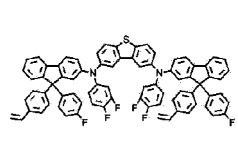
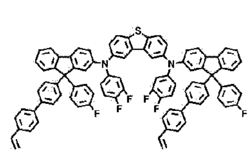

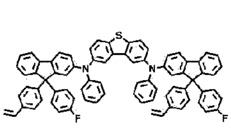
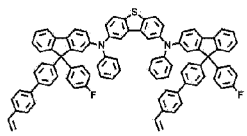
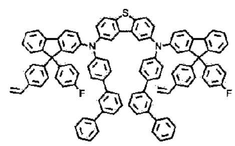
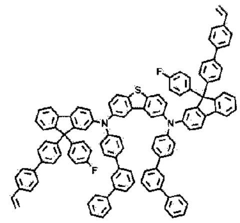

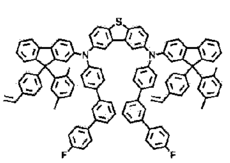
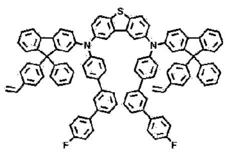
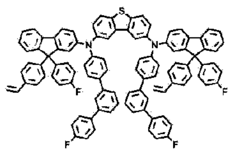
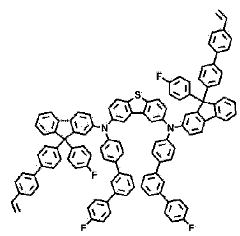

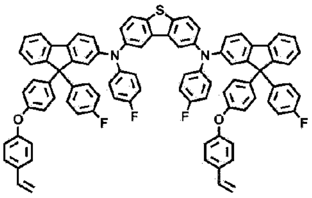
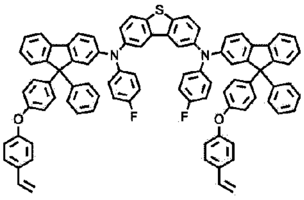
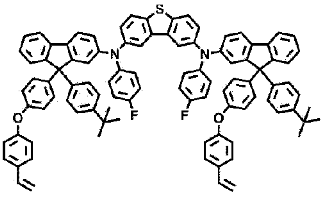

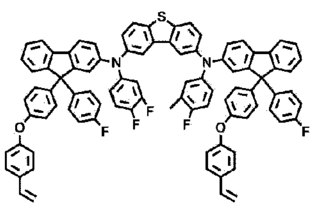
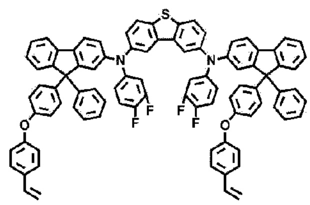
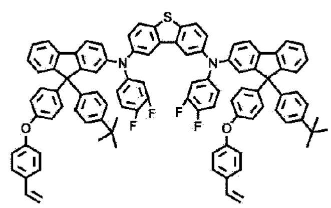

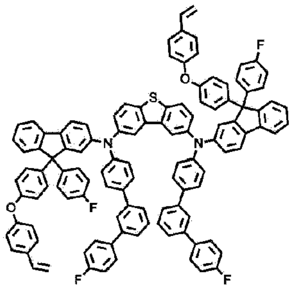
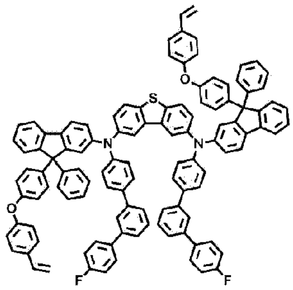
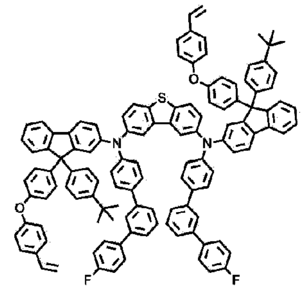

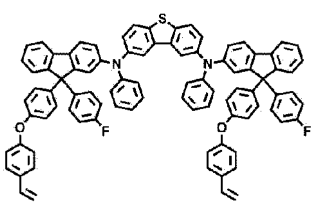
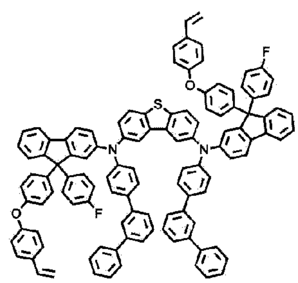

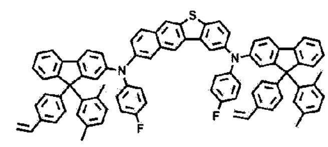
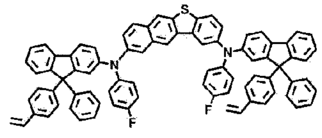
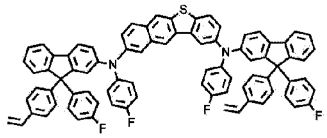

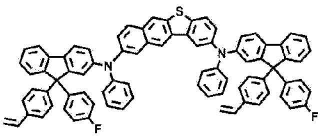
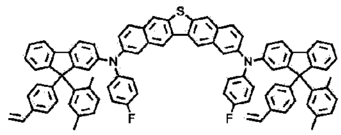
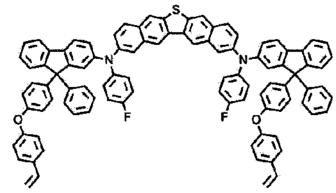

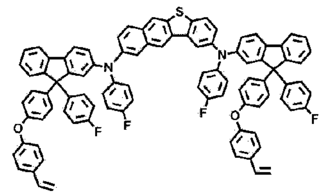
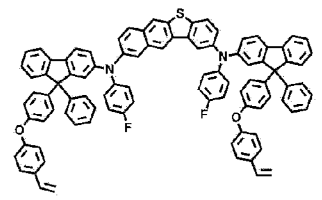
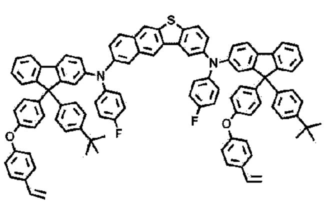

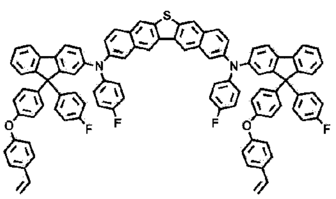
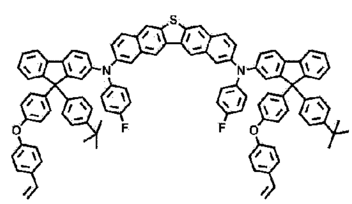
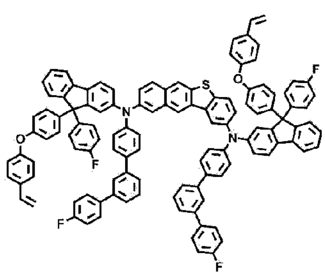

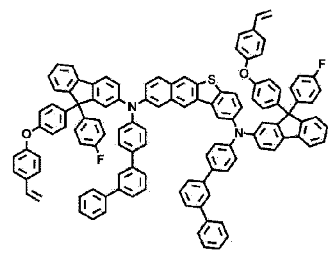

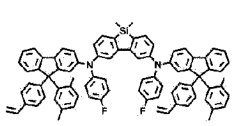
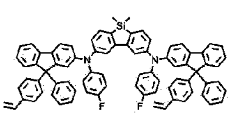
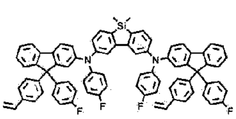
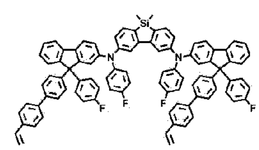

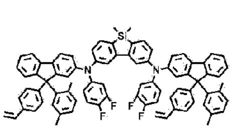
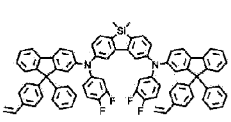
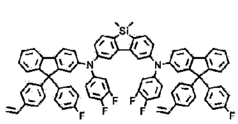
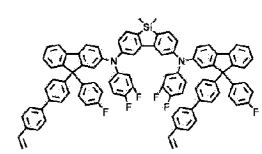

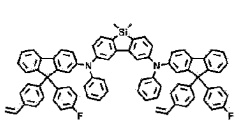
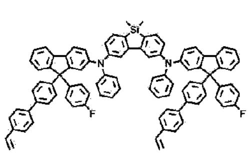
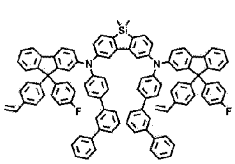
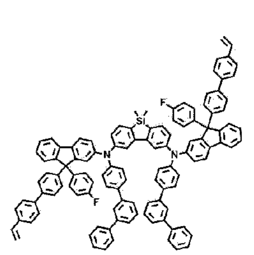

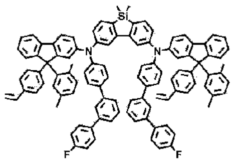
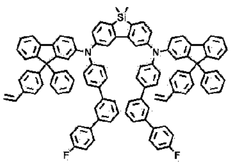
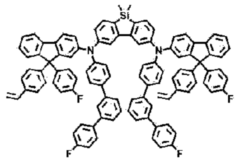
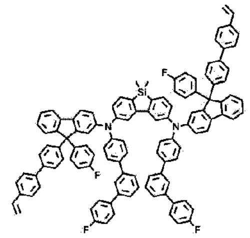

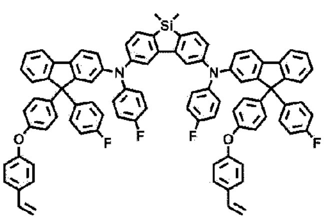
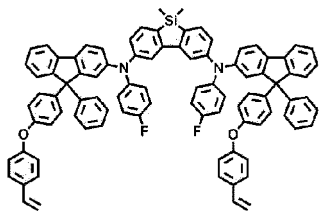
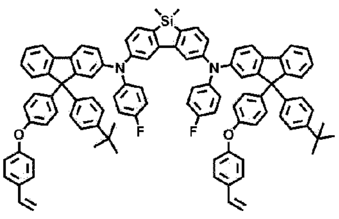

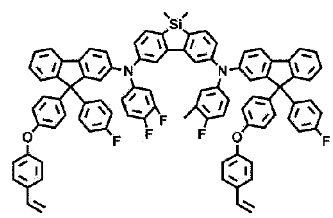
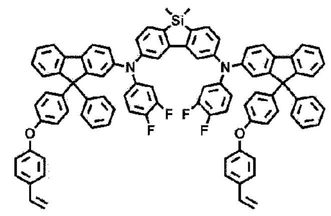
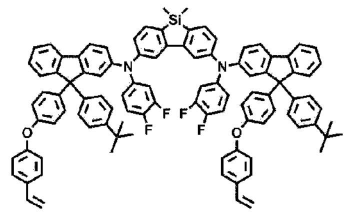

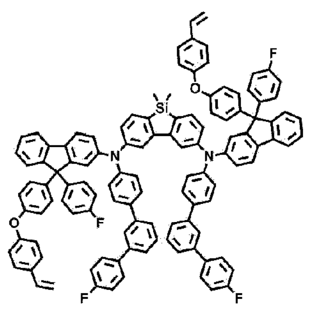
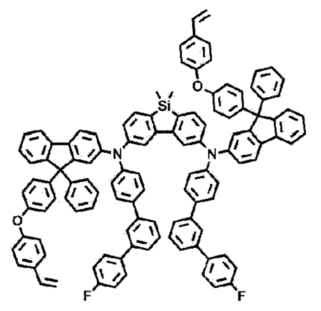
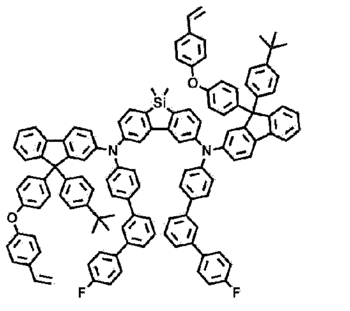

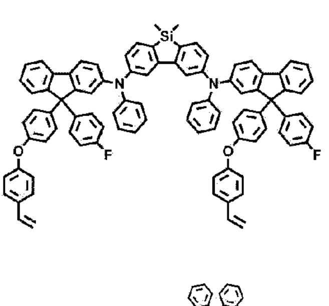
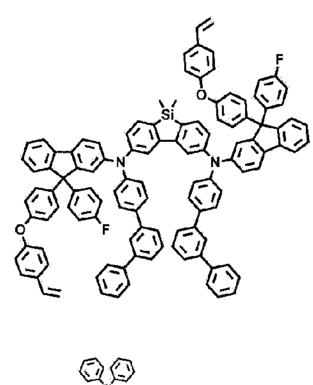

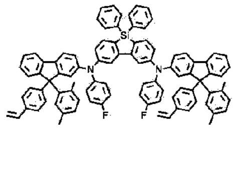
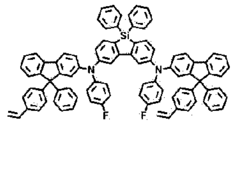
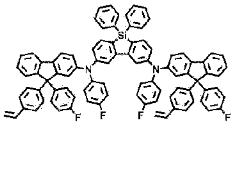
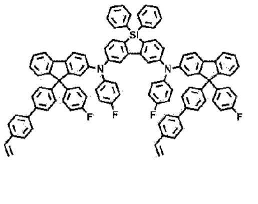

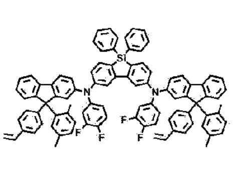
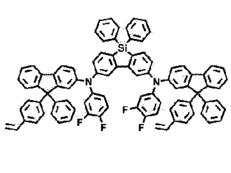
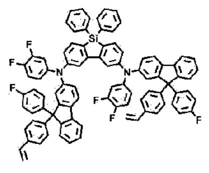
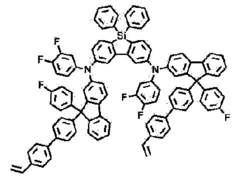

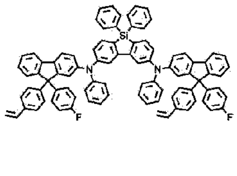
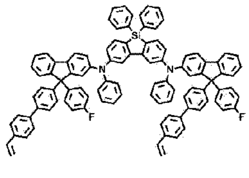
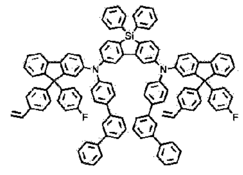
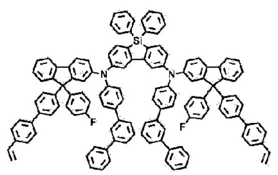

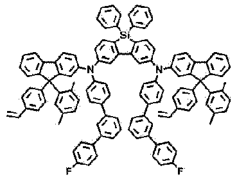
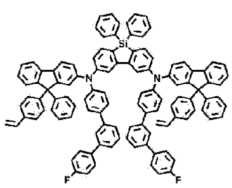
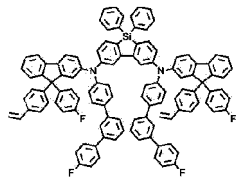
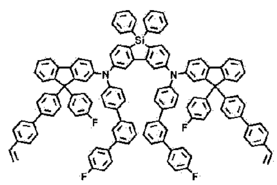

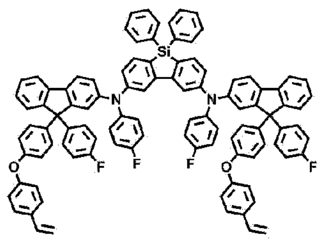
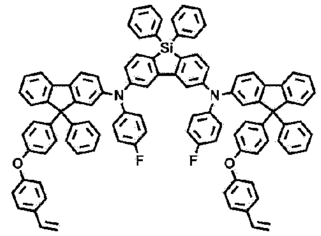
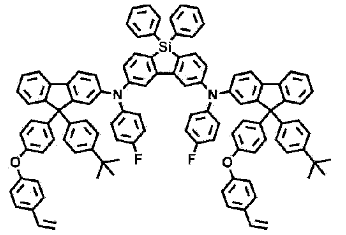

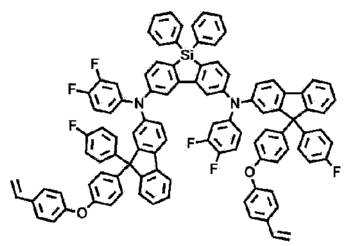
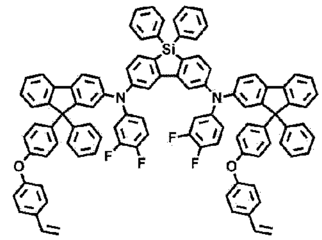
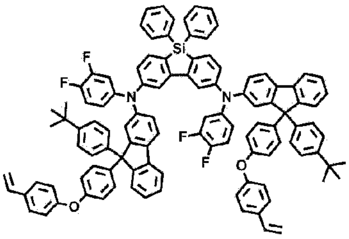

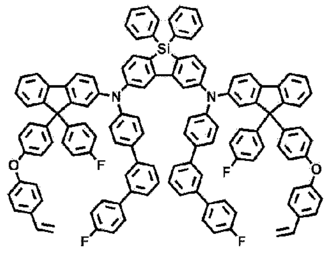
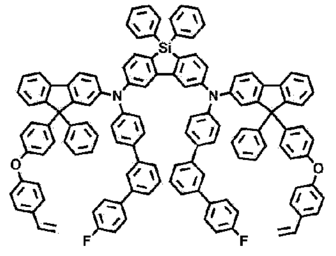
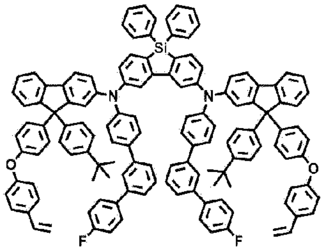

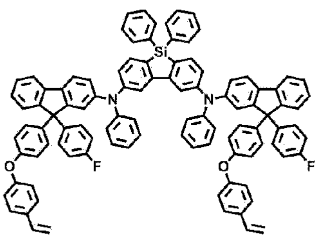
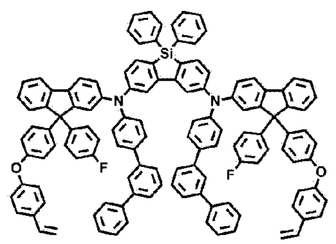

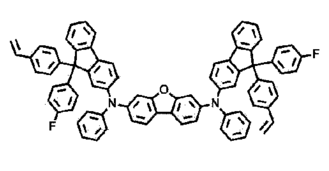
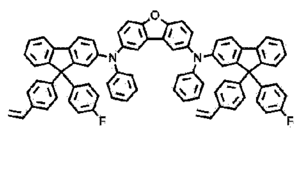
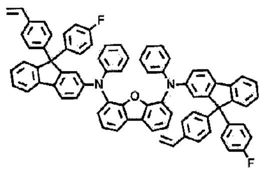

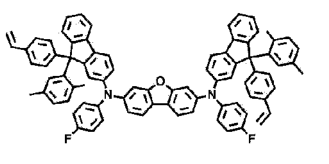
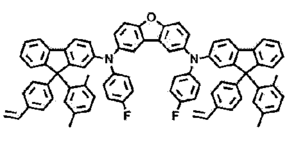
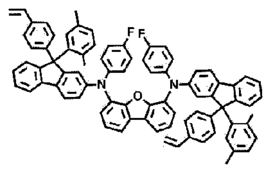

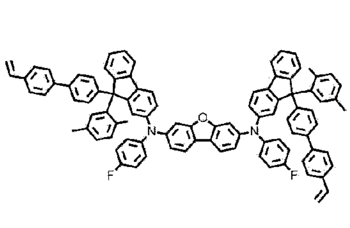
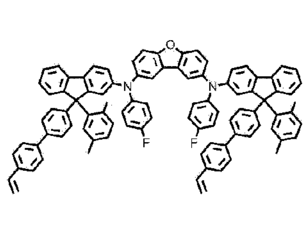
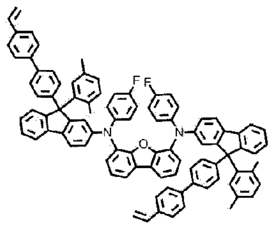

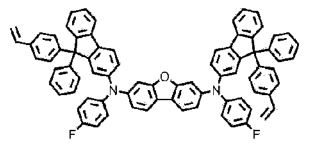
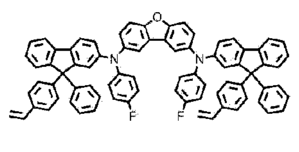
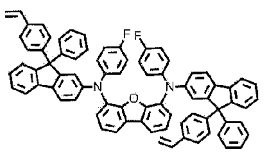

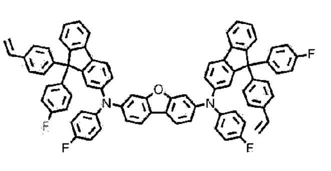
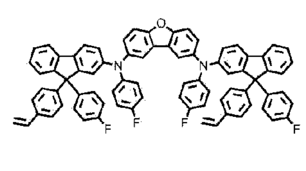
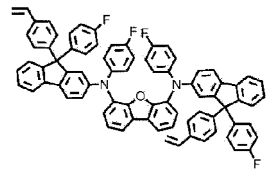

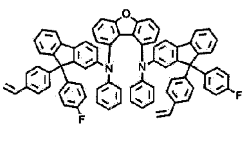
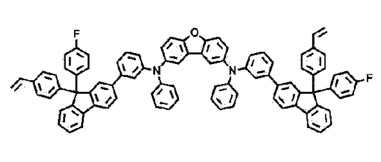
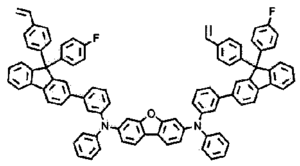

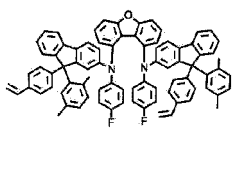
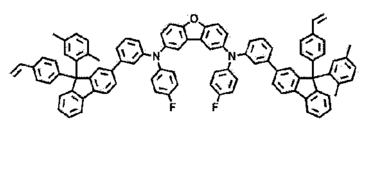
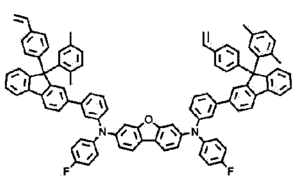

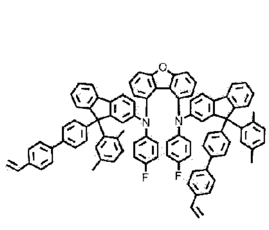
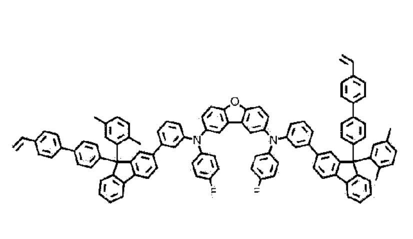
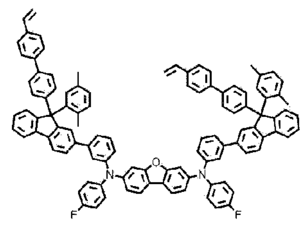

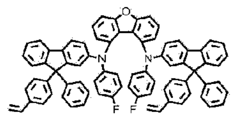
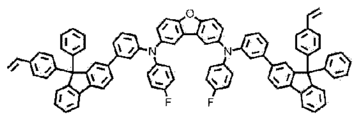
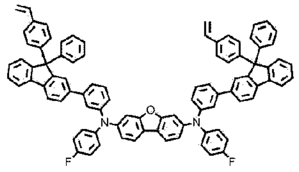
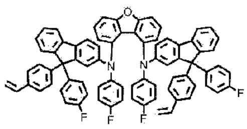
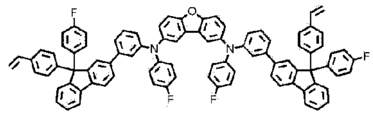
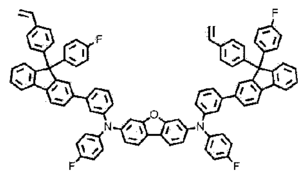
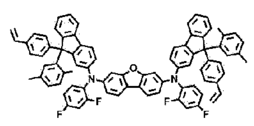
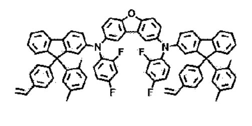
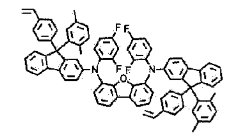
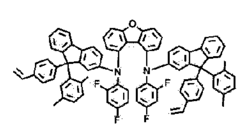
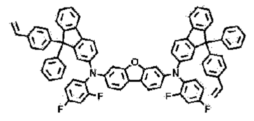
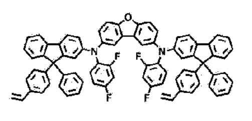
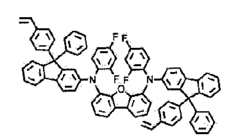
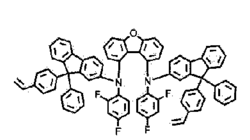
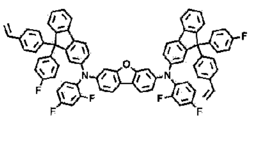
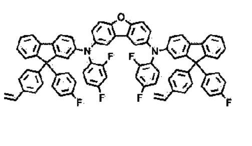
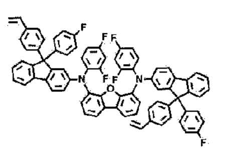
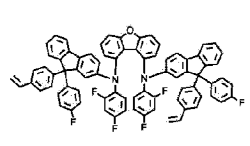
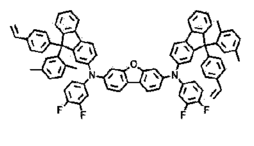
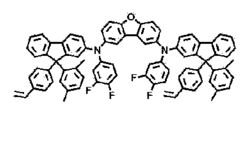
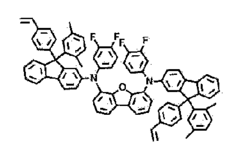
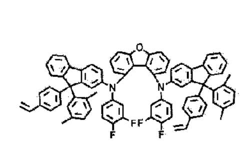
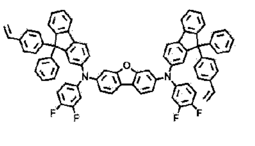
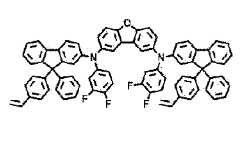
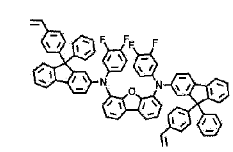
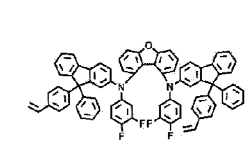
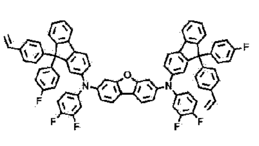
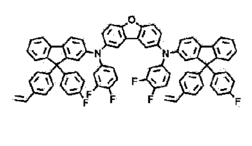
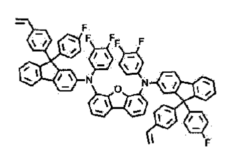
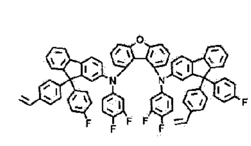
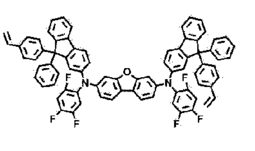
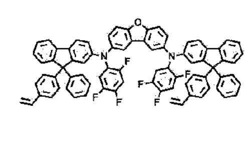
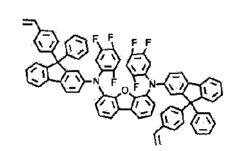
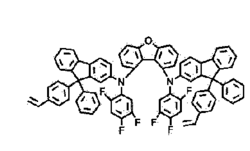

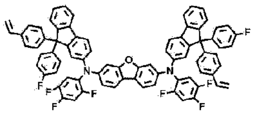
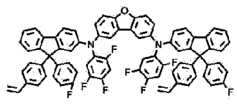
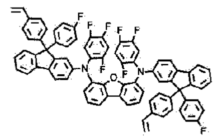
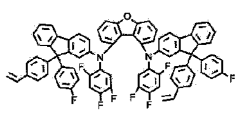

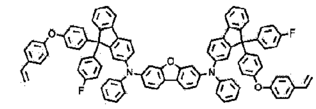
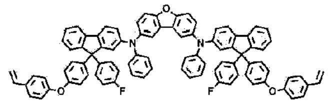
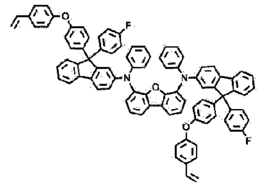

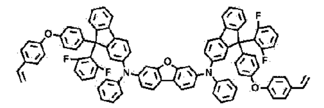
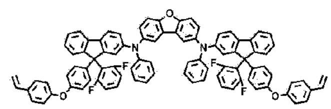
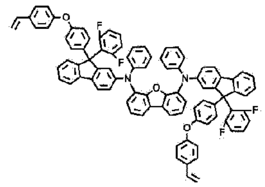

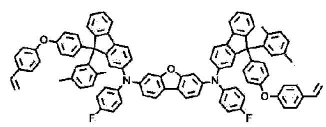
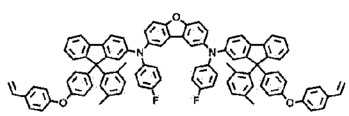
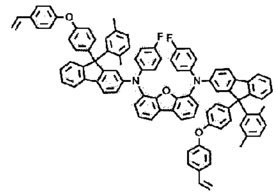

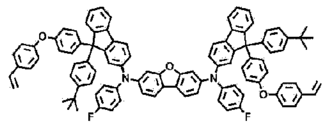
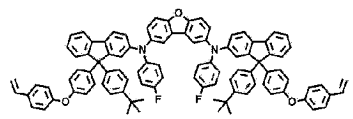
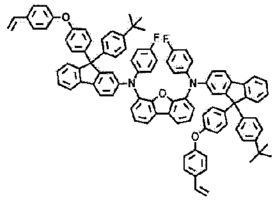

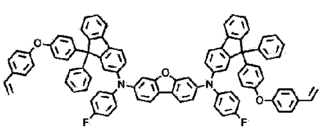
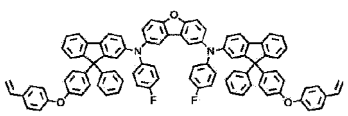
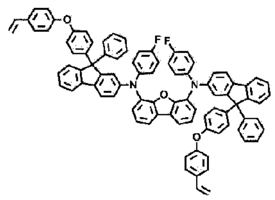

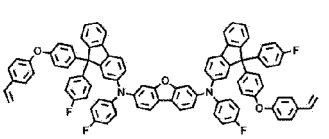
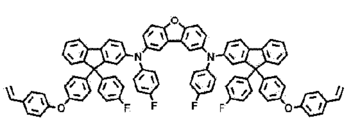
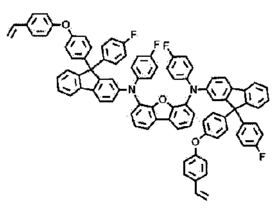

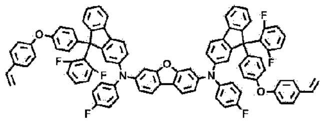
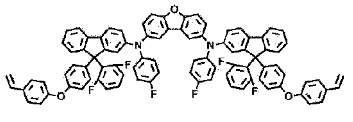
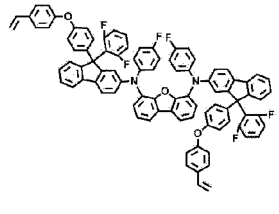

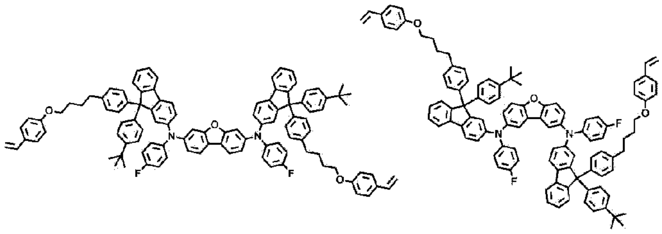
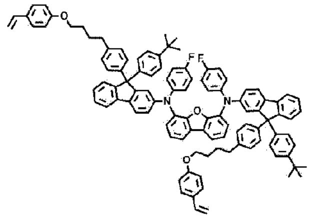

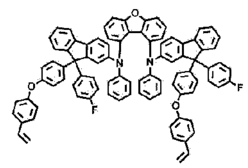
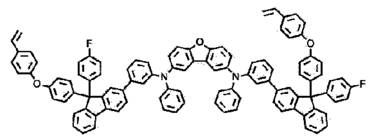
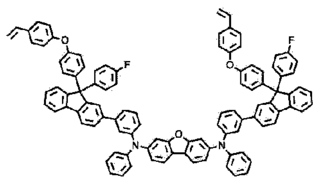

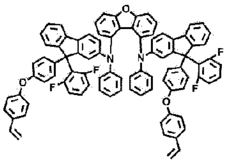
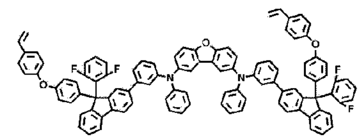
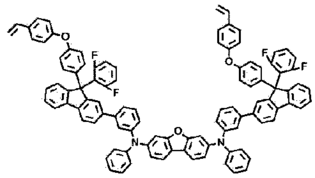

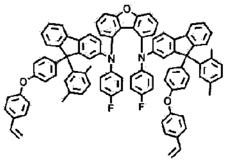
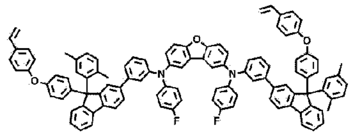
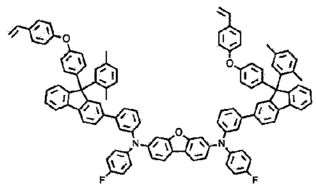

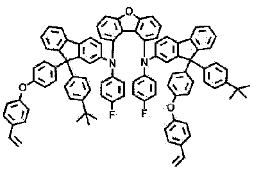
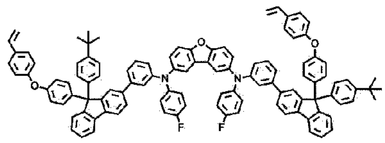
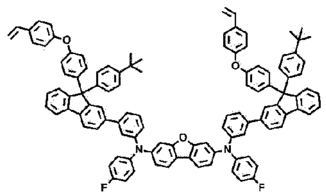

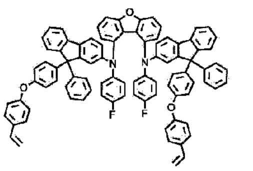
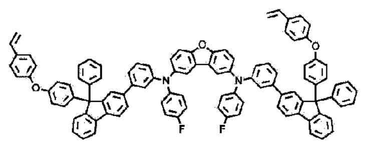
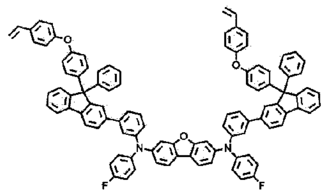

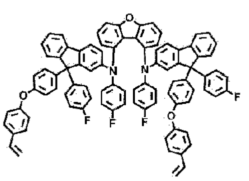
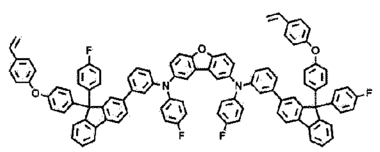
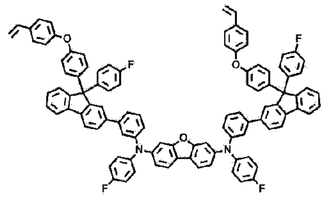

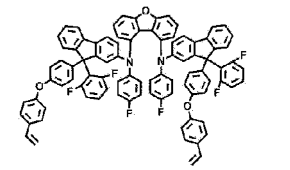 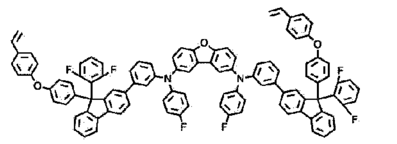 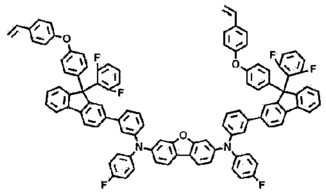

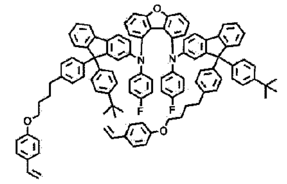 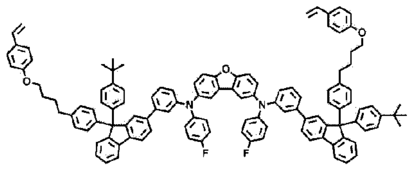 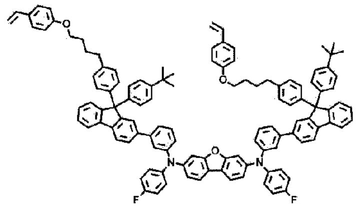

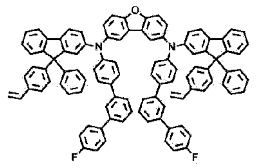 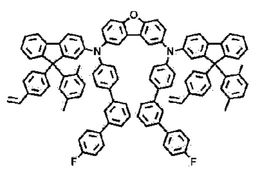 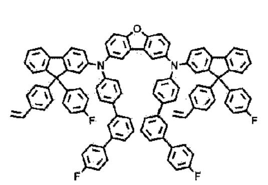

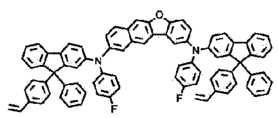 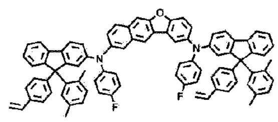 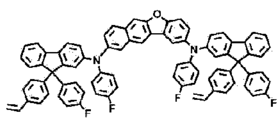

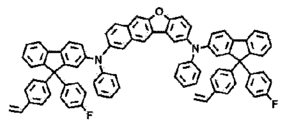 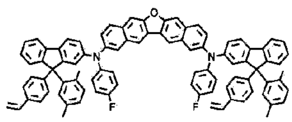 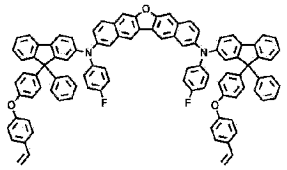

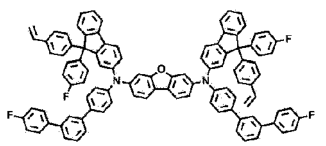 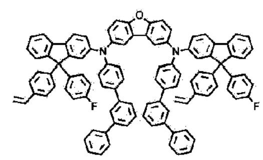 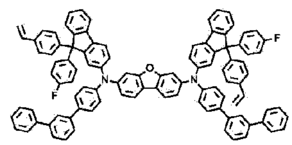

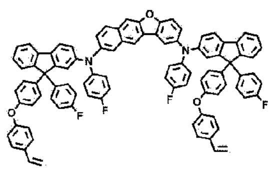 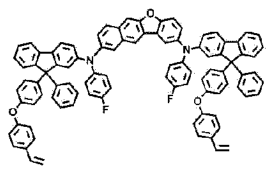 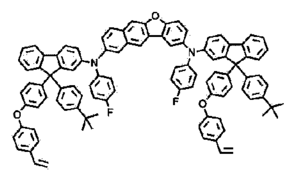

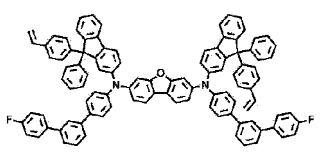 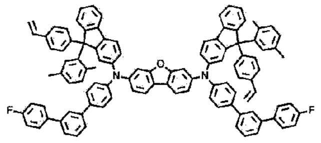 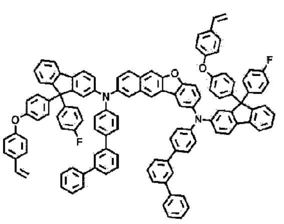

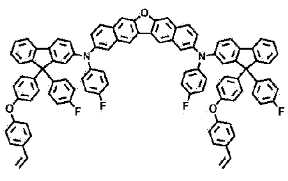
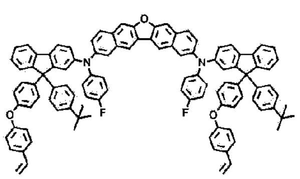
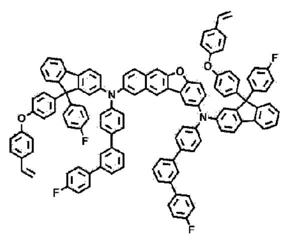

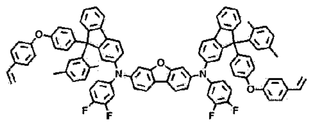
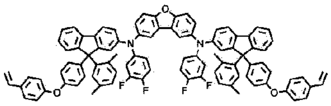
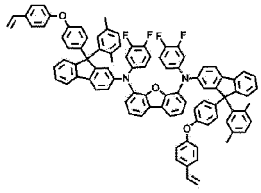

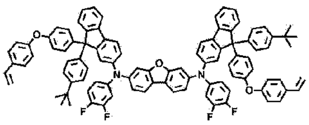
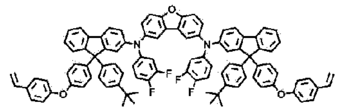
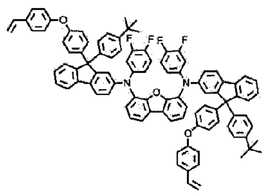

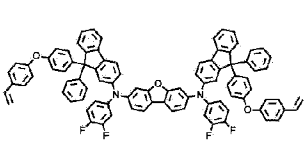
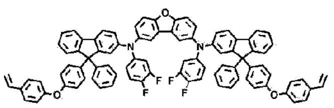
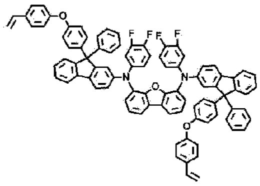

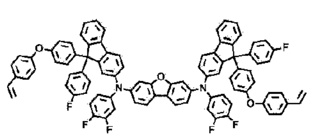
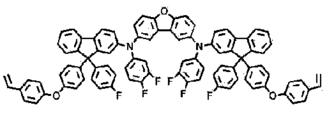
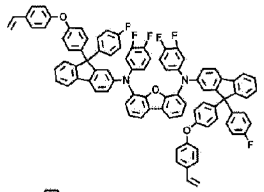

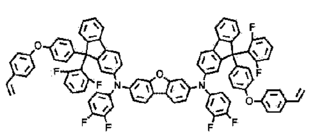
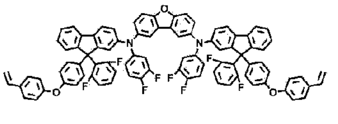
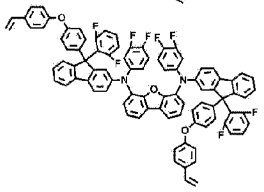

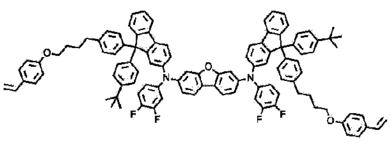
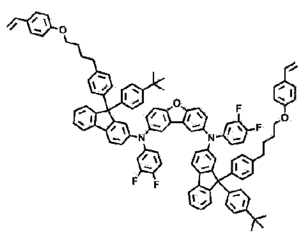
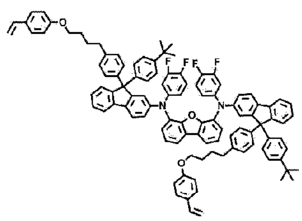

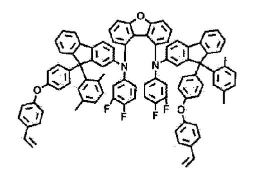
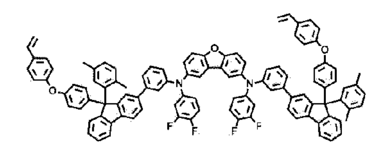
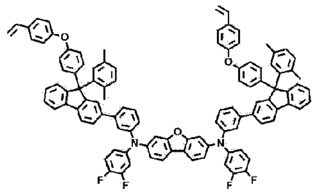

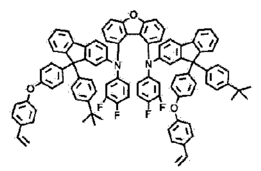
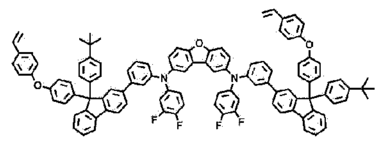
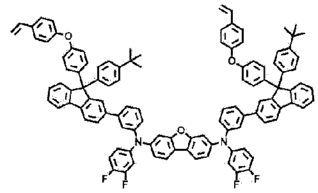

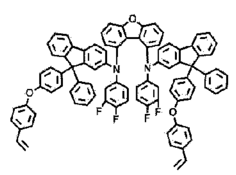
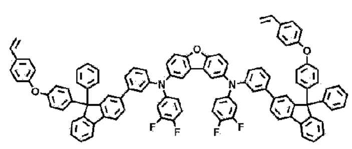
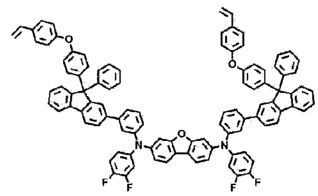

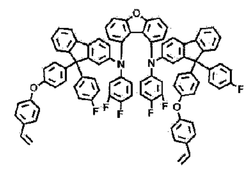
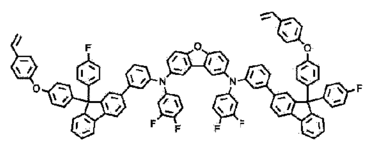
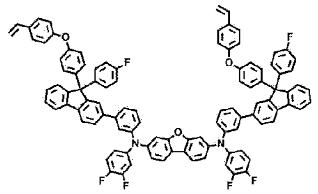

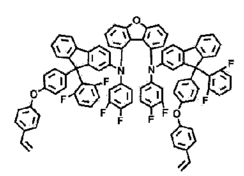
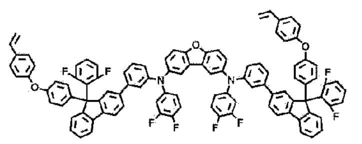
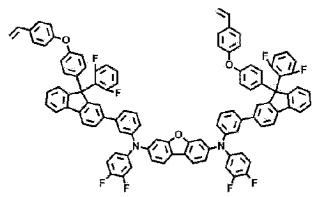

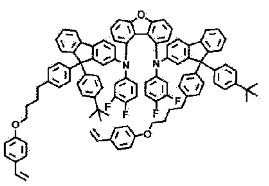
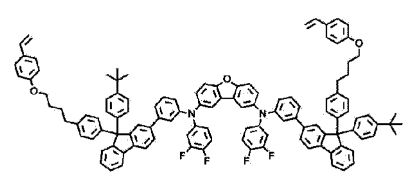
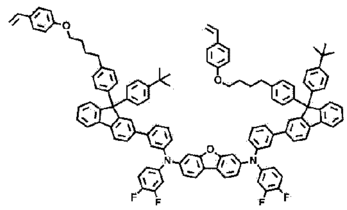

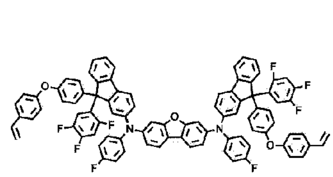
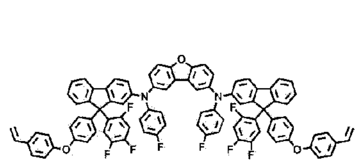
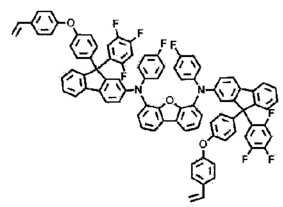

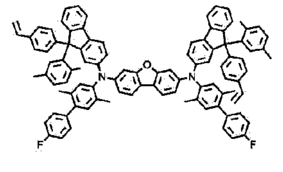
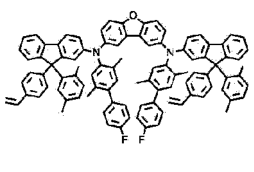
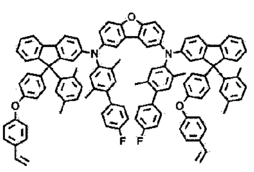

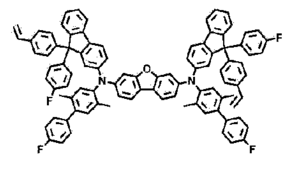
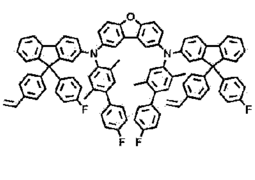
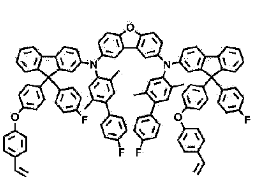

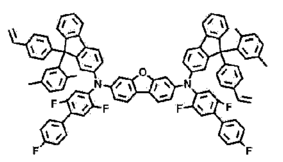
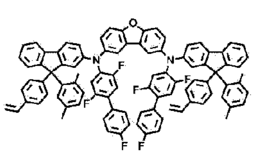
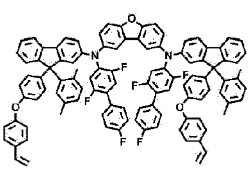

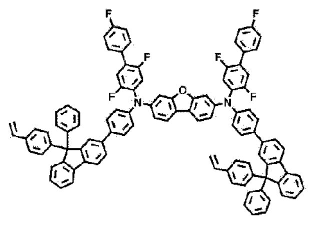
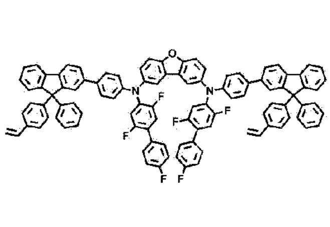
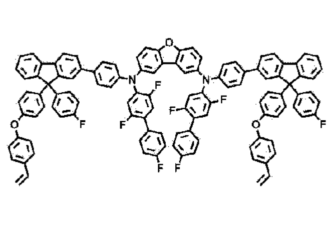

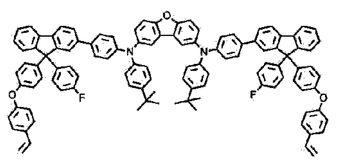

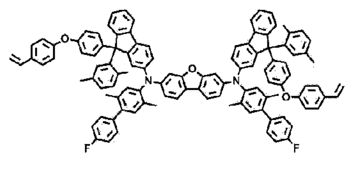
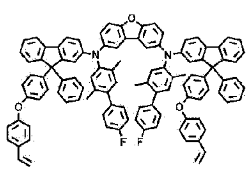
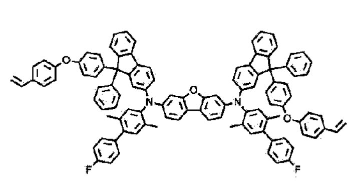

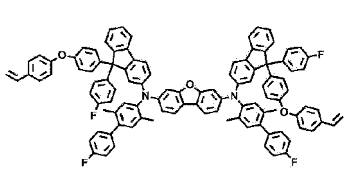
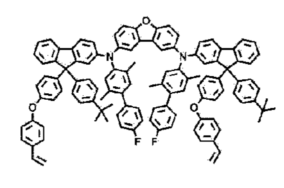
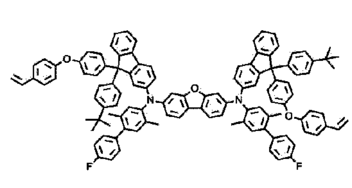

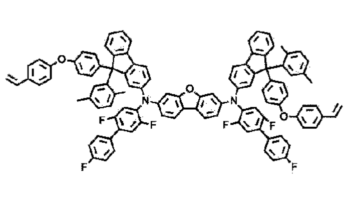
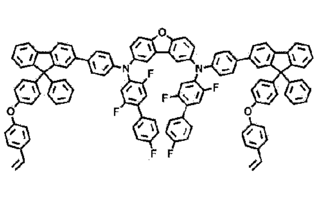
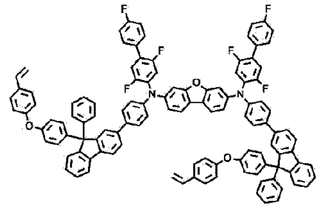

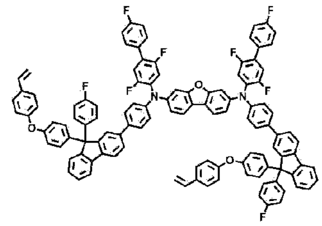
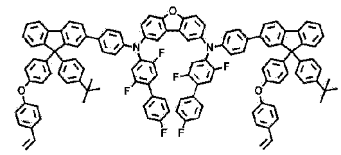
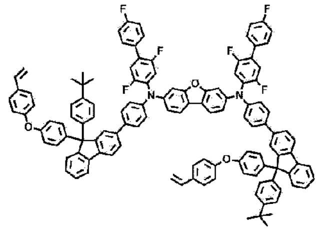

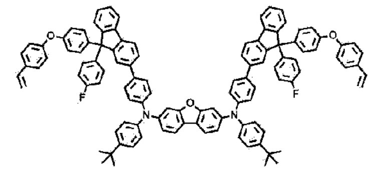

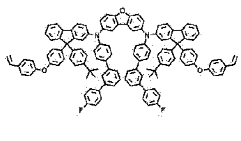
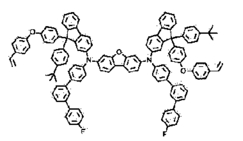
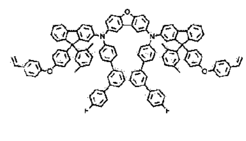
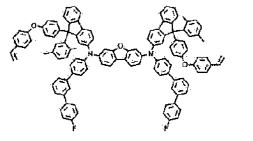

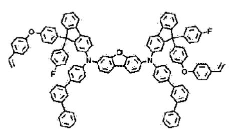
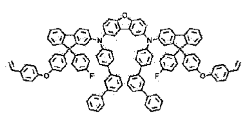
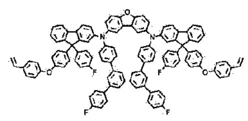
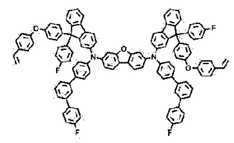

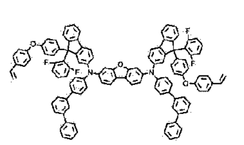
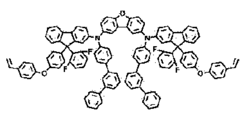
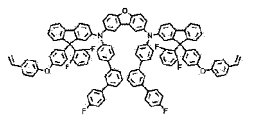
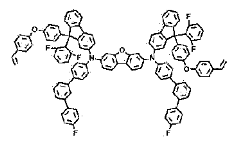

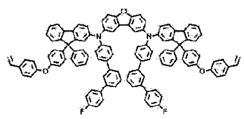
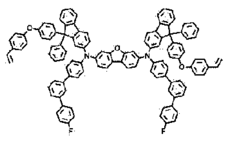
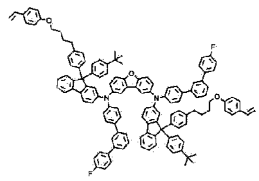
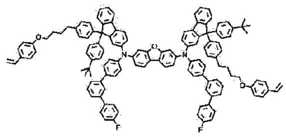

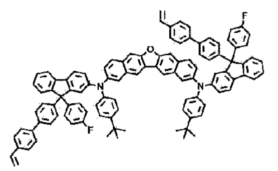
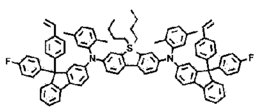
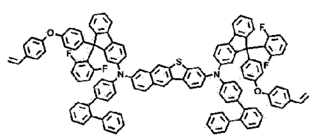

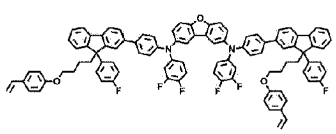
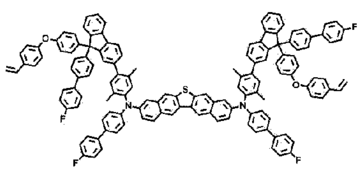

Hereinafter, a first solvent represented by Chemical Formula A will be specifically described.

According to an exemplary embodiment of the present invention, Y1 to Y10 are the same as or different from each other, and are each independentlyhydrogen; deuterium; a hydroxyl group; an ether group; a carbonyl group; an ester group; a substituted or unsubstituted alkyl group; a substituted or unsubstituted cycloalkyl group; a substituted or unsubstituted cycloalkenyl group; a substituted or unsubstituted alkoxy group; a substituted or unsubstituted aryl group; or a substituted or unsubstituted amine group.

According to an exemplary embodiment of the present invention, Y1 to Y10 are the same as or different from each other, and are each independentlyhydrogen; deuterium; a hydroxyl group; a substituted or unsubstituted alkyl group; a substituted or unsubstituted cycloalkyl group; a substituted or unsubstituted cycloalkenyl group; a substituted or unsubstituted alkoxy group; a substituted or unsubstituted aryl group; or a substituted or unsubstituted amine group.

According to an exemplary embodiment of the present invention, Y1 to Y10 are the same as or different from each other, and are each independently hydrogen; deuterium; a substituted or unsubstituted alkyl group; or a substituted or unsubstituted alkoxy group.

According to an exemplary embodiment of the present invention, Y1 to Y10 are the same as or different from each other, and are each independently hydrogen; deuterium; a substituted or unsubstituted alkyl group having 1 to 10 carbon atoms; or a substituted or unsubstituted alkoxy group having 1 to 10 carbon atoms.

According to an exemplary embodiment of the present invention, Y1 to Y10 are the same as or different from each other, and are each independently hydrogen; deuterium; a substituted or unsubstituted alkyl group having 1 to 8 carbon atoms; or a substituted or unsubstituted alkoxy group having 1 to 8 carbon atoms.

According to an exemplary embodiment of the present invention, Y1 to Y10 are the same as or different from each other, and are each independently hydrogen; deuterium; a substituted or unsubstituted alkyl group having 1 to 6 carbon atoms; or a substituted or unsubstituted alkoxy group having 1 to 6 carbon atoms.

According to an exemplary embodiment of the present invention, Y1 to Y10 are the same as or different from each other, and are each independently hydrogen; deuterium; an alkyl group; or an alkoxy group.

According to an exemplary embodiment of the present invention, Y1 to Y10 are the same as or different from each other, and are each independently hydrogen; deuterium; a substituted or unsubstituted methyl group; a substituted or unsubstituted ethyl group; a substituted or unsubstituted propyl group; a substituted or unsubstituted butyl group; a substituted or unsubstituted pentyl group; a substituted or unsubstituted hexyl group; a substituted or unsubstituted isopropyl group; a substituted or unsubstituted isobutyl group; a substituted or unsubstituted tert-butyl group; a substituted or unsubstituted methoxy group; a substituted or unsubstituted ethoxy group; a substituted or unsubstituted propoxy group or a substituted or unsubstituted butoxy group.

According to an exemplary embodiment of the present invention, Y1 to Y10 are the same as or different from each other, and are each independently hydrogen; deuterium; a methyl group; an ethyl group; a propyl group; a butyl group; a pentyl group; a hexyl group; an isopropyl group; an isobutyl group; a tert-butyl group; a methoxy group; an ethoxy group; a propoxy group; or a butoxy group.

According to an exemplary embodiment of the present invention, Y1 to Y10 are the same as or different from each other, and are each independently hydrogen; deuterium; an ethyl group; a propyl group; a butyl group; a pentyl group; an isopropyl group; or a methoxy group.

In an exemplary embodiment of the present invention, the first solvent represented by Chemical Formula A is any one of the following structures.

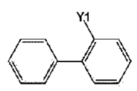 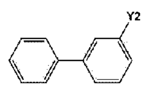 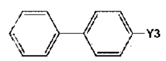 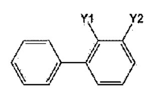 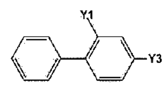

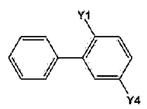 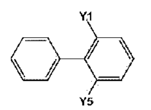 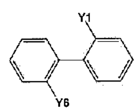 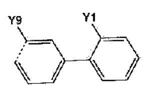 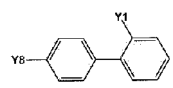

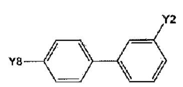 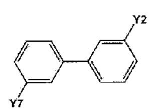 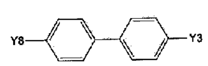 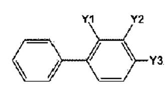 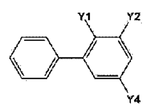

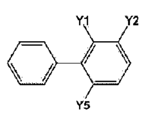 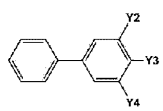 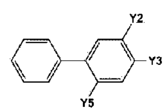 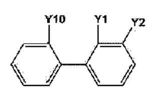 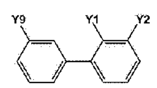

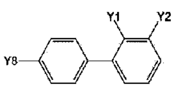 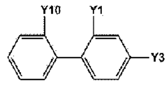 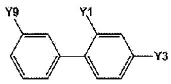 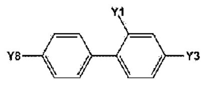 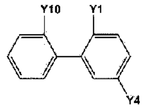

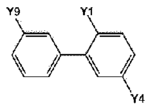 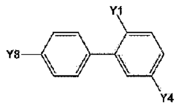 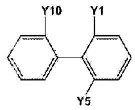 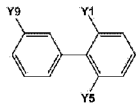 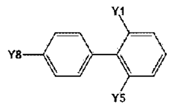

In the structures, Y1 to Y10 are the same as or different from each other, and are each independently a substituted or unsubstituted alkyl group; or a substituted or unsubstituted alkoxy group.

In an exemplary embodiment of the present invention, the first solvent represented by Chemical Formula A is any one or a mixed solution of two or more selected from the group consisting of the following compounds.

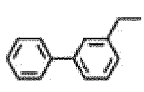 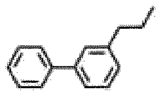 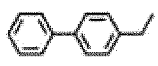

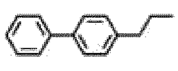 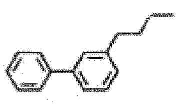 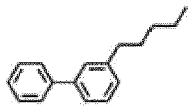 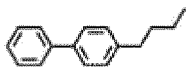

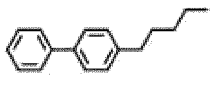 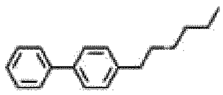 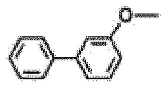 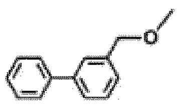

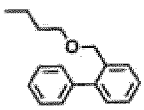 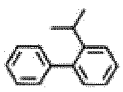 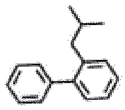 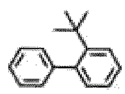

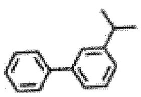 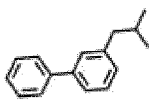 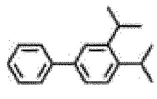 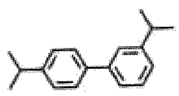

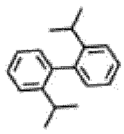 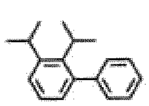 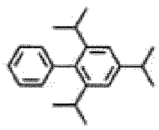 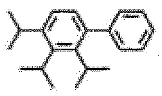

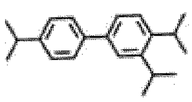 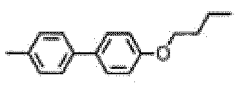

In an exemplary embodiment of the present invention, the first solvent represented by Chemical Formula A is any one of the above structures.

In an exemplary embodiment of the present invention, the first solvent represented by Chemical Formula A has a surface tension of 32 mN/m to 38 mN/m. Specifically, the surface tension is 33 mN/m to 37 mN/m; or 33.5 mN/m to 36.5 mN/m.

As the surface tension of the first solvent represented by Chemical Formula A according to an exemplary embodiment of the present invention satisfies the above-described range, the range of surface tension between materials other than the first solvent represented by Chemical Formula A may be easilyadjusted. Specifically, materials (for example, an additional solvent, other organic solvents, and the like) included in the ink composition used in the solution process generally need to be composed of materials, such that the ink composition has a surface tension in a range of 25

mN/m to 45 mN/m, and further, it is preferred that the difference in surface tension between materials is small. A surface tension in a range of 32 mN/m to 38 mN/m is close to the median value of the preferred surface tension range, and accordingly, when the first solvent represented by Chemical Formula A has a surface tension in a range of 32 mN/m to 38 mN/m, the difference in surface tension between materials other than the first solvent represented by Chemical Formula A may be adjusted so as to be small. When the difference in surface tension between the materials other than the first solvent represented by Chemical Formula A is small, the organic light emitting device manufactured by the solution process has an advantage in that the flatness of the organic material layer and the thickness uniformity of the pixel are excellent.

In an exemplary embodiment of the present invention, the first solvent represented by Chemical Formula A has a boiling point of 250°C to 350°C; 270°C to 350°C; or 280°C to 330°C.

As the first solvent represented by Chemical Formula A having a boiling point within the above range is included, it is possible to expect that when an organic material layer of an organic light emitting device is manufactured through a solution process, the flatness of the organic material layer and/or the thickness uniformity of the pixel are excellent. Specifically, since the first solvent represented by Chemical Formula A has the lowest vapor pressure among the constituent solvents, and thus, is not removed in the initial drying step, there is an advantage in that it is possible to adjust the difference in surface tension between materials remaining even after the initial drying step. Consequently, there is an advantage in that the flatness of the organic material layer and/or the thickness uniformity of the pixel of the organic light emitting device are excellent.

In an exemplary embodiment of the present invention, the ink composition further includes a second solvent, and the second solvent includes one or more of a solvent represented by any one of the following Chemical Formulae B to D, methoxytoluene and tetralin.

[Chemical Formula B]

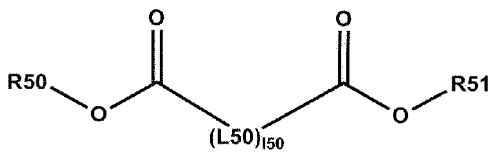

[Chemical Formula C]

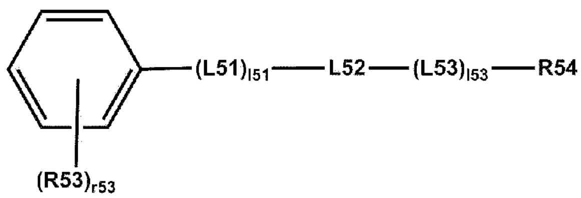

[Chemical Formula D]

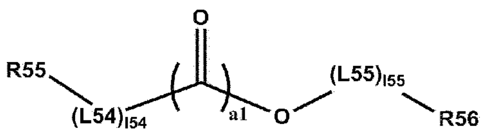

In Chemical Formulae B to D,

L50 is a direct bond; or an alkylene group,
L51 and L53 to L55 are the same as or different from each other, and are each independently a direct bond; -O-; or a substituted or unsubstituted alkylene group,
L52 is -COO-,
R50, R51 and R54 to R56 are the same as or different from each other, and are each independently a substituted or unsubstituted alkyl group,
R53 is hydrogen; deuterium; an alkoxy group; or a substituted or unsubstituted alkyl group,
a1 is 0 or 1,
r53 is an integer from 1 to 5, and when r53 is 2 or higher, two or more R53's are the same as or different from each other,

and

l50, l51 and l53 to l55 are each an integer from 1 to 10, and when l50, l51 and l53 to l55 are each 2 or higher, two or more structures in the parenthesis are the same as or different from each other.

In an exemplary embodiment of the present invention, L50 is a direct bond; or an alkylene group having 1 to 10 carbon atoms.

In an exemplary embodiment of the present invention, L50 is a direct bond; or an alkylene group having 1 to 6 carbon atoms.

In an exemplary embodiment of the present invention, L50 is a direct bond; a methylene group; an ethylene group; a propylene group; or a butylene group.

In an exemplary embodiment of the present invention, l50 is an integer from 1 to 5.

In an exemplary embodiment of the present invention, L51 and L53 to L55 are the same as or different from each other, and are each independently a direct bond; -O-; or an alkylene group having 1 to 10 carbon atoms.

In an exemplary embodiment of the present invention, L51 and L53 are the same as or different from each other, and are each independently a direct bond; -O-; or an alkylene group having 1 to 10 carbon atoms.

In an exemplary embodiment of the present invention, L51 and L53 are the same as or different from each other, and are each independently a direct bond; -O-; or an alkylene group having 1 to 5 carbon atoms.

In an exemplary embodiment of the present invention, L51 and L53 are the same as or different from each other, and are each independently a direct bond; -O-; a methylene group; an ethylene group; or a propylene group.

In an exemplary embodiment of the present invention, l51 and l53 are each an integer from 1 to 5.

In an exemplary embodiment of the present invention, L54 and L55 are the same as or different from each other, and are each independently -O-; or an alkylene group.

In an exemplary embodiment of the present invention, L54 and L55 are the same as or different from each other, and are each independently -O-; or a straight-chained or branched alkylene group.

In an exemplary embodiment of the present invention, l54 and l55 are each an integer from 1 to 10.

In an exemplary embodiment of the present invention, a1 is 0.

In an exemplary embodiment of the present invention, a1 is 1.

In an exemplary embodiment of the present invention, R50, R51 and R54 to R56 are the same as or different from each other, and are each independently a substituted or unsubstituted alkyl group having 1 to 30 carbon atoms.

In an exemplary embodiment of the present invention, R50, R51 and R54 to R56 are the same as or different from each other, and are each independently a substituted or unsubstituted alkyl group having 1 to 10 carbon atoms.

In an exemplary embodiment of the present invention, R50 and R51 are the same as or different from each other, and are each independently an alkyl group having 1 to 10 carbon atoms.

In an exemplary embodiment of the present invention, R50 and R51 are the same as or different from each other, and are each independently a straight-chained or branched alkyl group having 1 to 10 carbon atoms.

In an exemplary embodiment of the present invention, R50 and R51 are the same as or different from each other, and are each independently a straight-chained alkyl group having 1 to 10 carbon atoms; or a branched alkyl group having 3 to 10 carbon atoms.

In an exemplary embodiment of the present invention, R53 is hydrogen; or an alkoxy group.

In an exemplary embodiment of the present invention, R53 is hydrogen; or an alkoxy group having 1 to 10 carbon atoms.

In an exemplary embodiment of the present invention, R54 is an alkyl group having 1 to 30 carbon atoms.

In an exemplary embodiment of the present invention, R54 is a straight-chained or branched alkyl group having 1 to 30 carbon atoms.

In an exemplary embodiment of the present invention, R54 is a straight-chained alkyl group having 1 to 30 carbon atoms; or a branched alkyl group having 4 to 30 carbon atoms.

In an exemplary embodiment of the present invention, R54 is a straight-chained alkyl group having 1 to 10 carbon atoms; or a branched alkyl group having 4 to 10 carbon atoms.

In an exemplary embodiment of the present invention, R55 and R56 are the same as or different from each other, and are each independently a substituted or unsubstituted alkyl group having 1 to 10 carbon atoms.

In an exemplary embodiment of the present invention, R55 and R56 are the same as or different from each other, and are each independently a substituted or unsubstituted straight-chained or branched alkyl group having 1 to 10 carbon atoms.

In an exemplary embodiment of the present invention, R55 and R56 are the same as or different from each other, and are each independently an alkyl group unsubstituted or substituted with a hydroxyl group.

In an exemplary embodiment of the present invention, R55 and R56 are the same as or different from each other, and are each independently an alkyl group having 1 to 10 carbon atoms, which is unsubstituted or substituted with a hydroxyl group.

In an exemplary embodiment of the present invention, the second solvent includes one or two of the solvent represented by any one of Chemical Formulae B to D, methoxytoluene and tetralin.

In an exemplary embodiment of the present invention, the second solvent is one or more selected from the group consisting of dibutyl oxalate, ethyl benzoate, tripropylene glycol methyl ether, diethyl adipate, butyl carbitol acetate, benzyl butyrate, methyl methoxy benzoate, butyl benzoate, dibutyl succinate, isoamyl benzoate, 2-phenoxyethyl isobutyrate, diisopropyl malonate, tetralin, methoxytoluene and dipropylene glycol monomethyl ether.

In an exemplary embodiment of the present invention, the ink composition includes the second solvent represented by any one of Chemical Formulae B to D, and further includes a third solvent different from the first solvent and the second solvent.

In an exemplary embodiment of the present invention, the third solvent is any one of a solvent represented by any one of Chemical Formulae B to D, methoxytoluene and tetralin, and is different from the second solvent.

In an exemplary embodiment of the present invention, the second solvent has a boiling point of 180°C to 280°C.

In an exemplary embodiment of the present invention, the first solvent has a boiling point of 250°C to 350°C, the second solvent has a boiling point of 180°C to 280°C, and the boiling point of the first solvent is higher than the boiling point of the second solvent. As described above, since the boiling point of the second solvent is lower than the boiling point of the first solvent, the second solvent evaporates first when the ink composition is dried, and the proportion of the first solvent increases, and thus, may adjust the solvent drying speed and the flatness of ink.

In an exemplary embodiment of the present invention, as the first solvent and the second solvent are simultaneously used, an effect in which the drying time is shortened and the uniformity of the thin film is improved is exhibited.

In an exemplary embodiment of the present invention, the first solvent and the second solvent are included in an amount of 4 wt% to 60 wt% and 40 wt% to 96 wt%, respectively, based on the entire solvent. Specifically, the first solvent and the second solvent are included in an amount of 5 wt% to 35 wt% and 65 wt% to 95 wt%, respectively. The above-described ink composition needs to maintain a liquid state within a pixel after being printed and before entering a vacuum chamber, and when the first solvent is included in an amount less than 4 wt%, there is a problem in that a large amount or all of the ink composition is dried during the process of printing the ink composition. In contrast, when the first solvent in the ink composition is included in an amount exceeding 60 wt%, the solvent is likely to remain in the thin film.

In an exemplary embodiment of the present invention, the entire solvent means the first solvent and the second solvent combined.

Hereinafter, an ionic compound including an anionic group represented by Chemical Formula 2 will be specifically described.

In an exemplary embodiment of the present invention, the ink composition further includes an ionic compound including an anionic group represented by the following Chemical Formula 2.

[Chemical Formula 2]

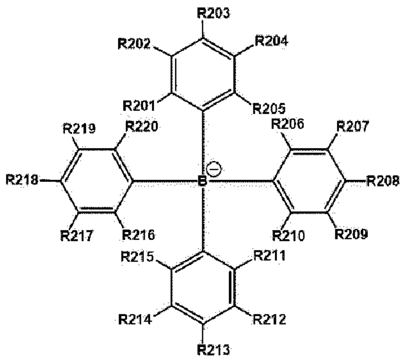

In Chemical Formula 2,

at least one of R201 to R220 is F; a cyano group; or a substituted or unsubstituted fluoroalkyl group,
at least one of the other R201 to R220 is a curable group,
the other R201 to R220 are the same as or different from each other, and are each independently hydrogen; deuterium; a halogen group; a nitro group; a cyano group; an amino group; -OR221; -SR222; $-SO_3R223$; -COOR224; -OC(O)R225; -C(O)NR226R227; -C(O)R228; a substituted or unsubstituted alkyl group; a substituted or unsubstituted alkenyl group; a substituted or unsubstituted alkynyl group; a substituted or unsubstituted amine group; a substituted or unsubstituted aryl group; or a substituted or unsubstituted heterocyclic group, and

R221 to R228 are the same as or different from each other, and are each independently hydrogen; deuterium; or a substituted or unsubstituted alkyl group.

A curable group is introduced into the ionic compound including an anionic group, which is represented by Chemical Formula 2 (hereinafter referred to as an anionic group compound) according to an exemplary embodiment of the present invention. In contrast, when a curable group is not introduced, the ionic compound is not cured, so that the characteristics of a device are reduced due to the migration of the ionic compound between electrodes or layers. Meanwhile, when the number of curable groups increases, the curing rate of the ionic compound or the composition including the same increases, and the film retention rate is improved.

In an exemplary embodiment of the present invention, the number of curable groups of the anionic group compound represented by Chemical Formula 2 is 1.

In an exemplary embodiment of the present invention, the number of curable groups of the anionic group compound represented by Chemical Formula 2 is 2.

In an exemplary embodiment of the present invention, the number of curable groups of the anionic group compound represented by Chemical Formula 2 is 4.

In an exemplary embodiment of the present invention, the number of F's; cyano groups; or substituted or unsubstituted fluoroalkyl groups of the anionic group compound represented by Chemical Formula 2 is 16 to 19.

In an exemplary embodiment of the present invention, based on 100 parts by weight of the anionic group compound, the part by weight of F in the anionic group compound is 15 parts by weight to 50 parts by weight.

In an exemplary embodiment of the present invention, based on 100 parts by weight of the anionic group compound, the part by weight of F in the anionic group compound is 10 parts by weight to 45 parts by weight.

In an exemplary embodiment of the present invention, based on 100 parts by weight of the anionic group compound, the number of F's in the anionic group compound is 8 to 20.

As described above, when the ratio of F, the cyano group, or the fluoroalkyl group in the molecule is increased, the film retention rate during heat treatment is improved.

According to an exemplary embodiment of the present invention, the ionic compound may be used in the hole injection layer of the organic light emitting device, and may be used as a dopant when used in the hole injection layer. In this case, when the content of F of the ionic compound is increased, the force of attracting electrons from another compound (host compound) is increased, and holes are more proficiently produced in the host, so that the performance in the hole injection layer is improved.

In an exemplary embodiment of the present invention, the content of F may be analyzed using COSAAQF-100 combustion furnace coupled to a Dionex ICS 2000 ion-chromatograph, or may be confirmed through 19F NMR which is a method generally used in the F analysis.

In an exemplary embodiment of the present invention, at least one benzene ring of a benzene ring including R201 to R205, a benzene ring including R206 to R210, a benzene ring including R211 to R215, and a benzene ring including R216 to R220 in Chemical Formula 2 is selected from the following structural formulae.

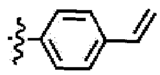 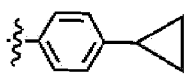 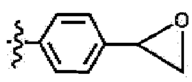 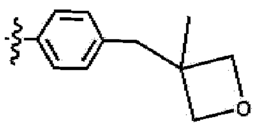

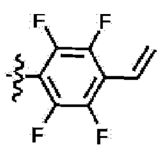 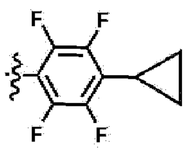 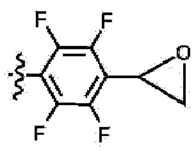 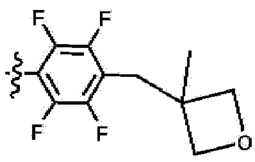

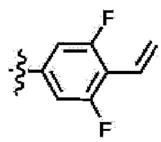 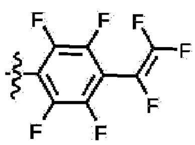 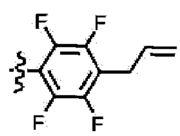 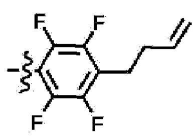

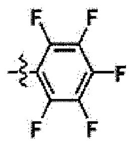 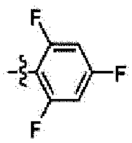 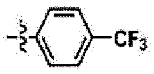 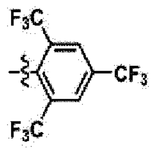 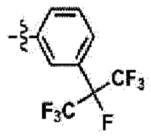 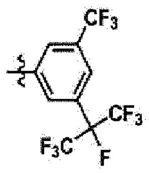

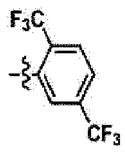 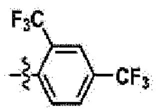 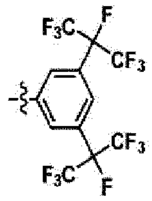 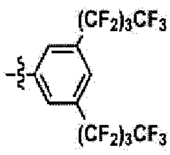

In an exemplary embodiment of the present invention, Chemical Formula 2 is any one of the following structures.

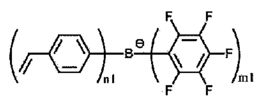 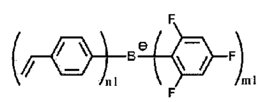 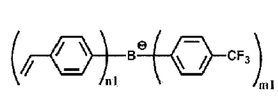

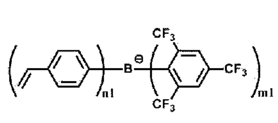 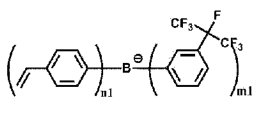 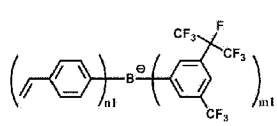

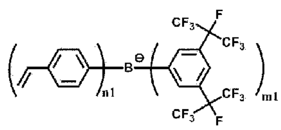 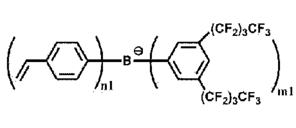 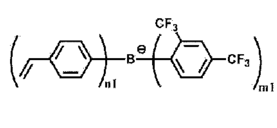

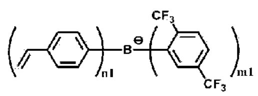 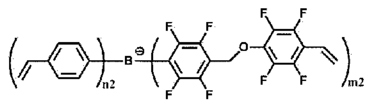

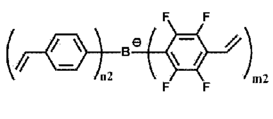 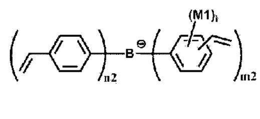 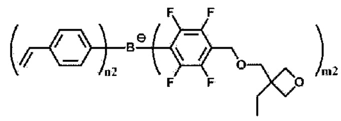

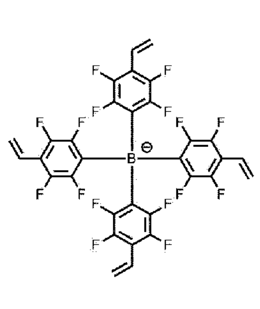 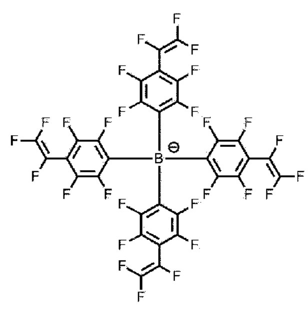 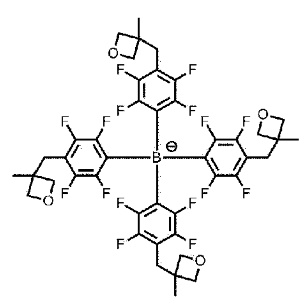

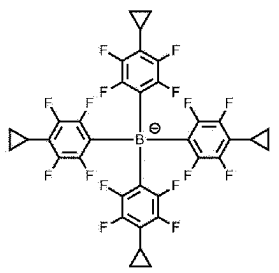
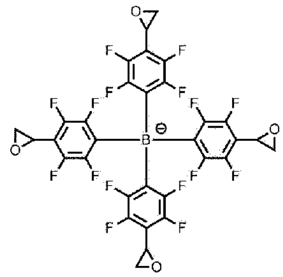

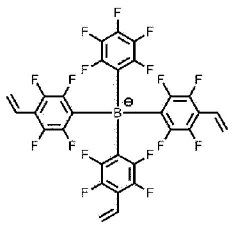
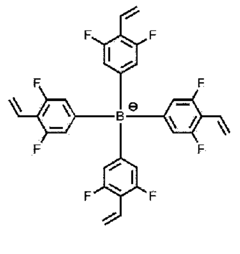
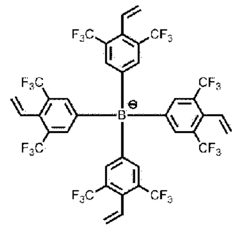

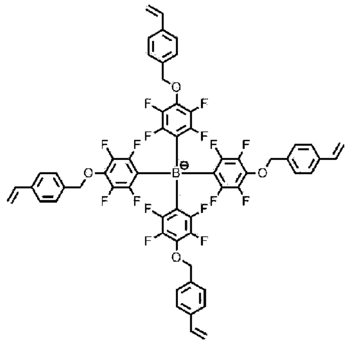
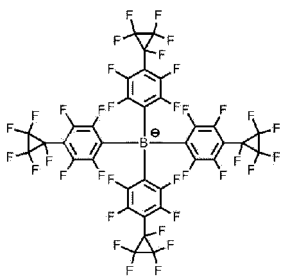
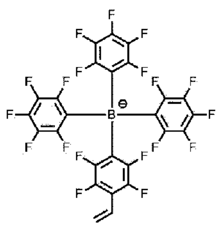

In the structures,

n1 is an integer from 1 to 3, m1 is an integer from 1 to 3, and n1+m1=4,
n2 is an integer from 0 to 3, m2 is an integer from 1 to 4, and n2+m2=4,
M1 is deuterium; a halogen group; a nitro group; a cyano group; an amino group; -OR221; -SR222; -$SO_3$R223; -COOR224; -OC(O)R225; -C(O)NR226R227; -C(O)R228; a substituted or unsubstituted alkyl group; a substituted or unsubstituted alkenyl group; a substituted or unsubstituted alkynyl group; a substituted or unsubstituted amine group; a substituted or unsubstituted aryl group; or a substituted or unsubstituted heterocyclic group,
R221 to R228 are the same as or different from each other, and are each independently hydrogen; deuterium; or a substituted or unsubstituted alkyl group, and
i is an integer from 1 to 4, and when i is 2 or higher, two or more M1's are the same as or different from each other.

In an exemplary embodiment of the present invention, the ionic compound further includes a cationic group. Specifically, the above-described ink composition further includes an ionic compound including the anionic group represented by the above-described Chemical Formula 2 and the cationic group.

In an exemplary embodiment of the present invention, the ionic compound further includes a cationic group, and the cationic group is a monovalent cationic group, an onium compound or any one of the following structures.

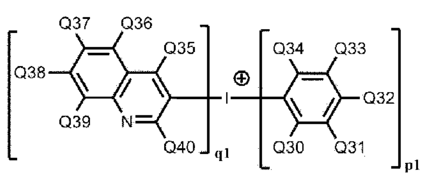
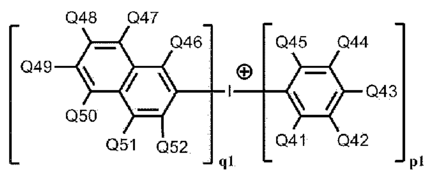

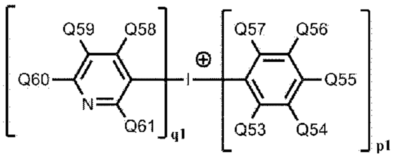
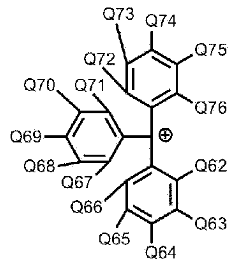
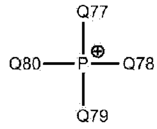

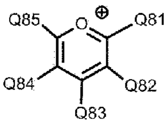
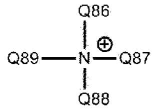
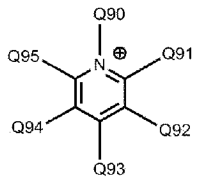
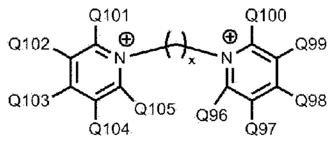

In the structures,

Q30 to Q105 are the same as or different from each other, and are each independently hydrogen; deuterium; a cyano group; a nitro group; a halogen group; a hydroxyl group; -COOR250; a substituted or unsubstituted alkyl group; a substituted or unsubstituted alkoxy group; a substituted or unsubstituted aryloxy group; a substituted or unsubstituted cycloalkyl group; a substituted or unsubstituted aryl group; or a curable group,
R250 is hydrogen; deuterium; or a substituted or unsubstituted alkyl group,
x is an integer from 0 to 10, and
p1 is 1 or 2, q1 is 0 or 1 and p1+q1=2.

In an exemplary embodiment of the present invention, the monovalent cationic group may be an alkali metal cation, and examples of the alkali metal cation include $Na^+$, $Li^+$, $K^+$, and the like, but are not limited thereto.

In an exemplary embodiment of the present invention, the cationic group is an onium compound; or any one selected from the above-described structural formulae.

In an exemplary embodiment of the present invention, the cationic group is any one of the following structures.

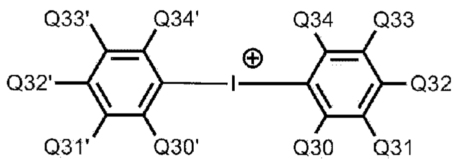
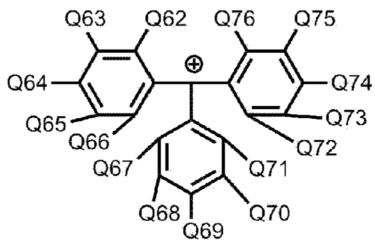

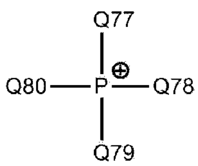
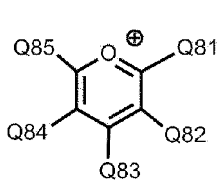
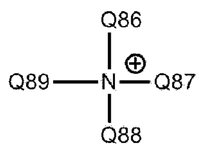
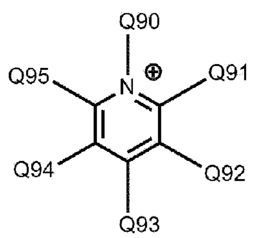

In the structures,

Q30 to Q34, Q30' to Q34' and Q62 to Q95 are the same as or different from each other, and are each hydrogen; deuterium; a cyano group; a nitro group; a halogen group; a hydroxyl group; -COOR250; a substituted or unsubstituted alkyl group; a substituted or unsubstituted alkoxy group; a substituted or unsubstituted aryloxy group; a substituted or unsubstituted cycloalkyl group; a substituted or unsubstituted aryl group; or a curable group, and
R250 is hydrogen; deuterium; or a substituted or unsubstituted alkyl group.

In an exemplary embodiment of the present invention, the cationic group is any one of the following structures.

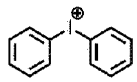
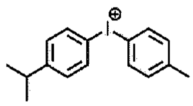
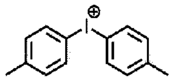
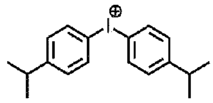

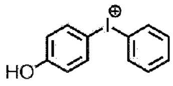
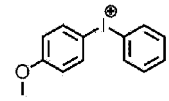
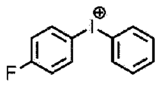
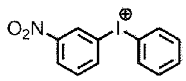

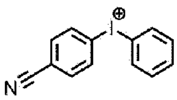
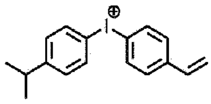
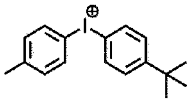
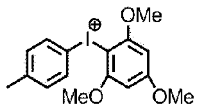

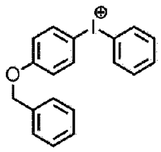
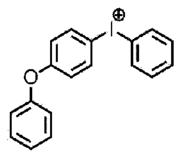
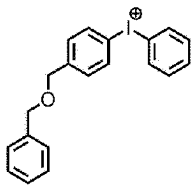
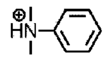
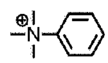

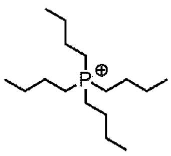
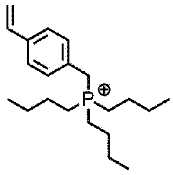
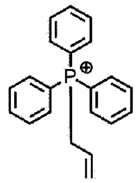
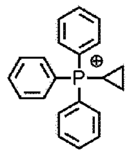
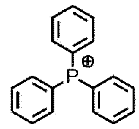

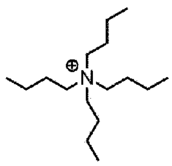
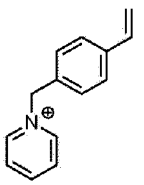
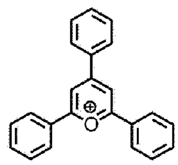

In an exemplary embodiment of the present invention, the ionic compound is any one of the following Chemical Formulae D-1 to D-36.

[Chemical Formula D-1]

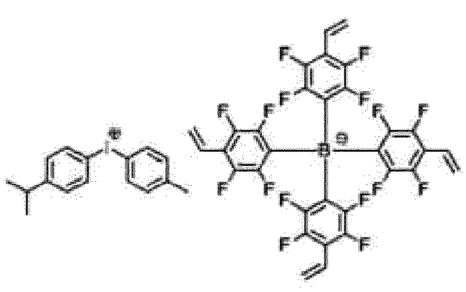

[Chemical Formula D-2]

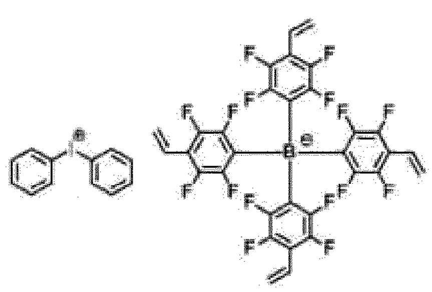

[Chemical Formula D-3]

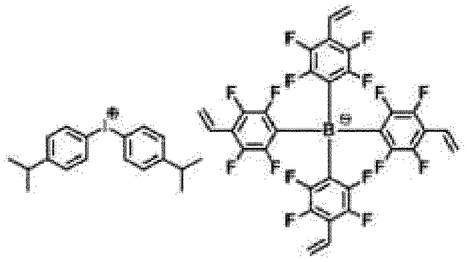

[Chemical Formula D-4]

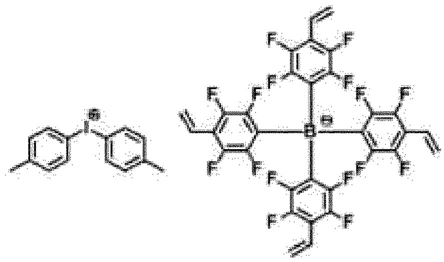

[Chemical Formula D-5]

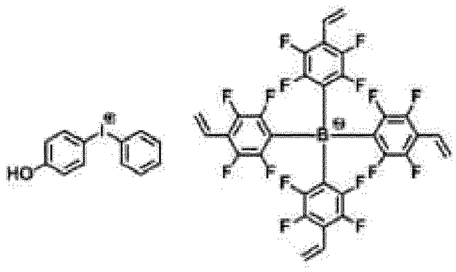

[Chemical Formula D-6]

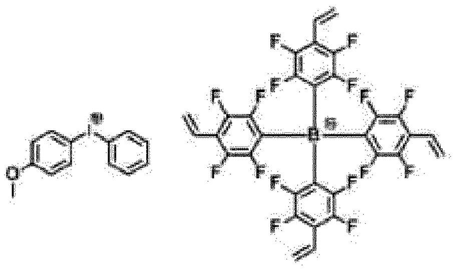

[Chemical Formula D-7]

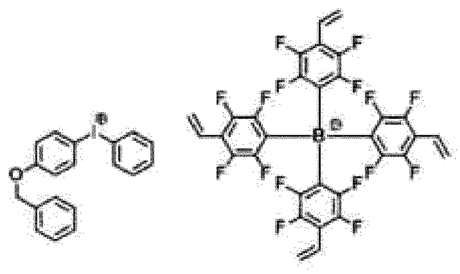

[Chemical Formula D-8]

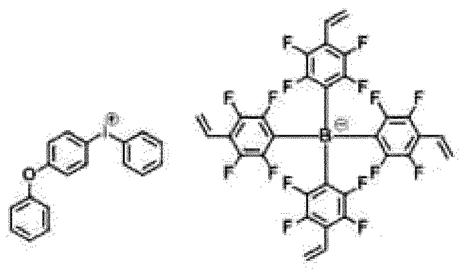

[Chemical Formula D-9]

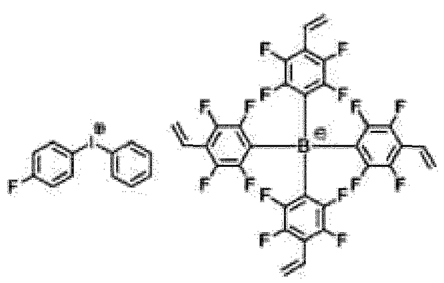

[Chemical Formula D-10]

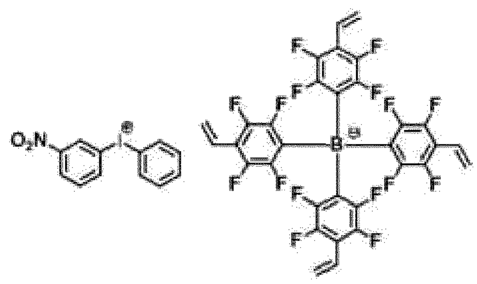

[Chemical Formula D-11]

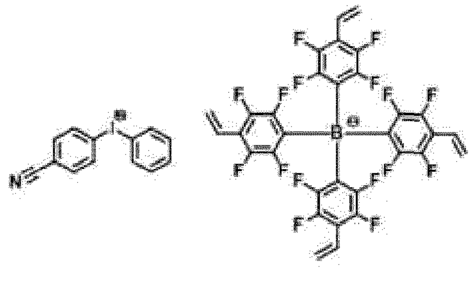

[Chemical Formula D-12]

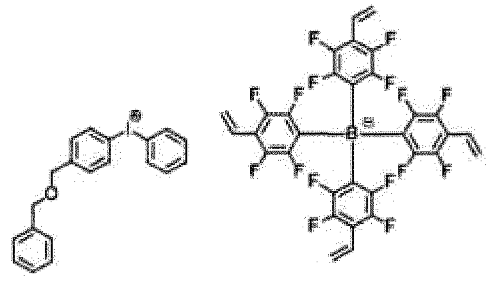

[Chemical Formula D-13]

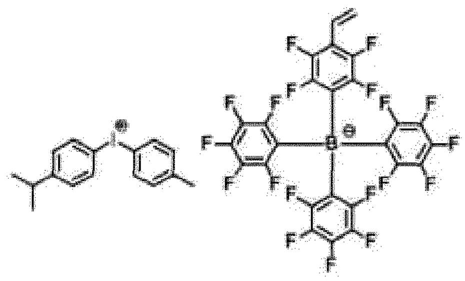

[Chemical Formula D-14]

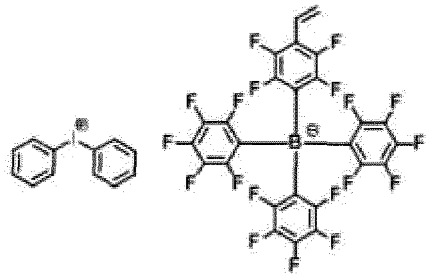

[Chemical Formula D-15]

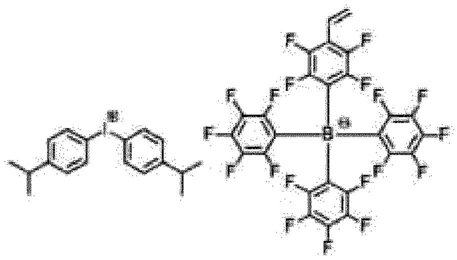

[Chemical Formula D-16]

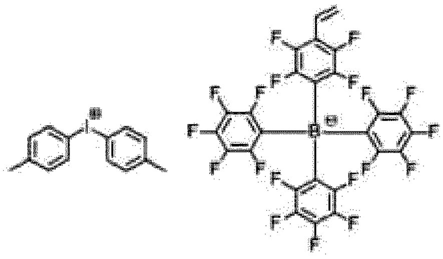

[Chemical Formula D-17]

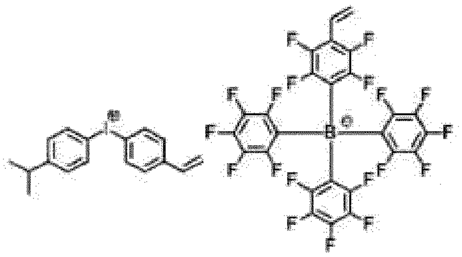

[Chemical Formula D-18]

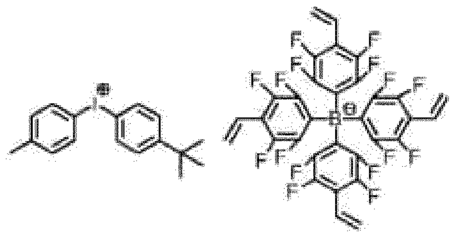

[Chemical Formula D-19]

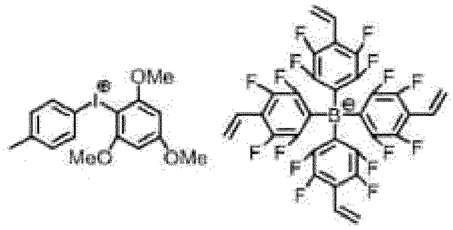

[Chemical Formula D-20]

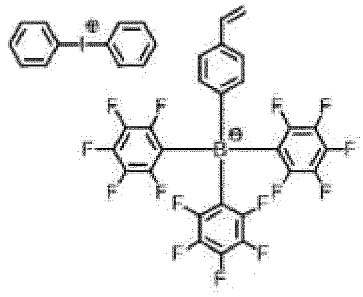

[Chemical Formula D-21]

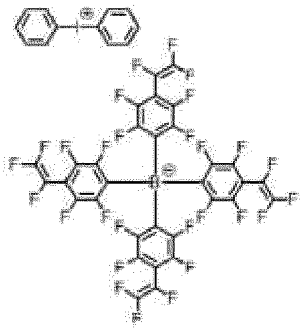

[Chemical Formula D-22]

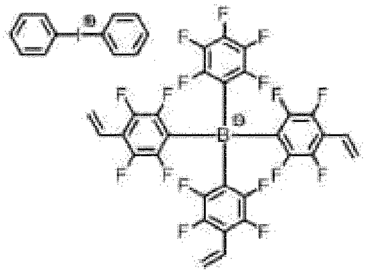

[Chemical Formula D-23]

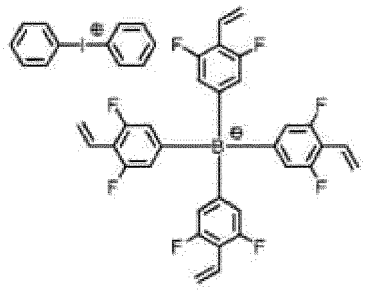

[Chemical Formula D-24]

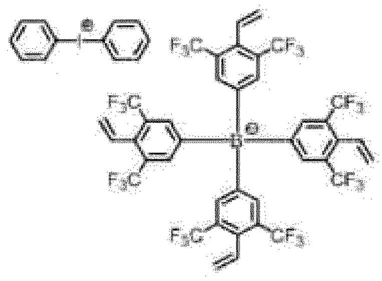

[Chemical Formula D-25]

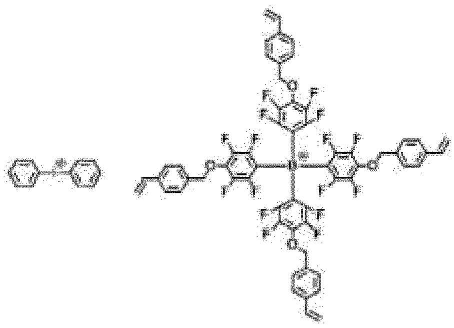

[Chemical Formula D-26]

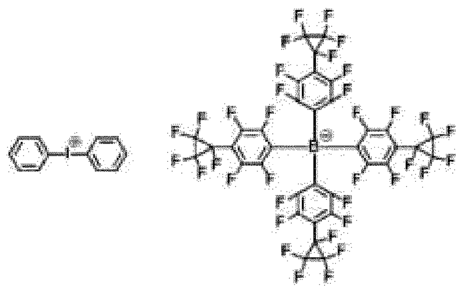

[Chemical Formula D-27]

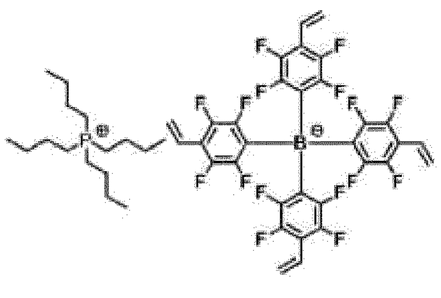

[Chemical Formula D-28]

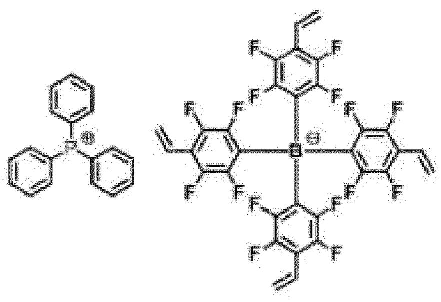

[Chemical Formula D-29]

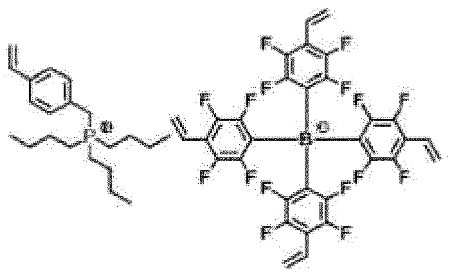

[Chemical Formula D-30]

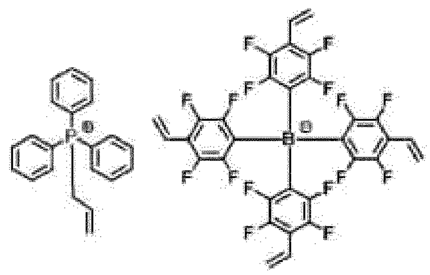

[Chemical Formula D-31]

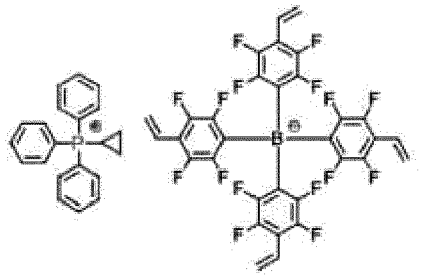

[Chemical Formula D-32]

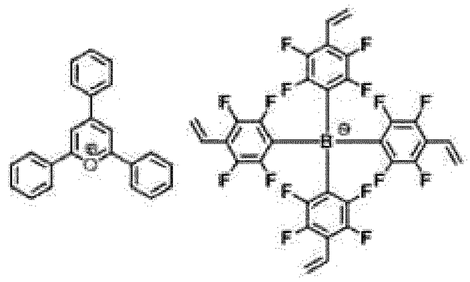

[Chemical Formula D-33]

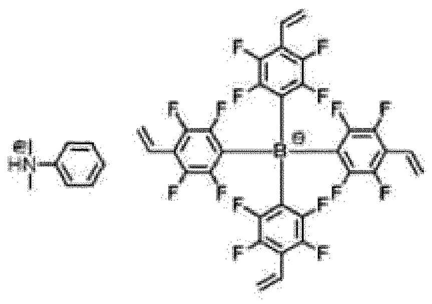

[Chemical Formula D-34]

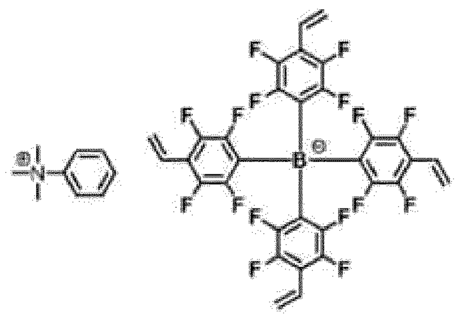

[Chemical Formula D-35]

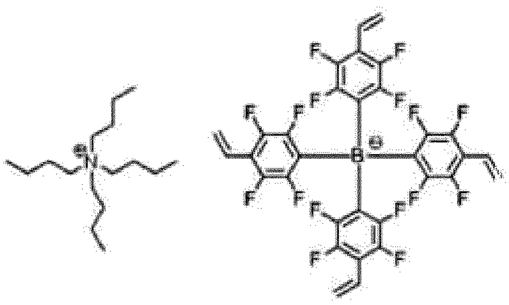

[Chemical Formula D-36]

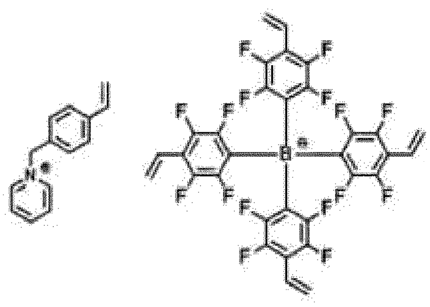

In an exemplary embodiment of the present invention, in the ionic compound, the anionic group represented by Chemical Formula 2 and the cationic group are included at an equivalent ratio of 1 : 5 to 5 : 1. Specifically, the anionic group represented by Chemical Formula 2 and the cationic group are included at an equivalent ratio of 1 : 1.

Hereinafter, an ink composition will be specifically described.

An exemplary embodiment of the present invention provides an ink composition including the compound represented by the above-described Chemical Formula 1 and the first solvent represented by the above-described Chemical Formula A.

According to an exemplary embodiment of the present invention, the ink composition further includes an ionic compound including the anionic group represented by the above-described Chemical Formula 2.

According to an exemplary embodiment of the present invention, the ionic compound further includes the above-described cationic group. That is, the ink composition further includes an ionic compound including the anionic group represented by the above-described Chemical Formula 2 and the above-described cationic group.

An exemplary embodiment of the present invention provides an ink composition including the compound represented by the above-described Chemical Formula 1 and the first solvent represented by the above-described Chemical Formula A, and further including: the above-described anionic group compound; the above-described cationic group; and one or more of the above-described second solvents.

An exemplary embodiment of the present invention provides an ink composition including: the compound represented by the above-described Chemical Formula 1; the first solvent represented by the above-described Chemical Formula A; an ionic compound including the anionic group represented by the above-described Chemical Formula 2 and the above-described cationic group; and the above-described second solvent.

According to an exemplary embodiment of the present invention, based on 100 wt% of the ink composition, the compound represented by Chemical Formula 1 is included in an amount of 0.1 wt% to 15 wt%; 0.1 wt% to 10 wt%; or 0.1 wt% to 5 wt%.

According to an exemplary embodiment of the present invention, based on 100 wt% of the ink composition, the first solvent represented by Chemical FormulaA is included in an amount of 4 wt% to 70 wt%; 4 wt% to 50 wt%; or 4 wt% to 35 wt%.

According to an exemplary embodiment of the present invention, based on 100 wt% of the ink composition, the second solvent is included in an amount of 20 wt% to 95 wt%; 40 wt% to 95 wt%; or 65 wt% to 95 wt%.

According to an exemplary embodiment of the present invention, based on 100 wt% of the ink composition, the ionic compound including the anionic group represented by Chemical Formula 2 is included in an amount of 0.1 wt% to 15 wt%; 0.1 wt% to 10 wt%; or 0.1 wt% to 5 wt%.

According to an exemplary embodiment of the present invention, based on 100 wt% of the ink composition, the compound represented by Chemical Formula 1, the first solvent represented by Chemical Formula A; the second solvent; and the ionic compound including the anionic group represented by Chemical Formula 2 are included in an amount of 0.1 wt% to 15 wt%; 4 wt% to 50 wt%; 40 wt% to 95 wt%; and 0.1 wt% to 15 wt%, respectively.

According to an exemplary embodiment of the present invention, based on 100 wt% of the ink composition, the compound represented by Chemical Formula 1, the first solvent represented by Chemical Formula A; the second solvent; and the ionic compound including the anionic group represented by Chemical Formula 2 are included in an amount of 0.1 wt% to 15 wt%; 4 wt% to 35 wt%; 65 wt% to 95 wt%; and 0.1 wt% to 15 wt%, respectively.

In an exemplary embodiment of the present invention, the ink composition has a viscosity of 2 cPto 15 cP at room temperature. When the above viscosity is satisfied, a device is easily manufactured. Specifically, a uniform film may be formed when an organic material layer in an organic light emitting device is formed.

The above viscosity is a value measured at room temperature using a viscometer manufactured by Brookfield Engineering Labs Inc., after dissolving an object to be measured at any one concentration of 1 wt% to 3 wt% in the first solvent or a mixture in which the first solvent and the second solvent are mixed at any ratio. In this case, the object to be measured is a compound represented by Chemical Formula 1; or a mixture of the compound represented by Chemical Formula 1 and the above-described ionic compound.

According to an exemplary embodiment of the present invention, the ink composition is a liquid phase. The "liquid phase" means that the composition is in a liquid state at room temperature under atmospheric pressure.

In an exemplary embodiment of the present specification, the ink composition can be cured by a heat treatment or a light treatment. When the ink composition is cured, this may be expressed as a cured product of the ink composition.

In an exemplary embodiment of the present invention, the ink composition further includes: a single molecule including a photocurable group and/or a thermosetting group; or a single molecule including an end group capable of forming a polymer by heat. As described above, the single molecule including a photocurable group and/or a thermosetting group; or the single molecule including an end group capable of forming a polymer by heat may be a compound having a molecular weight of 3,000 g/mol or less, but the molecular weight is not limited to the exemplified molecular weight.

The single molecule including a photocurable group and/or a thermosetting group; or the single molecule including an end group capable of forming a polymer by heat may mean aryl such as phenyl, biphenyl, fluorene, and naphthalene; arylamine; or a single molecule in which a photocurable group and/or a thermosetting group or an end group capable of forming a polymer by heat is substituted with fluorene.

In an exemplary embodiment of the present invention, the ink composition is a composition for forming one or more layers selected from the group consisting of a hole injection layer, a hole transport layer, a hole injection and transport layer, and an electron blocking layer.

Hereinafter, a pixel including the above-described ink composition will be specifically described.

An exemplary embodiment of the present invention provides a pixel including the above-described ink composition or a cured product thereof. The pixel maybe included in an organic material layer, an organic light emitting diode, or an organic light emitting display device. Details of the organic material layer will be described below.

In an exemplary embodiment of the present invention, the organic light emitting display device includes a plurality of pixels composed of red (R), green (G), and blue (B) sub-pixels, and an organic light emitting diode and a pixel circuit are located for each sub-pixel. An organic light emitting diode includes two electrodes (anode and cathode) and an organic light emitting layer located therebetween, and a pixel circuit includes at least two thin film transistors and at least one capacitor.

In an exemplary embodiment of the present invention, the organic material layer, the organic light emitting diode and/or the organic light emitting display device include (s) a bank which may be separated from each sub-pixel to apply ink or a bank in which ink droplets are connected in two or more sub-pixels.

In an exemplary embodiment of the present invention, the form of the bank is not limited. As an example, the organic material layer, the organic light emitting diode, or the organic light emitting display device may include a line-shaped bank. The line-shaped bank may define a line-shaped pixel region and/or a sub-pixel region. As another example, the organic material layer, the organic light emitting diode, or the organic light emitting display device may include separated banks instead of a line-shaped shape. In a normal case, the light emitting layer among the organic material layers is composed of a red light emitting layer, a green light emitting layer and a blue light emitting layer located in a red sub-pixel, a green sub-pixel and a blue sub-pixel, respectively. In this case, the above-described pixel may correspond to the pixel or sub-pixel. As a preferred exemplary embodiment, the pixel corresponds to the sub-pixel.

In an exemplary embodiment of the present invention, one or more of the pixels may be included in the above-described organic material layer, organic light emitting diode or organic light emitting display device.

Hereinafter, an organic material layer including the above-described pixel will be specifically described.

An exemplary embodiment of the present invention provides an organic material layer including the above-described pixel. Since the pixel includes the above-described ink composition or a cured product thereof, an exemplary embodiment of the present invention can be said to provide an organic material layer including the above-described ink composition or a cured product thereof.

In an exemplary embodiment of the present invention, the organic material layer includes a plurality of the above-described pixels. For example, the organic material layer includes an x-axis on which na pixels are aligned and a y-axis that is perpendicular to the x-axis and on which nb pixels are aligned, and na and nb are each an integer from 2 to $10^4$, an integer from 10 to $10^3$, or an integer from 20 to $10^2$.

In an exemplary embodiment of the present invention, na and nb are each 2 or higher, 5 or higher, 10 or higher, or 20 or higher, and $10^4$ or lower, $10^3$ or lower, or $10^2$ or lower.

In an exemplary embodiment of the present invention, the organic material layer includes 2 or more, 4 or more, 10 or more, 20 or more, 40 or more, 80 or more, or 100 or more and $10^8$ or less, $10^6$ or less, or $10^4$ or less pixels.

In an exemplary embodiment of the present invention, pixels included in the organic material layer are aligned in the form of a line. For example, as shown in FIGS. 4 and 7, a plurality of pixels (1') are aligned in a row to form a line.

In an exemplary embodiment of the present invention, the organic material layer includes a plurality of lines in which the plurality of pixels are aligned in a row. For example, as shown in FIGS. 4 and 7, a plurality of lines may be formed at regular intervals. For example, the y-axis on which the above-described nb pixels are aligned is one line, and it is possible to include as many lines as the number of pixels (na) included in the x-axis.

In an exemplary embodiment of the present invention, pixels included in the organic material layer are aligned not in the form of a line, but in a separated form. For example, as shown in FIG. 8, a plurality of pixels may be formed in a separated form.

In an exemplary embodiment of the present invention, the organic material layer includes na x nb pixels.

In an exemplary embodiment of the present invention, a plurality of pixels included in the organic material layer have a uniform thickness.

In an exemplary embodiment of the present invention, the organic material layer includes an x-axis on which nc pixels are aligned and a y-axis that is perpendicular to the x-axis and on which nd pixels are aligned, in which nc and nd are each an integer from 20 to $10^4$, and satisfies the following Equation 1.

[Equation 1]

$$|X(i')-X(5)| \leq 5nm$$

In Equation 1,

X(i') is the average thickness of the [(nd/2)-4]th to [(nd/2)+5]th pixels,
X(5) is the thickness of the 5th pixel from the edge, and
when the nd is an odd number, the (nd/2) is a value obtained by rounding off the first digit of a decimal number.

For the case where the nd is an odd number, for example, when the measurement is performed using 25 pixels

(that is, when nd is 25), X(i') is the average thickness of the 13th to 18th pixels.

In an exemplary embodiment of the present invention, the [ (nd/2) -4] th to [ (nd/2)+5]th pixels mean pixels located at the central part (center) of a number of pixels formed.

In an exemplary embodiment of the present invention, nd is an integer from 20 to $10^4$, an integer from 20 to $10^3$, or an integer from 20 to 100.

In an exemplary embodiment of the present invention, the thickness of the pixel may be measured by an optical thickness measuring device. As the optical thickness measuring device, an optical profiler manufactured by Bruker or the like may be used, but the optical thickness measuring device is not limited thereto.

In an exemplary embodiment of the present invention, satisfying Equation 1 means that the difference between the average thickness of the pixel located in the center of a number of pixels and the thickness of the pixel located at the fifth position from the edge is 5 nm or less. That is, it means that there is almost no difference in thickness between the center and edge portions of the pixel. Therefore, satisfying Equation 1 means that the thickness uniformity between pixels is improved.

In an exemplary embodiment of the present invention, the organic material layer satisfies the following Equation 2.

[Equation 2]

$$|X(i')-X(4)| \leq 5nm$$

In Equation 2,

X(i') is the same as that defined in Equation 1, and
X(4) is the thickness of the 4th pixel from the edge.

In an exemplary embodiment of the present invention, the organic material layer satisfies the following Equation 3.

[Equation 3]

$$|X(i')-X(3)| \leq 5nm$$

In Equation 3,

X(i') is the same as that defined in Equation 1, and
X(3) is the thickness of the 3rd pixel from the edge.

In an exemplary embodiment of the present invention, in the organic material layer, a pixel that satisfies the following Equation 11 is present within the second position from the edge.

[Equation 11]

$$|Y(20)-Y(80)| \leq 5nm$$

In Equation 11,
Y(20) is the height of the thin film in a section corresponding to 20% of the pixel length, and Y (80) is the height of the thin film in a section corresponding to 80% of the pixel length.

Satisfying Equation 11 means that in one pixel having the length Lx, the difference between the height of the thin film in a section (0.2Lx) corresponding to 20% of the length and the height of the thin film in a section (0.8Lx) corresponding to 80% of the length satisfies 5 nm or less. That is, satisfying Equation 11 means that the thin film within the pixel is formed symmetrically without being tilted to one side.

The fact that a pixel satisfying Equation 11 is within the second position from the edge means that among the formed pixels, the pixels on the edge side also maintain their shape and thickness. Therefore, it can be confirmed therefrom that the shape and thickness deviations of the pixels at the edge portion and the pixels at the center are formed in a small number.

In an exemplary embodiment of the present invention, the pixels included in the organic material layer are excellent in both thickness uniformity among a number of pixels and thickness uniformity within one pixel.

In an exemplary embodiment of the present invention, the length (Lx) of the pixel is 10 μm to 300 μm.

In the present invention, the edge means both end portions on which the ink composition is printed. For example, in FIGS. 7 and 8, when ink is printed in a direction from (a) to (b) (arrow direction), the (a) or (b) portion is expressed as an edge. Although FIG. 7 illustrates that the ink composition is applied in the vertical direction, the direction in which the ink composition is applied is not limited thereto. For example, the ink may be applied in the lateral direction.

In an exemplary embodiment of the present invention, the organic material layer is included in an organic light emitting device.

In an exemplary embodiment of the present invention, the organic material layer is formed by a solution process.

In an exemplary embodiment of the present invention, the organic material layer is one or more layers selected from the group consisting of a hole injection layer, a hole transport layer, a hole injection and transport layer, an electron blocking layer, a light emitting layer, a hole blocking layer, an electron injection layer, an electron transport layer, and an electron injection and transport layer.

In an exemplary embodiment of the present invention, the organic material layer is one or more layers selected from the group consisting of a hole injection layer, a hole transport layer, a hole injection and transport layer, an electron blocking layer, and a light emitting layer.

In an exemplary embodiment of the present invention, the organic material layer is one or more layers selected from the group consisting of a hole injection layer, a hole transport layer, a hole injection and transport layer, and an electron blocking layer.

In a preferred exemplary embodiment of the present invention, the organic material layer is a hole injection layer, a hole transport layer or an electron blocking layer.

Hereinafter, an organic light emitting device will be specifically described.

An exemplary embodiment of the present invention provides an organic light emitting device including: a first electrode; a second electrode; and an organic material layer having one or more layers provided between the first electrode and the second electrode, in which one or more layers of the organic material layer are the above-described organic material layer.

That is, an exemplary embodiment of the present specification provides an organic light emitting device including: a first electrode; a second electrode; and an organic material layer having one or more layers provided between the first electrode and the second electrode, in which one or more layers of the organic material layer include the above-described ink composition or a cured product thereof.

In an exemplary embodiment of the present invention, the organic material layer includes one or more layers selected from the group consisting of a hole injection layer, a hole transport layer, a hole injection and transport layer, an electron blocking layer, a light emitting layer, a hole blocking layer, an electron injection layer, an electron transport layer, and an electron injection and transport layer, and the one or more layers selected from the group consisting of the hole injection layer, the hole transport layer, the hole injection and transport layer, the electron blocking layer, the light emitting layer, the hole blocking layer, the electron injection layer, the electron transport layer, and the electron injection and transport layer include the above-described ink composition or a cured product thereof.

In an exemplary embodiment of the present invention, the organic material layer includes one or more layers selected from the group consisting of a hole injection layer, a hole transport layer, a hole injection and transport layer, and an electron blocking layer, and the one or more layers selected from the group consisting of the hole injection layer, the hole transport layer, the hole injection and transport layer, and the electron blocking layer include the above-described ink composition or a cured product thereof.

In an exemplary embodiment of the present invention, the organic material layer includes a hole injection layer, a hole transport layer, or an electron blocking layer, and the hole injection layer, the hole transport layer, or the electron blocking layer includes the above-described ink composition or a cured product thereof.

In an exemplary embodiment of the present invention, the organic material layer includes the na x nb pixels described above, and the na x nb pixels satisfy Equation 1.

Hereinafter, a method for manufacturing an organic light emitting device will be specifically described.

An exemplary embodiment of the present invention provides a method for manufacturing an organic light emitting device, the method including: preparing a first electrode;

forming an organic material layer having one or more layers on the first electrode; and
forming a second electrode on the organic material layer having one or more layers,
in which the forming of the organic material layer includes forming an organic material layer using the above-described ink composition.

In an exemplary embodiment of the present invention, the forming of the organic material layer using the ink composition uses a spin coating method.

In an exemplary embodiment of the present invention, the forming of the organic material layer using the ink

composition uses a printing method.

In an exemplary embodiment of the present invention, examples of the printing method include inkjet printing, nozzle printing, offset printing, transfer printing, screen printing, or the like, but are not limited to the printing methods listed above.

In an exemplary embodiment of the present invention, the forming of the organic material layer using the ink composition uses an inkjet printing method.

In an exemplary embodiment of the present invention, the forming of the one or more organic material layers using the ink composition may be performed by applying the ink composition on a substrate or an organic material layer including banks, and then drying or heat-treating the ink composition.

As an example, the above-described ink composition is applied on a substrate (a line bank inkjet substrate, FIG. 4) including a line-shaped bank (FIG. 5), and then a thin film in which the ink composition is dried and/or heat-treated (FIG. 6) may be formed.

As another example, the ink composition may be applied to a substrate including banks that do not form line forms. In this case, the ink composition is applied to each bank.

A solution process is suitable for the ink composition according to an exemplary embodiment of the present invention due to the structural characteristics thereof, so that the organic material layer may be formed by a printing method, and as a result, there is an economic effect in terms of time and costs when a device is manufactured.

In an exemplary embodiment of the present invention, the forming of the organic material layer on the first electrode may further include drying after one or more steps of pressure reduction. As an example, the forming of the organic material layer having one or more layers on the first electrode further includes drying after two steps of pressure reduction. In this case, the drying after the first pressure reduction is performed under normal pressure to $2x10^{-2}$ torr, and the pressure reduction time under normal pressure to $2x10^{-2}$ torr may be 30 seconds to 600 seconds. Further, the drying after the second pressure reduction is performed under $2x10^{-2}$ torr to $2x10^{-6}$ torr, and the pressure reduction time under $2x10^{-2}$ torr to $2x10^{-6}$ torr may also be 30 seconds to 600 seconds.

In an exemplary embodiment of the present invention, the forming of the organic material layer using the ink composition includes: coating the ink composition; and heat-treating or light-treating the coated ink composition.

In an exemplary embodiment of the present invention, the forming of the organic material layer having one or more layers using the ink composition includes: coating the first electrode or the organic material layer having one or more layers with the ink composition; and heat-treating or light-treating the coated ink composition.

In an exemplary embodiment of the present invention, the heat-treating of the ink composition may be performed through a heat treatment, and the heat treatment temperature in the heat-treating of the ink composition may be 85°C to 250°C, may be 100°C to 250°C in an exemplary embodiment, and may be 150°C to 250°C in another exemplary embodiment.

In an exemplary embodiment of the present invention, the heat treatment time in the heat treatment step may be 10 minutes to 2 hours, maybe 10 minutes to 1 hour in an exemplary embodiment, and may be 20 minutes to 1 hour in another exemplary embodiment.

When the forming of the organic material layer using the ink composition includes the heat-treating or light-treating of the ink composition, a plurality of the compounds included in the ink composition may form a cross-linkage, thereby providing an organic material layer including a thin-filmed structure. In this case, it is possible to prevent the organic material layer from being dissolved, morphologically affected or decomposed by a solvent when another layer is stacked on the surface of the organic material layer formed using the ink composition.

Therefore, when the organic material layer is formed by heat-treating or light-treating the ink composition, the resistance to solvents increases. Accordingly, the solution deposition and crosslinking methods may be repeatedly performed to form multiple layers, and the stability may be increased to increase the service life characteristics of the device.

Hereinafter, the types of organic material layers included in the above-described organic light emitting device will be specifically described.

In an exemplary embodiment of the present invention, the organic light emitting device includes an organic material layer having one layer, and one or more layers of the organic material layer include the ink composition or a cured product thereof. As an example, the organic material layer including the above-described ink composition or a cured product thereof is a hole injection layer.

In an exemplary embodiment of the present invention, the organic light emitting device includes an organic material layer having two or more layers, and one or more layers of the organic material layer having two or more layers include the ink composition or a cured product thereof. For example, among organic material layers having two or more layers, the organic material layer having any one layer includes the ink composition or a cured product thereof, and further includes another organic material layer. The another organic material layer according to an exemplary embodiment does not include the ink composition or a cured product thereof. The another organic material layer according to another exemplary embodiment further includes the ink composition or a cured product thereof. However, the organic light emitting

device is not limited to the example.

The organic material layer having two or more layers includes two or more layers selected from the group consisting of, for example, a hole injection layer, a hole transport layer, a hole injection and transport layer, an electron blocking layer, a light emitting layer, a hole blocking layer, an electron transport layer, an electron injection layer, an electron injection and transport layer, and the like. In this case, the hole injection and transport layer means a layer which simultaneously injects and transports holes, and the electron injection and transport layer means a layer which simultaneously injects and transports electrons. However, the organic material layers forming the group are merely an example, and are not limited to the above example. Further, the organic material layer having two or more layers may include two or more layers that play the same role, if necessary. The organic light emitting device according to an exemplary embodiment includes a first hole injection layer and a second hole injection layer. However, the organic material layer having two or more layers is not limited to the examples.

In an exemplary embodiment of the present invention, the organic material layer includes a light emitting layer. As an example, the light emitting layer includes the ink composition or a cured product thereof. As a specific example, the light emitting layer includes the ink composition or a cured product thereof as a host of the light emitting layer. As another specific example, the light emitting layer includes the ink composition or a cured product thereof as a dopant of the light emitting layer.

In an exemplary embodiment of the present invention, the organic material layer includes a hole injection and transport layer, a hole injection layer, a hole transport layer and an electron blocking layer. As an example, the hole injection and transport layer, the hole injection layer, the hole transport layer or the electron blocking layer includes an ink composition or a cured product thereof.

In an exemplary embodiment of the present invention, the organic material layer is a hole injection layer, a hole transport layer and/or an electron blocking layer. As an example, the hole injection layer, the hole transport layer and/or the electron blocking layer includes the ink composition or a cured product thereof.

In an exemplary embodiment of the present invention, the organic material layer further includes one or more layers selected from the group consisting of a hole blocking layer, an electron transport layer, an electron injection layer, and an electron injection and transport layer. As an example, one or more layers selected from the group consisting of the hole blocking layer, the electron transport layer, the electron injection layer, and the electron injection and transport layer include the ink composition or a cured product thereof. As another example, one or more layers selected from the group consisting of the hole blocking layer, the electron transport layer, the electron injection layer, and the electron injection and transport layer do not include the ink composition or a cured product thereof.

In an exemplary embodiment of the present invention, the organic light emitting device includes: a first electrode; a second electrode; and an organic material layer having one or more layers provided between the first electrode and the second electrode, the organic material layer includes a light emitting layer, a hole injection layer and an electron blocking layer, and the hole injection layer or the electron blocking layer include the ink composition or a cured product thereof.

Hereinafter, the stacking structure of the organic material layer and the organic light emitting device including the organic material layer will be specifically described.

In an exemplary embodiment of the present invention, the organic material layer of the organic light emitting device has a single-layered structure. For example, the organic material layer having the single-layered structure is provided between the first electrode and the second electrode of the organic light emitting device, and the organic material layer includes the ink composition or a cured product thereof. In a specific exemplary embodiment, the organic material layer having the single-layered structure is a light emitting layer, and in this case, the light emitting layer includes the ink composition or a cured product thereof.

In an exemplary embodiment of the present invention, the organic material layer of the organic light emitting device has a multi-layered structure in which an organic material layer having two or more layers is stacked. For example, the organic material layer having the multi-layered structure is provided between the first electrode and the second electrode of the organic light emitting device.

In an exemplary embodiment of the present invention, the organic material layer having the multi-layered structure includes a light emitting layer and an organic material layer other than the light emitting layer. As an example, the light emitting layer is provided between the first electrode and the second electrode, and the organic material layer other than the light emitting layer is provided between the first electrode and the light emitting layer. As another example, the light emitting layer is provided between the first electrode and the second electrode, and the organic material layer other than the light emitting layer is provided between the light emitting layer and the second electrode. As still another example, the light emitting layer is provided between the first electrode and the second electrode, any one organic material layer other than the light emitting layer is provided between the first electrode and the light emitting layer, and any other organic material layer other than the light emitting layer is provided between the light emitting layer and the second electrode. However, the above structure is merely an example, and the structure is not limited to the above structure. Further, the organic material layer other than the light emitting layer may be one or more layers selected from the group consisting of, for example, a hole injection and transport layer, a hole injection layer, a hole transport layer, an electron blocking layer, a hole

blocking layer, an electron transport layer, an electron injection layer, an electron injection and transport layer, and the like, but is not limited thereto.

In general, a hole injection layer, a hole transport layer or an electron blocking layer in an organic light emitting device is provided between an anode and a light emitting layer. As a specific example, the hole injection layer is provided on the anode, the hole transport layer is provided on the hole injection layer, and the electron blocking layer is provided on the hole injection layer, but the present invention is not limited to the above examples.

Further, in general, an electron injection layer, an electron transport layer or a hole blocking layer in an organic light emitting device is provided between a cathode and a light emitting layer. As a specific example, the hole blocking layer is provided on the light emitting layer, the electron transport layer is provided on the hole blocking layer, and the electron injection layer is provided on the electron transport layer, but the present invention is not limited to the above examples.

In an exemplary embodiment of the present invention, the organic material layer having a multi-layered structure included in the organic light emitting device includes: one or more layers selected from the group consisting of a hole injection and transport layer, a hole injection layer, a hole transport layer, an electron blocking layer, a hole blocking layer, an electron transport layer, an electron injection layer, and an electron injection and transport layer; and a light emitting layer, the light emitting layer is provided between a first electrode and a second electrode, the one or more layers are provided between the first electrode and the light emitting layer, and the one or more layers include the compound represented by Chemical Formula 1 and/or the first solvent represented by Chemical Formula A.

The structure of the organic light emitting device according to an exemplary embodiment of the present invention is illustrated in FIG. 1. FIG. 1 exemplifies a structure of an organic light emitting device in which a first electrode 201, a hole injection layer 301, a hole transport layer 401, a light emitting layer 501, an electron injection and transport layer 601, and a second electrode 701 are sequentially stacked on a substrate 101. The hole injection layer 301 and/or the hole transport layer 401 of FIG. 1 include/includes the above-described ink composition or a cured product thereof, or may be formed using the ink composition.

FIG. 1 exemplifies an organic light emitting device accordingto an exemplary embodiment of the present specification, and the structure of the organic light emitting device of the present invention is not limited thereto.

As described above, an organic light emitting device having an organic material layer having a single-layered or multi-layered structure may have, for example, the following stacking structure, but the stacking structure is not limited thereto.

(1) Anode/Hole transport layer/Light emitting layer/Cathode
(2) Anode/Hole injection layer/Hole transport layer/Light emitting layer/Cathode
(3) Anode/Hole injection layer/Hole buffer layer/Hole transport layer/Light emitting layer/Cathode
(4) Anode/Hole transport layer/Light emitting layer/Electron transport layer/Cathode
(5) Anode/Hole transport layer/Light emitting layer/Electron transport layer/Electron injection layer/Cathode
(6) Anode/Hole injection layer/Hole transport layer/Light emitting layer/Electron transport layer/Cathode
(7) Anode/Hole injection layer/Hole transport layer/Light emitting layer/Electron transport layer/Electron injection layer/Cathode
(8) Anode/Hole injection layer/Hole buffer layer/Hole transport layer/Light emitting layer/Electron transport layer/-Cathode
(9) Anode/Hole injection layer/Hole buffer layer/Hole transport layer/Light emitting layer/Electron transport layer/-Electron injection layer/Cathode
(10) Anode/Hole transport layer/Electron blocking layer/Light emitting layer/Electron transport layer/Cathode
(11) Anode/Hole transport layer/Electron blocking layer/Light emitting layer/Electron transport layer/Electron injection layer/Cathode
(12) Anode/Hole injection layer/Hole transport layer/Electron blocking layer/Light emitting layer/Electron transport layer/Cathode
(13) Anode/Hole injection layer/Hole transport layer/Electron blocking layer/Light emitting layer/Electron transport layer/Electron injection layer/Cathode
(14) Anode/Hole transport layer/Light emitting layer/Hole blocking layer/Electron transport layer/Cathode
(15) Anode/Hole transport layer/Light emitting layer/Hole blocking layer/Electron transport layer/Electron injection layer/Cathode
(16) Anode/Hole injection layer/Hole transport layer/Light emitting layer/Hole blocking layer/Electron transport layer/Cathode
(17) Anode/Hole injection layer/Hole transport layer/Light emitting layer/Hole blocking layer/Electron transport layer/Electron injection layer/Cathode
(18) Anode/Hole injection layer/Hole transport layer/Light emitting layer/Hole blocking layer/Electron transport layer/Electron injection layer/Cathode/Capsule
(19) Anode/Hole injection layer/First hole transport layer/Second hole transport layer/Light emitting layer/Hole

blocking layer/Electron transport layer/Electron injection layer/Cathode/Capsule

In the structures, the 'Electron transport layer/Electron injection layer' may be replaced with an' electron injection and transport layer' or a 'layer that simultaneously injects and transports electrons'.

Further, in the structures, the 'Hole injection layer/Hole transport layer' may be replaced with the 'hole injection and transport layer' or the "layer which simultaneously injects and transports holes".

In an exemplary embodiment of the present invention, the first electrode is an anode, and the second electrode is a cathode.

In an exemplary embodiment of the present invention, the first electrode is a cathode, and the second electrode is an anode.

In an exemplary embodiment of the present invention, the organic light emitting device may be a normal type organic light emitting device in which an anode, an organic material layer having one or more layers, and a cathode are sequentially stacked on a substrate.

In an exemplary embodiment of the present invention, the organic light emitting device may be an inverted type organic light emitting device in which a cathode, an organic material layer having one or more layers, and an anode are sequentially stacked on a substrate.

In an exemplary embodiment of the present invention, in an organic light emittingdevice, one or more layers of the organic material layer are formed using the above-described ink composition. Except for this, the organic light emitting device may be manufactured by materials and methods known in the art.

For example, the organic light emitting device of the present invention may be manufactured by sequentially stacking an anode, an organic material layer, and a cathode on a substrate. In this case, the organic light emitting device may be manufactured by depositing a metal or a metal oxide having conductivity, or an alloy thereof on a substrate to form an anode, forming an organic material layer including one or more layers of a hole injection layer, a hole transport layer, a light emitting layer, an electron injection layer, an electron transport layer, a hole transport and injection layer, and an electron transport and injection layer thereon through a solution process, a deposition process, the like, and then depositing a material, which may be used as a cathode, thereon, by using a physical vapor deposition (PVD) method such as sputtering or e-beam evaporation. In addition to such a method, the organic light emitting device may also be manufactured by consecutively depositing a cathode material, an organic material layer and an anode material on a substrate.

As the anode material, materials having a high work function are usually preferred so as to facilitate the injection of holes into an organic material layer. Examples thereof include: a metal, such as vanadium, chromium, copper, zinc, and gold, or an alloy thereof; a metal oxide, such as zinc oxide, indium oxide, indium tin oxide (ITO), and indium zinc oxide (IZO); a combination of a metal and an oxide, such as ZnO:Al or $SnO_2$:Sb; a conductive polymer, such as poly(3-methylthiophene), poly[3,4-(ethylene-1,2-dioxy)thiophene] (PEDOT), polypyrrole, and polyaniline; and the like, but are not limited thereto.

As the cathode material, materials having a low work function are usually preferred so as to facilitate the injection of electrons into an organic material layer. Examples thereof include: a metal, such as magnesium, calcium, sodium, potassium, titanium, indium, yttrium, lithium, gadolinium, aluminum, silver, tin, and lead, or an alloy thereof; a multi-layer structured material, such as LiF/Al or $LiO_2$/Al; and the like, but are not limited thereto.

The light emitting layer may include ahostmaterial and/or a dopant material.

Examples of the host material include a fused aromatic ring derivative, a hetero ring-containing compound, or the like. Specific examples of the fused aromatic ring derivative include anthracene derivatives, pyrene derivatives, naphthalene derivatives, pentacene derivatives, phenanthrene compounds, fluoranthene compounds, and the like, and specific examples of the hetero ring-containing compound include dibenzofuran derivatives, ladder-type furan compounds, pyrimidine derivatives, and the like, but the examples are not limited thereto.

Examples of the dopant material include an aromatic amine derivative, a styrylamine compound, a boron complex, a fluoranthene compound, a metal complex, and the like. Specifically, the aromatic amine derivative is a fused aromatic ring derivative having a substituted or unsubstituted arylamine group, and examples there of include pyrene, anthracene, chrysene, periflanthene, and the like having an arylamine group. Further, the styrylamine compound is a compound in which a substituted or unsubstituted arylamine is substituted with at least one arylvinyl group, and one or two or more substituents selected from the group consisting of an aryl group, a silyl group, an alkyl group, a cycloalkyl group, and an arylamine group are substituted or unsubstituted. Specific examples thereof include styrylamine, styryldiamine, styryltriamine, styryltetramine, and the like, but are not limited thereto. Further, examples of the metal complex include an iridium complex, a platinum complex, and the like, but are not limited thereto.

The hole injection layer is a layer which accepts holes from an electrode. It is preferred that hole injection material has an ability to transport holes, and has an effect of accepting holes from an anode and an excellent hole injection effect for a light emitting layer or a light emitting material. Further, the hole injection material is preferably a material which is excellent in ability to prevent excitons produced from a light emitting layer from moving to an electron injection layer or an electron

injection material. In addition, the hole injection material is preferably a material which is excellent in ability to form a thin film. In addition, the HOMO of the hole injection material is preferably a value between the work function of the anode material and the HOMO of the neighboring organic material layer. Specific examples of the hole injection material include: metal porphyrin, oligothiophene, and arylamine-based organic materials; hexanitrile hexaazatriphenylene-based organic materials; quinacridone-based organic materials; perylene-based organic materials; polythiophene-based conductive polymers such as anthraquinone and polyaniline; the compound of the above-described Chemical Formula 1, and the like, but are not limited thereto.

In an exemplary embodiment of the present invention, the hole injection layer is formed from the above-described ink composition or a cured product thereof.

In an exemplary embodiment of the present invention, the compound of Chemical Formula 1 is included as a host of a hole injection layer.

In an exemplary embodiment of the present invention, the ionic compound is included as a dopant of a hole injection layer.

The hole transport layer is a layer which accepts holes from a hole injection layer and transports the holes to a light emitting layer, and may have a single-layered structure or a multi-layered structure having two or more layers. A hole transport material is preferably a material having high hole mobility which may accept holes from an anode or a hole injection layer and transfer the holes to a light emitting layer. Specific examples of the hole transport material include arylamine-based organic materials, carbazole-based compounds, conductive polymers, block copolymers having both conjugated portions and non-conjugated portions, and the like, but are not limited thereto.

The electron transport layer is a layer which accepts electrons from an electron injection layer and transports the electrons to a light emitting layer. An electron transport material is preferably a material having high electron mobility which may proficiently accept electrons from a cathode and transfer the electrons to a light emitting layer. Specific examples thereof include: Al complexes of 8-hydroxyquinoline; complexes including $Alq_3$; organic radical compounds; hydroxyflavone-metalcomplexes; and the like, but are not limited thereto. The electron transport layer may be used with any desired cathode material, as used according to the related art. In particular, an appropriate cathode material is a typical material which has a low work function, followed by an aluminum layer or a silver layer. Specific examples thereof include cesium, barium, calcium, ytterbium, and samarium, in each case followed by an aluminum layer or a silver layer.

The electron injection layer is a layer which accepts electrons from an electrode. It is preferred that an electron injection material is excellent in ability to transport electrons and has an effect of accepting electrons from the cathode and an excellent electron injection effect for a light emitting layer or a light emitting material. Further, the electron injection material is preferably a material which prevents excitons produced from a light emitting layer from moving to a hole injection layer and is excellent in ability to form a thin film. Specific examples thereof include fluorenone, anthraquinodimethane, diphenoquinone, thiopyran dioxide, oxazole, oxadiazole, triazole, imidazole, perylenetetracarboxylic acid, fluorenylidene methane, anthrone, and the like, and derivatives thereof, metal complex compounds, nitrogen-containing 5-membered ring derivatives, and the like, but are not limited thereto. Examples of the metal complex compounds include 8-hydroxyquinolinato lithium, bis(8-hydroxyquinolinato) zinc, bis(8-hydroxyquinolinato) copper, bis(8-hydroxyquinolinato) manganese, tris(8-hydroxyquinolinato) aluminum, tris(2-methyl-8-hydroxyquinolinato) aluminum, tris(8-hydroxyquinolinato) gallium, bis(10-hydroxybenzo[h]quinolinato) beryllium, bis(10-hydroxybenzo[h]quinolinato) zinc, bis(2-methyl-8-quinolinato) chlorogallium, bis(2-methyl-8-quinolinato) (o-cresolato) gallium, bis(2-methyl-8-quinolinato) (1-naphtholato) aluminum, bis(2-methyl-8-quinolinato) (2-naphtholato) gallium, and the like, but are not limited thereto.

The electron blocking layer is a layer which may improve the service life and efficiency of a device by preventing electrons injected from an electron injection layer from passing through a light emitting layer and entering a hole injection layer. The electron-blocking layer may be formed between the light emitting layer and the hole injection layer, or between the light emitting layer and the layer which simultaneously injects and transports holes using the compound of the above-described Chemical Formula 2.

The hole blocking layer is a layer which blocks holes from reaching a cathode, and may be generally formed under the same conditions as those of the electron injection layer. Specific examples of the hole blocking layer material include oxadiazole derivatives or triazole derivatives, phenanthroline derivatives, aluminum complexes, and the like, but are not limited thereto.

The hole injection and transport layer may include materials for the above-described hole injection layer and hole transport layer.

The electron injection and transport layer may include materials for the above-described electron injection layer and electron transport layer.

When the organic light emitting device includes a plurality of organic material layers, the organic material layers may be formed of the same material or different materials.

The organic light emitting device according to the present invention may be a top emission type, a bottom emission type, or a dual emission type according to the material to be used.

An exemplary embodiment of the present invention provides an electronic device including an organic light

emitting device including the above-described ink composition or a cured product thereof, or including an organic material layer formed using the ink composition.

The electronic device may include all of the interlayer insulation film of a semiconductor device, a color filter, a black matrix, an overcoat, a column spacer, a passivation film, a buffer coating film, a multilayer printed board insulation film, a cover coat of a flexible copper-clad board, a buffer coating film, a multilayer printed board insulation film, a solder resist film, an insulation film of OLED, a protection film of a thin-film transistor of a liquid crystal display device, an electrode protection film and a semiconductor protection film of an organic EL device, an OLED insulation film, an LCD insulation film, a semiconductor insulation film, a solar light module, a touch panel, a display device such as a display panel, and the like, but is not limited thereto.

[Mode for Invention]

Hereinafter, the present invention will be described in detail with reference to Examples for specifically describing the present invention. However, the Examples according to the present invention may be modified into various different forms, and it should not be interpreted that the scope of the present invention is limited to the Examples to be described below. The Examples of the present invention are provided for more completely explaining the present invention to the person with ordinary skill in the art.

**<Synthesis Example A. Preparation of Compound>**

**Synthesis Example A-1. Synthesis of Compound H-1**

(1) Synthesis of Intermediate 1-1

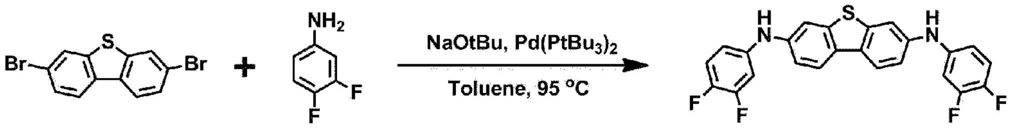


a-1 a-2 1-1

Compound a-1 (1.0 eq), Compound a-2 (2.1 eq), sodium tert-butoxide (NaOtBu) (4.0 eq) and toluene (0.1 M) were put into a flask, and the resulting mixture was stirred at 40°C to 50°C. Thereafter, bis(tri-tert-butylphosphine) palladium(0) (Pd $(PtBu_3)_2$) (0.08 eq) was added thereto and the resulting mixture was stirred at 95°C. After it was confirmed whether the reaction had been completely carried out, water was added to terminate the reaction. After layers were separated by adding ethyl acetate (EA) thereto, the aqueous layer was again separated into layers using ethyl acetate. Magnesium sulfate ($MgSO_4$) was added to the organic layer, and the resulting mixture was stirred, and then filtered. The filtered mixture was purified by column chromatography to obtain Intermediate 1-1. The intermediate was confirmed by LC-MS.
MS : [M+H]+ = 438.4

(2) Synthesis of Compound H-1

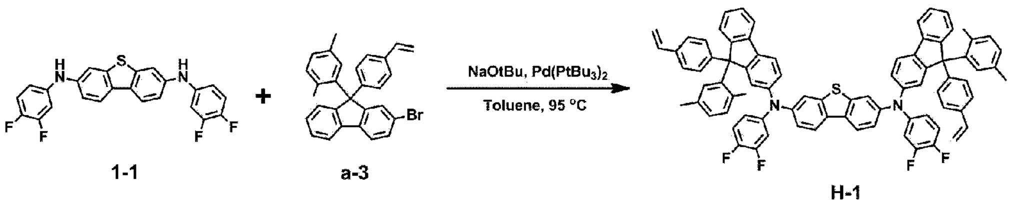


1-1 a-3 H-1

Intermediate 1-1 (1.0 eq), Compound a-3 (2.1 eq), NaOtBu (4.0 eq) and toluene (0.1 M) were put into a flask, and the resulting mixture was stirred at 40°C to 50°C. Thereafter, $Pd(PtBu_3)_2$(0.08 eq) was added thereto and the resulting mixture was stirred at 95°C. After it was confirmed whether the reaction had been completely carried out, water was added to terminate the reaction. After layers were separated by adding ethyl acetate thereto, the aqueous layer was again

separated into layers using ethyl acetate. Magnesium sulfate was added to the organic layer, and the resulting mixture was stirred, and then filtered. The filtered mixture was purified by column chromatography to obtain Compound H-1. The compound was confirmed by LC-MS, $^1$H-NMR.

MS : [M+H]+ = 1179.4
$^1$H NMR (500 MHz) : $\delta$ = 8.2-6.85 (m, 64H), 6.8-6.7 (m, 2H), 5.8-5.7 (d, 2H), 5.3-5.2 (d, 2H), 2.4-2.2 (d, 12H)

**Synthesis Example A-2. Synthesis of Compound H-2**

(1) Synthesis of Intermediate 1-2

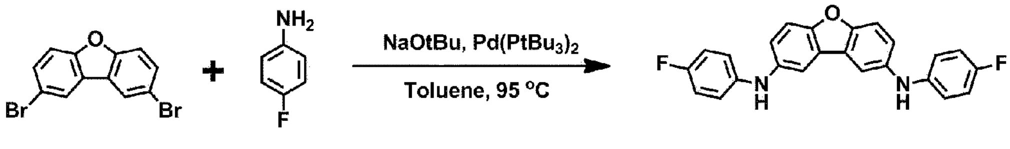


b-1 b-2 1-2

Compound b-1 (1.0 eq), Compound b-2 (2.1 eq), NaOtBu (4.0 eq) and toluene (0.1 M) were put into a flask, and the resulting mixturewas stirredat 40°C to 50°C. Thereafter, $Pd(PtBu_3)_2$(0.08 eq) was added thereto and the resulting mixture was stirred at 95°C. After it was confirmed whether the reaction had been completely carried out, water was added to terminate the reaction. After layers were separated by adding ethyl acetate thereto, the aqueous layer was again separated into layers using ethyl acetate. Magnesium sulfate was added to the organic layer, and the resulting mixture was stirred, and then filtered. The filtered mixture was purified by column chromatography to obtain Intermediate 1-2. The intermediate was confirmed by LC-MS.
MS : [M+H]+ = 386.4

(2) Synthesis of Compound H-2

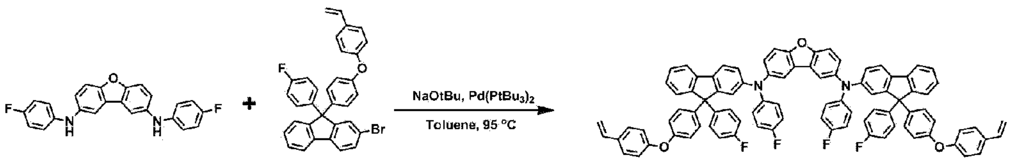


1-2 b-3 H-2

Intermediate 1-2 (1.0 eq), Compound b-3 (2.1 eq), NaOtBu (4.0 eq) and toluene (0.1 M) were put into a flask, and the resulting mixture was stirred at 40°C to 50°C. Thereafter, $Pd(PtBu_3)_2$(0.08 eq) was added thereto and the resulting mixture was stirred at 95°C. After it was confirmed whether the reaction had been completely carried out, water was added to terminate the reaction. After layers were separated by adding ethyl acetate thereto, the aqueous layer was again separated into layers using ethyl acetate. Magnesium sulfate was added to the organic layer, and the resulting mixture was stirred, and then filtered. The filtered mixture was purified by column chromatography to obtain Compound H-2. The compound was confirmed by LC-MS, $^1$H-NMR.

MS : [M+H]+ = 1291.4
$^1$H NMR (500 MHz) : $\delta$ = 8.3-6.9 (m, 84H), 6.8-6.7 (m, 2H), 5.8-5.7 (d, 2H), 5.3-5.2 (d, 2H)

**Synthesis Example A-3. Synthesis of Compound H-3**

(1) Synthesis of Intermediate 1-3

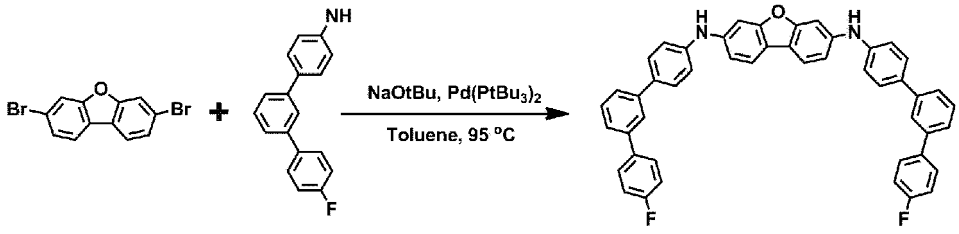


c-1 c-2 1-3

Compound c-1 (1.0 eq), Compound c-2 (2.1 eq), NaOtBu (4.0 eq) and toluene (0.1 M) were put into a flask, and the resulting mixture was stirred at 40°C to 50°C. Thereafter, Pd(PtBu$_3$)$_2$(0.08 eq) was added thereto and the resulting mixture was stirred at 95°C. After it was confirmed whether the reaction had been completely carried out, water was added to terminate the reaction. After layers were separated by adding ethyl acetate thereto, the aqueous layer was again separated into layers using ethyl acetate. Magnesium sulfate was added to the organic layer, and the resulting mixture was stirred, and then filtered. The filtered mixture was purified by column chromatography to obtain Intermediate 1-3. The intermediate was confirmed by LC-MS.
MS : [M+H]+ = 690.7

(2) Synthesis of Compound H-3

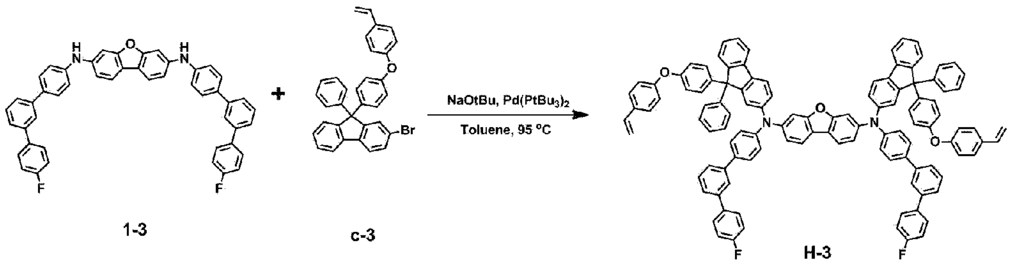


1-3 c-3 H-3

Intermediate 1-3 (1.0 eq), Compound c-3 (2.1 eq), NaOtBu (4.0 eq) and toluene (0.1 M) were put into a flask, and the resulting mixture was stirred at 40°C to 50°C. Thereafter, Pd(PtBu$_3$)$_2$(0.08 eq) was added thereto and the resulting mixture was stirred at 95°C. After it was confirmed whether the reaction had been completely carried out, water was added to terminate the reaction. After layers were separated by adding ethyl acetate thereto, the aqueous layer was again separated into layers using ethyl acetate. Magnesium sulfate was added to the organic layer, and the resulting mixture was stirred, and then filtered. The filtered mixture was purified by column chromatography to obtain Compound H-3. The compound was confirmed by LC-MS, $^1$H-NMR.

MS : [M+H]+ = 1559.8
$^1$H NMR (500 MHz) : $\delta$ = 8.1-6.9 (m, 108H), 6.8-6.7 (m, 2H), 5.8-5.7 (d, 2H), 5.3-5.2 (d, 2H)

**Synthesis Example 4. Synthesis of Compound H-4**

(1) Synthesis of Intermediate 1-4

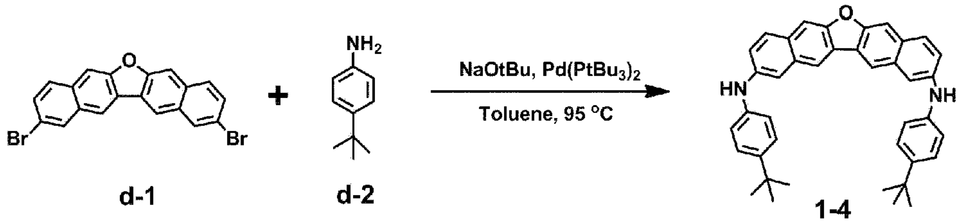


d-1 d-2 1-4

Compound d-1 (1.0 eq), Compound d-2 (2.1 eq), NaOtBu (4.0 eq) and toluene (0.1 M) were put into a flask, and the resulting mixturewasstirredat40°Cto50°C. Thereafter, $Pd(PtBu_3)_2$(0.08 eq) was added thereto and the resulting mixture was stirred at 95°C. After it was confirmed whether the reaction had been completely carried out, water was added to terminate the reaction. After layers were separated by adding ethyl acetate thereto, the aqueous layer was again separated into layers using ethyl acetate. Magnesium sulfate was added to the organic layer, and the resulting mixture was stirred, and then filtered. The filtered mixture was purified by column chromatography to obtain Intermediate 1-4. The intermediate was confirmed by LC-MS.
MS : [M+H]+ = 562.7

(2) Synthesis of Compound H-4

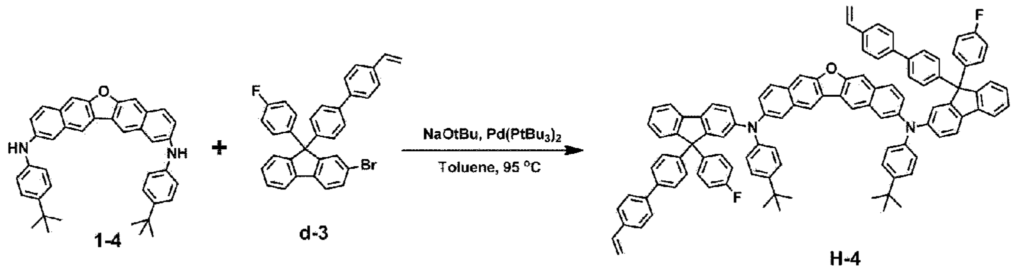


Intermediate 1-4 (1.0 eq), Compound d-3 (2.1 eq), NaOtBu (4.0 eq) and toluene (0.1 M) were put into a flask, and the resulting mixture was stirred at 40°C to 50°C. Thereafter, $Pd(PtBu_3)_2$ (0.08 eq) was added thereto and the resulting mixture was stirred at 95°C. After it was confirmed whether the reaction had been completely carried out, water was added to terminate the reaction. After layers were separated by adding ethyl acetate (EA) thereto, the aqueous layer was again separated into layers using ethyl acetate [EA]. Magnesium sulfate was added to the organic layer, and the resulting mixture was stirred, and then filtered. The filtered mixture was purified by column chromatography to obtain Compound H-4. The compound was confirmed by LC-MS, $^1$H-NMR.

MS : [M+H]+ = 1435.8
$^1$H NMR (500 MHz) : $\delta$ = 8.0-7.8 (m, 4H), 7.7-6.9 (m, 52H), 6.8-6.7 (m, 2H), 5.8-5.7 (d, 2H), 5.3-5.2 (d, 2H), 1.4-1.3 (s, 18H)

**Synthesis Example 5. Synthesis of Compound H-5**

(1) Synthesis of Intermediate 1-5

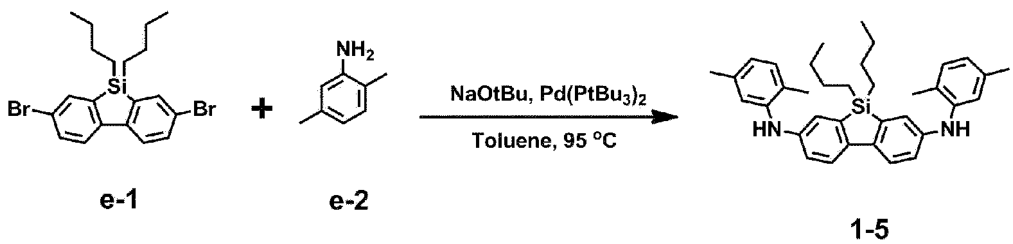


Compound e-1 (1.0 eq), Compound e-2 (2.1 eq), NaOtBu (4.0 eq) and toluene (0.1 M) were put into a flask, and the resulting mixturewasstirredat40°Cto50°C. Thereafter, $Pd(PtBu_3)_2$(0.08 eq) was added thereto and the resulting mixture was stirred at 95°C. After it was confirmed whether the reaction had been completely carried out, water was added to terminate the reaction. After layers were separated by adding ethyl acetate thereto, the aqueous layer was again separated into layers using ethyl acetate. Magnesium sulfate was added to the organic layer, and the resulting mixture was stirred, and then filtered. The filtered mixture was purified by column chromatography to obtain Intermediate 1-5. The intermediate was confirmed by LC-MS.
MS : [M+H]+ = 532.8

(2) Synthesis of Compound H-5

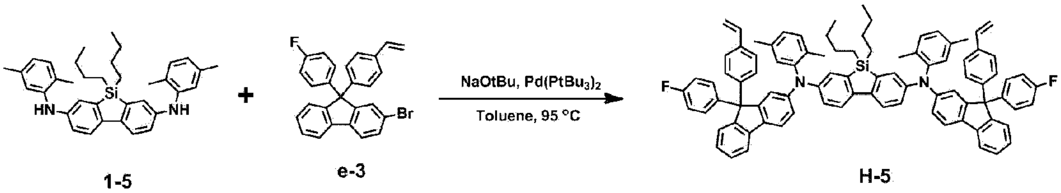


1-5 e-3 H-5

Intermediate 1-5 (1.0 eq), Compound e-3 (2.1 eq), NaOtBu (4.0 eq) and toluene (0.1 M) were put into a flask, and the resulting mixture was stirred at 40°C to 50°C. Thereafter, $Pd(PtBu_3)_2$ (0.08 eq) was added thereto and the resulting mixture was stirred at 95°C. After it was confirmed whether the reaction had been completely carried out, water was added to terminate the reaction. After layers were separated by adding ethyl acetate thereto, the aqueous layer was again separated into layers using ethyl acetate. Magnesium sulfate was added to the organic layer, and the resulting mixture was stirred, and then filtered. The filtered mixture was purified by column chromatography to obtain Compound H-5. The compound was confirmed by LC-MS, $^1$H-NMR.

MS : [M+H]+ = 1253.7
$^1$H NMR (500 MHz) : $\delta$ = 8.0-6.9 (m, 40H), 6.8-6.7(m, 4H), 5.8-5.7 (d, 2H), 5.3-5.2 (d, 2H), 2.3 (s, 6H), 2.0(s, 6H), 1.5-1.3 (m, 12H), 0.9 (t, 6H)

**<Synthesis Example B. Preparation of Ionic Compound>**

**Synthesis Example B-1. Preparation of Compound D-A**

(1) Preparation of Compound F-1

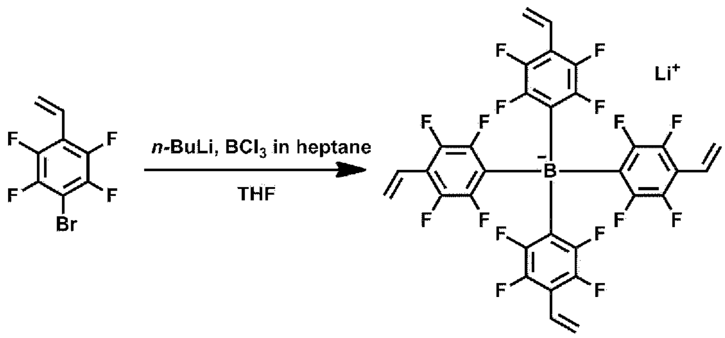


F-1

1-Bromo-2,3,5,6-tetrafluoro-4-vinylbenzene (2 g, 7.8428 mmol) was put into 20 mL of THF in a 50-mL round bottom flask, and the resulting solution was stirred under a condition of -78°C for 30 minutes. n-BuLi (3.45 mL, 8.6271 mmol, 2.5 M in a hexane solution) was slowly added to the solution, and the resulting mixture was stirred at -78°C for 30 minutes. $BCl_3$ (2.6 mL, 2.6142 mmol, 1 M in a heptane solution) was added to the reaction solution at -78°C over 15 minutes. The resulting solution was slowly warmed to room temperature, the reaction solution was stirred overnight, and then 30 mL of water was added thereto. The synthesized material was extracted with EA (3 x 10 mL), and then the solvent was completely removed. Water was completely removed by means of a Dean-stock using benzene, and the solid was filtered to prepare 800 mg of Compound F-1. (Yield: 43%) .

(2) Preparation of Compound D-A

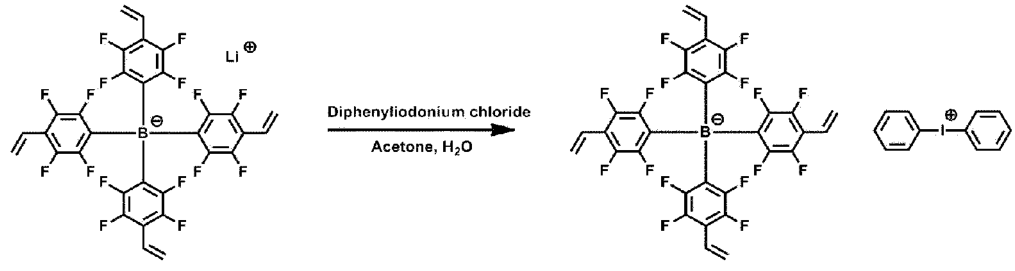


F-1 D-A

Compound F-1 (400 mg, 0.5569 mmol), diphenyliodonium chloride (176 mg, 0.5569 mmol), 10 mL of $H_2O$, and 10 mL of acetone were put into a 25-mL round bottom flask and stirred vigorously for 30 minutes. Extraction was performed using dichloromethane to remove and dry the solvent. After the solvent was thoroughly removed, water was completely removed by means of a Dean-stock using benzene, and the solid was filtered to prepare 340 mg of the target compound D-A. (Yield: 28%) The synthesis of the compound was confirmed through LC-MS and NMR.

MS: [M-H]- = 711 (negative mode)
MS: [M+H]+ = 281 (positive mode)

FIG. 2 shows the NMR measurement results of Compound D-A.

**Synthesis Example B-2. Preparation of Compound D-B**

(1) Preparation of Compound F-2

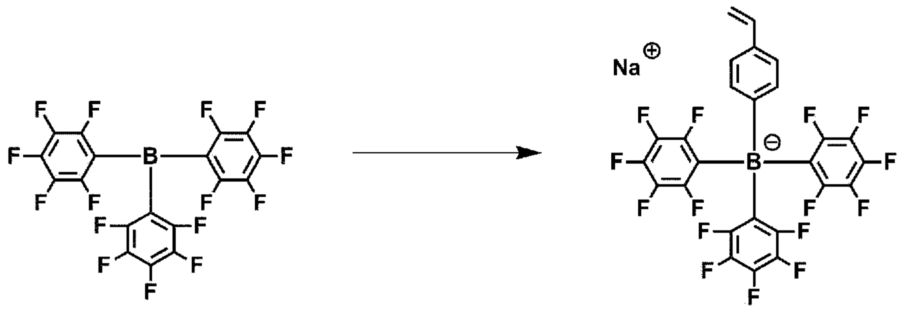

F-2

Mg (193 mg, 7.9208 mmol), $I_2$ (4 mg), and tetrahydrofuran (THF) (10 mL) were put into a 100-ml round bottom flask under a nitrogen atmosphere, and the resulting mixture was stirred for 30 minutes. 4-Bromostyrene (1.04 mL, 7.9208 mmol) was put thereinto, a water bath at 30°C was placed under the round bottom flask, and the resulting mixture was stirred overnight. It was confirmed that the reaction solution had become black and Mg had been dissolved therein. The reaction solution was diluted by adding 5 mL of ether thereto. Tris (pentafluorophenyl) borane (1g, 3.9604 mmol) was dissolved in 5 mL of ether, and the resulting solution was slowly added to the reaction solution for 30 minutes. The solution was stirred overnight. $Na_2CO_3$ (0.1 M, 80 mL, 8.0 mmol) was slowly added to the reaction solution. The organic solvent was extracted using EA, and the remaining water was removed over $MgSO_4$. Additionally, distillation was conducted with benzene by using a Dean-stock in order to remove the remaining water and impurities . When about 10 mL of the solvent remained, the solution was cooled and filtered to prepare 1.6 g of Compound F-2. (Yield: 64 %).

(2) Preparation of Compound D-B

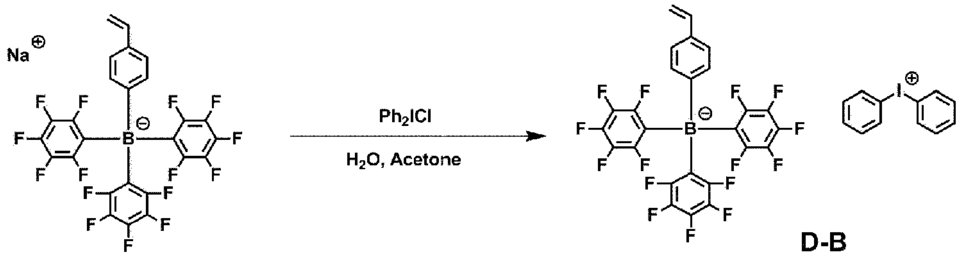


D-B

F-2

Compound F-2 (100 mg, 0.1567 mmol), 10 mL of distilled water and $Ph_2ICl$ (60 mg, 0.1881 mmol) were put into a 25-mL round bottom flask and stirred for 1 hour. When 15 mL of acetone was added to the reaction solution, a precipitate was produced, and the precipitate was filtered and dried to prepare 140 mg of Compound D-B. (Yield: 100 %) The synthesis of the compound was confirmed through LC-MS and NMR.

MS: [M-H]- = 615 (negative mode)
MS: [M+H]+ = 281 (positive mode)

FIG. 3 shows the NMR measurement results of Compound D-B.

**<Preparation of Ink Composition>**

**Preparation Example 1. Preparation of Ink Composition** 1

Compound H-1 prepared in Synthesis Example A-1 and Compound D-A prepared in Synthesis Example B-1 were mixed at a weight ratio of 8:2 to prepare Mixture 1. Thereafter, Mixture 1 was added to a solvent in which 3-isopropylbiphenyl (first solvent represented by Chemical Formula A) and dibutyl oxalate (additional solvent) were mixed at 20 wt% and 80 wt%, respectively, such that the concentration was 2 wt%, and then Ink Composition 1 was prepared by stirring the resulting mixture for 24 hours.

**Preparation Examples 2 to 71. Preparation of Ink Compositions 2 to 71.**

Ink Compositions 2 to 71 were prepared in the same manner as in Preparation Example 1, except that Compound H-1, Compound D-A, the first solvent, and the additional solvent were each used as the materials shown in the following Table 1.

In this case, when two types were used as the additional solvent, the solvent of Chemical Formula A, the first additional solvent, and the second additional solvent were mixed at 20 wt%, 50 wt%, and 30 wt%, respectively.

* Hole injection layer host compound (HIL host)

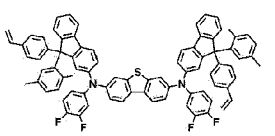

H-1

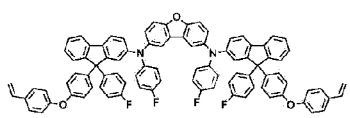

H-2

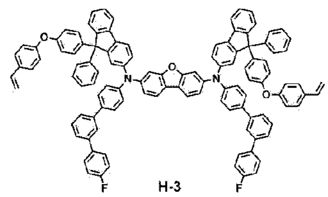

H-3

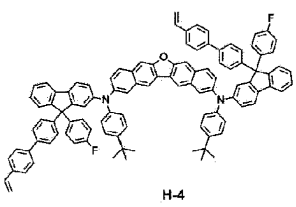

H-4

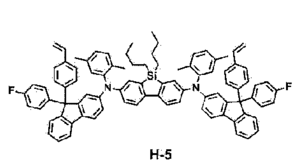

H-5

* Hole injection layer dopant compound (HIL dopant)

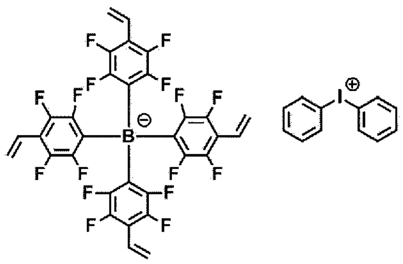

D-A

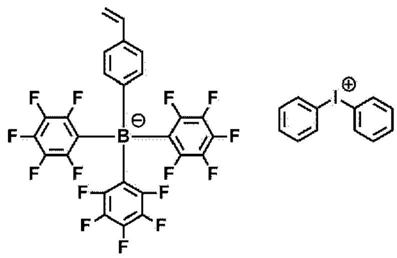

D-B

[Table 1]

| Ink composition | HIL HOST | HIL DOPANT | First solvent | First additional solvent (Second solvent) | Second additional solvent (Third solvent) |
|---|---|---|---|---|---|
| 1 | Compound H-1 | Compound D-A | 3-Isopropylbiphenyl | Dibutyl oxalate | - |
| 2 | Compound H-2 | Compound D-A | 3-Isopropylbiphenyl | Ethyl benzoate | - |
| 3 | Compound H-4 | Compound D-A | 3-Isopropylbiphenyl | Tripropylene glycol methyl ether | - |
| 4 | Compound H-5 | Compound D-B | 3-Isopropylbiphenyl | Diethyl adipate | - |
| 5 | Compound H-2 | Compound D-B | 3-Isopropylbiphenyl | Isoamylbenzoate | - |
| 6 | Compound H-3 | Compound D-B | 3-Isopropylbiphenyl | Dibutyl succinate | - |
| 7 | Compound H-3 | Compound D-A | 3-Isopropylbiphenyl | Methyl methoxy benzoate | - |
| 8 | Compound H-3 | Compound D-A | 3-Isopropylbiphenyl | Methyl methoxy benzoate | Diisopropyl malonate |
| 9 | Compound H-3 | Compound D-A | 3-Isopropylbiphenyl | Methyl methoxy benzoate | Butyl benzoate |
| 10 | Compound H-2 | Compound D-B | 3-Ethylbiphenyl | Butyl benzoate | - |
| 11 | Compound H-1 | Compound D-A | 3-Ethylbiphenyl | Dibutyl oxalate | - |
| 12 | Compound H-2 | Compound D-A | 3-Ethylbiphenyl | 2-Phenoxyethyl isobutyrate | - |
| 13 | Compound H-4 | Compound D-A | 3-Ethylbiphenyl | Tripropylene glycol methyl ether | - |
| 14 | Compound H-2 | Compound D-B | 3-Ethylbiphenyl | Tripropylene glycol methyl ether | Tetralin |
| 15 | Compound H-4 | Compound D-B | 3-Ethylbiphenyl | Tripropylene glycol methyl ether | Methoxytoluene |
| 16 | Compound H-2 | Compound D-A | 3-Methoxyb iphenyl | Dibutyl oxalate | - |
| 17 | Compound H-3 | Compound D-A | 3-Methoxyb iphenyl | Ethyl benzoate | - |

(continued)

| Ink composition | HIL HOST | HIL DOPANT | First solvent | First additional solvent (Second solvent) | Second additional solvent (Third solvent) |
|---|---|---|---|---|---|
| 18 | Compound H-4 | Compound D-A | 3-Methoxybiphenyl | Tripropylene glycol methyl ether | - |
| 19 | Compound H-3 | Compound D-B | 3-Methoxybiphenyl | Diethyl adipate | - |
| 20 | Compound H-4 | Compound D-B | 3-Methoxybiphenyl | Butyl carbitol acetate | - |
| 21 | Compound H-5 | Compound D-B | 3-Methoxybiphenyl | Butyl benzoate | - |
| 22 | Compound H-1 | Compound D-A | 3-Methoxybiphenyl | Methyl methoxy benzoate | - |
| 23 | Compound H-2 | Compound D-A | 3-Methoxybiphenyl | Benzyl butyrate | - |
| 24 | Compound H-5 | Compound D-B | 3-Methoxyb iphenyl | Benzyl butyrate | Dipropylene glycol monomethyl ether |
| 25 | Compound H-1 | Compound D-A | 4-Butylbip henyl | Dibutyl oxalate | - |
| 26 | Compound H-3 | Compound D-A | 4-Butylbip henyl | Diethyl adipate | - |
| 27 | Compoun d H-4 | Comp ound D-B | 4-Butylbip henyl | Tripropylen e glycol methyl ether | - |
| 28 | Compoun d H-5 | Comp ound D-B | 4-Butylbip henyl | 2-Phenoxyet hyl isobutyrate | - |
| 29 | Compoun d H-2 | Comp ound D-A | 4-Butylbip henyl | Butyl benzoate | - |
| 30 | Compoun d H-2 | Comp ound D-A | 4-Butylbip henyl | Butyl benzoate | 2-Phenoxyet hyl isobutyrate |
| 31 | Compoun d H-2 | Comp ound D-A | 4-Butylbip henyl | Butyl benzoate | Dibutyl succinate |
| 32 | Compound H-5 | Compound D-A | 4-Pentylbiphenyl | Methyl methoxy benzoate | - |
| 33 | Compound H-1 | Compound D-B | 4-Pentylbiphenyl | Tripropylene glycol methyl ether | - |
| 34 | Compound H-2 | Compound D-B | 4-Pentylbi phenyl | Ethyl benzoate | - |
| 35 | Compound H-1 | Compound D-A | 4-Pentylbiphenyl | Butyl carbitol acetate | - |
| 36 | Compound H-1 | Compound D-A | 4-Pentylbiphenyl | Dibutyl oxalate | - |
| 37 | Compound H-1 | Compound D-A | 4-Pentylbiphenyl | Dibutyl oxalate | Methoxytolu ene |
| 38 | Compound H-1 | Compound D-A | 4-Pentylbiphenyl | Dibutyl oxalate | Tetralin |
| 39 | Compound H-3 | Compound D-B | 2,2'-Diisopropyl biphenyl | Isoamyl benzoate | - |

(continued)

| Ink composition | HIL HOST | HIL DOPANT | First solvent | First additional solvent (Second solvent) | Second additional solvent (Third solvent) |
|---|---|---|---|---|---|
| 40 | Compound H-1 | Compound D-B | 2,2'-Diiso propyl biphenyl | Butyl benzoate | - |
| 41 | Compound H-2 | Compound D-B | 2,2'-Diiso propyl biphenyl | Butyl benzoate | Dibutyl succinate |
| 42 | Compoun | Comp | 2,2'-Diiso | Dibutyl | - |
| | d H-1 | ound D-A | propyl biphenyl | oxalate | |
| 43 | Compound H-2 | Compound D-A | 2,2'-Diiso propyl biphenyl | Diethyl adipate | - |
| 44 | Compound H-2 | Compound D-A | 2,2'-Diiso propyl biphenyl | Diethyl adipate | Diisopropyl malonate |
| 45 | Compound H-2 | Compound D-A | 2,2'-Diiso propyl biphenyl | Diethyl adipate | Diethyl malonate |
| 46 | Compound H-1 | Compound D-A | Tastromine | Dibutyl oxalate | - |
| 47 | Compound H-2 | Compound D-A | Tastromine | Ethyl benzoate | - |
| 48 | Compound H-4 | Compound D-A | Tastromine | Butyl carbitol acetate | - |
| 49 | Compound H-5 | Compound D-B | Tastromine | Methyl methoxy benzoate | - |
| 50 | Compound H-2 | Compound D-B | Tastromine | Butyl benzoate | - |
| 51 | Compound H-3 | Compound D-B | Tastromine | Butyl benzoate | Diisopropyl malonate |
| 52 | Compound H-3 | Compound D-A | DELTA-TRID ECANOLACTO NE | Ethyl benzoate | - |
| 53 | Compound H-3 | Compound D-A | DELTA-TRID ECANOLACTO NE | Tripropylen e glycol methyl ether | - |
| 54 | Compound H-3 | Compound D-A | DELTA-TRID ECANOLACTO NE | Diethyl adipate | - |
| 55 | Compound H-2 | Compound D-B | DELTA-TRID ECANOLACTO NE | Butyl carbitol acetate | - |
| 56 | Compound H-1 | Compound D-A | DELTA-TRID ECANOLACTO NE | Benzyl butyrate | Dipropylene glycol monomethyl ether |
| 57 | Compound H-2 | Compound D-A | DELTA-TRID ECANOLACTO NE | Methyl methoxy benzoate | Tetralin |
| 58 | Compound H-4 | Compound D-A | 1-Nonylimi dazole | Dibutyl oxalate | - |
| 59 | Compound H-2 | Compound D-B | 1-Nonylimidazole | Ethyl benzoate | - |
| 60 | Compound H-4 | Compound D-B | 1-Nonylimidazole | Diethyl adipate | - |
| 61 | Compound H-2 | Compound D-A | 1-Nonylimidazole | Tripropylene glycol methyl ether | - |

(continued)

| Ink composition | HIL HOST | HIL DOPANT | First solvent | First additional solvent (Second solvent) | Second additional solvent (Third solvent) |
|---|---|---|---|---|---|
| 62 | Compound H-3 | Compound D-A | 1-Nonylimidazole | Tripropylene glycol methyl ether | Methoxytoluene |
| 63 | Compound H-4 | Compound D-A | 1-Nonylimidazole | Tripropylene glycol methyl ether | Tetralin |
| 64 | Compound H-3 | Compound D-B | N-Isopenty 1-N-phenyl propionamide | Dibutyl oxalate | - |
| 65 | Compound H-4 | Compound D-B | N-Isopenty 1-N-phenyl propionamide | Ethyl benzoate | - |
| 66 | Compound H-5 | Compound D-B | N-Isopenty 1-N-phenyl propionamide | Tripropylene glycol methyl ether | - |
| 67 | Compound H-1 | Compound D-A | N-Isopenty 1-N-phenyl propionamide | Diethyl adipate | - |
| 68 | Compound H-2 | Compound D-A | N-Isopenty 1-N-phenyl propionami de | Butyl carbitol acetate | - |
| 69 | Compound H-5 | Compound D-B | N-Isopenty 1-N-phenyl propionamide | Methyl methoxy benzoate | - |
| 70 | Compound H-3 | Compound D-A | 3-Isopropy lbiphenyl | Methyl methoxy benzoate | Tetralin |
| 71 | Compound H-3 | Compound D-A | 1-Nonylimidazole | Tripropylene glycol methyl ether | Butyl benzoate |

**<Experimental Example A>**

**Example 1-1.**

Ink Composition 1 was printed on a substrate on which a number of pixels were formed in the form of lines. The printed substrate was placed in a vacuum chamber and a high vacuum ($1x10^{-6}$ torr or less) was reached within 10 minutes. A thin film was cured by per forming a heat treatment in a glove box ($N_2$ atmosphere, 230°C hot plate conditions) for 30 minutes.

FIG. 4 illustrates a line bank inkjet substrate to which the ink composition is applied.

FIG. 5 illustrates that the ink composition is applied to a line bank inkjet substrate.

FIG. 6 illustrates that the ink composition is formed as a thin film on a line bank inkjet substrate.

FIG. 7 is a view illustrating a plan view of an organic material layer in which line banks are formed. In FIG. 7, the ink composition is printed in a direction from (a) to (b) (arrow direction), and in this case, the (a) or (b) portion is expressed as an edge.

**Examples 1-2 to 1-45 and Comparative Examples 1-1 to 1-24.**

Organic material layers were prepared in the same manner as in Example 1-1, except that the ink compositions shown in the following Table 2 were used instead of Ink Composition 1 in Example 1-1, and the thicknesses of pixels were measured.

The following Table 2 shows that a thin film with a thickness deviation of 5 nm or less is located at n-th pixel from the edge by selecting one line among a number of pixels in which the ink compositions prepared in Examples 1-1 to 1-45 and Comparative Examples 1-1 to 1-24 were formed as thin films to compare the average thickness of 10 pixels located at the line center with the thicknesses of the pixels located at the line edge portions.

In this case, the thicknesses of the pixels included in the cured thin film were measured using an optical profiler (model name: Contour GT-I) manufactured by Bruker, which is an optical thickness measuring device.

Specifically, in a line bank in which 70 pixels are formed in a row, the average thickness of the 31st to 40th pixels is compared with the thickness of the i-th pixel at the edge, and the minimum value of i whose value is ±5 nm is shown in the

following Table 2. In this case, the small number of i means that the thickness is uniformly formed to a position close to the edge (that is, the thickness uniformity is improved).

[Table 2]

| | Ink composition | Pixel position with $\pm$5 nm or less |
|---|---|---|
| Example 1-1 | 1 | 2 |
| Example 1-2 | 2 | 2 |
| Example 1-3 | 3 | 3 |
| Example 1-4 | 4 | 2 |
| Example 1-5 | 5 | 3 |
| Example 1-6 | 6 | 2 |
| Example 1-7 | 7 | 2 |
| Example 1-8 | 8 | 3 |
| Example 1-9 | 9 | 2 |
| Example 1-10 | 10 | 4 |
| Example 1-11 | 11 | 4 |
| Example 1-12 | 12 | 5 |
| Example 1-13 | 13 | 4 |
| Example 1-14 | 14 | 4 |
| Example 1-15 | 15 | 4 |
| Example 1-16 | 16 | 2 |
| Example 1-17 | 17 | 2 |
| Example 1-18 | 18 | 2 |
| Example 1-19 | 19 | 3 |
| Example 1-20 | 20 | 2 |
| Example 1-21 | 21 | 3 |
| Example 1-22 | 22 | 3 |
| Example 1-23 | 23 | 4 |
| Example 1-24 | 24 | 4 |
| Example 1-25 | 25 | 2 |
| Example 1-26 | 26 | 3 |
| Example 1-27 | 27 | 2 |
| Example 1-28 | 28 | 5 |
| Example 1-29 | 29 | 2 |
| Example 1-30 | 30 | 4 |
| Example 1-31 | 31 | 2 |
| Example 1-32 | 32 | 2 |
| Example 1-33 | 33 | 3 |
| Example 1-34 | 34 | 2 |
| Example 1-35 | 35 | 2 |
| Example 1-36 | 36 | 2 |
| Example 1-37 | 37 | 2 |

(continued)

| | Ink composition | Pixel position with ±5 nm or less |
|---|---|---|
| Example 1-38 | 38 | 2 |
| Example 1-39 | 39 | 2 |
| Example 1-40 | 40 | 2 |
| Example 1-41 | 41 | 2 |
| Example 1-42 | 42 | 2 |
| Example 1-43 | 43 | 2 |
| Example 1-44 | 44 | 2 |
| Example 1-45 | 45 | 2 |
| Comparative Example 1-1 | 46 | 7 |
| Comparative Example 1-2 | 47 | 6 |
| Comparative Example 1-3 | 48 | 6 |
| Comparative Example 1-4 | 49 | 6 |
| Comparative Example 1-5 | 50 | 8 |
| Comparative Example 1-6 | 51 | 7 |
| Comparative Example 1-7 | 52 | 9 |
| Comparative Example 1-8 | 53 | 8 |
| Comparative Example 1-9 | 54 | 7 |
| Comparative Example 1-10 | 55 | 8 |
| Comparative Example 1-11 | 56 | 9 |
| Comparative Example 1-12 | 57 | 8 |
| Comparative Example 1-13 | 58 | 10 |
| Comparative Example 1-14 | 59 | 9 |
| Comparative Example 1-15 | 60 | 9 |
| Comparative Example 1-16 | 61 | 8 |
| Comparative Example 1-17 | 62 | 9 |
| Comparative Example 1-18 | 63 | 9 |
| Comparative Example 1-19 | 64 | 8 |
| Comparative Example 1-20 | 65 | 9 |
| Comparative Example 1-21 | 66 | 8 |
| Comparative Example 1-22 | 67 | 7 |
| Comparative Example 1-23 | 68 | 8 |
| Comparative Example 1-24 | 69 | 9 |

Through Table 2 above, it can be confirmed that in the case of Examples 1-1 to 1-45, the pixels showing ±5 nm with the center average thickness are located at the 5th or less position from the edge, whereas in the case of Comparative Examples 1-1 to 1-24, the pixels are located at the 6th or more position from the edge.

In this regard, FIGS. 9 and 10 illustrate thickness uniformity characteristics of pixels according to the Examples of the present invention. Specifically, FIG. 9 illustrates the thickness uniformity of pixels measured in Example 1-1, and FIG. 10 illustrates the thickness uniformity of pixels measured in Comparative Example 1-1. In FIGS. 9 and 10, the horizontal axis means the spacing (μm) between pixels, and the vertical axis means the thickness (nm) of the pixel. Through FIGS. 9 and 10, it can be confirmed that in Example 1-1 (FIG. 9) in which the ink composition according to an exemplary embodiment of the present invention is used, the number of pixels in which the thin film is formed to be thick even at the

edge portion, whereas in Comparative Example 1-1 (FIG. 10) in which the ink composition according to an exemplary embodiment of the present invention is not used, the number of pixels where the thin film is formed to be thick increases toward the edge portion, and the thickness of the thin film also becomes larger.

Through this, it can be seen that the thickness uniformity is improved when the ink composition according to an exemplary embodiment of the present invention is used. Accordingly, it is possible to expect excellent light emitting and/or coloring effects by reducing factors that affect the interference condition of light emitted according to the thickness when the ink composition is used in the organic material layer and the like in the organic light emitting device. In contrast, when an ink composition that does not comply with the present invention is used, the difference in thickness between pixels is large and the thickness uniformity is uneven, so that when the ink composition is applied to an organic material layer, and the like in an organic light emitting device, it can be expected that the performance of the device will deteriorate.

**Example 2-1.**

Ink Composition 1 was printed on a substrate on which 30 x 60 pixels were formed. The printed substrate was placed in a vacuum chamber and a high vacuum ($1x10^{-6}$ torr or less) was reached within 10 minutes. A thin film was cured by performing a heat treatment in a glove box ($N_2$ atmosphere, 230°C hot plate conditions) for 30 minutes.

FIG. 8 is a view illustrating a plan view of an organic material layer in which separated banks are formed. In FIG. 8, the ink composition is printed in a direction from (a) to (b) (arrow direction), and in this case, the (a) or (b) portion is expressed as an edge.

**Examples 2-2 to 2-27 and Comparative Examples 2-1 to 2-14.**

Organic material layers were prepared in the same manner as in Example 2-1, except that the ink compositions shown in the following Table 3 were used instead of Ink Composition 1 in Example 2-1, and the thin film height step in the pixel was measured.

In this case, the thin film height step in the pixel was measured using an optical profiler (model name: Contour GT-I) manufactured by Bruker, which is a thin film thickness measuring device.

The thin film height step between a section corresponding to 20% and a section corresponding to 80% of the pixel length in one pixel was measured, and the minimum value of i whose value is ±5 nm is shown in the following Table 3. In this case, i means the i-th pixel from the edge. Further, the small number of i means that the thickness of the thin film in the pixel is uniformly formed to a position close to the edge (that is, the thickness uniformity is improved).

[Table 3]

| | Ink composition | Pixel position with ±5 nm or less |
|---|---|---|
| Example 2-1 | 1 | 2 |
| Example 2-2 | 2 | 2 |
| Example 2-3 | 5 | 2 |
| Example 2-4 | 6 | 2 |
| Example 2-5 | 70 | 2 |
| Example 2-6 | 8 | 2 |
| Example 2-7 | 9 | 2 |
| Example 2-8 | 16 | 2 |
| Example 2-9 | 17 | 2 |
| Example 2-10 | 18 | 2 |
| Example 2-11 | 19 | 2 |
| Example 2-12 | 20 | 2 |
| Example 2-13 | 21 | 2 |
| Example 2-14 | 25 | 2 |
| Example 2-15 | 26 | 2 |
| Example 2-16 | 27 | 2 |
| Example 2-17 | 28 | 2 |

(continued)

| | Ink composition | Pixel position with ±5 nm or less |
|---|---|---|
| Example 2-18 | 29 | 2 |
| Example 2-19 | 30 | 2 |
| Example 2-20 | 31 | 2 |
| Example 2-21 | 39 | 2 |
| Example 2-22 | 40 | 2 |
| Example 2-23 | 41 | 2 |
| Example 2-24 | 42 | 2 |
| Example 2-25 | 43 | 2 |
| Example 2-26 | 44 | 2 |
| Example 2-27 | 45 | 2 |
| Comparative Example 2-1 | 46 | 3 |
| Comparative Example 2-2 | 47 | 3 |
| Comparative Example 2-3 | 50 | 3 |
| Comparative Example 2-4 | 51 | 3 |
| Comparative Example 2-5 | 59 | 4 |
| Comparative Example 2-6 | 60 | 4 |
| Comparative Example 2-7 | 61 | 3 |
| Comparative Example 2-8 | 71 | 4 |
| Comparative Example 2-9 | 63 | 4 |
| Comparative Example 2-10 | 64 | 3 |
| Comparative Example 2-11 | 66 | 3 |
| Comparative Example 2-12 | 67 | 3 |
| Comparative Example 2-13 | 68 | 4 |
| Comparative Example 2-14 | 69 | 4 |

The fact that the height step between sections corresponding to 20% and 80% of the pixel length is ±5 nm (that is, the absolute value of the height difference is 5 nm or less) means that the thickness of the thin film is formed to be uniform in the pixel.

Through Table 3, it can be confirmed that in Examples 2-1 to 2-27, the thin film in the pixel was formed symmetrically even at pixels closer to the edge portion without being tilted to one side, compared to Comparative Examples 2-1 to 2-14. That is, it can be confirmed that when the ink composition according to an exemplary embodiment of the present invention is applied, the thickness of the thin film was formed to be uniform even at pixels close to the edge than when other ink compositions were applied.

Through this, in the ink composition of the present invention, it is possible to expect excellent light emitting and/or coloring effects by reducing factors that affect the interference condition of light emitted according to the thickness because the ink composition is used in the organic material layer and the like in the organic light emitting device. In contrast, when an ink composition that does not comply with the present invention is used, the thin film on the edge side is not formed to be uniform, so that when the ink composition is applied to an organic material layer, and the like in an organic light emitting device, it can be expected that the performance of the device will deteriorate.

**<Experimental Example B>**

**Example 3-1.**

A glass substrate which was thin-film coated to have a thickness of 700 Å of ITO (indiumtinoxide) and patterned

with hydrophobic banks was washed with distilled water for 30 minutes and then dried on a hot plate at 230°C for 10 minutes. Ink Composition 1 in Table 1 was inkjet printed on a washed substrate patterned with banks, and heat-treated at 230°C for 30 minutes, thereby forming a hole injection layer having a thickness of 30 nm. A hole transport layer having a thickness of 40 nm was formed on the hole injection layer by inkjet printing an ink prepared by dissolving the following α-NPD compound in cyclohexyl benzene at a concentration of 2 wt %. Thereafter, the glass substrate was transferred to a vacuum deposition machine, and then the following ADN compound and the following DPAVBi compound were vacuum-deposited on the hole transport layer at a weight ratio of 20:1 (ADN:DPAVBi) to have a thickness of 20 nm, thereby forming a light emitting layer. The following BCP compound was vacuum-deposited to have a thickness of 35 nmon the light emitting layer, thereby forming an electron injection and transport layer. A cathode was formed by sequentially depositing LiF and aluminum to have a thickness of 1 nm and 100 nm, respectively, on the electron injection and transport layer, thereby manufacturing an organic light emitting device.

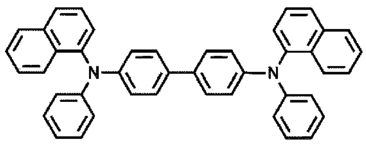

a-NPD

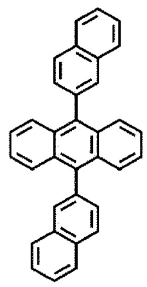

ADN

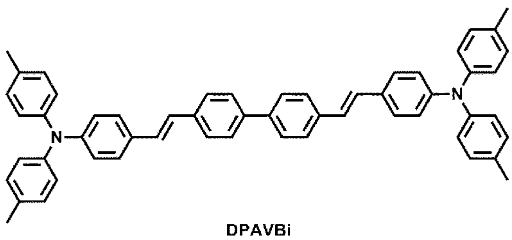

DPAVBi

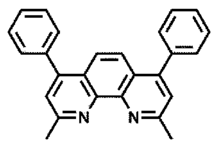

BCP

**Examples 3-2 to 3-46.**

Organic light emitting devices were manufactured in the same manner as in Example 3-1, except that the ink compounds in the following Table 4 were used instead of Ink Composition 1 in Example 3-1.

[Table 4]

| | Ink composition |
|---|---|
| Example 3-1 | 1 |
| Example 3-2 | 2 |
| Example 3-3 | 3 |
| Example 3-4 | 4 |
| Example 3-5 | 5 |
| Example 3-6 | 6 |
| Example 3-7 | 7 |
| Example 3-8 | 8 |
| Example 3-9 | 9 |
| Example 3-10 | 10 |
| Example 3-11 | 11 |

(continued)

| | Ink composition |
|---|---|
| Example 3-12 | 12 |
| Example 3-13 | 13 |
| Example 3-14 | 14 |
| Example 3-15 | 15 |
| Example 3-16 | 16 |
| Example 3-17 | 17 |
| Example 3-18 | 18 |
| Example 3-19 | 19 |
| Example 3-20 | 20 |
| Example 3-21 | 21 |
| Example 3-22 | 22 |
| Example 3-23 | 23 |
| Example 3-24 | 24 |
| Example 3-25 | 25 |
| Example 3-26 | 26 |
| Example 3-27 | 27 |
| Example 3-28 | 28 |
| Example 3-29 | 29 |
| Example 3-30 | 30 |
| Example 3-31 | 31 |
| Example 3-32 | 32 |
| Example 3-33 | 33 |
| Example 3-34 | 34 |
| Example 3-35 | 35 |
| Example 3-36 | 36 |
| Example 3-37 | 37 |
| Example 3-38 | 38 |
| Example 3-39 | 39 |
| Example 3-40 | 40 |
| Example 3-41 | 41 |
| Example 3-42 | 42 |
| Example 3-43 | 43 |
| Example 3-44 | 44 |
| Example 3-45 | 45 |
| Example 3-46 | 70 |

It was confirmed that the organic light emitting devices manufactured in Examples 3-1 to 3-46 were driven. Through this, it was confirmed that the ink compositions according to the exemplary embodiments of the present invention can be applied to an organic light emitting device.

**Comparative Examples 3-1 to 3-4.**

Ink Compositions 72 to 75 were prepared in the same manner as in Preparation Example 1, except that Compound H-1, Compound D-A, the first solvent, and the additional solvent were each used as the materials shown in the following Table 5.

Thereafter, organic light emitting devices were manufactured in the same manner as in Example 3-1, except that the ink compounds in the following Table 6 were used instead of Ink Composition 1 in Example 3-1.

The structures of Compounds X-1 to X-4 used in the following Table 5 are as follows.

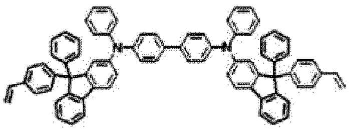

Compound X-1

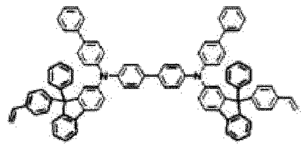

Compound X-2

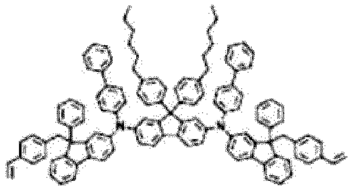

Compound X-3

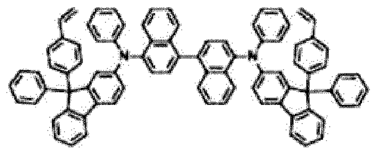

Compound X-4

[Table 5]

| Ink Composition | HIL HOST | HIL DOPANT | First solvent | First additional solvent (Second solvent) | Second additional solvent (Third solvent ) |
|---|---|---|---|---|---|
| 72 | Compound X-1 | Compound D-A | 4-Butylbiphenyl | Butyl benzoate | - |
| 73 | Compound X-2 | Compound D-A | 3-Methoxybiphenyl | Ethyl benzoate | - |
| 74 | Compound X-3 | Compound D-A | 3-Isopropylbiphenyl | Dibutyl oxalate | - |
| 75 | Compound X-4 | Compound D-A | 4-Butylbiphenyl | Butyl benzoate | Dibutyl succinate |

Efficiency and service life values of the organic light emitting devices manufactured in Examples 3-1, 3-17, 3-29 and 3-31 and the organic light emitting devices manufactured in Comparative Examples 3-1 to 3-4 were compared and are shown in the following Table 6.

The relative efficiency values and relative service life values in the following Table 6 were obtained as follows.

* Relative efficiency value: Efficiency of Example X/Efficiency of Example 3-29
* T95 relative value: T95 of Example X/T95 of Example 3-29

(Example X: Examples 3-1, 3-17, 3-29, and 3-31, and Comparative Example 3-1, 3-2, 3-3 or 3-4)

In this case, T95 indicates the service life, and is a value measured as the time it takes to reach 95% of the initial brightness under 1000 nit constant current conditions.

[Table 6]

| | Ink composition | Efficiency relative value | T95 relative value |
|---|---|---|---|
| Example 3-1 | 1 | 1.05 | 1.01 |

(continued)

| | Ink composition | Efficiency relative value | T95 relative value |
|---|---|---|---|
| Example 3-17 | 17 | 1.02 | 0.95 |
| Example 3-29 | 29 | 1 | 1 |
| Example 3-31 | 31 | 1.01 | 0.98 |
| Comparative Example 3-1 | 72 | 0.9 | 0.80 |
| Comparative Example 3-2 | 73 | 0.89 | 0.81 |
| Comparative Example 3-3 | 74 | 0.92 | 0.87 |
| Comparative Example 3-4 | 75 | 0.91 | 0.85 |

From Tables 5 and 6, it can be seen that when the host is changed in the ink composition of the present specification, the efficiency and service life of the organic light emitting device deteriorate.

## Claims

**1.** An ink composition comprising a compound represented by the following Chemical Formula 1 and a first solvent represented by the following Chemical Formula A:

[Chemical Formula 1]

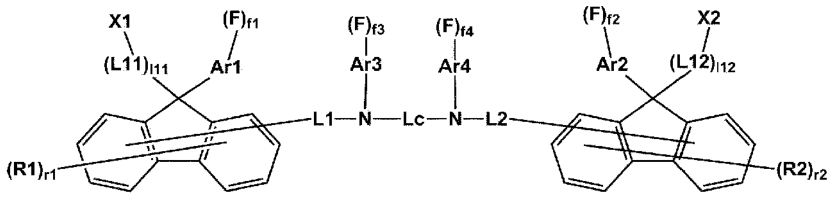

[Chemical Formula A]

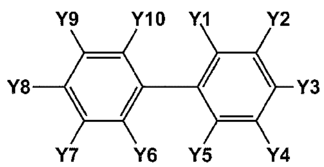

wherein, in Chemical Formulae 1 and A,
Y1 to Y10 are the same as or different from each other, and are each independently hydrogen; deuterium; ahydroxylgroup; an ether group; a carbonyl group; an ester group; a substituted or unsubstituted alkyl group; a substituted or unsubstituted cycloalkyl group; a substituted or unsubstituted cycloalkenyl group; a substituted or unsubstituted alkoxy group; a substituted or unsubstituted aryl group; or a substituted or unsubstituted amine group,
Lc is a substituted or unsubstituted heteroarylene group including O, S or Si,
L1 and L2 are the same as or different from each other, and are each independently a direct bond; or a substituted or unsubstituted arylene group,
L11 and L12 are the same as or different from each other, and are each independently a direct bond; -O-; a substituted or unsubstituted alkylene group; or a substituted or unsubstituted arylene group,
Ar1 to Ar4 are the same as or different from each other, and are each independently a substituted or unsubstituted aryl group; or a substituted or unsubstituted heteroaryl group,
R1 and R2 are the same as or different from each other, and are each independently hydrogen; deuterium; a halogen group; or a substituted or unsubstituted alkyl group,
X1 and X2 are the same as or different from each other, and are each independently a curable group,
r1 and r2 are each an integer from 0 to 7, and when r1 and r2 are each 2 or higher, two or more substituents in the

parenthesis are the same as or different from each other,
l11 and l12 are each an integer from 1 to 3, and when l11 and l12 are each 2 or higher, two or more substituents in the parenthesis are the same as or different from each other,
f1 is 0 to the maximum bondable number of substituents capable of being bonded to Ar1,
f2 is 0 to the maximum bondable number of substituents capable of being bonded to Ar2,
f3 is 0 to the maximum bondable number of substituents capable of being bonded to Ar3, and
f4 is 0 to the maximum bondable number of substituents capable of being bonded to Ar4.

**2.** The ink composition of claim 1, wherein the curable group is any one of the following structures:

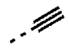 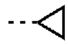 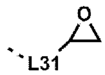 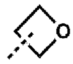 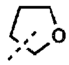 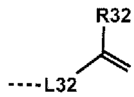 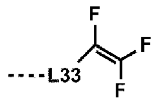

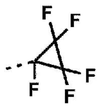 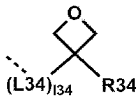 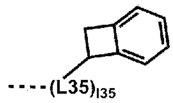 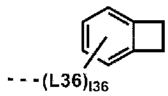 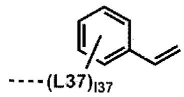

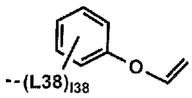 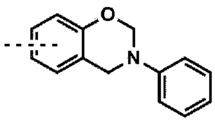 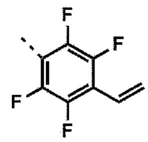 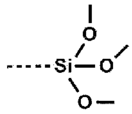

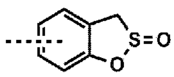 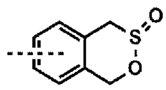

in the structures,
R32 and R34 are the same as or different from each other, and are each independently hydrogen; deuterium; or a substituted or unsubstituted alkyl group,
L31 to L38 are the same as or different from each other, and are each independently a direct bond; -O-; a substituted or unsubstituted alkylene group; or a substituted or unsubstituted arylene group,
l34 to l38 are each an integer from 1 to 10, and when l34 to l38 are each 2 or higher, two or more substituents in the parenthesis are the same as or different from each other, and
------ is a moiety bonded to Chemical Formula 1.

**3.** The ink composition of claim 1, wherein Chemical Formula 1 is represented by the following Chemical Formula 1-1:

[Chemical Formula 1-1]

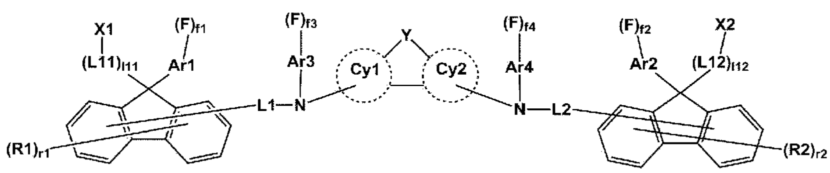

in Chemical Formula 1-1,
Cy1 and Cy2 are the same as or different from each other, and are each independently a substituted or unsubstituted aromatic ring having 6 to 20 carbon atoms,
Y is O, S or SiRy1Ry2,
Ry1 and Ry2 are the same as or different from each other, and are each independently hydrogen; deuterium; a substituted or unsubstituted alkyl group; or a substituted or unsubstituted aryl group, and
L1, L2, L11, L12, Ar1 to Ar4, R1, R2, X1, X2, r1, r2, l11, l12 and f1 to f4 are the same as those defined in Chemical Formula 1.

4. The ink composition of claim 1, wherein the solvent represented by Chemical Formula A is any one of the following structures:

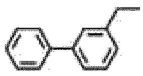
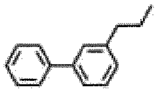
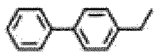
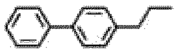
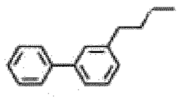
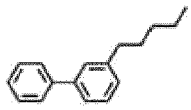
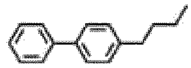
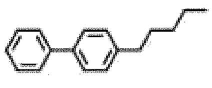
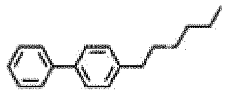
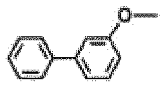
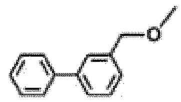
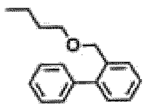
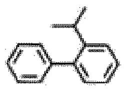
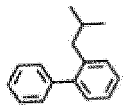
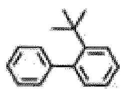
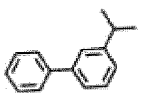
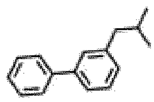
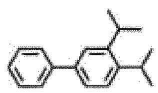
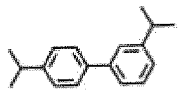
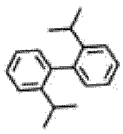
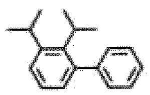
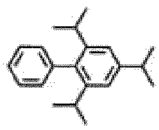
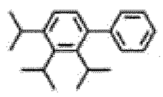
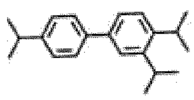
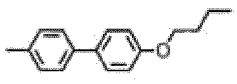

.

5. The ink composition of claim 1, wherein the compound represented by Chemical Formula 1 is any one of the following structures:

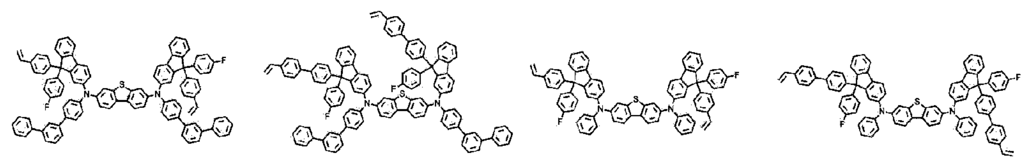
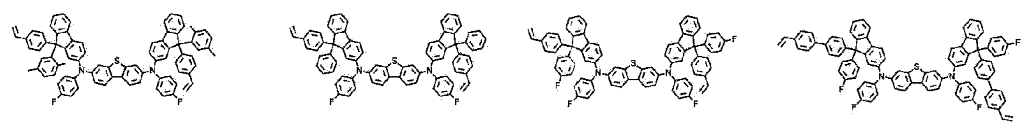
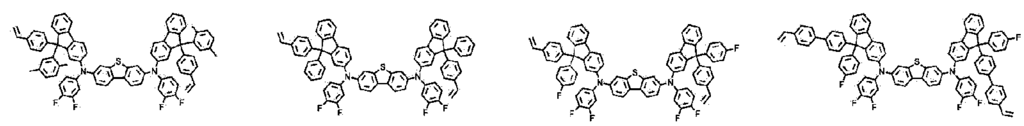

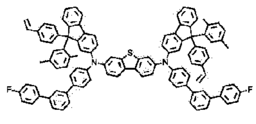
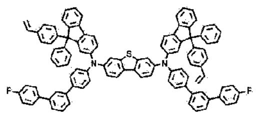
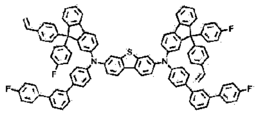
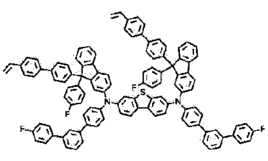
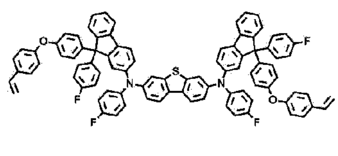
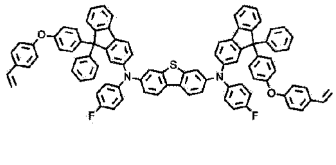
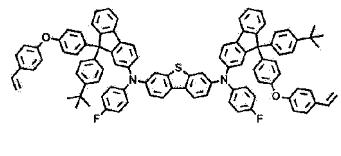
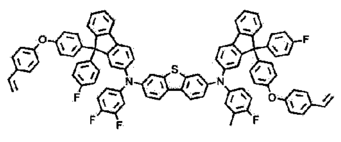
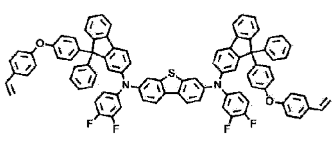
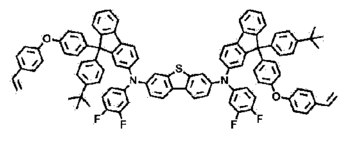
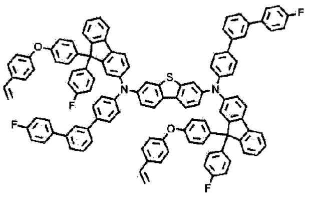
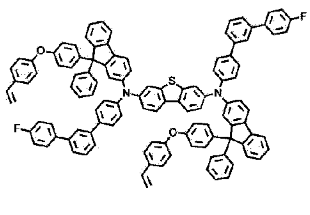
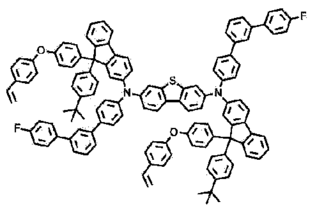
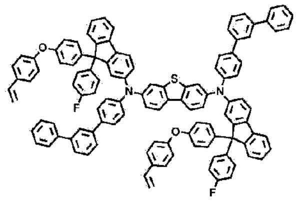
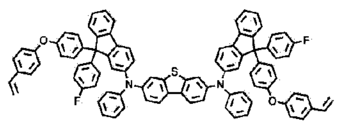
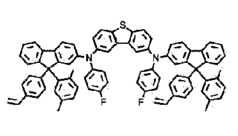
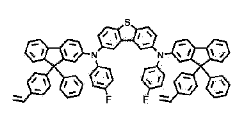
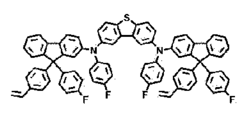
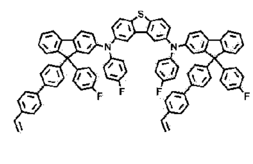
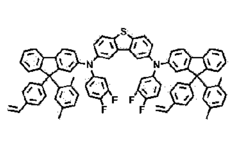
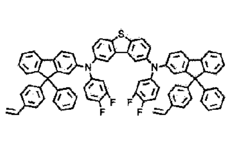
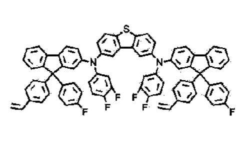
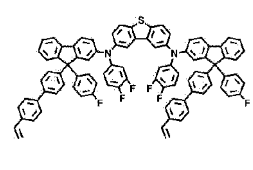
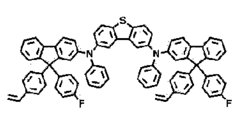
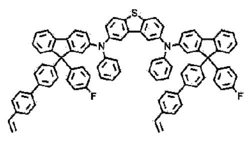
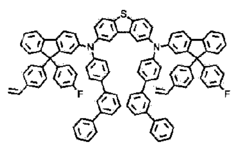
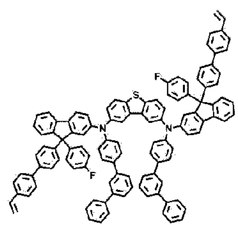

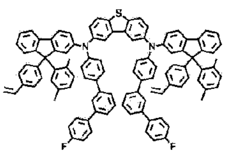
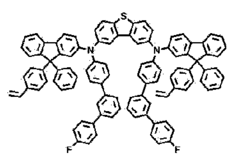
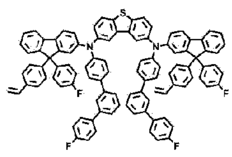
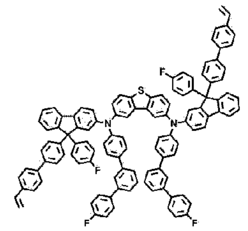

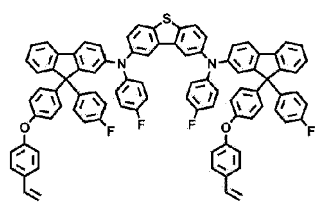
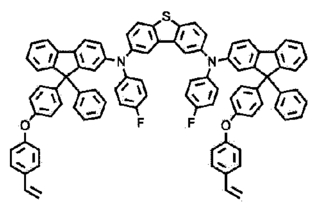
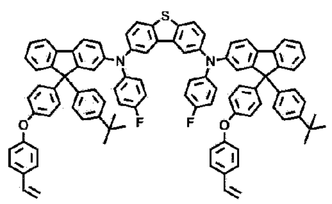

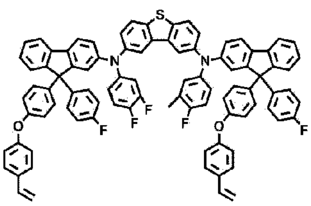
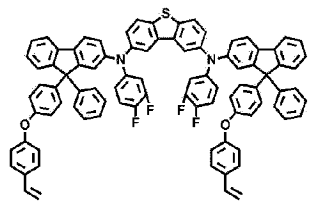
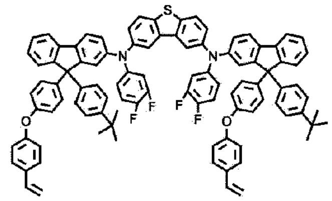

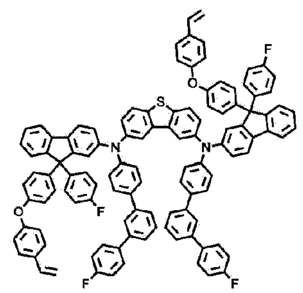
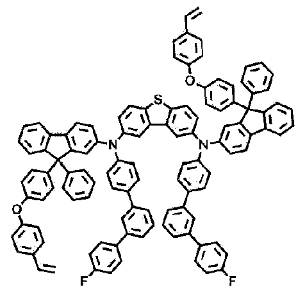
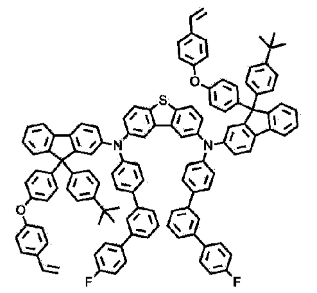

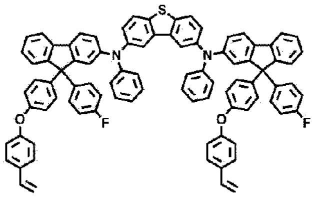
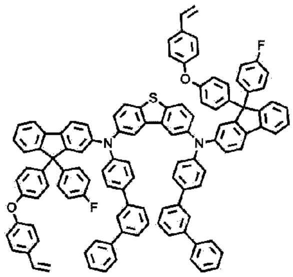

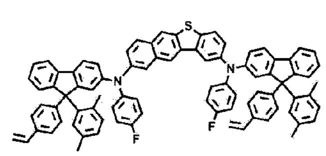
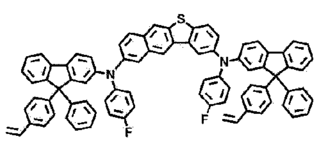
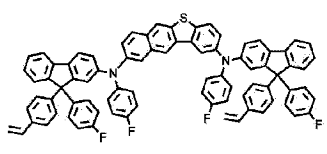

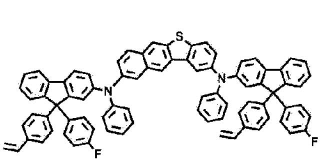
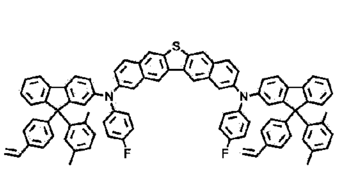
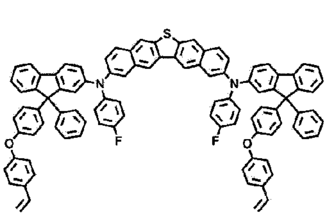

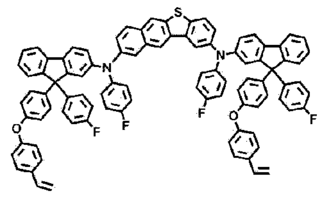
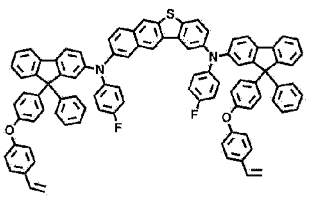
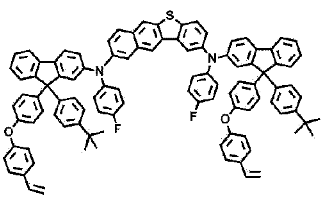

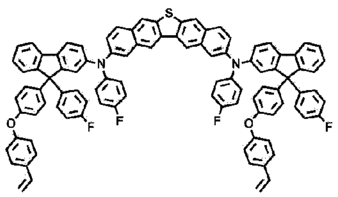
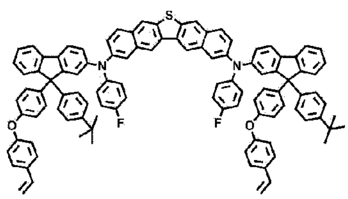
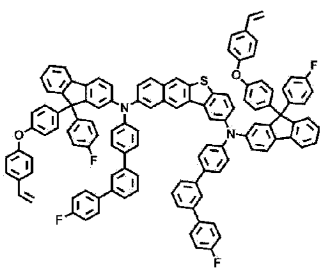

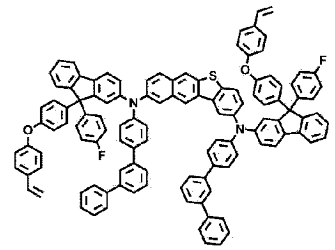

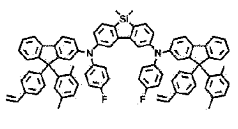
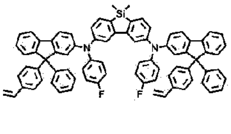
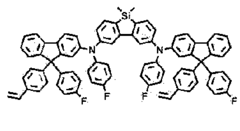
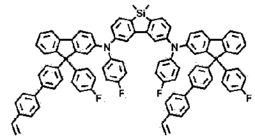

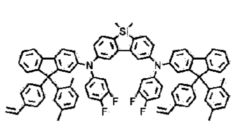
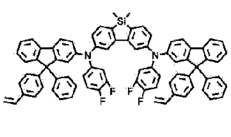
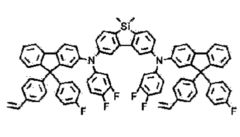
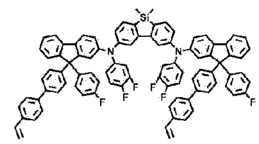

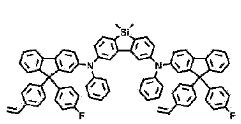
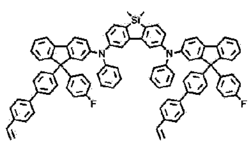
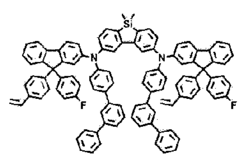
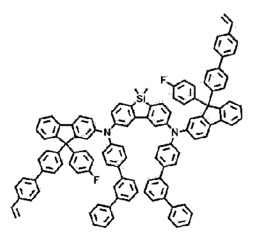

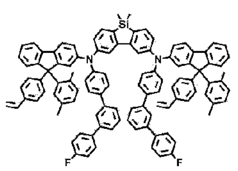
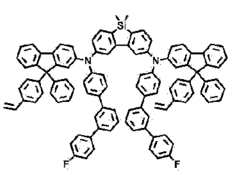
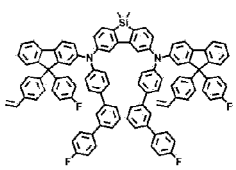
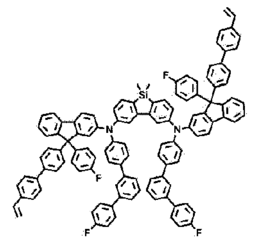

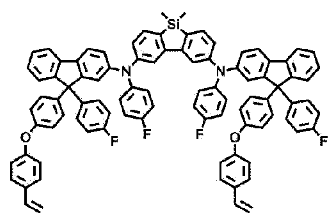

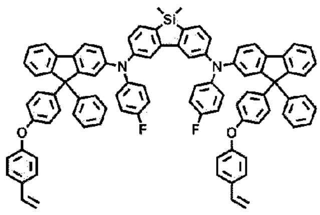

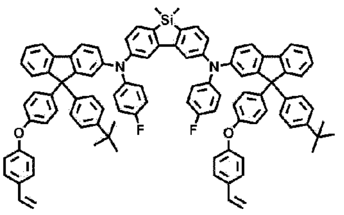

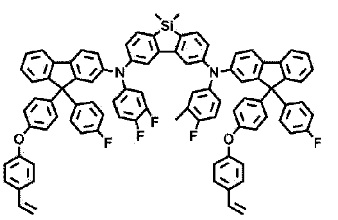

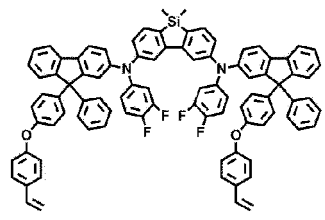

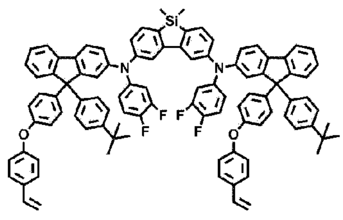

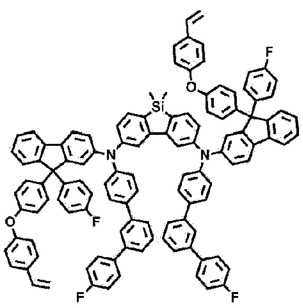

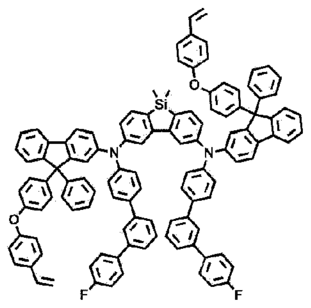

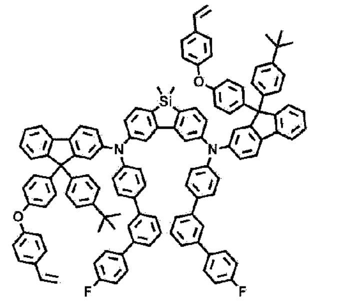

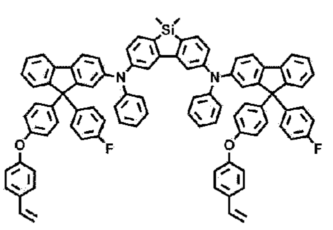

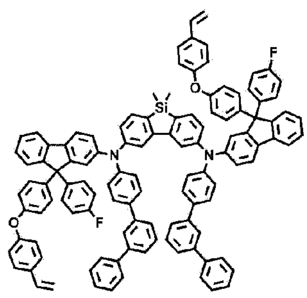

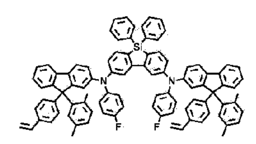

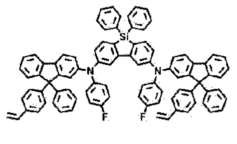

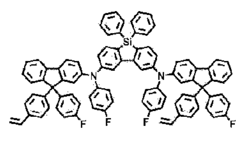

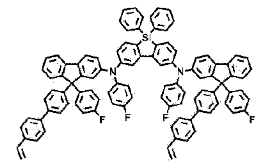

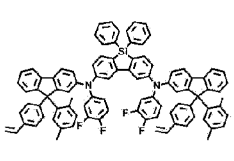

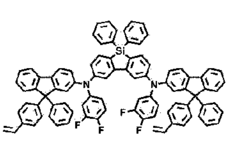

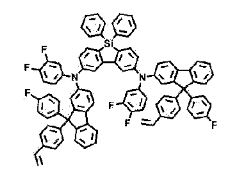

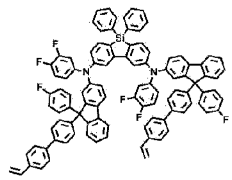

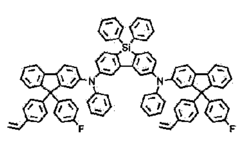

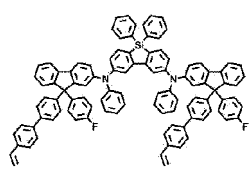

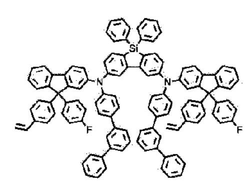

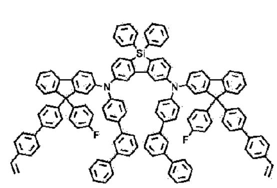

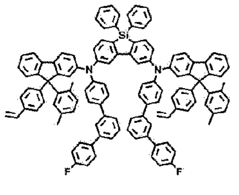
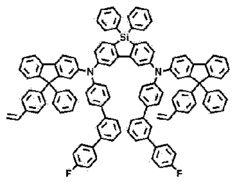
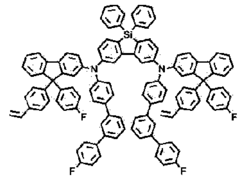
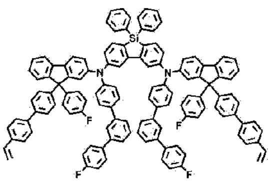

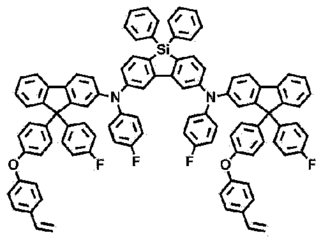
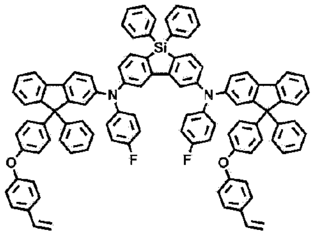
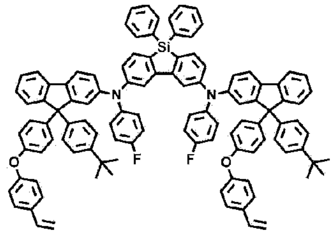

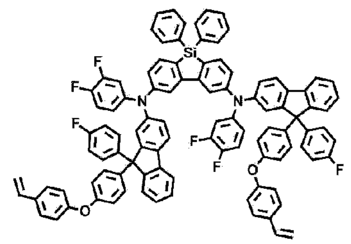
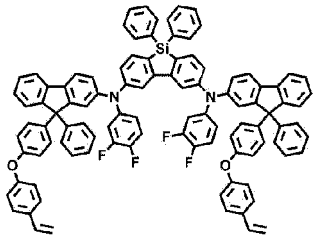
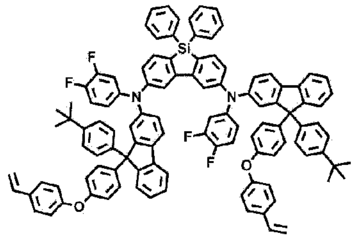

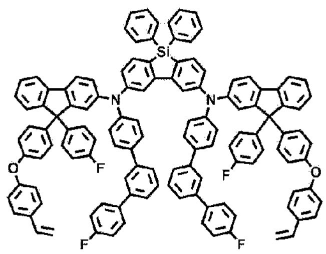
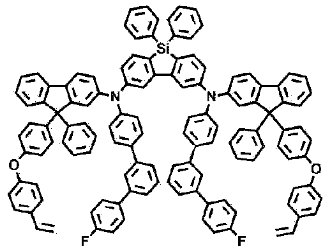
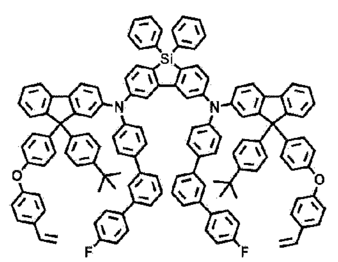

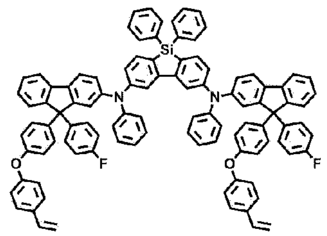
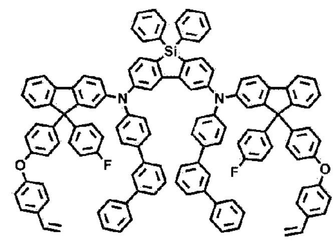

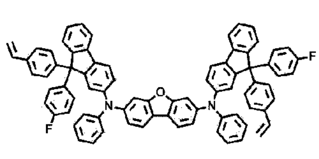
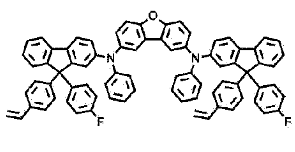
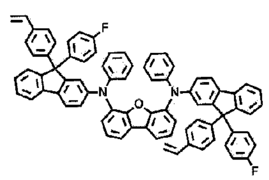

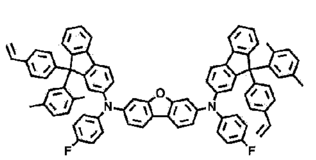
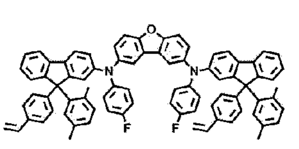
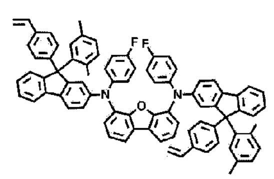

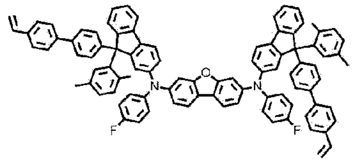
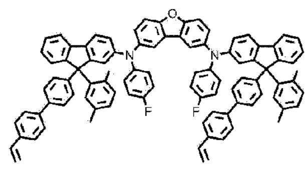
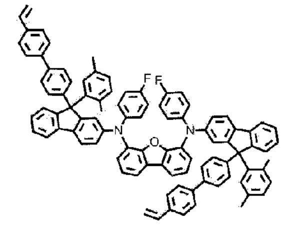
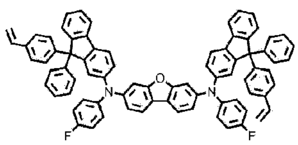
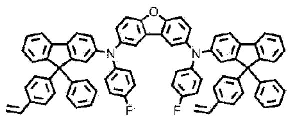
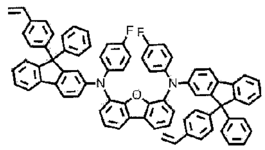
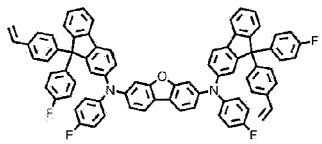
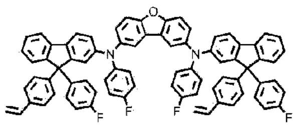
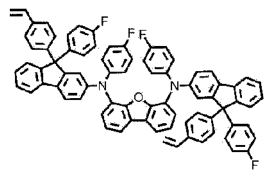
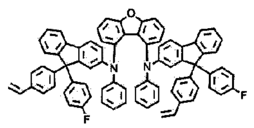
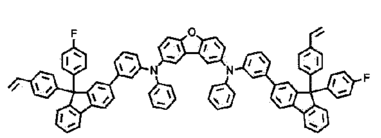
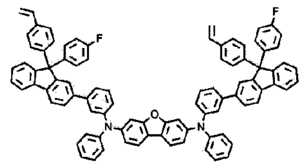
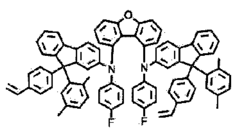
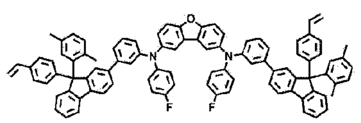
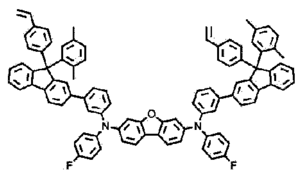
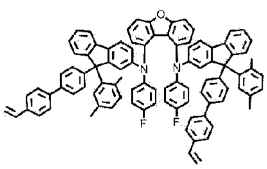
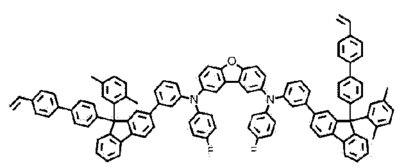
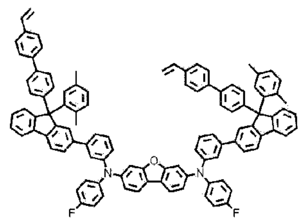
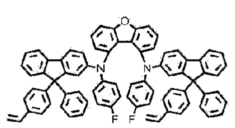
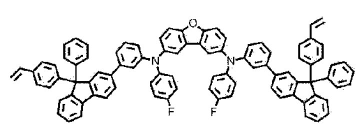
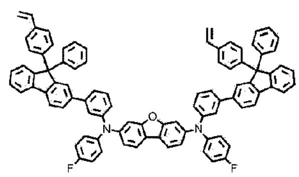
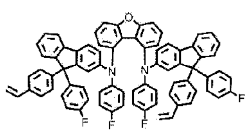
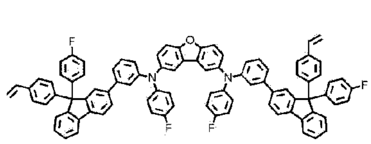
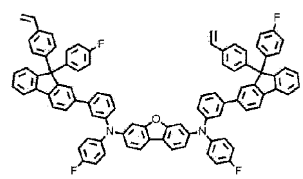

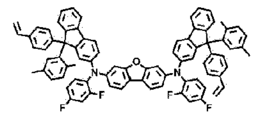 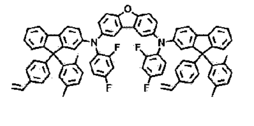 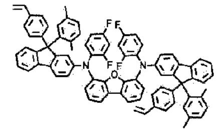 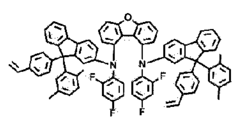

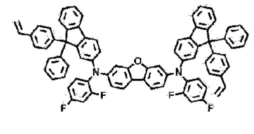 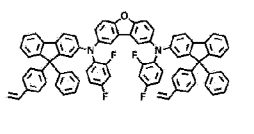 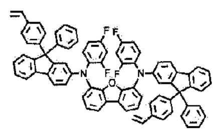 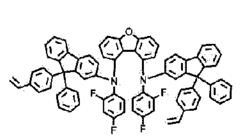

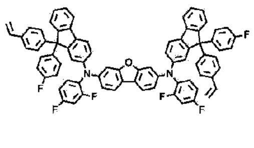 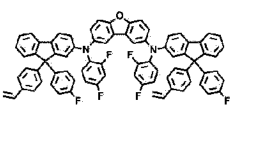 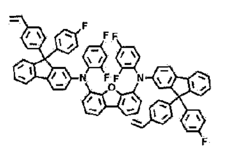 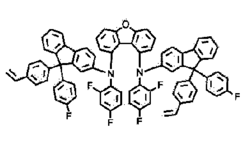

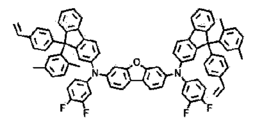 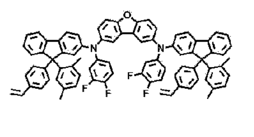 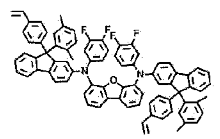 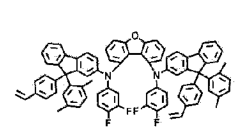

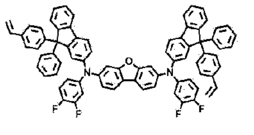 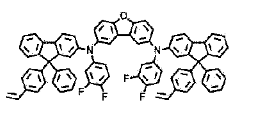 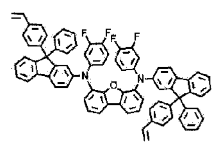 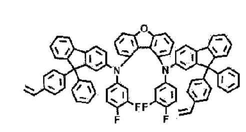

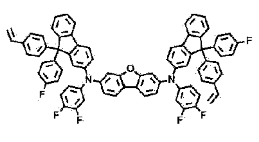 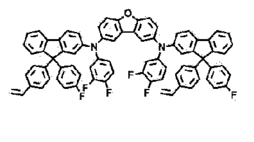 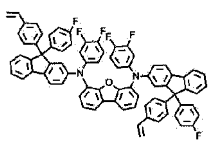 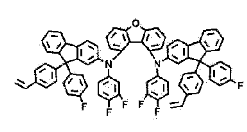

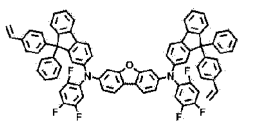 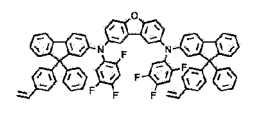 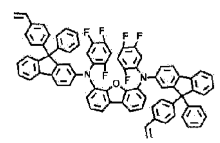 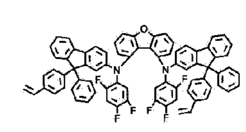

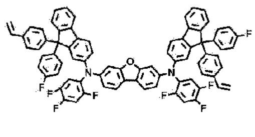 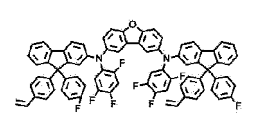 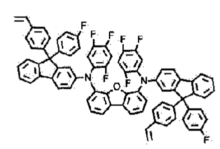 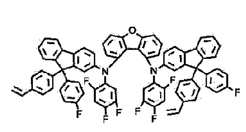

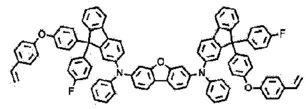
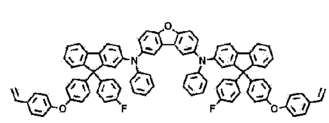
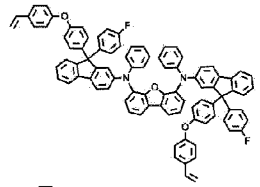

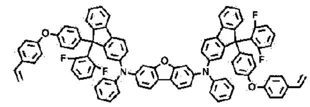
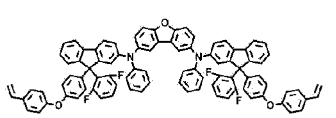
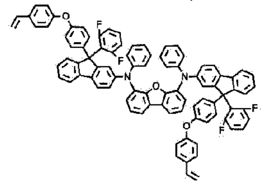

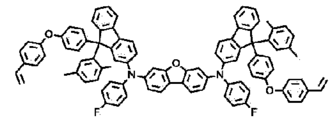
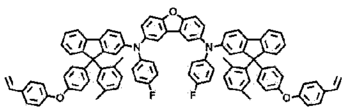
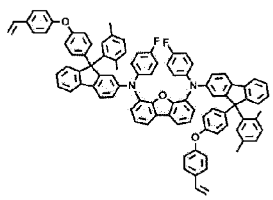

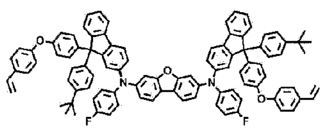
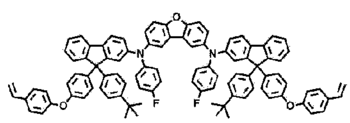
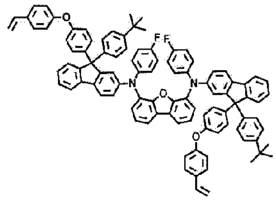

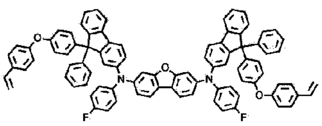
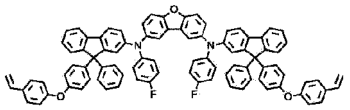
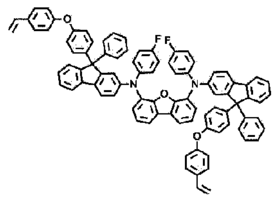

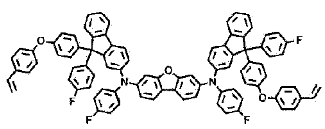
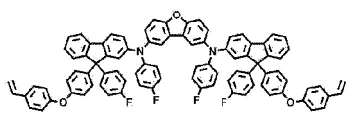
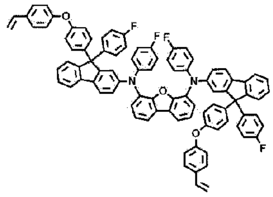

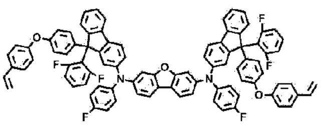
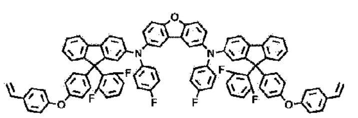
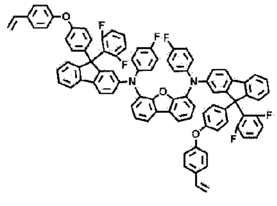

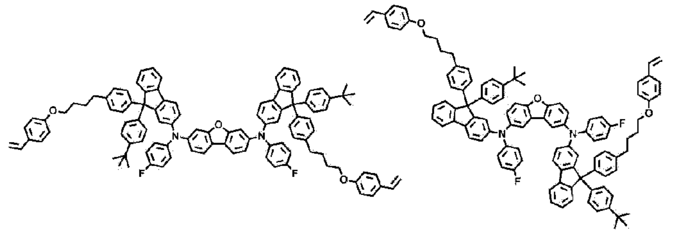

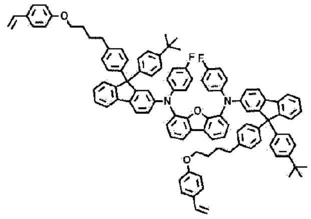

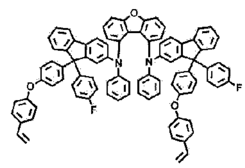

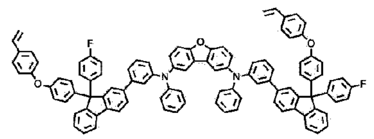

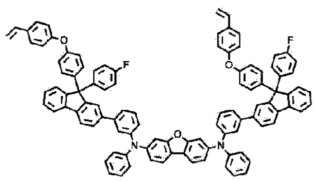

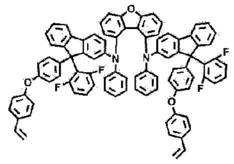

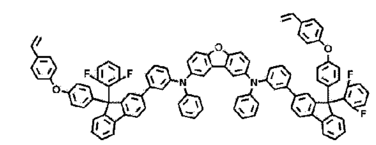

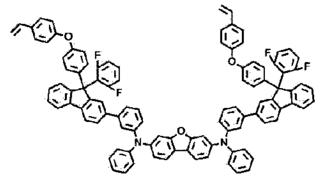

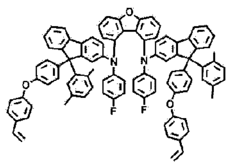

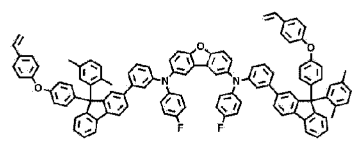

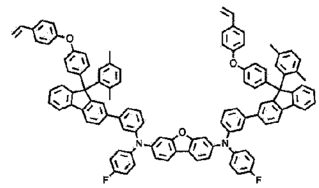

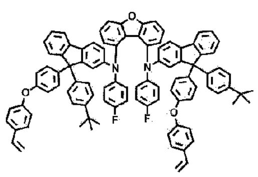

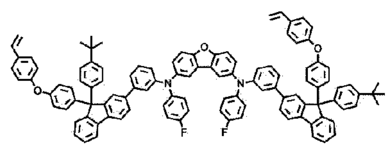

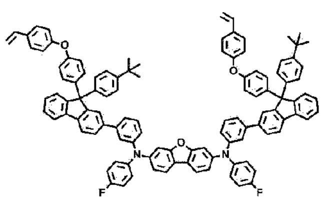

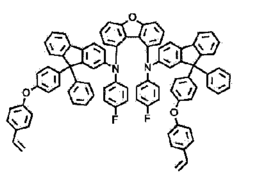

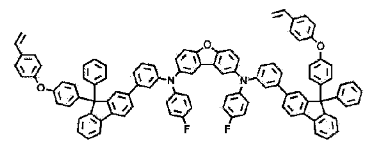

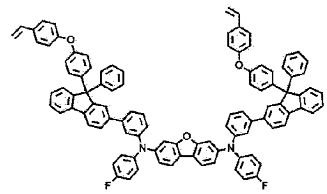

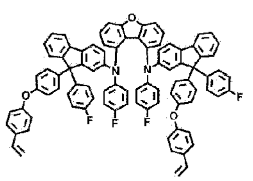

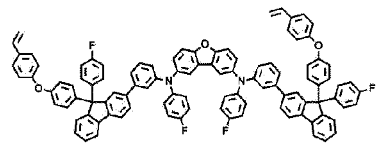

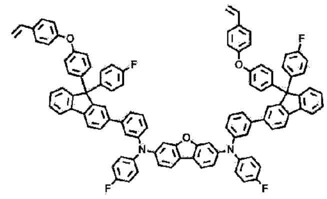

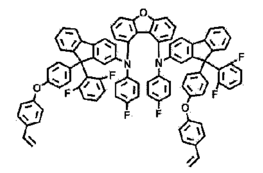
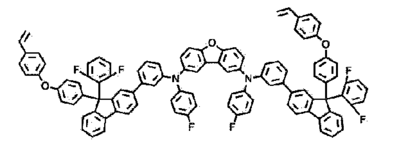
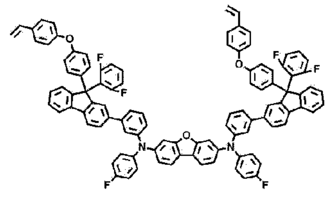

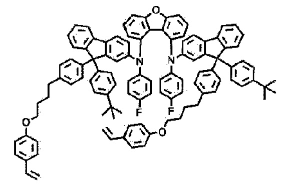
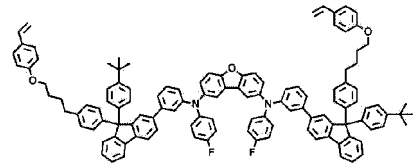
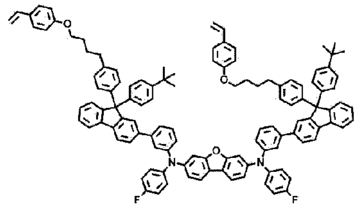

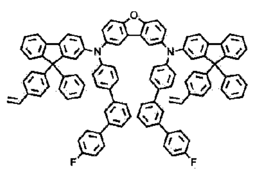
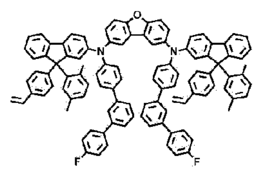
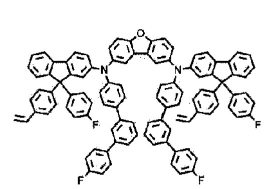

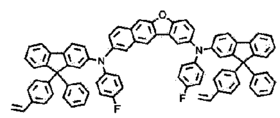
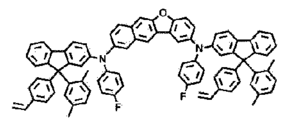
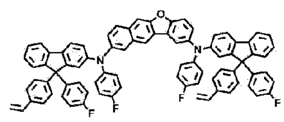

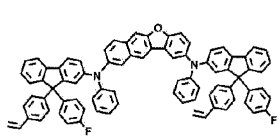
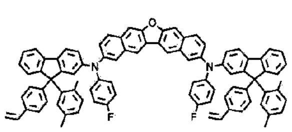
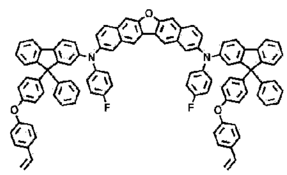

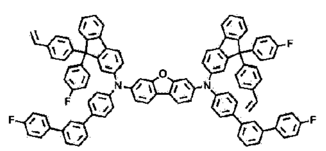
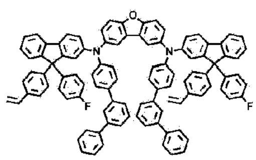
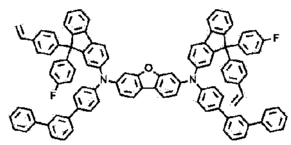

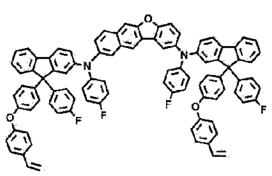
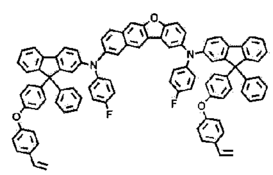
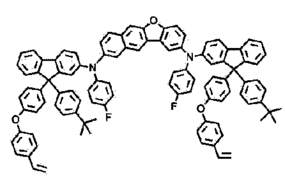

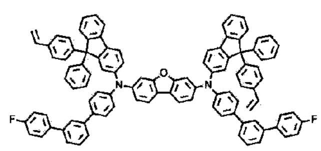
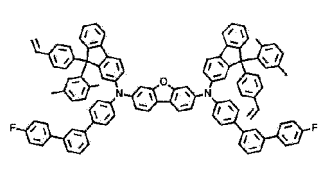
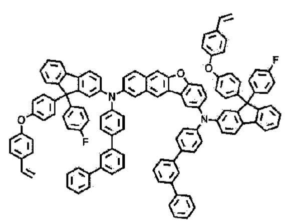

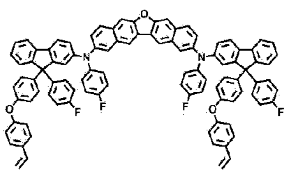
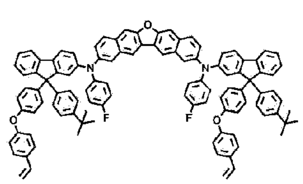
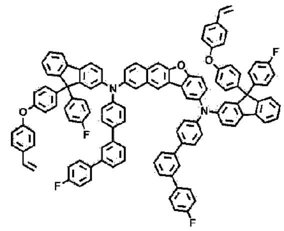

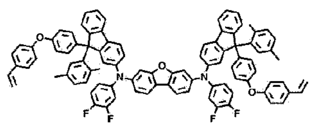
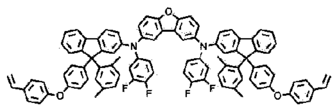
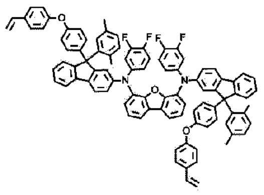

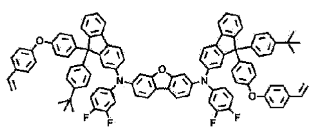
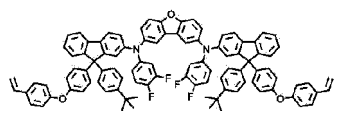
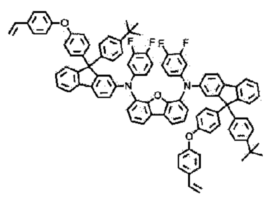

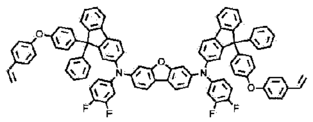
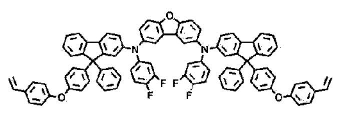
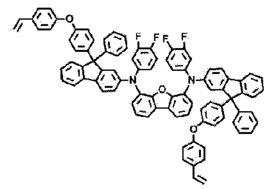

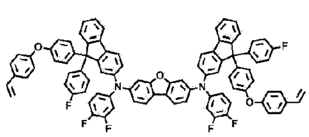
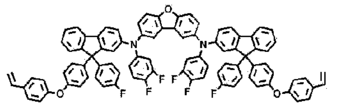
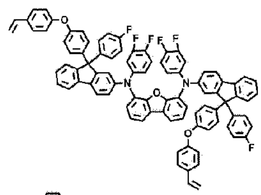

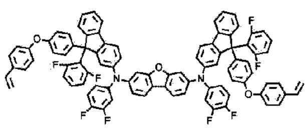
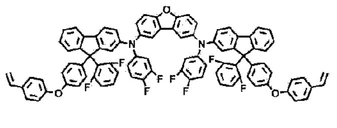
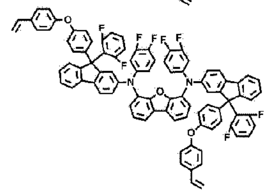

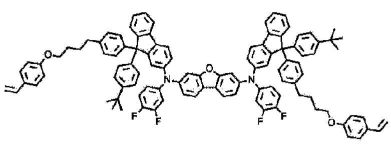
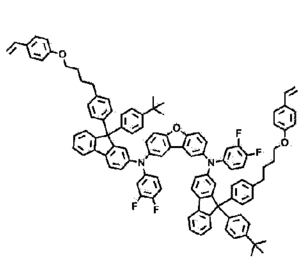
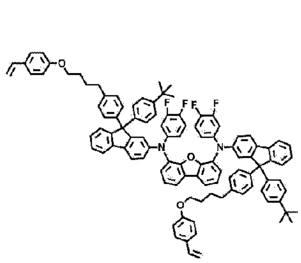

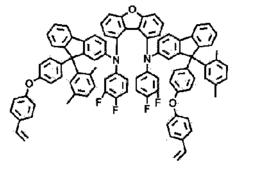
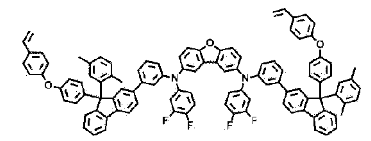
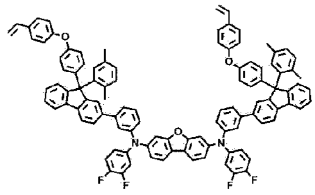

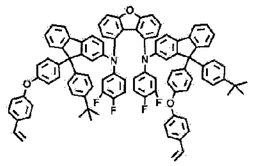
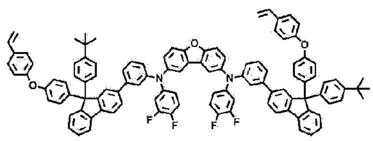
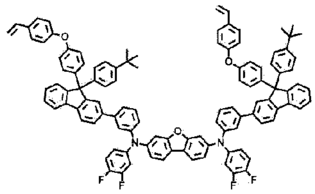

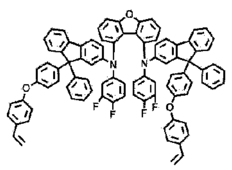
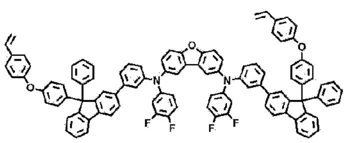
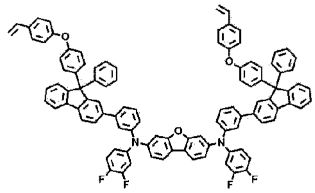

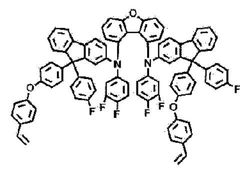
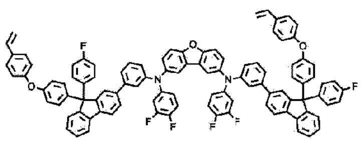
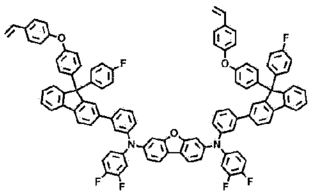

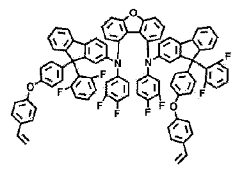
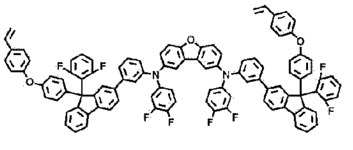
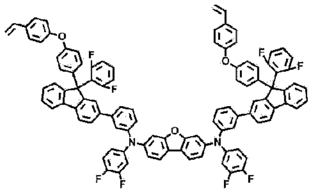

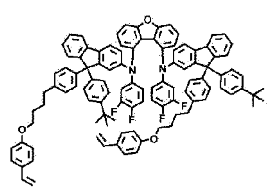
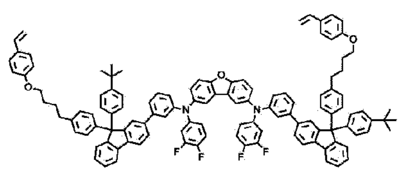
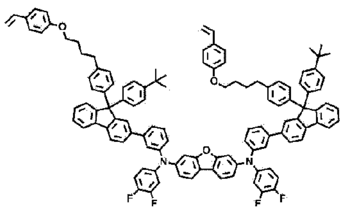

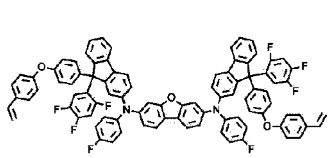
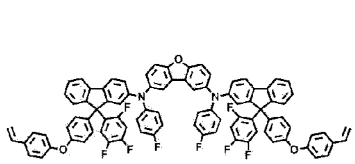
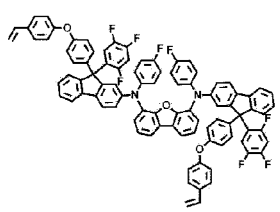

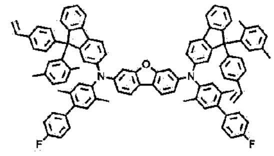

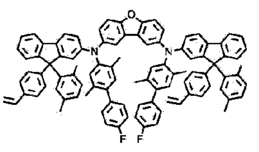

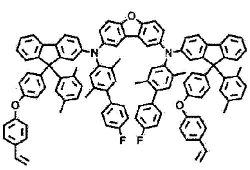

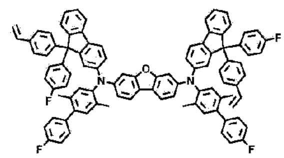

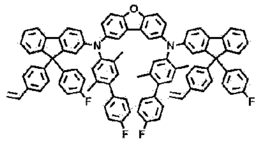

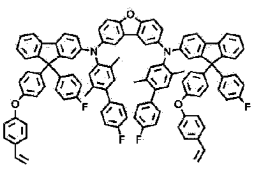

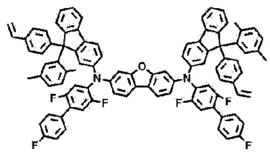

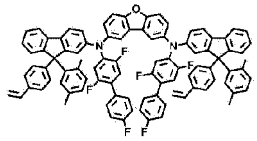

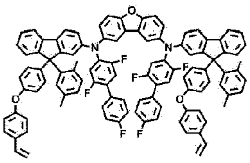

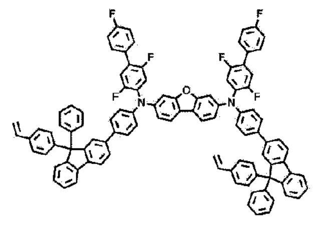

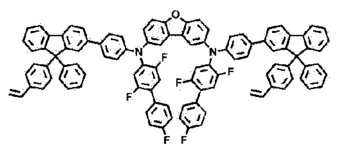

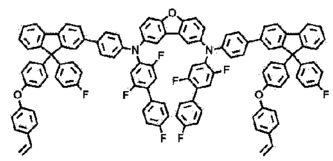

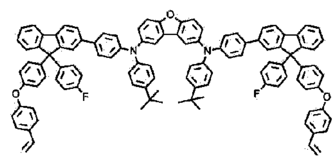

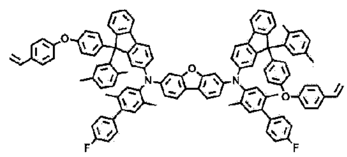

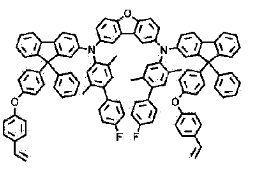

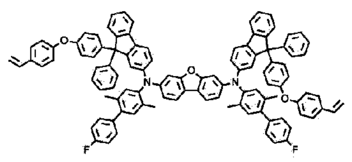

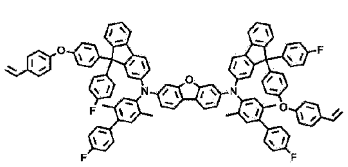

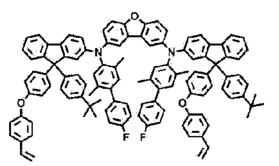

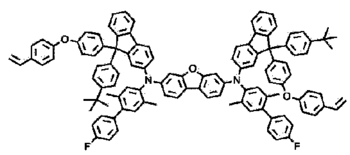

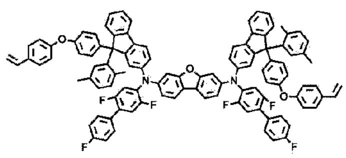

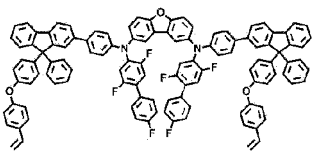

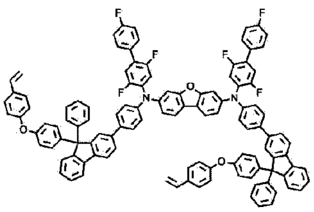

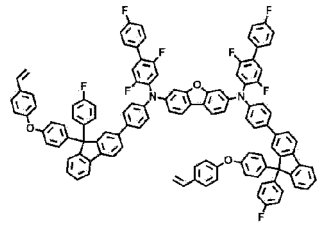
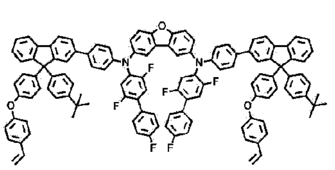
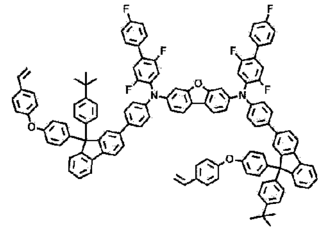
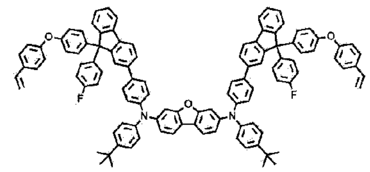
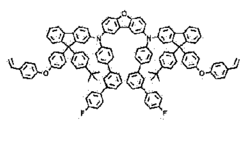
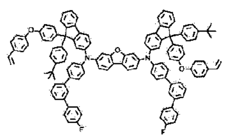
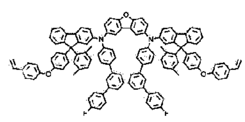
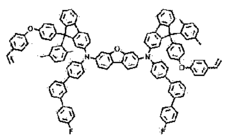
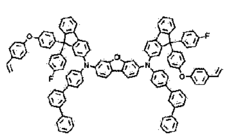
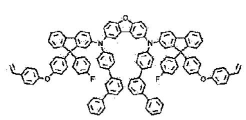
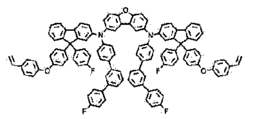
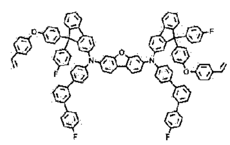
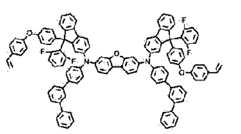
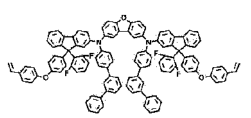
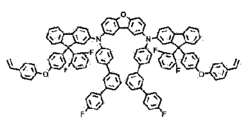
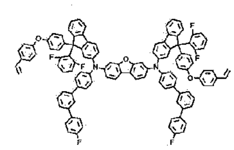
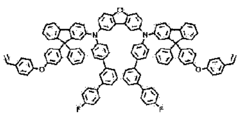
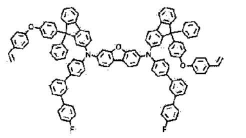
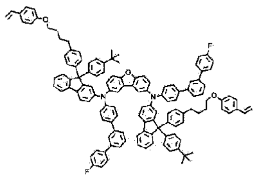
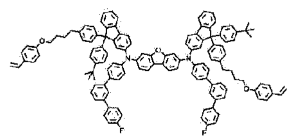
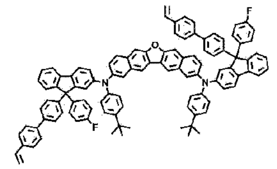
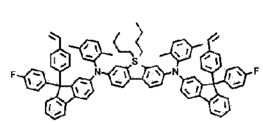
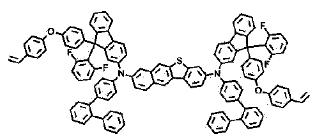
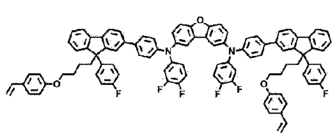
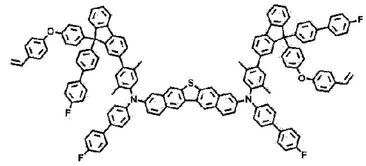
.

6. The ink composition of claim 1, further comprising a second solvent, wherein the second solvent comprises one or more of a solvent represented by any one of the following Chemical Formulae B to D, methoxytoluene and tetralin:

[Chemical Formula B]

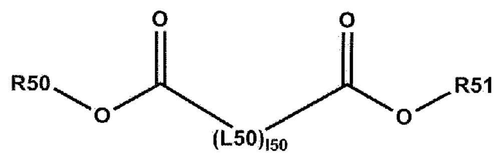

[Chemical Formula C]

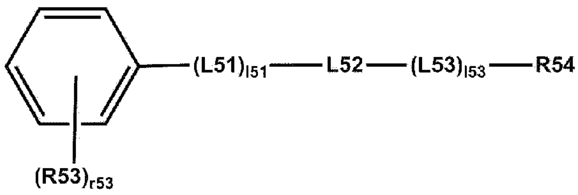

[Chemical Formula D]

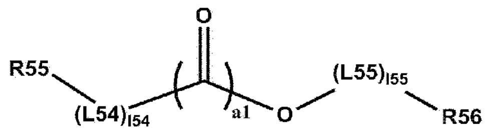

in Chemical Formulae B to D,
L50 is a direct bond; or an alkylene group,
L51 and L53 to L55 are the same as or different from each other, and are each independently a direct bond; -O-; or a substituted or unsubstituted alkylene group,
L52 is -COO-,
R50, R51 and R54 to R56 are the same as or different from each other, and are each independently a substituted or unsubstituted alkyl group,
R53 is hydrogen; deuterium; an alkoxy group; or a substituted or unsubstituted alkyl group,
a1 is 0 or 1,
r53 is an integer from 1 to 5, and when r53 is 2 or higher, two or more R53' s are the same as or different from each other, and
l50, l51 and l53 to l55 are each an integer from 1 to 10, and when l50, l51 and l53 to l55 are each 2 or higher, two or more structures in the parenthesis are the same as or different from each other.

**7.** The ink composition of claim 6, wherein the first solvent has a boiling point of 250°C to 350°C,

the second solvent has a boiling point of 180°C to 280°C, and
the boiling point of the first solvent is higher than the boiling point of the second solvent.

**8.** The ink composition of claim 1, further comprising an ionic compound comprising an anionic group represented by the following Chemical Formula 2:

[Chemical Formula 2]

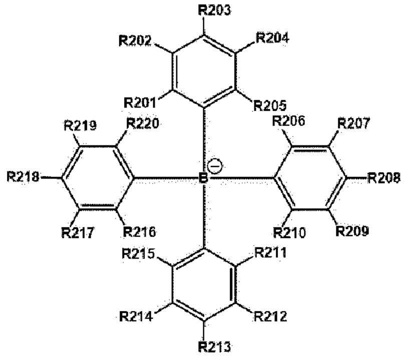

wherein, in Chemical Formula 2,
at least one of R201 to R220 is F; a cyano group; or a substituted or unsubstituted fluoroalkyl group,
at least one of the other R201 to R220 is a curable group,
the other R201 to R220 are the same as or different from each other, and are each independently hydrogen; deuterium; a halogen group; a nitro group; a cyano group; an amino group; -OR221; -SR222; $-SO_3R223$; -COOR224; -OC(O)R225; -C(O)NR226R227; -C(O)R228; a substituted or unsubstituted alkyl group; a substituted or unsubstituted alkenyl group; a substituted or unsubstituted alkynyl group; a substituted or unsubstituted amine group; a substituted or unsubstituted aryl group; or a substituted or unsubstituted heterocyclic group, and
R221 to R228 are the same as or different from each other, and are each independently hydrogen; deuterium; or a substituted or unsubstituted alkyl group.

**9.** The ink composition of claim 8, wherein Chemical Formula 2 is any one of the following structures:

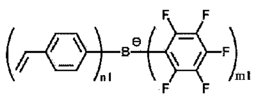 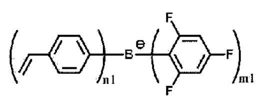 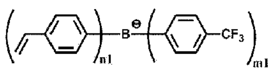

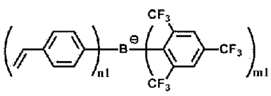 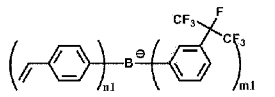 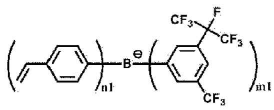

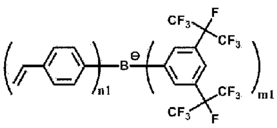 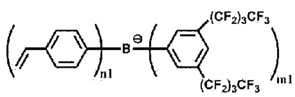 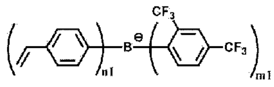

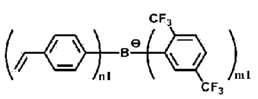 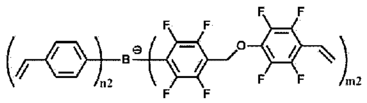

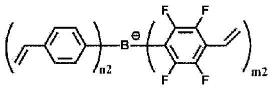 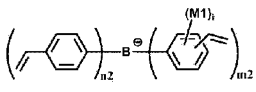 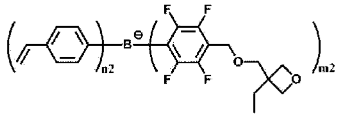

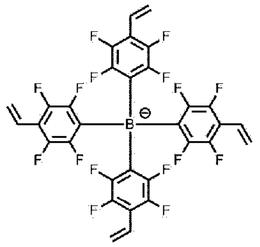

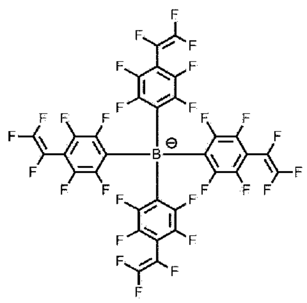

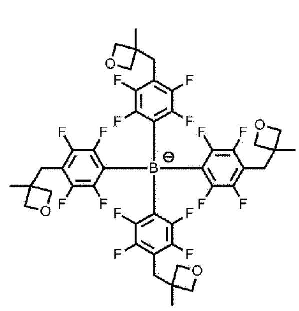

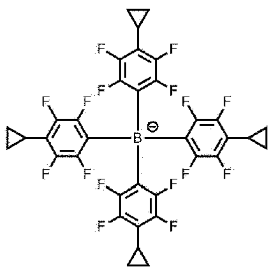

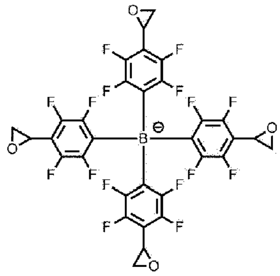

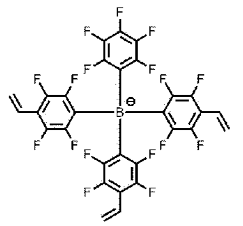

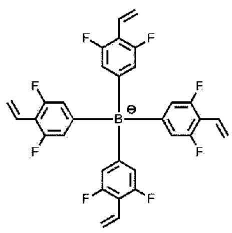

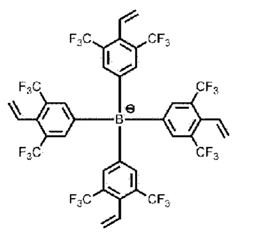

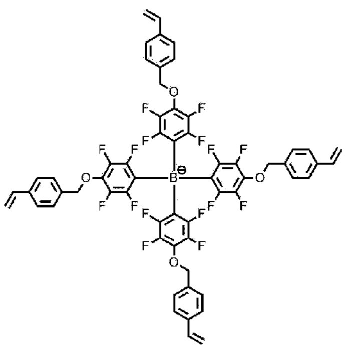

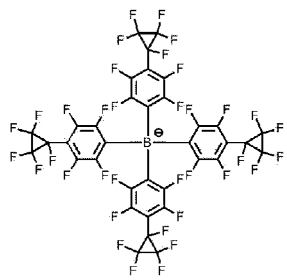

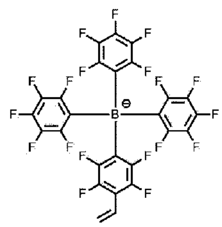

in the structures,

n1 is an integer from 1 to 3, m1 is an integer from 1 to 3, and n1+m1=4,

n2 is an integer from 0 to 3, m2 is an integer from 1 to 4, and n2+m2=4,

M1 is deuterium; a halogen group; a nitro group; a cyano group; an amino group; -OR221; -SR222; $-SO_3R223$; -COOR224; -OC(O)R225; -C(O)NR226R227; -C(O)R228; a substituted or unsubstituted alkyl group; a substituted or unsubstituted alkenyl group; a substituted or unsubstituted alkynyl group; a substituted or unsubstituted amine group; a substituted or unsubstituted aryl group; or a substituted or unsubstituted heterocyclic group,

R221 to R228 are the same as or different from each other, and are each independently hydrogen; deuterium; or a substituted or unsubstituted alkyl group, and

i is an integer from 1 to 4, and when i is 2 or higher, two or more M1's are the same as or different from each other.

**10.** The ink composition of claim 8, wherein the ionic compound further comprises a cationic group, and the cationic group is a monovalent cationic group, an onium compound or any one of the following structures:

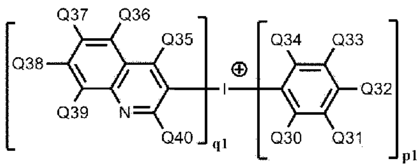
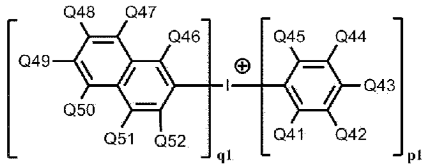

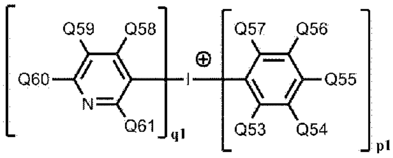
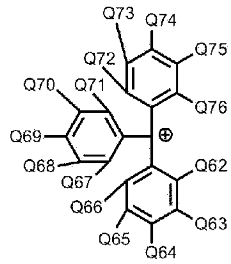
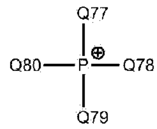

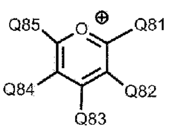
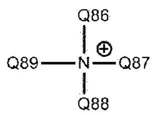
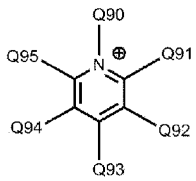
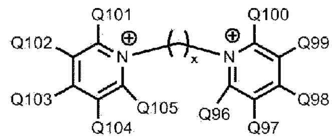

in the structures,
Q30 to Q105 are the same as or different from each other, and are each independently hydrogen; deuterium; a cyano group; a nitro group; a halogen group; a hydroxyl group; -COOR250; a substituted or unsubstituted alkyl group; a substituted or unsubstituted alkoxy group; a substituted or unsubstituted aryloxy group; a substituted or unsubstituted cycloalkyl group; a substituted or unsubstituted aryl group; or a curable group, R250 is hydrogen; deuterium; or a substituted or unsubstituted alkyl group,
x is an integer from 0 to 10, and
p1 is 1 or 2, q1 is 0 or 1 and p1+q1=2.

**11.** The ink composition of claim 8, wherein the ionic compound is any one of the following Chemical Formulae D-1 to D-36:

[Chemical Formula D-1]

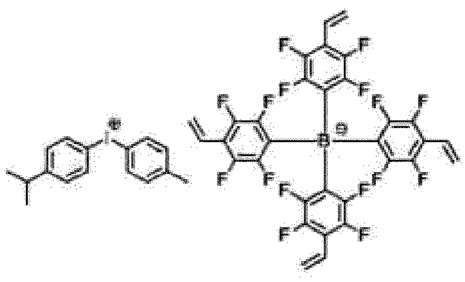

[Chemical Formula D-2]

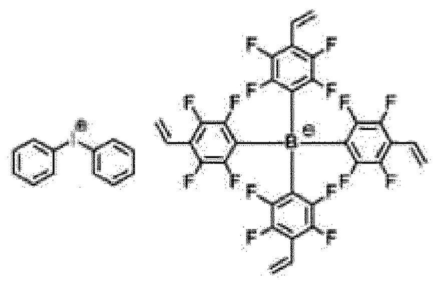

[Chemical Formula D-3]

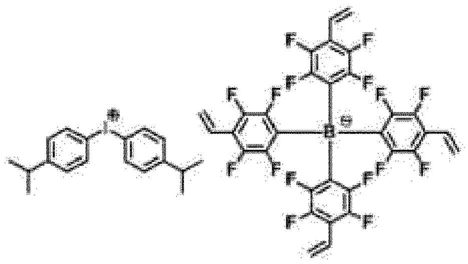

[Chemical Formula D-4]

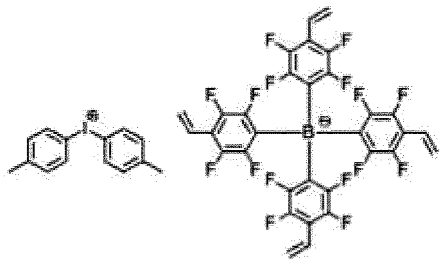

[Chemical Formula D-5]

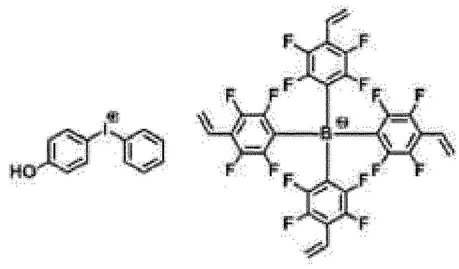

[Chemical Formula D-6]

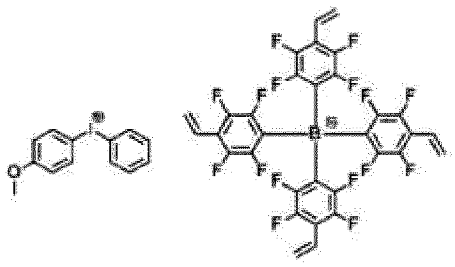

[Chemical Formula D-7]

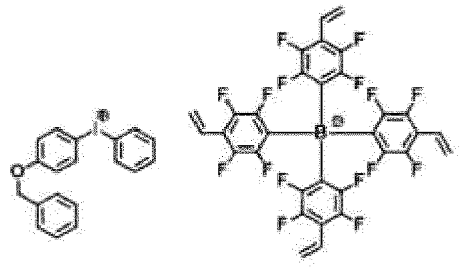

[Chemical Formula D-8]

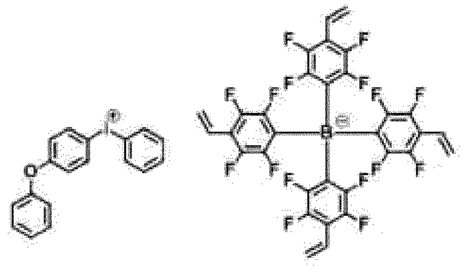

[Chemical Formula D-9]

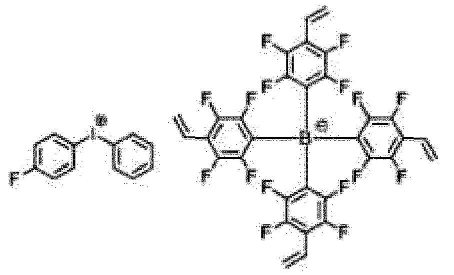

[Chemical Formula D-10]

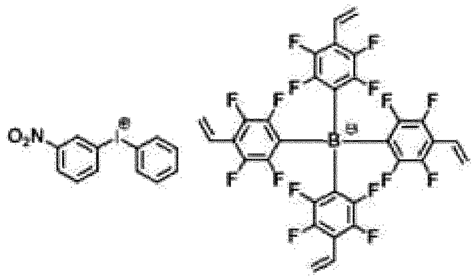

[Chemical Formula D-11]

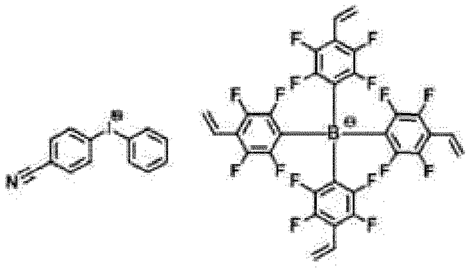

[Chemical Formula D-12]

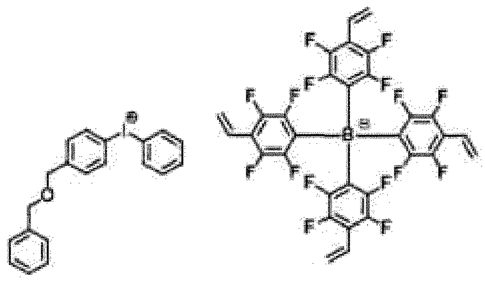

[Chemical Formula D-13]

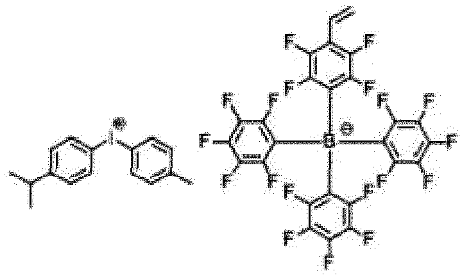

[Chemical Formula D-14]

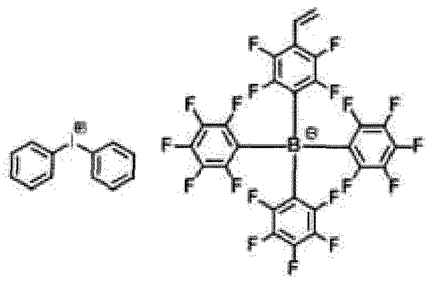

[Chemical Formula D-15]

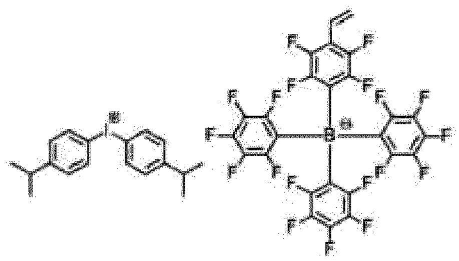

[Chemical Formula D-16]

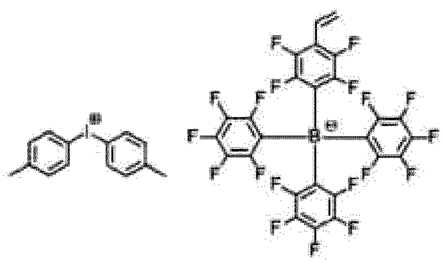

[Chemical Formula D-17]

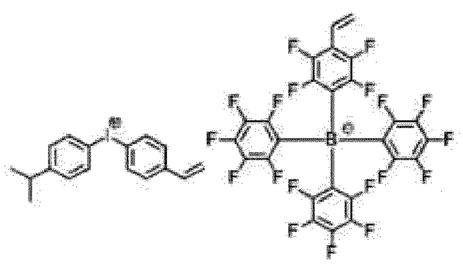

[Chemical Formula D-18]

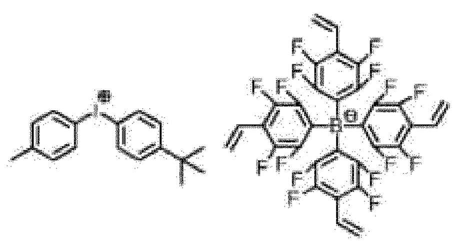

[Chemical Formula D-19]

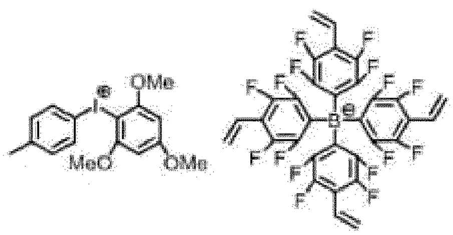

[Chemical Formula D-20]

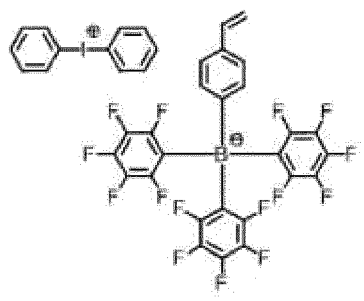

[Chemical Formula D-21]

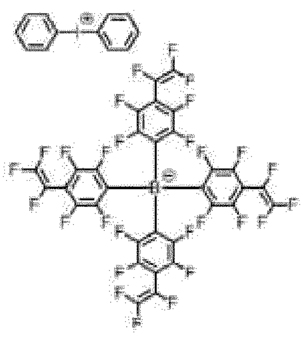

[Chemical Formula D-22]

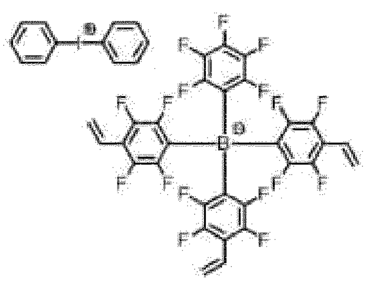

[Chemical Formula D-23]

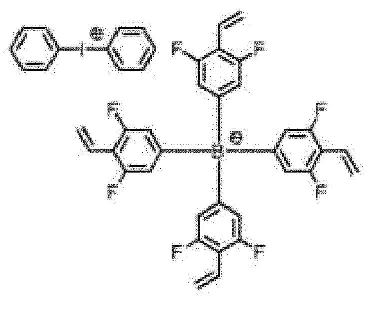

[Chemical Formula D-24]

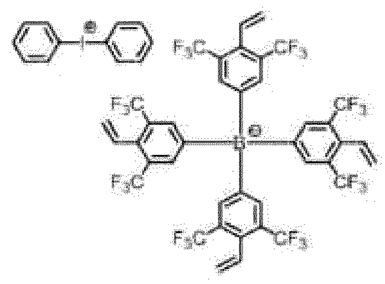

[Chemical Formula D-25]

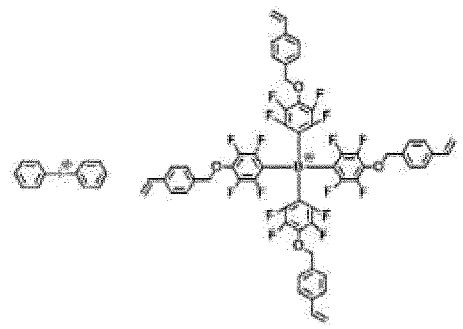

[Chemical Formula D-26]

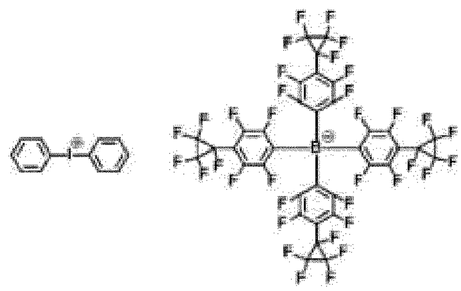

[Chemical Formula D-27]

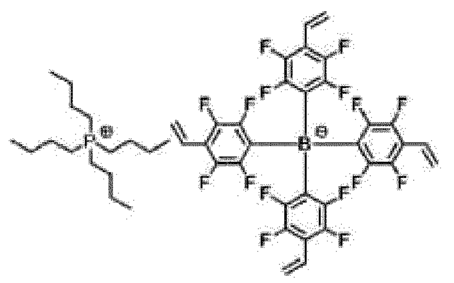

[Chemical Formula D-28]

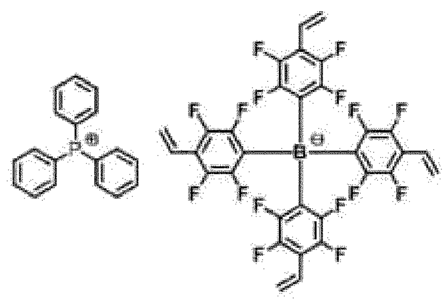

[Chemical Formula D-29]

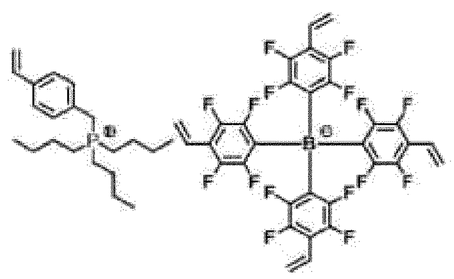

[Chemical Formula D-30]

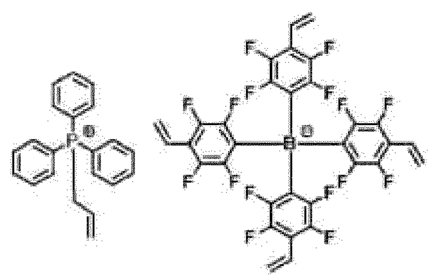

[Chemical Formula D-31]

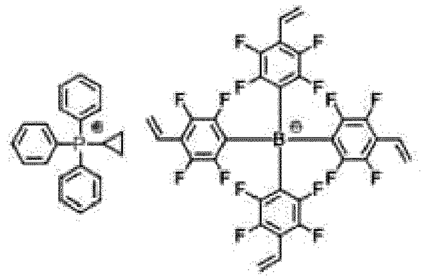

[Chemical Formula D-32]

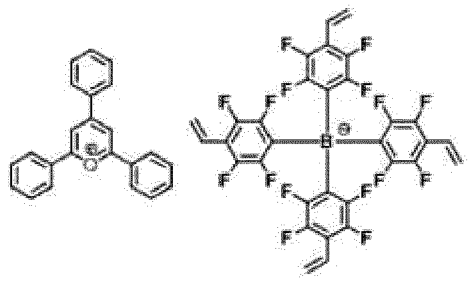

[Chemical Formula D-33]

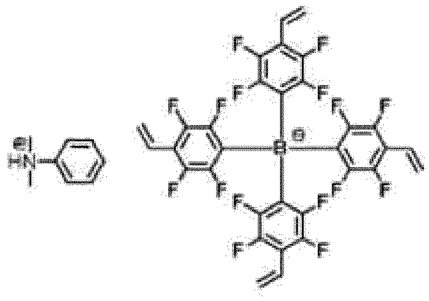

[Chemical Formula D-34]

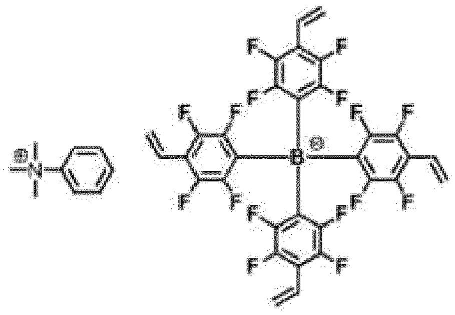

[Chemical Formula D-35]

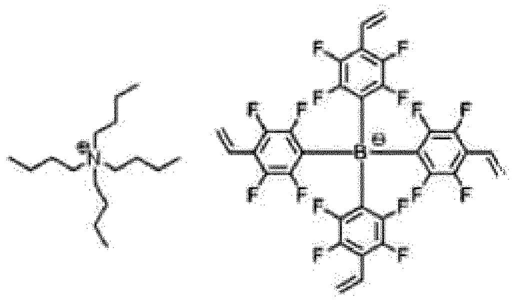

[Chemical Formula D-36]

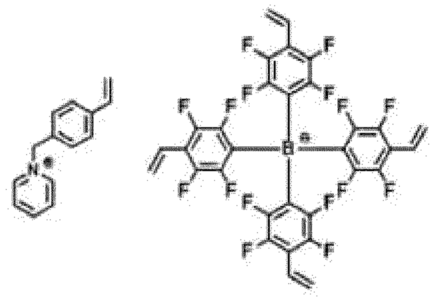

**12.** A pixel comprising the ink composition of any one of claims 1 to 11 or a cured product thereof.

**13.** An organic material layer comprising the pixel of claim 12.

**14.** An organic light emitting device comprising: a first electrode;

a second electrode; and
an organic material layer having one or more layers provided between the first electrode and the second electrode,
wherein one or more layers of the organic material layer are the organic material layer of claim 13.

**15.** The organic light emitting device of claim 14, wherein the organic material layer comprises one or more layers selected from the group consisting of a hole injection layer, a hole transport layer, a hole injection and transport layer, and an electron blocking layer, and
the one or more layers selected from the group consisting of the hole injection layer, the hole transport layer, the hole injection and transport layer, and the electron blocking layer comprise the ink composition or a cured product thereof.

## Patentansprüche

1. Tintenzusammensetzung, umfassend eine durch die folgende chemische Formel 1 dargestellte Verbindung und ein erstes Lösungsmittel, dargestellt durch die folgende chemische Formel A:

[Chemische Formel 1]

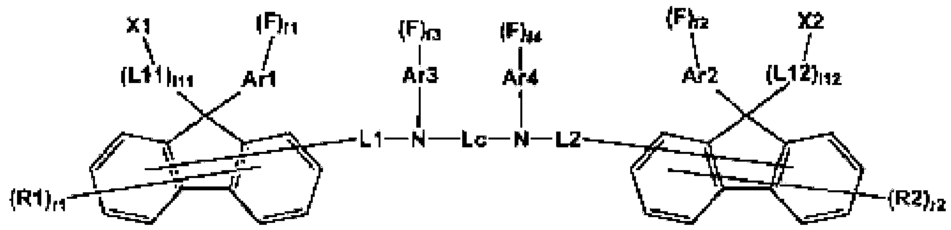

[Chemische Formel A]

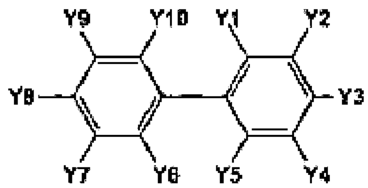

worin in den chemischen Formeln 1 und A
Y1 bis Y10 gleich oder voneinander verschieden sind und jeweils unabhängig Wasserstoff; Deuterium; eine Hydroxylgruppe; eine Ethergruppe; eine Carbonylgruppe; eine Estergruppe, eine substituierte oder unsubstituierte Alkylgruppe; eine substituierte oder unsubstituierte Cycloalkylgruppe; eine substituierte oder unsubstituierte Cycloalkenylgruppe; eine substituierte oder unsubstituierte Alkoxygruppe; eine substituierte oder unsubstituierte Arylgruppe oder eine substituierte oder unsubstituierte Amingruppe sind,
Lc eine substituierte oder unsubstituierte Heteroarylengruppe, umfassend O, S oder Si, ist,
L1 und L2 gleich oder voneinander verschieden sind und jeweils unabhängig eine direkte Bindung; oder eine substituierte oder unsubstituierte Arylengruppe sind,
L11 und L12 gleich oder voneinander verschieden sind und jeweils unabhängig eine direkte Bindung; -O-; eine substituierte oder unsubstituierte Alkylengruppe; oder eine substituierte oder unsubstituierte Arylengruppe sind,
Ar1 bis Ar4 gleich oder voneinander verschieden sind und jeweils unabhängig eine substituierte oder unsubstituierte Arylgruppe; oder eine substituierte oder unsubstituierte Heteroarylgruppe sind,
R1 und R2 gleich oder voneinander verschieden sind und jeweils unabhängig Wasserstoff; Deuterium; eine Halogengruppe; oder eine substituierte oder unsubstituierte Alkylgruppe sind,
X1 und X2 gleich oder voneinander verschieden sind und jeweils unabhängig eine härtbare Gruppe sind,
r1 und r2 jeweils eine ganze Zahl von 0 bis 7 sind, und wenn r1 und r2 jeweils 2 oder größer sind, zwei oder mehr der Substituenten in den Klammern gleich oder voneinander verschieden sind,
111 und 112 jeweils eine ganze Zahl von 1 bis 3 sind, und wenn 111 und 112 jeweils 2 oder größer sind, zwei oder mehr Substituenten in den Klammern gleich oder voneinander verschieden sind,
f1 0 bis zur maximalen bindbaren Anzahl von Substituenten, die an Ar1 gebunden sein können, ist,
f2 0 bis zur maximal bindbaren Anzahl von Substituenten, die an Ar2 gebunden sein können, ist,
f3 0 bis zur maximal bindbaren Anzahl von Substituenten, die an Ar3 gebunden sein können, ist und
f4 0 bis zur maximal bindbaren Anzahl von Substituenten, die an Ar4 gebunden sein können, ist.

2. Tintenzusammensetzung gemäß Anspruch 1, worin die härtbare Gruppe irgendeine der folgenden Strukturen ist:

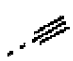 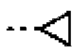 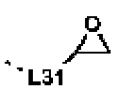 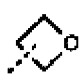 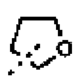 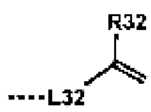 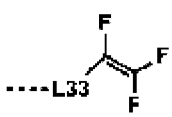

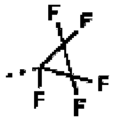 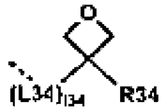 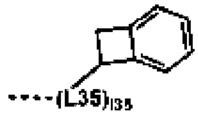 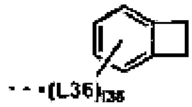 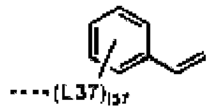

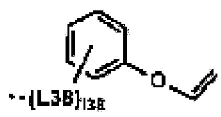 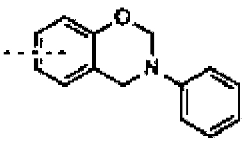 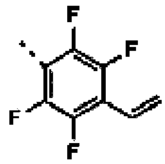 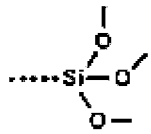

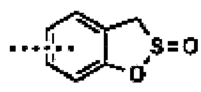 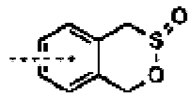

worin in den Strukturen
R32 und R34 gleich oder voneinander verschieden sind und jeweils unabhängig Wasserstoff; Deuterium; oder eine substituierte oder unsubstituierte Alkylgruppe sind,
L31 bis L38 gleich oder voneinander verschieden sind und jeweils unabhängig eine direkte Bindung; -O-; eine substituierte oder unsubstituierte Alkylengruppe; oder substituierte oder unsubstituierte Arylengruppe sind,
134 bis 138 jeweils eine ganze Zahl von 1 bis 10 sind, und wenn 134 bis 138 jeweils 2 oder größer sind, zwei oder mehr Substituenten in den Klammern gleich oder voneinander verschieden sind, und
------ ein an die chemische Formel 1 gebundener Rest ist.

**3.** Tintenzusammensetzung gemäß Anspruch 1, worin die chemische Formel 1 durch die folgende chemische Formel 1-1 dargestellt ist:

[Chemische Formel 1-1]

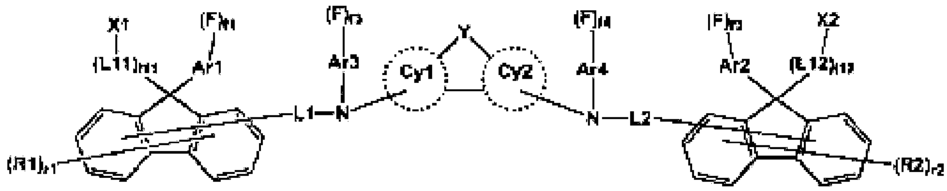

worin in der chemischen Formel 1-1
Cy1 und Cy2 gleich oder voneinander verschieden sind und jeweils unabhängig ein substituierter oder unsubstituierter aromatischer Ring mit 6 bis 20 Kohlenstoffatomen sind,
Y 0, S oder SiRy1Ry2 ist,
Ry1 und Ry2 gleich oder voneinander verschieden sind und jeweils unabhängig Wasserstoff; Deuterium; eine substituierte oder unsubstituierte Alkylgruppe; oder eine substituierte oder unsubstituierte Arylgruppe sind und L1, L2, L11, L12, Ar1 bis Ar4, R1, R2, X1, X2, r1, r2, 111, 112 und f1 bis f4 die gleichen sind wie diejenigen, die in der chemischen Formel 1 definiert sind.

**4.** Tintenzusammensetzung gemäß Anspruch 1, worin das durch die chemische Formel A dargestellte Lösungsmittel irgendeine der folgenden Strukturen aufweist:

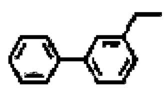 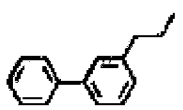 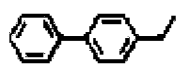

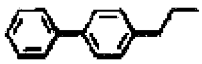 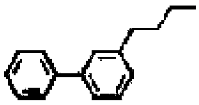 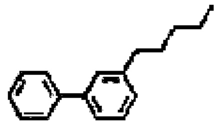 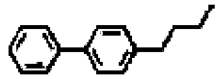

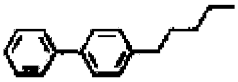 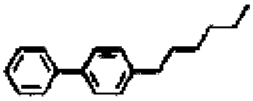 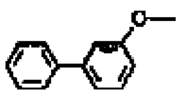 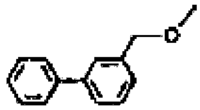

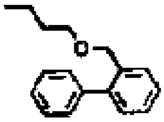 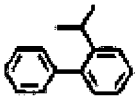 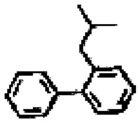 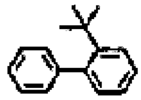

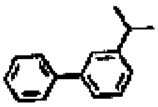 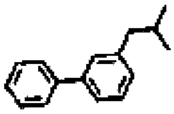 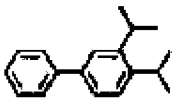 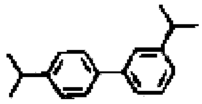

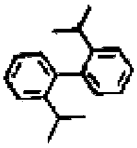 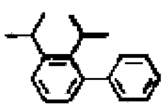 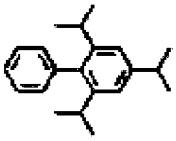 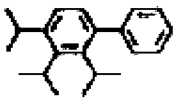

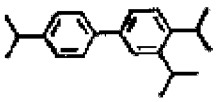 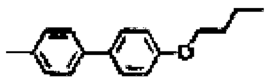

**5.** Tintenzusammensetzung gemäß Anspruch 1, worin die durch die chemische Formel 1 dargestellte Verbindung irgendeine der folgenden Strukturen aufweist:

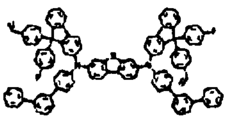 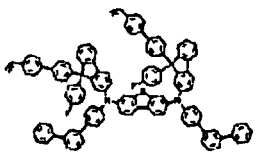 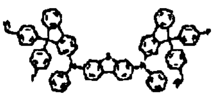 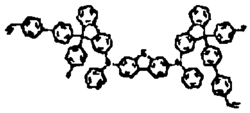

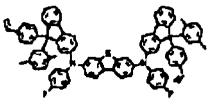 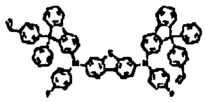 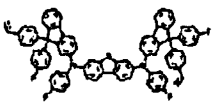 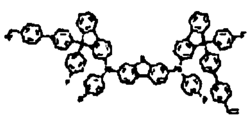

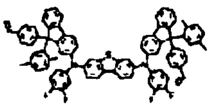 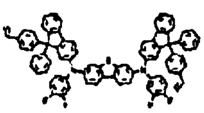 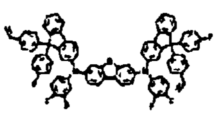 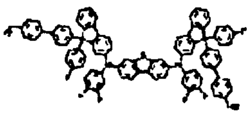

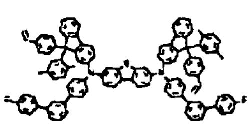 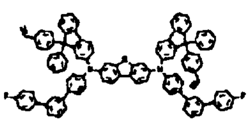 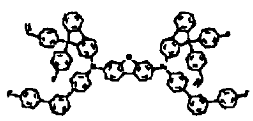 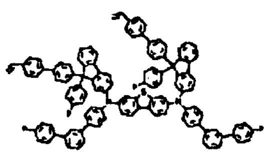

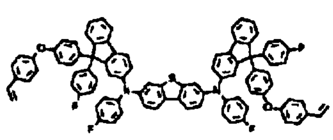
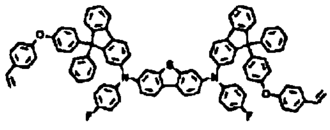
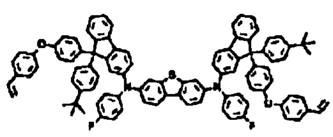

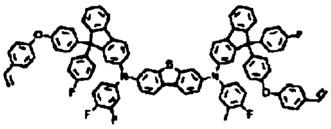
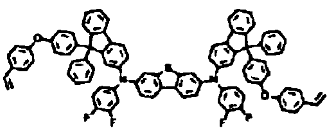
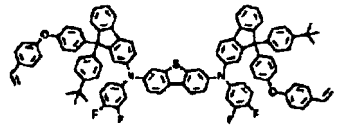

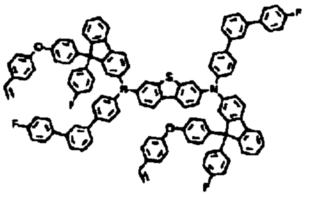
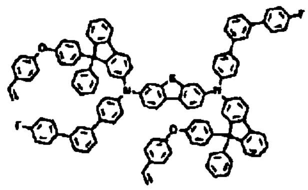
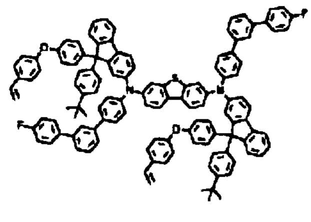

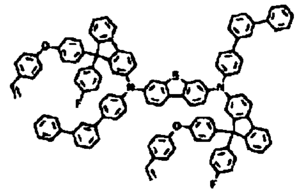
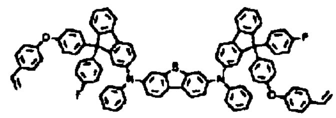

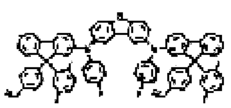
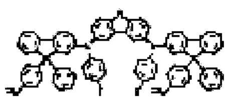
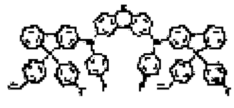
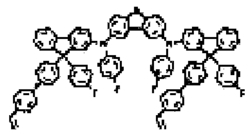

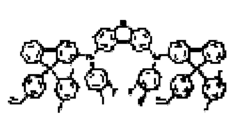
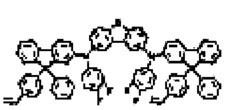
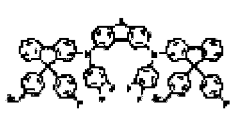
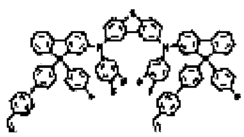

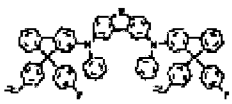
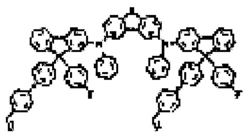
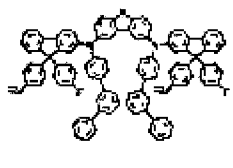
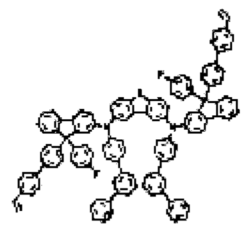

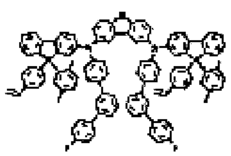
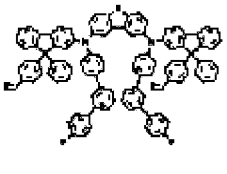
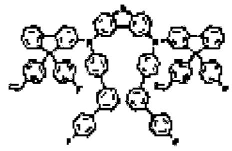
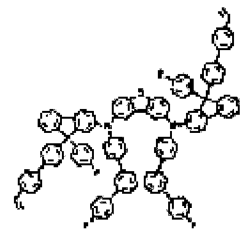

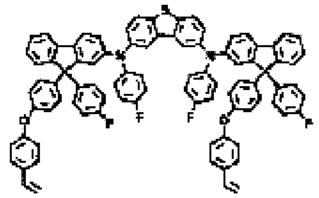
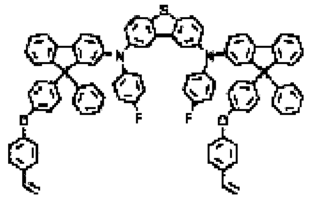
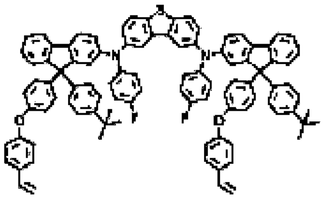

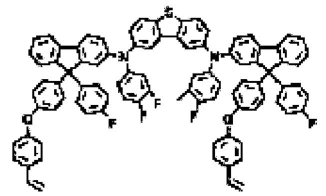
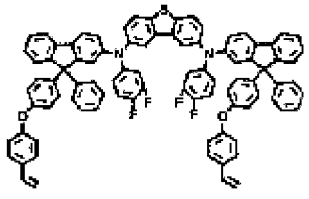
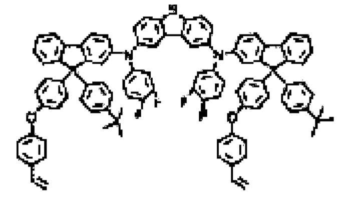

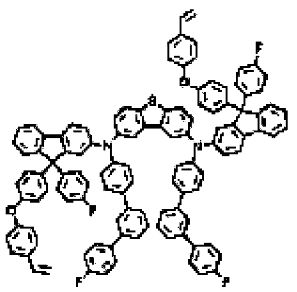
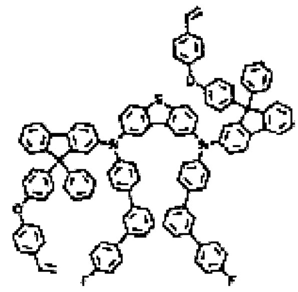
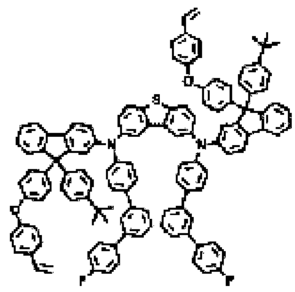

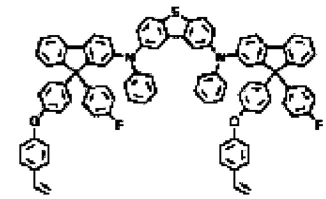
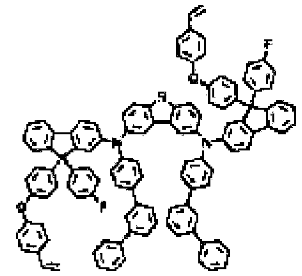

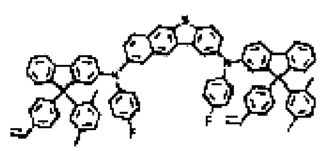
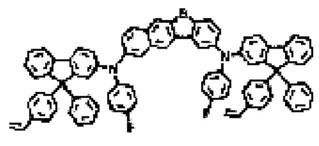
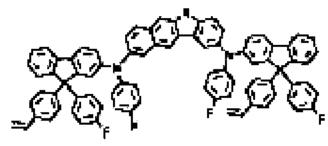

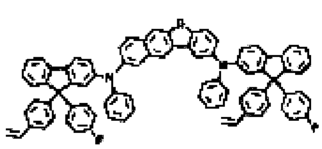
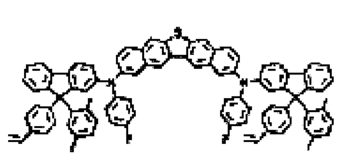
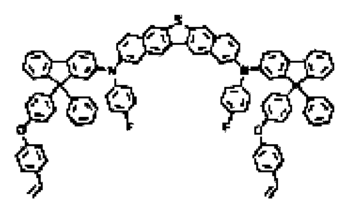

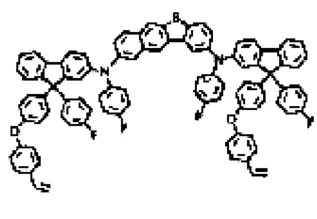
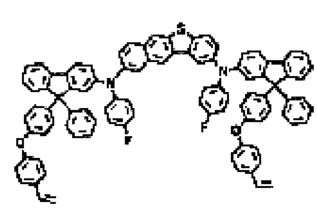
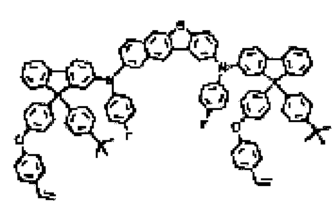

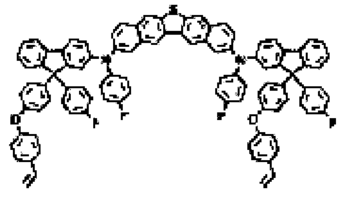
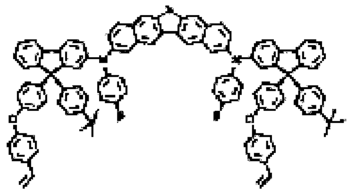
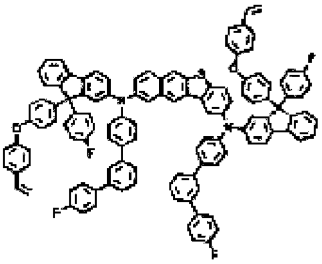

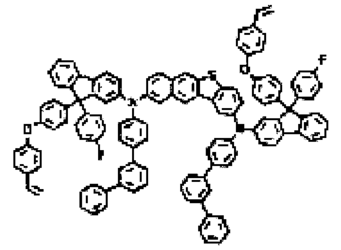

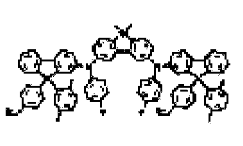
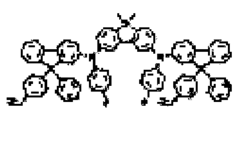
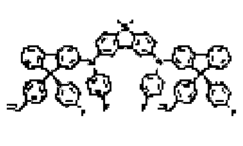
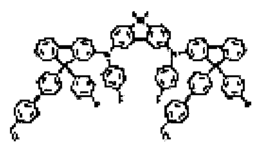

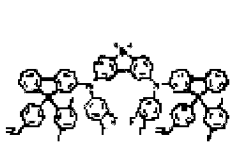
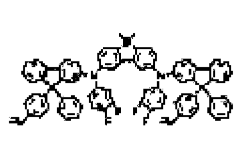
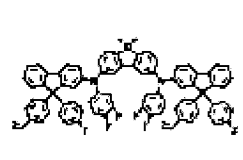
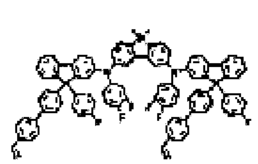

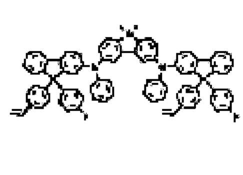
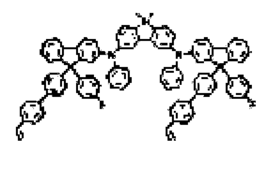
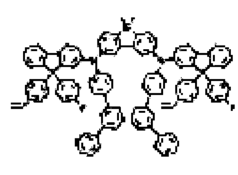
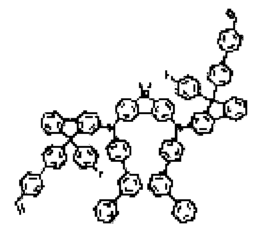

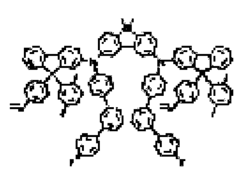
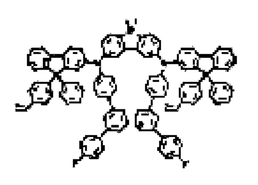
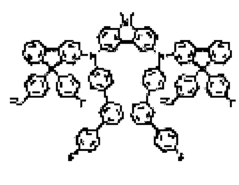
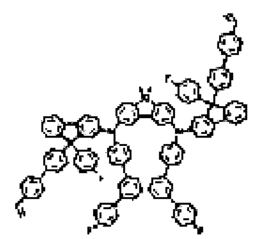

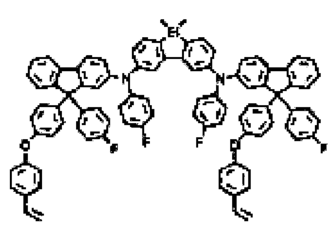
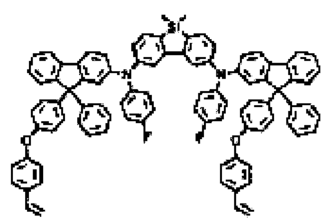
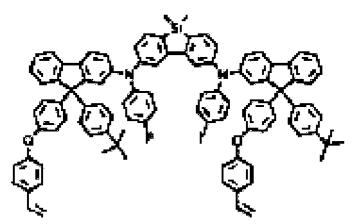

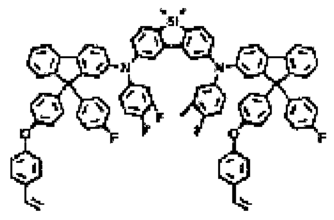
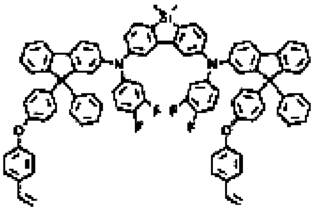
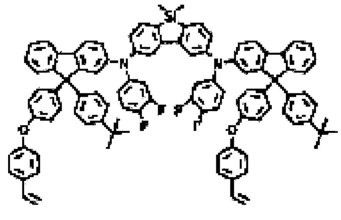
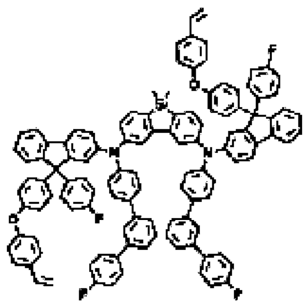
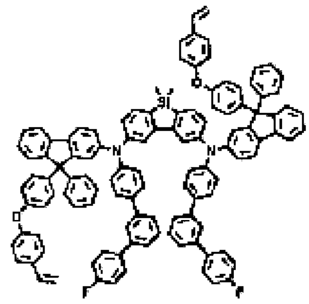
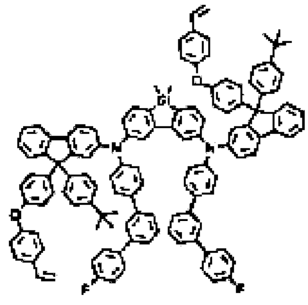
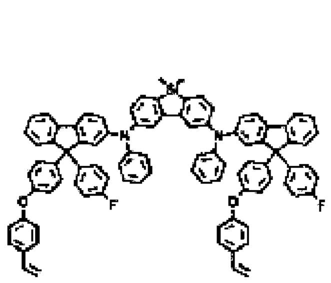
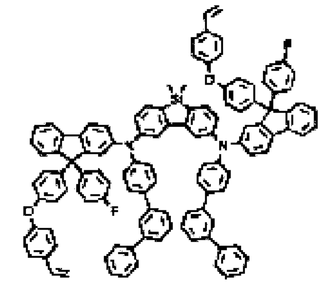
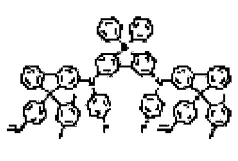
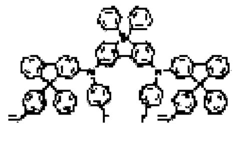
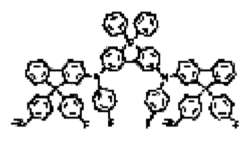
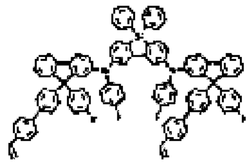
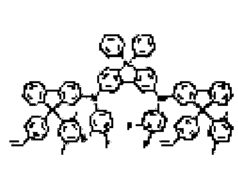
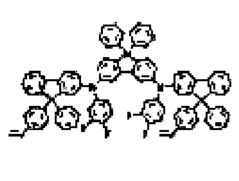
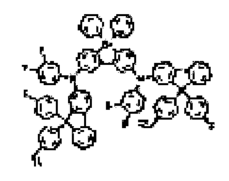
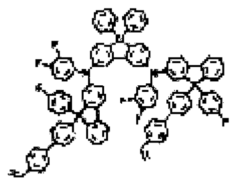
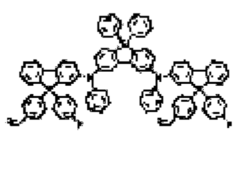
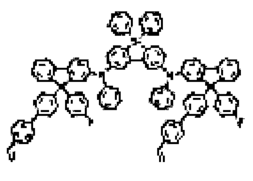
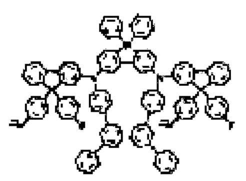
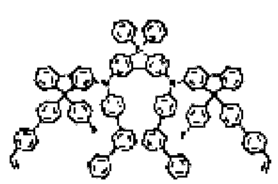
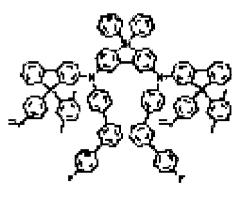
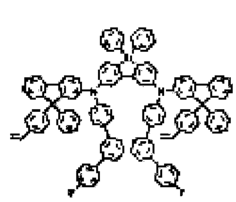
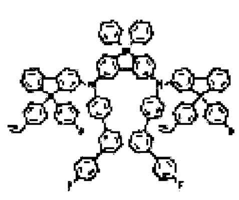
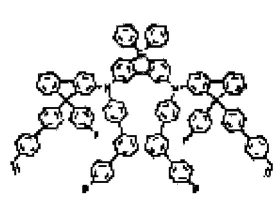

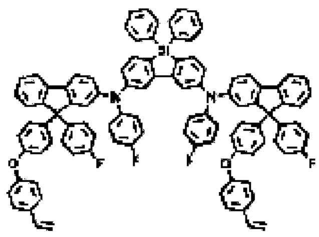
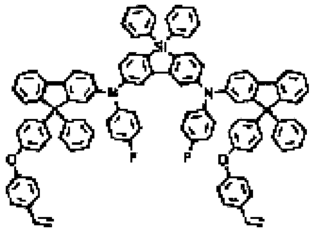
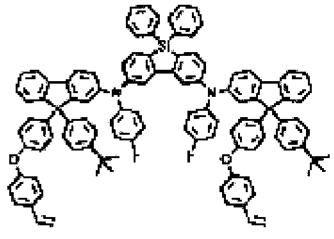

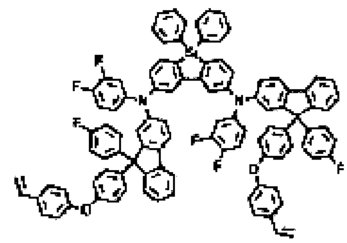
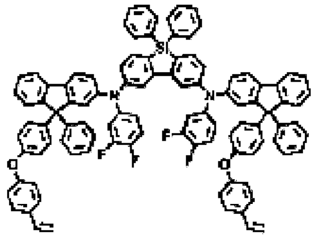
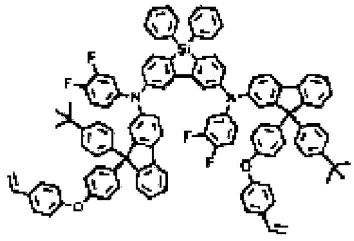

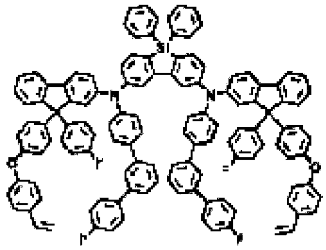
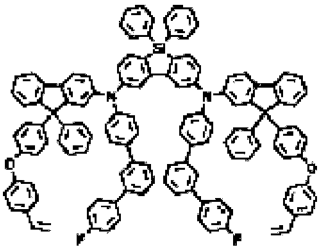
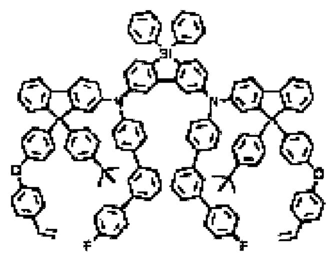

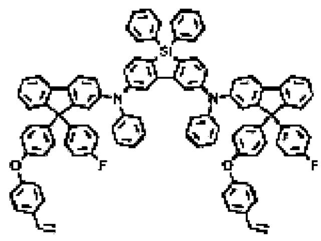
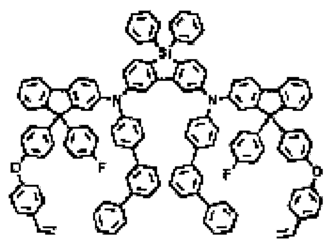

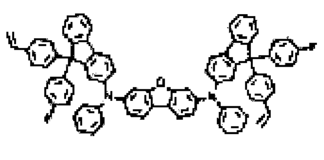
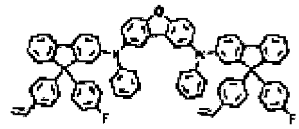
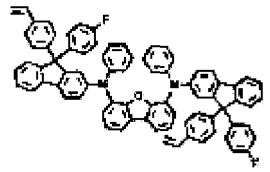

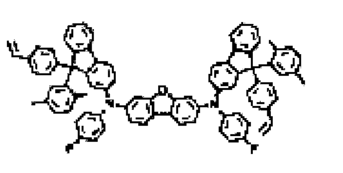
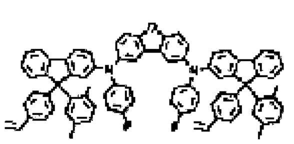
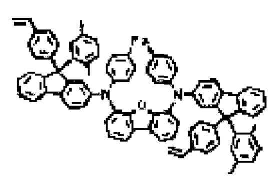

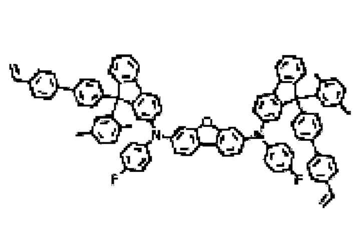
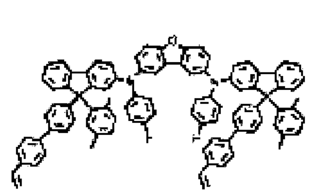
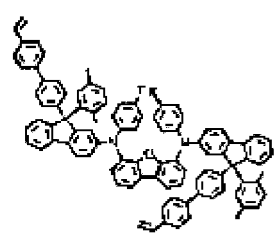

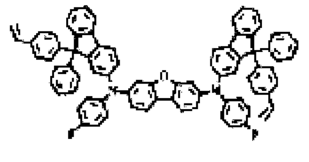
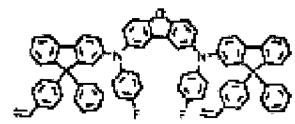
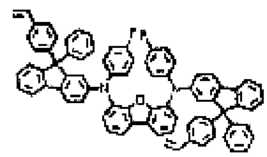

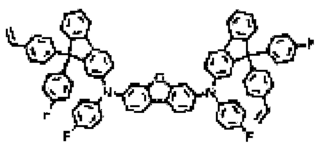
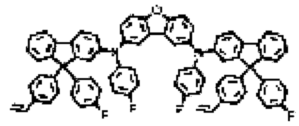
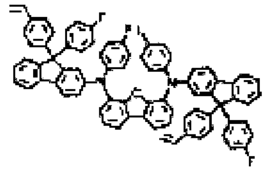

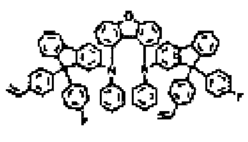
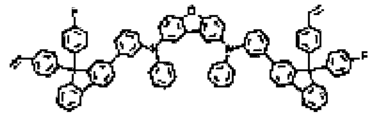
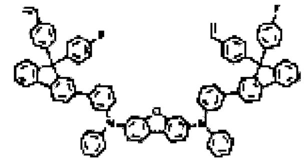

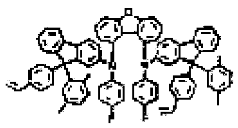
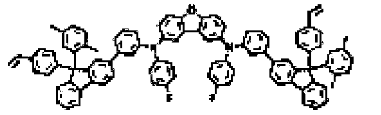
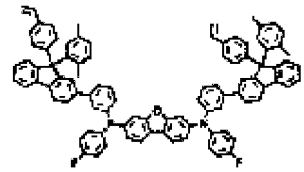

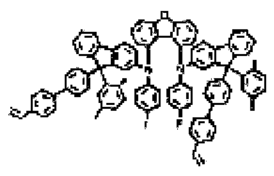
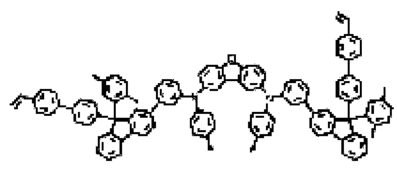
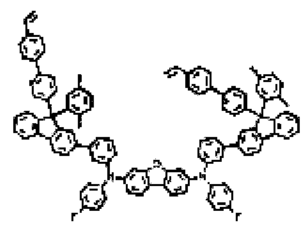

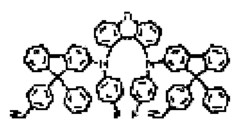
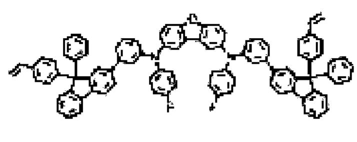
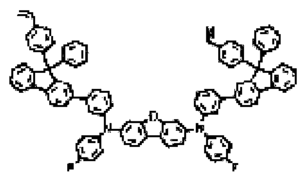

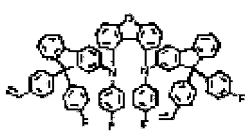
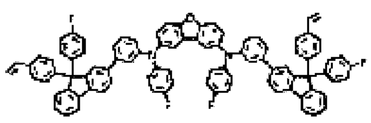
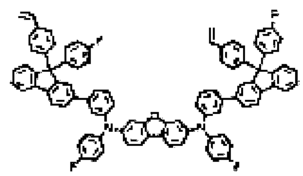

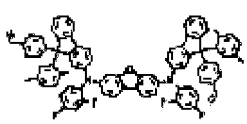
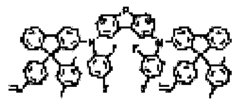
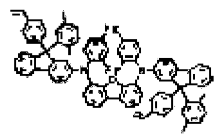
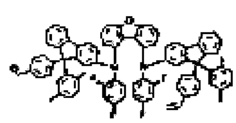

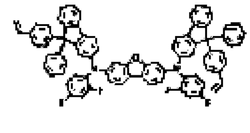
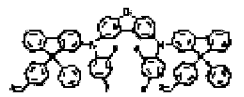
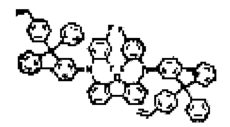
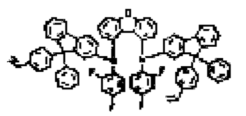
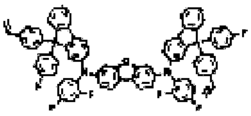
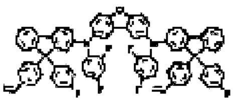
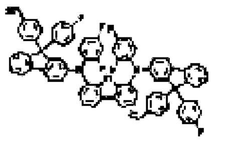
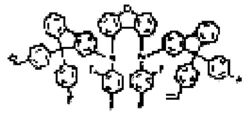
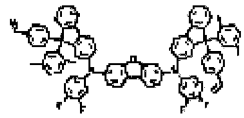
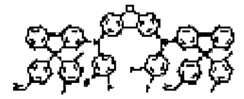
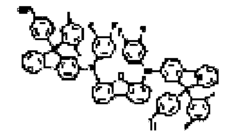
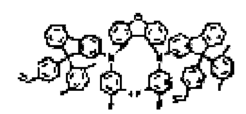
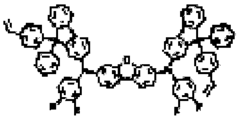
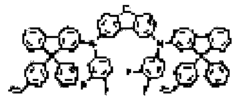
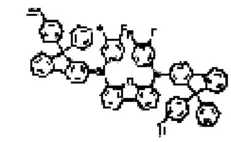
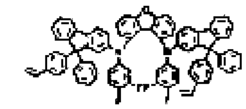
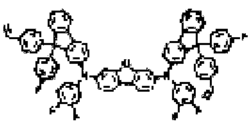
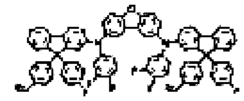
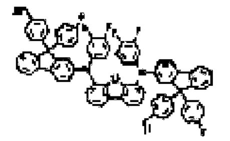
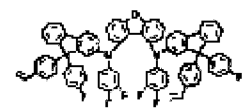
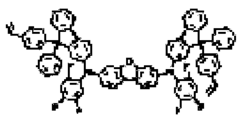
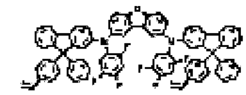
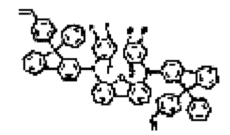
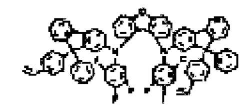
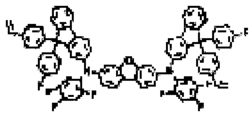
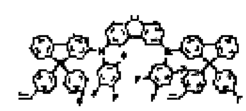
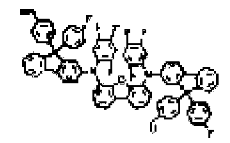
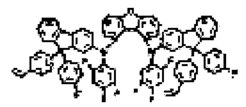
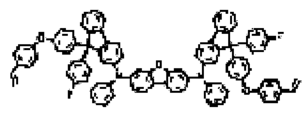
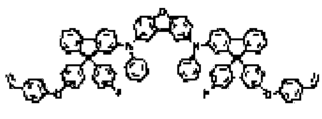
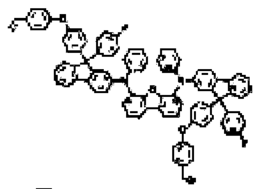
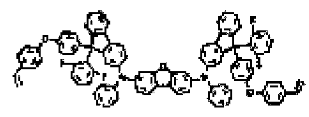
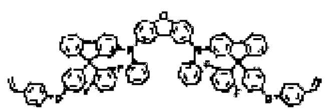
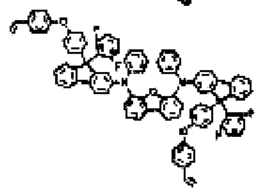

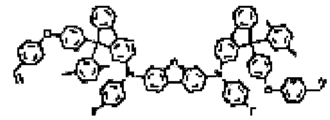
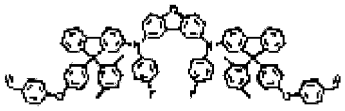
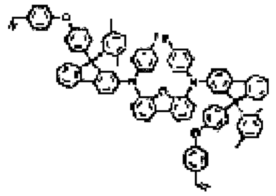

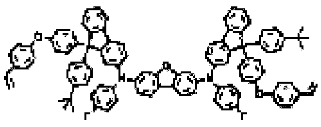
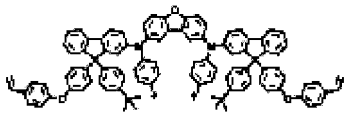
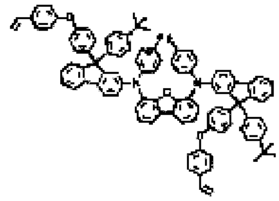

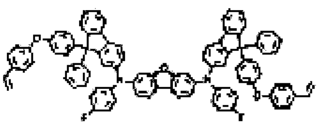
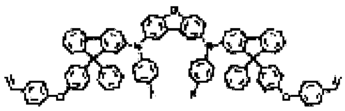
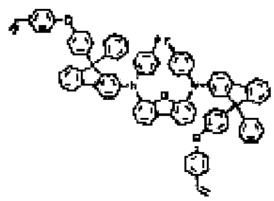

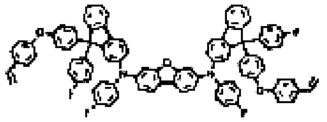
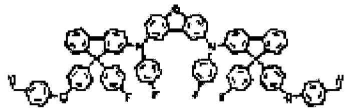
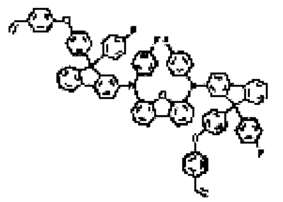

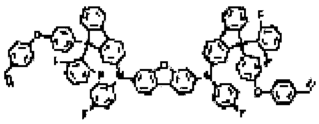
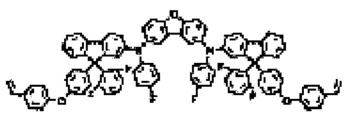
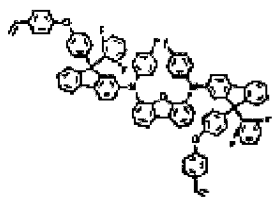

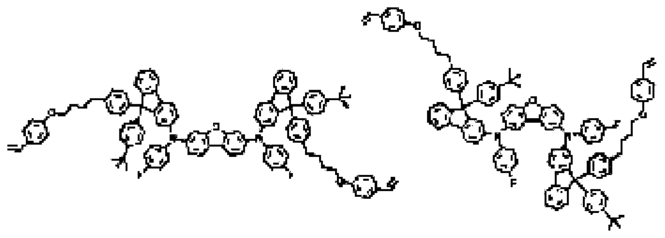
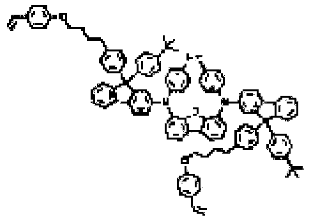

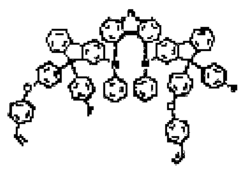
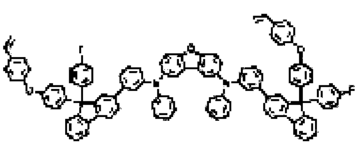
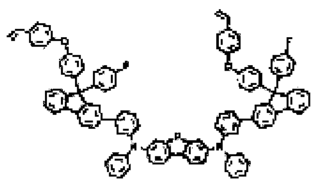

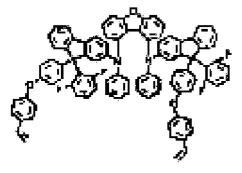
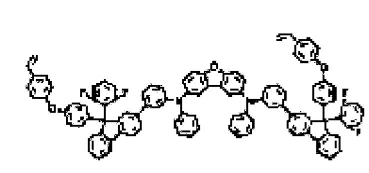
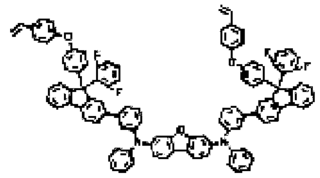

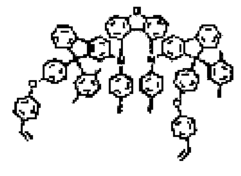
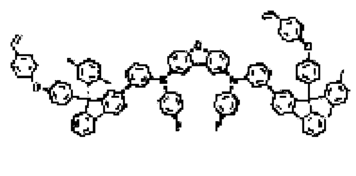
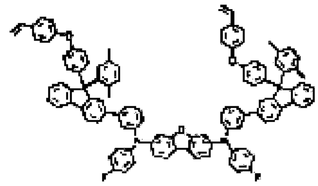

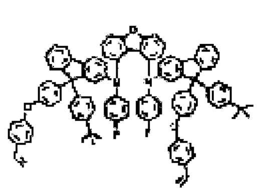
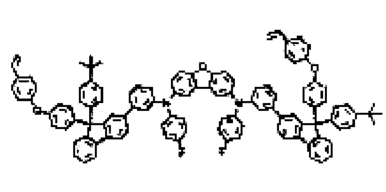
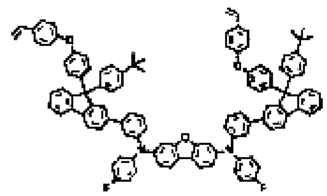

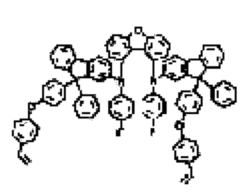
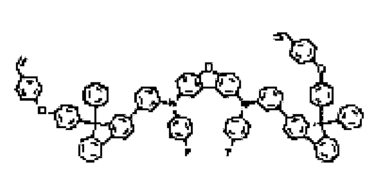
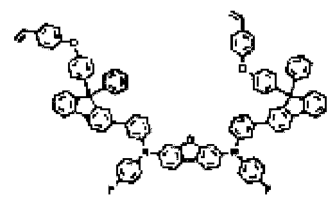

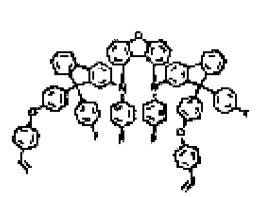
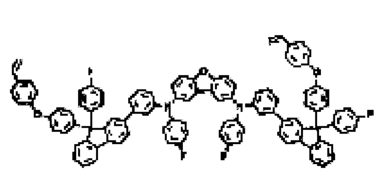
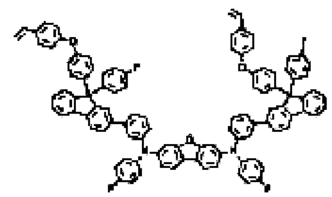

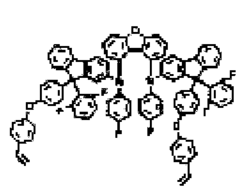
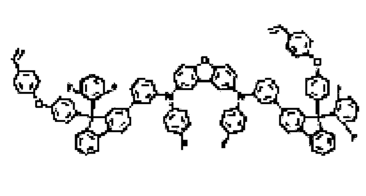
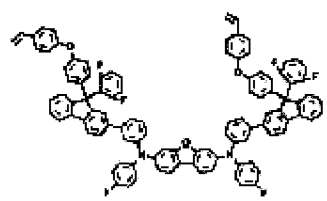

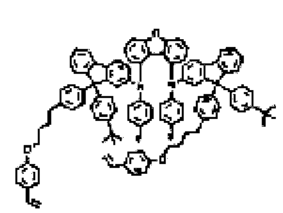
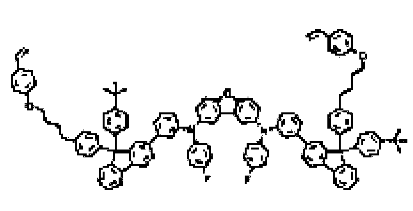
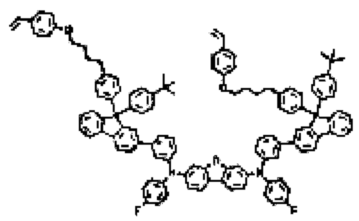

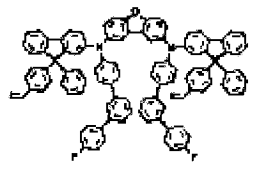
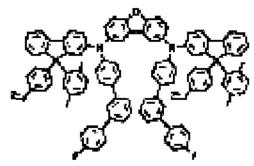
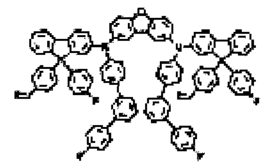

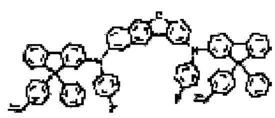
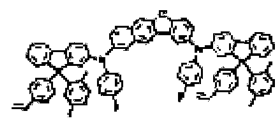
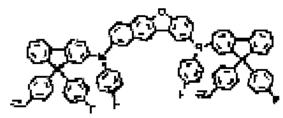

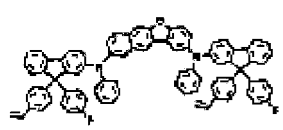
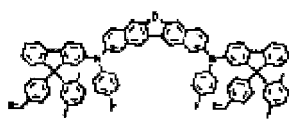
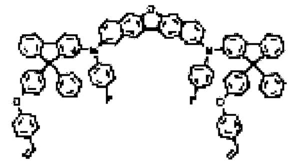

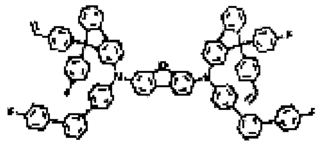
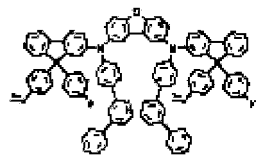
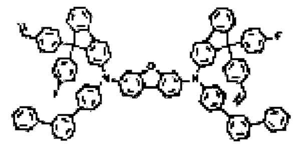

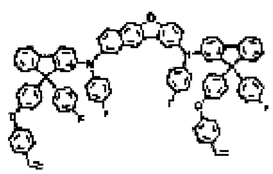
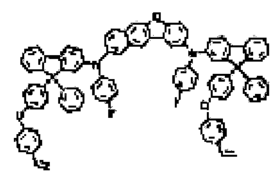
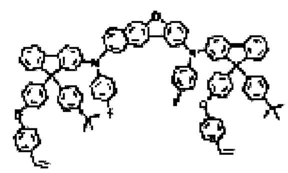

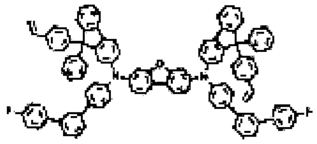
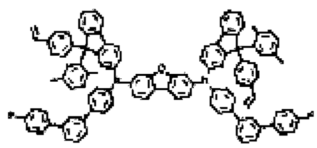
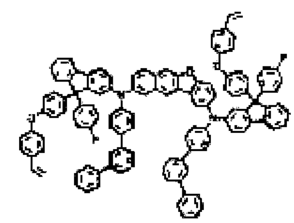

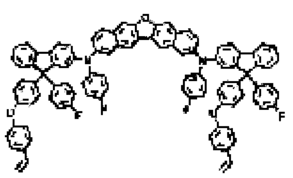
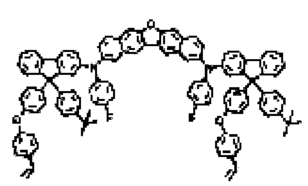
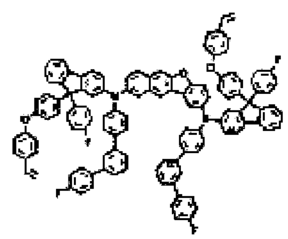

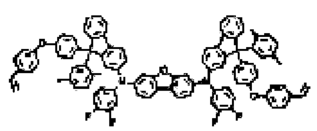
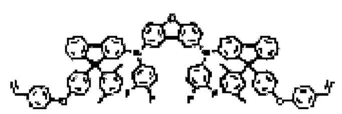
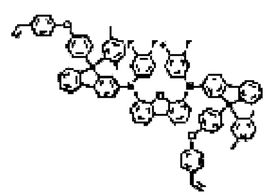

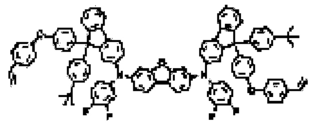
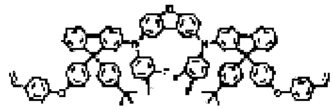
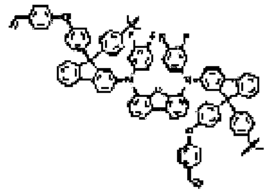
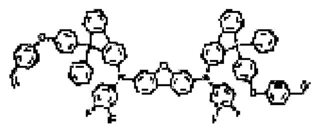
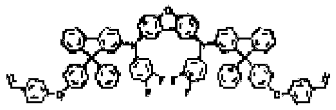
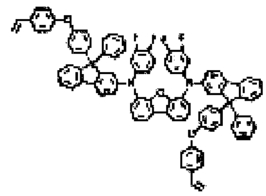
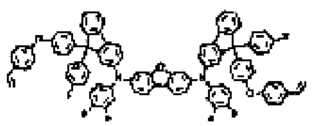
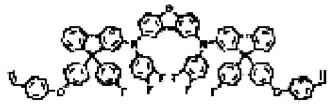
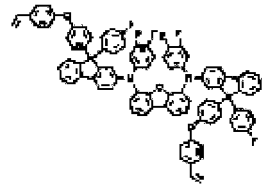
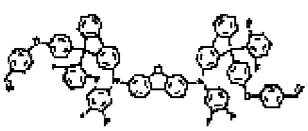
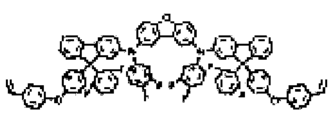
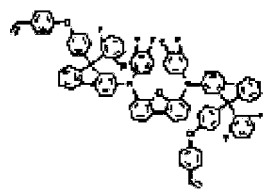
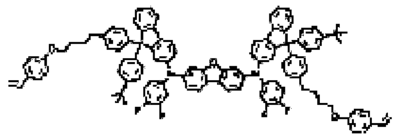
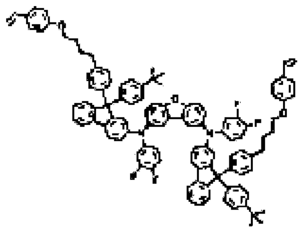
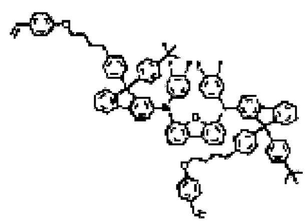
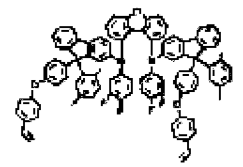
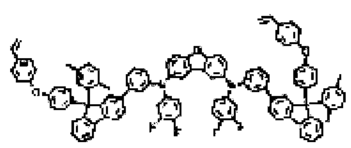
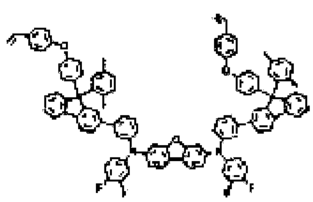
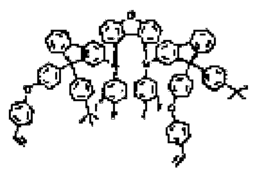
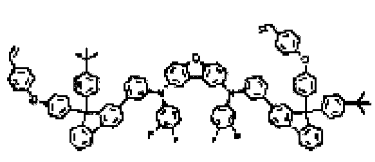
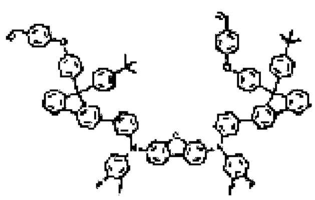

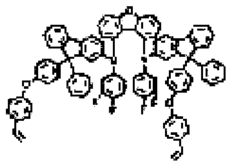
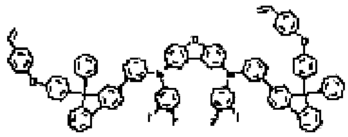
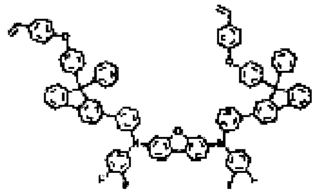

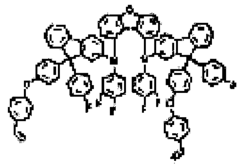
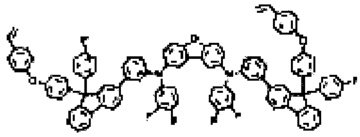
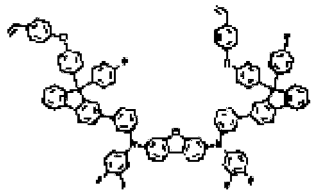

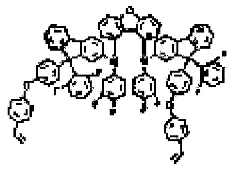
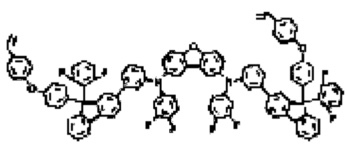
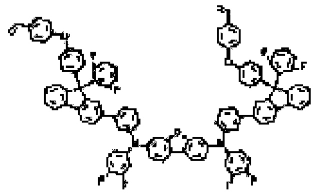

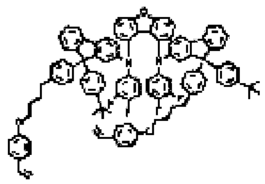
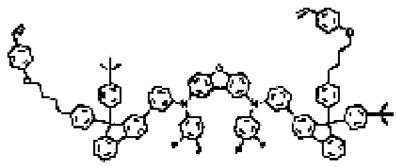
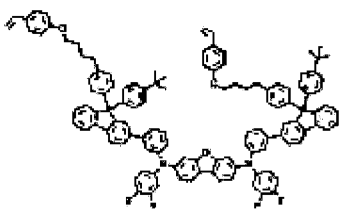

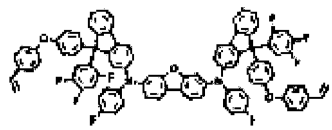
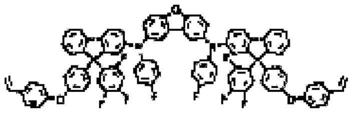
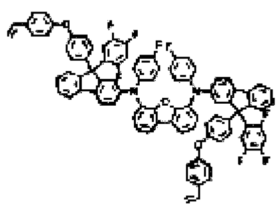

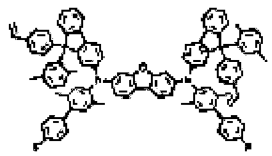
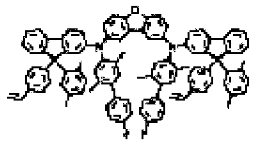
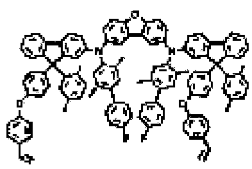

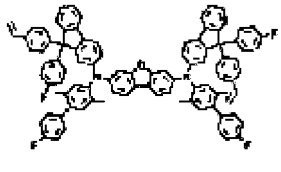
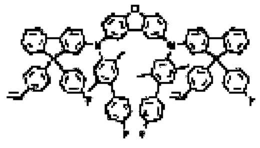
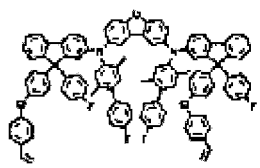

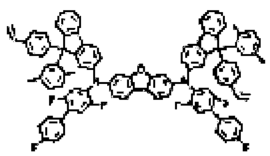
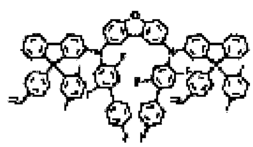
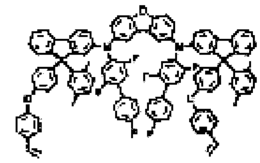

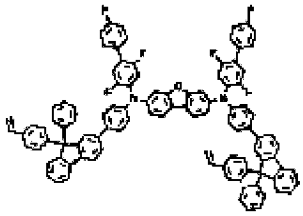
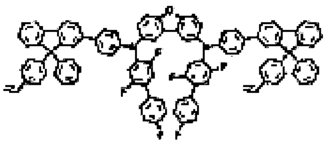
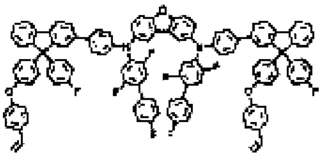

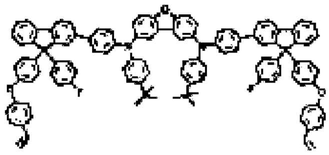

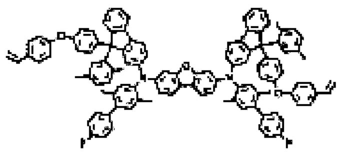
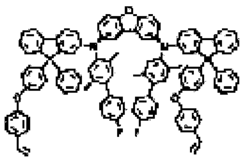
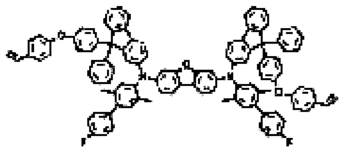

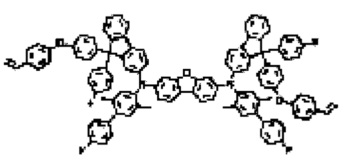
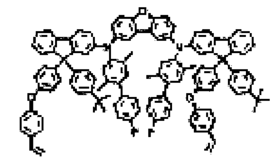
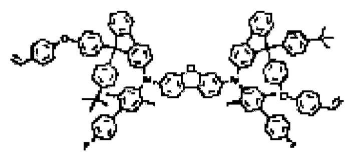

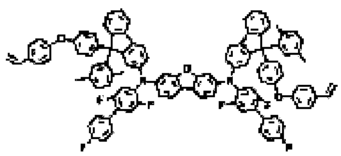
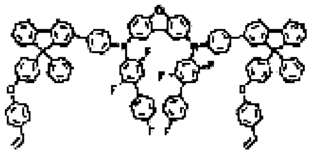
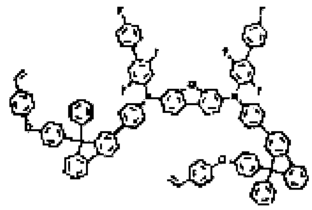

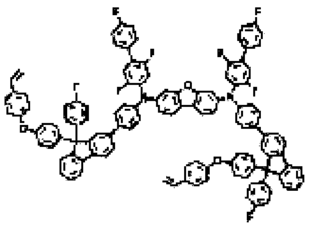
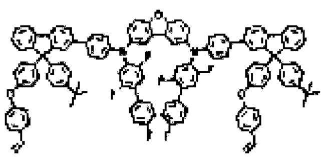
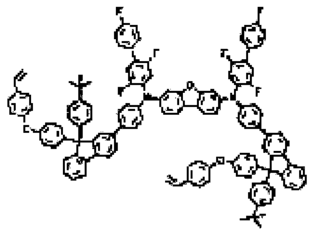

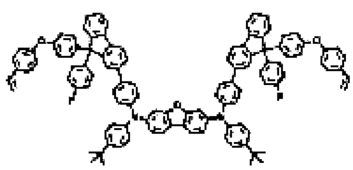

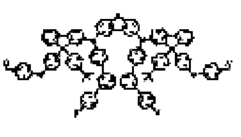
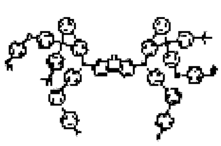
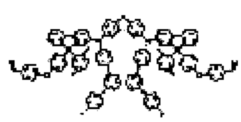
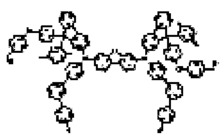

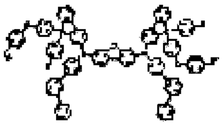
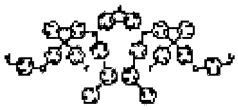
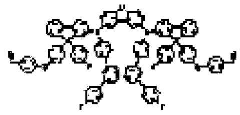
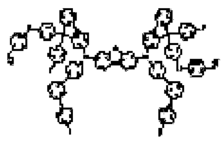

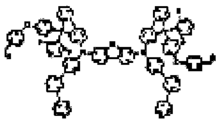
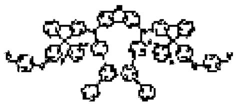
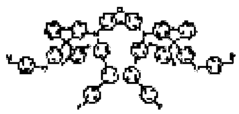
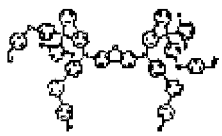

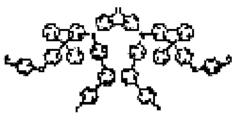
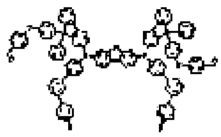
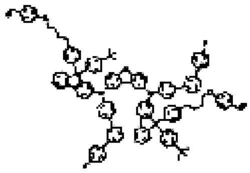
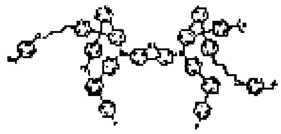

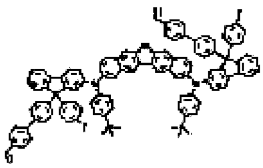
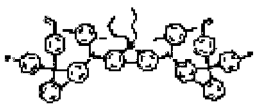
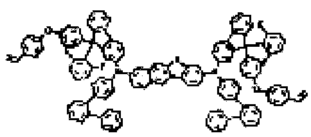

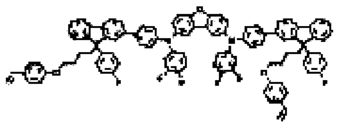
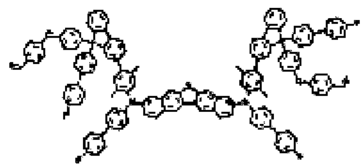

6. Tintenzusammensetzung gemäß Anspruch 1, ferner umfassend ein zweites Lösungsmittel, worin das zweite Lösungsmittel eines oder mehrere umfasst von einem durch irgendeine der folgenden chemischen Formeln B bis D dargestellten Lösungsmittel, Methoxytoluol und Tetralin:

[Chemische Formel B]

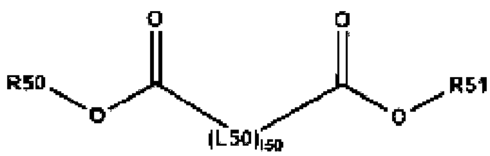

[Chemische Formel C]

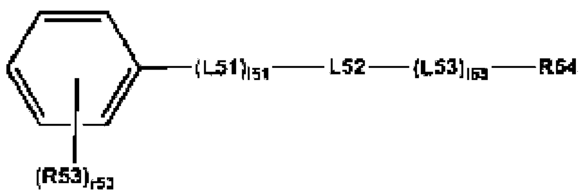

[Chemische Formel D]

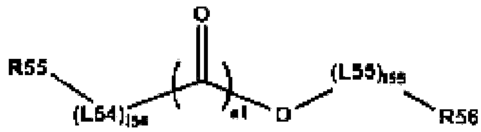

worin in den chemischen Formeln B bis D
L50 eine direkte Bindung; oder eine Alkylengruppe ist,
L51 und L53 bis L55 gleich oder voneinander verschieden sind und jeweils unabhängig eine direkte Bindung; -O-; oder eine substituierte oder unsubstituierte Alkylengruppe sind,
L52 -COO- ist,
R50, R51 und R54 bis R56 gleich oder voneinander verschieden sind und jeweils unabhängig eine substituierte oder unsubstituierte Alkylgruppe sind,
R53 Wasserstoff; Deuterium; eine Alkoxygruppe; oder eine substituierte oder unsubstituierte Alkylgruppe ist,
a1 0 oder 1 ist,
r53 eine ganze Zahl von 1 bis 5 ist, und wenn r53 2 oder größer ist, zwei oder mehr der R53 gleich oder voneinander verschieden sind, und
150, 151 und 153 bis 155 jeweils eine ganze Zahl von 1 bis 10 sind, und wenn 150, 151 und 153 bis 155 jeweils 2 oder größer sind, zwei oder mehr Strukturen in den Klammern gleich oder voneinander verschieden sind.

7. Tintenzusammensetzung gemäß Anspruch 6, worin das erste Lösungsmittel einen Siedepunkt von 250°C bis 350°C aufweist,

das zweite Lösungsmittel einen Siedepunkt von 180°C bis 280°C aufweist und
der Siedepunkt des ersten Lösungsmittels höher ist als der Siedepunkt des zweiten Lösungsmittels.

8. Tintenzusammensetzung gemäß Anspruch 1, ferner umfassend eine ionische Verbindung, umfassend eine durch die folgende chemische Formel 2 dargestellte anionische Gruppe:

[Chemische Formel 2]

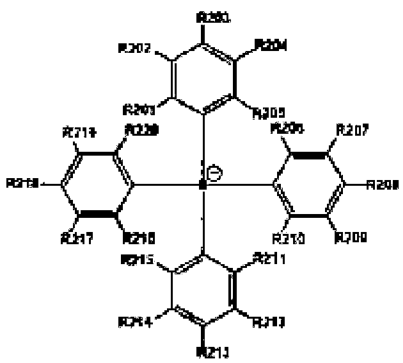

worin in der chemischen Formel 2
zumindest eines von R201 bis R220 F; eine Cyanogruppe; oder eine substituierte oder unsubstituierte Fluoralkylgruppe ist,
zumindest eines der anderen von R201 bis R220 eine härtbare Gruppe ist,
die restlichen R201 bis R220 gleich oder voneinander verschieden sind und jeweils unabhängig Wasserstoff; Deuterium; eine Halogengruppe, eine Nitrogruppe; eine Cyanogruppe; eine Aminogruppe; -OR221; -SR222; $-SO_3R223$; -COOR224; -OC(O)R225; -C(O)NR226R227; -C(O)R228; eine substituierte oder unsubstituierte Alkylgruppe; eine substituierte oder unsubstituierte Alkenylgruppe; eine substituierte oder unsubstituierte Alkinylgruppe; eine substituierte oder unsubstituierte Amingruppe; eine substituierte oder unsubstituierte Arylgruppe; oder eine substituierte oder unsubstituierte heterocyclische Gruppe sind, und
R221 bis R228 gleich oder voneinander verschieden sind und jeweils unabhängig Wasserstoff; Deuterium; oder

eine substituierte oder unsubstituierte Alkylgruppe sind.

9. Tintenzusammensetzung gemäß Anspruch 8, worin die chemische Formel 2 irgendeine der folgenden Strukturen ist:

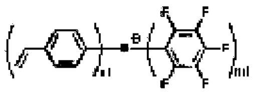
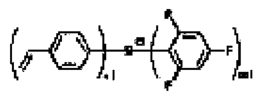
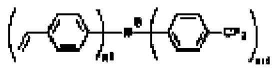
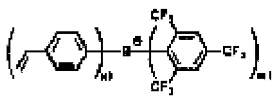
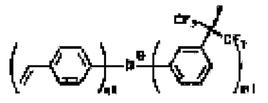
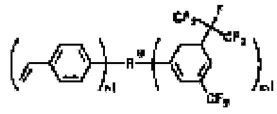
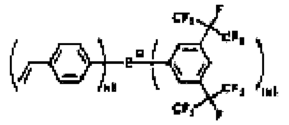
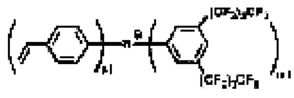
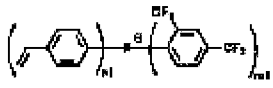
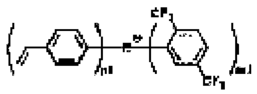
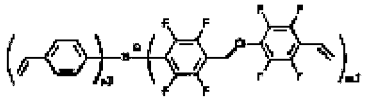
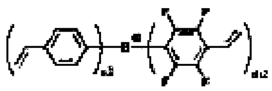
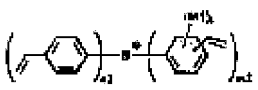
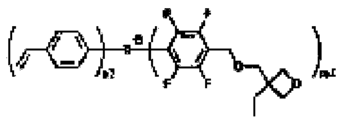
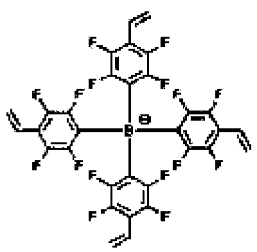
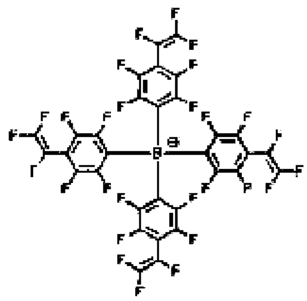
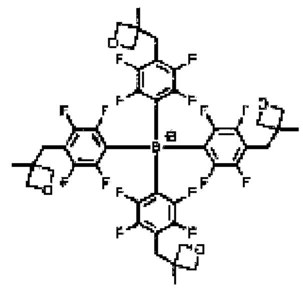

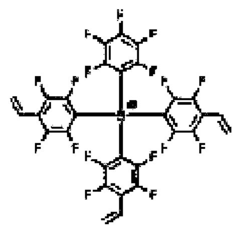 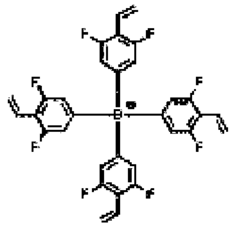 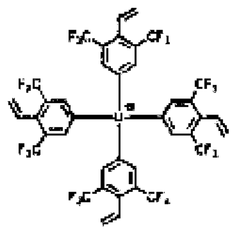

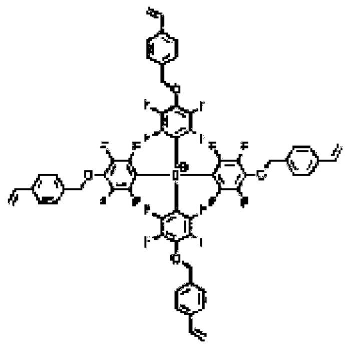 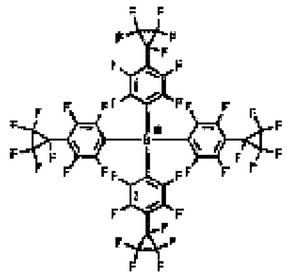 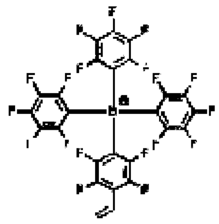

worin in den Strukturen

n1 eine ganze Zahl von 1 bis 3 ist, m1 eine ganze Zahl von 1 bis 3 ist, und n1+m1=4,

n2 eine ganze Zahl von 0 bis 3 ist, m2 eine ganze Zahl von 1 bis 4 ist, und n2+m2=4,

M1 Deuterium; eine Halogengruppe; eine Nitrogruppe; eine Cyanogruppe; eine Aminogruppe; -OR221; -SR222; $-SO_3R223$; -COOR224; -OC(O)R225; -C(O)NR226R227; -C(O)R228; eine substituierte oder unsubstituierte Alkylgruppe; eine substituierte oder unsubstituierte Alkenylgruppe; eine substituierte oder unsubstituierte Alkinylgruppe; eine substituierte oder unsubstituierte Aminogruppe, eine substituierte oder unsubstituierte Arylgruppe; oder eine substituierte oder unsubstituierte heterocyclische Gruppe ist,

R221 bis R228 gleich oder voneinander verschieden sind und jeweils Wasserstoff; Deuterium; oder eine substituierte oder unsubstituierte Alkylgruppe sind, und

i eine ganze Zahl von 1 bis 4 ist, und wenn i 2 oder größer ist, zwei oder mehr M1 gleich oder voneinander verschieden sind.

**10.** Tintenzusammensetzung gemäß Anspruch 8, worin die ionische Verbindung ferner eine kationische Gruppe umfasst und die kationische Gruppe eine monovalente kationische Gruppe, eine Oniumverbindung oder irgendeine der folgenden Strukturen ist:

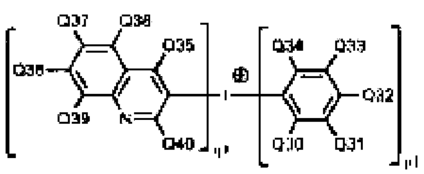 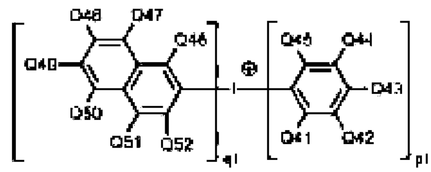

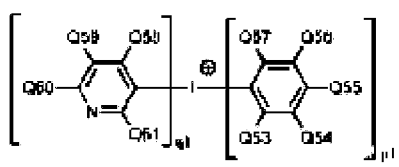 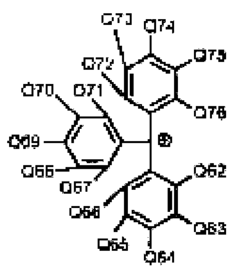 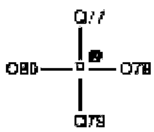

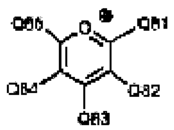 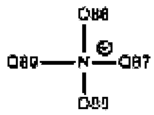 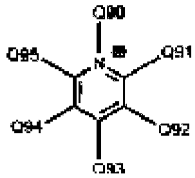 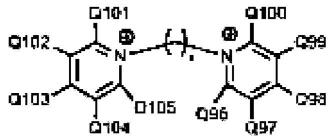

worin in den Strukturen
Q30 bis Q105 gleich oder voneinander verschieden sind und jeweils unabhängig Wasserstoff; Deuterium; eine Cyanogruppe; eine Nitrogruppe; eine Halogengruppe; eine Hydroxylgruppe; -COOR250; eine substituierte oder unsubstituierte Alkylgruppe; eine substituierte oder unsubstituierte Alkoxygruppe; eine substituierte oder unsubstituierte Aryloxygruppe; eine substituierte oder unsubstituierte Cycloalkylgruppe; eine substituierte oder unsubstituierte Arylgruppe; oder eine härtbare Gruppe sind,
R250 Wasserstoff; Deuterium; oder eine substituierte oder unsubstituierte Alkylgruppe ist;
x eine ganze Zahl von 0 bis 10 ist und
p1 1 oder 2 ist, q1 0 oder 1 ist und p1+q1=2.

**11.** Tintenzusammensetzung gemäß Anspruch 8, worin die ionische Verbindung irgendeine der chemischen Formeln D-1 bis D-36 ist:

[Chemische Formel D-1]

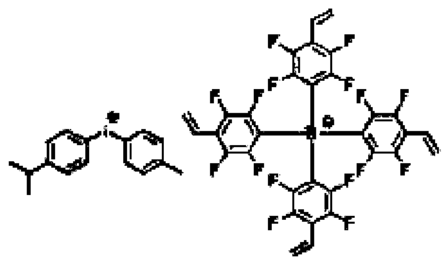

[Chemische Formel D-2]

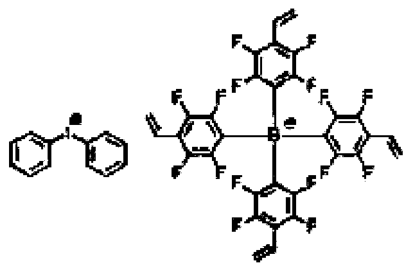

[Chemische Formel D-3]

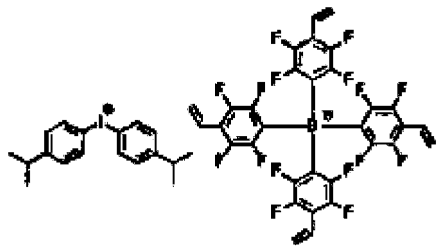

[Chemische Formel D-4]

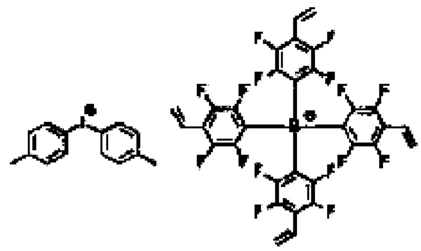

[Chemische Formel D-5]

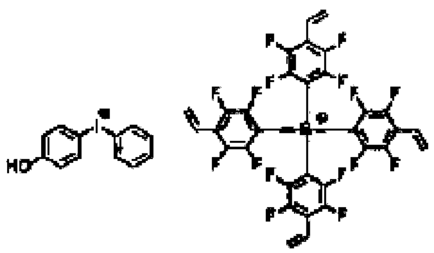

[Chemische Formel D-6]

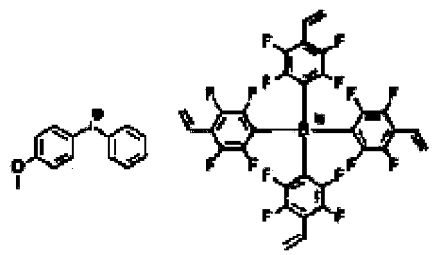

[Chemische Formel D-7]

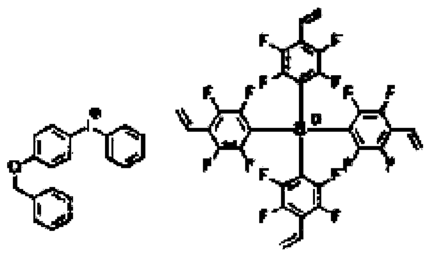

[Chemische Formel D-8]

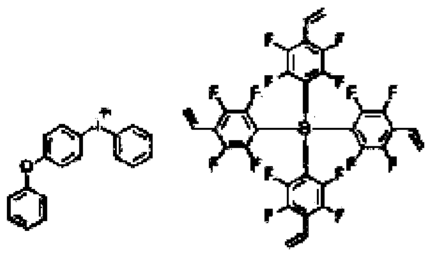

[Chemische Formel D-9]

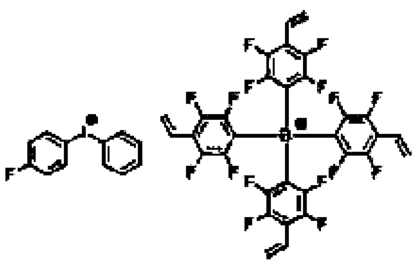

[Chemische Formel D-10]

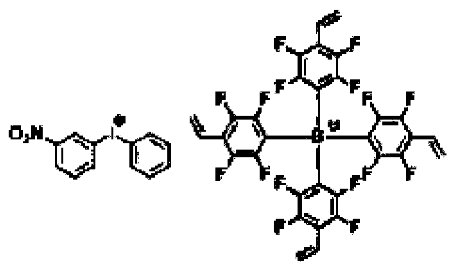

[Chemische Formel D-11]

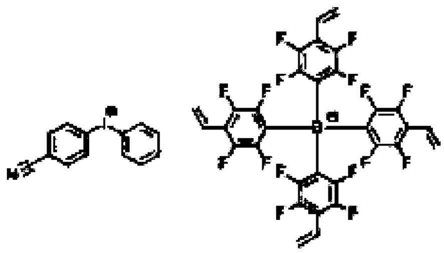

[Chemische Formel D-12]

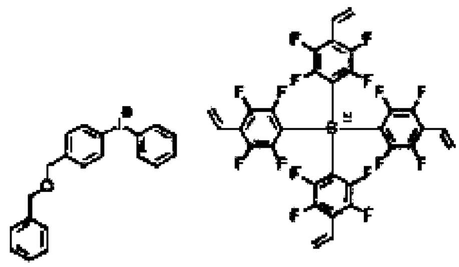

[Chemische Formel D-13]

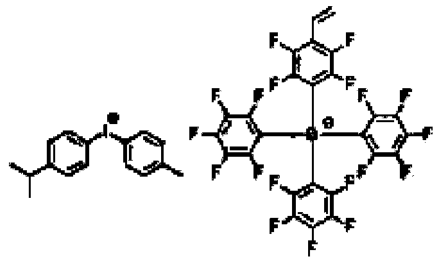

[Chemische Formel D-14]

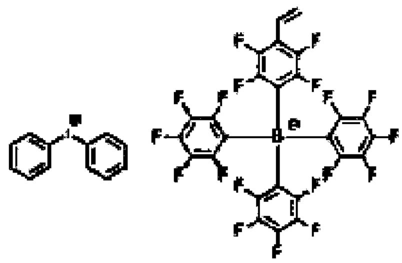

[Chemische Formel D-15]

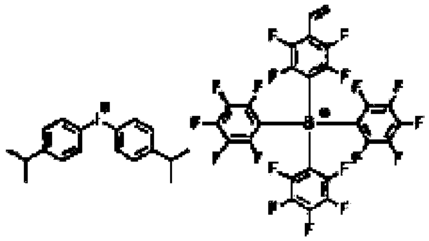

[Chemische Formel D-16]

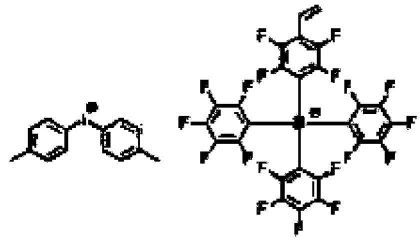

[Chemische Formel D-17]

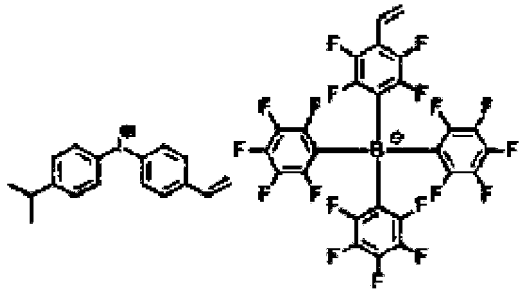

[Chemische Formel D-18]

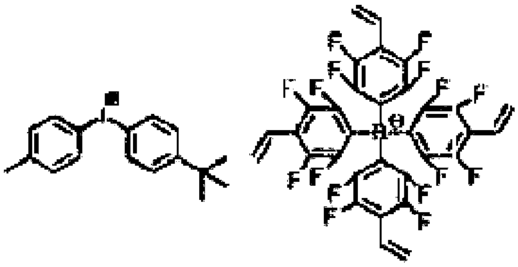

[Chemische Formel D-19]

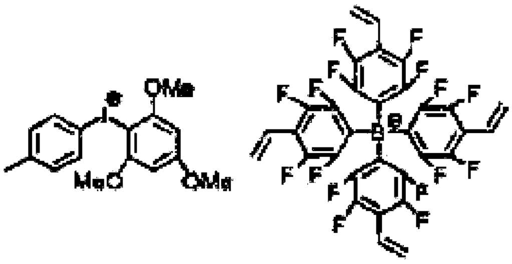

[Chemische Formel D-20]

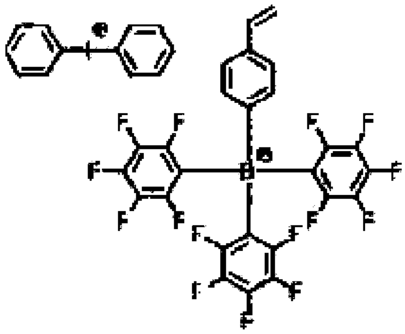

[Chemische Formel D-21]

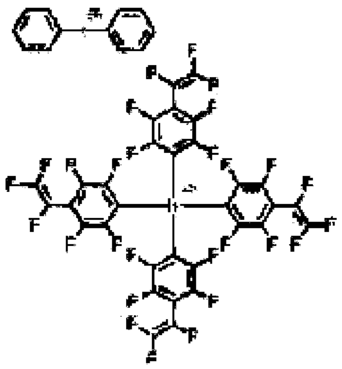

[Chemische Formel D-22]

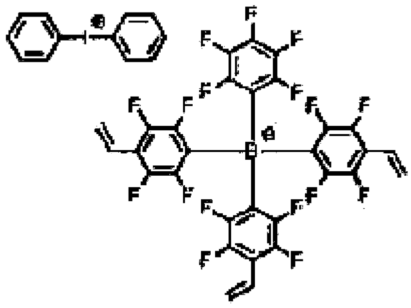

[Chemische Formel D-23]

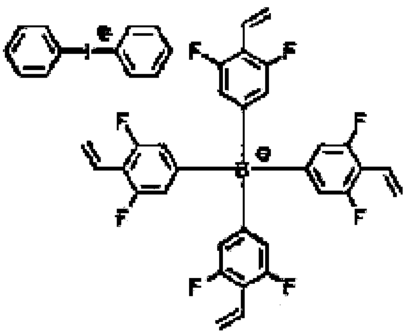

[Chemische Formel D-24]

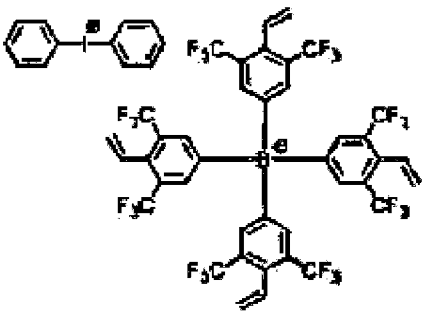

[Chemische Formel D-25]

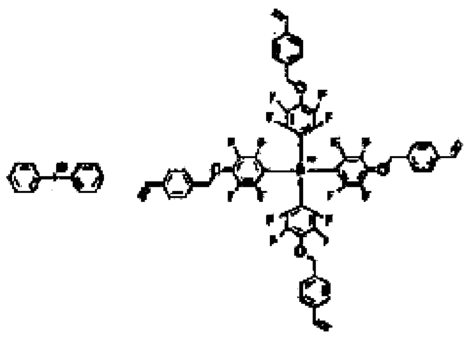

[Chemische Formel D-26]

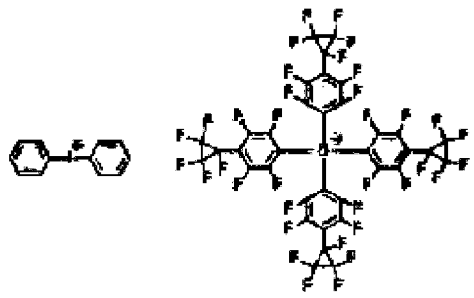

[Chemische Formel D-27]

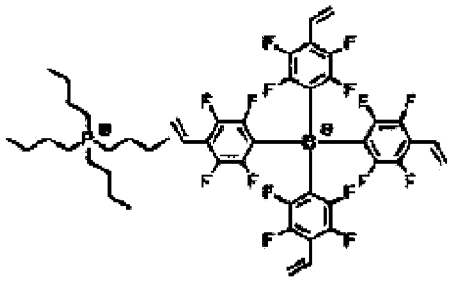

[Chemische Formel D-28]

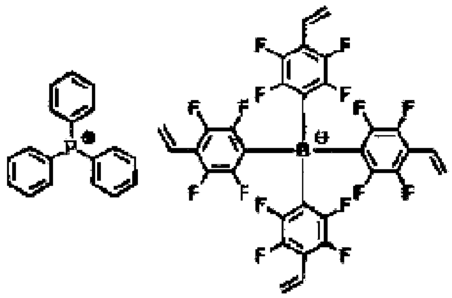

[Chemische Formel D-29]

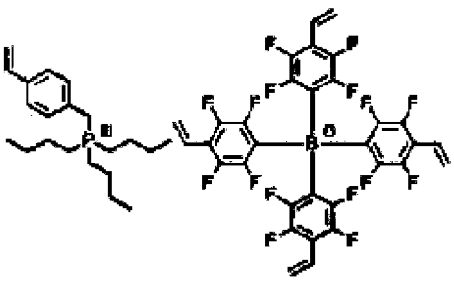

[Chemische Formel D-30]

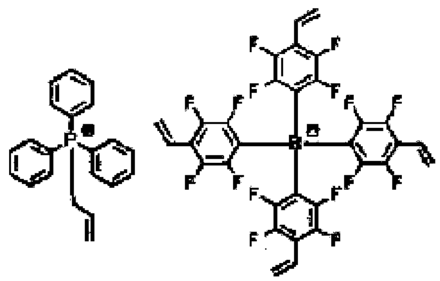

[Chemische Formel D-31]

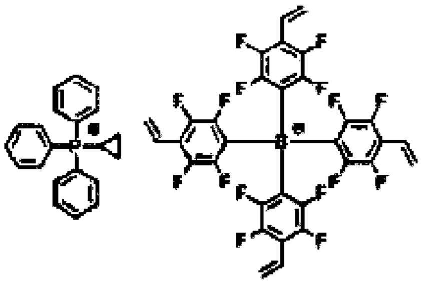

[Chemische Formel D-32]

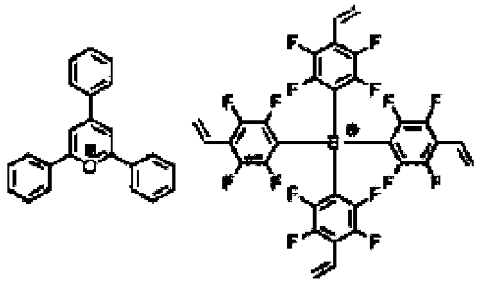

[Chemische Formel D-33]

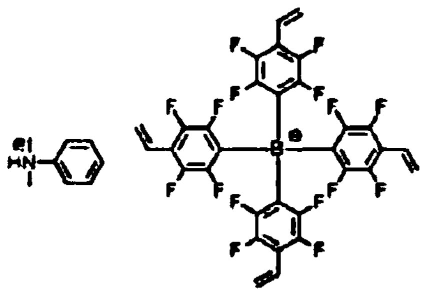

[Chemische Formel D-34]

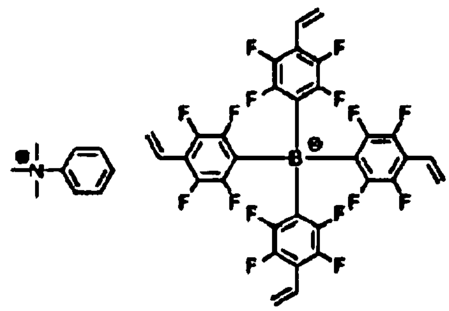

[Chemische Formel D-35]

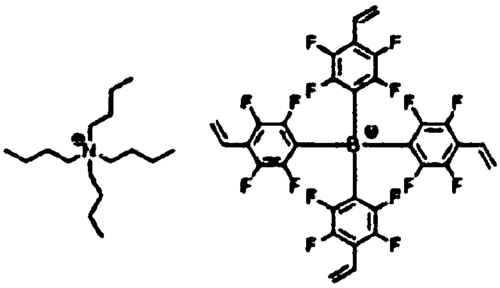

[Chemische Formel D-36]

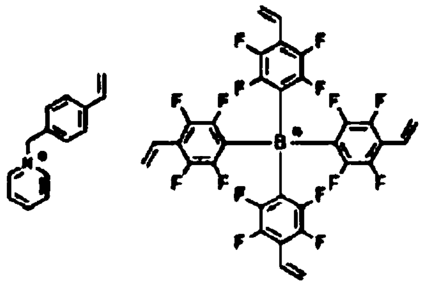

**12.** Pixel, umfassend die Tintenzusammensetzung gemäß irgendeinem der Ansprüche 1 bis 11 oder ein gehärtetes Produkt hiervon.

**13.** Organische Materialschicht, umfassen den Pixel gemäß Anspruch 12.

**14.** Organische lichtemittierende Vorrichtung, umfassend: eine erste Elektrode;

eine zweite Elektrode; und
eine organische Materialschicht, die eine oder mehr Schichten aufweist, vorgesehen zwischen der ersten Elektrode und der zweiten Elektrode,
worin eine oder mehr Schichten der organischen Materialschicht die organische Materialschicht gemäß Anspruch 13 sind.

**15.** Organische lichtemittierende Vorrichtung gemäß Anspruch 14, worin die organische Materialschicht eine oder mehrere Schichten umfasst, ausgewählt aus der Gruppe bestehend aus einer Lochinjektionsschicht, einer Lochtransportschicht, einer Lochinjektions- und Transportschicht und einer Elektronensperrschicht, und
worin die eine oder mehr Schichten, ausgewählt aus der Gruppe bestehend aus der Lochinjektionsschicht, der Lochtransportschicht, der Lochinjektions- und Transportschicht und der Elektronensperrschicht, die Tintenzusammensetzung oder ein gehärtetes Produkt hiervon umfassen.

## Revendications

**1.** Composition d'encre comprenant un composé représenté par la formule chimique 1 suivante et un premier solvant représenté par la formule chimique A suivante :

[Formule chimique 1]

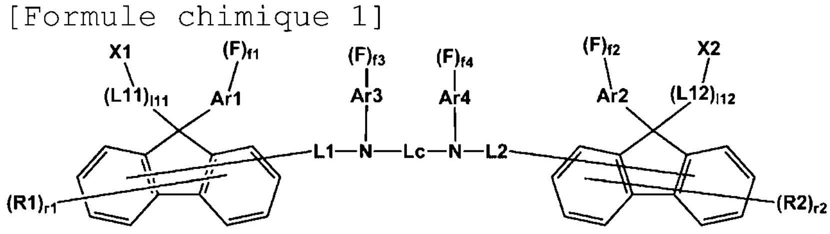

[Formule chimique A]

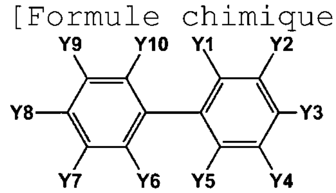

dans lesquelles, dans les formules chimiques 1 et A,
Y1 à Y10 sont identiques ou différents les uns des autres, et représentent chacun, indépendamment, un atome d'hydrogène ; un atome de deutérium ; un groupe hydroxyle ; un groupe éther ; un groupe carbonyle ; un groupe ester ; un groupe alkyle substitué ou non substitué ; un groupe cycloalkyle substitué ou non substitué ; un groupe cycloalcényle substitué ou non substitué ; un groupe alcoxy substitué ou non substitué ; un groupe aryle substitué ou non substitué ; ou un groupe amine substitué ou non substitué,
Lc est un groupe hétéroarylène substitué ou non substitué comprenant O, S ou Si,
L1 et L2 sont identiques ou différents l'un de l'autre, et sont chacun indépendamment une liaison directe ; ou un groupe arylène substitué ou non substitué,
L11 et L12 sont identiques ou différents l'un de l'autre, et sont chacun indépendamment une liaison directe ; -O- ; un groupe alkylène substitué ou non substitué ; ou un groupe arylène substitué ou non substitué,
Ar1 à Ar4 sont identiques ou différents les uns des autres, et représentent chacun indépendamment un groupe aryle substitué ou non substitué ; ou un groupe hétéroaryle substitué ou non substitué,
R1 et R2 sont identiques ou différents l'un de l'autre, et représentent chacun indépendamment un atome d'hydrogène ; un atome de deutérium ; un groupe halogène ; ou un groupe alkyle substitué ou non substitué,
X1 et X2 sont identiques ou différents l'un de l'autre, et représentent chacun indépendamment un groupe durcissable,
r1 et r2 sont chacun un nombre entier compris entre 0 et 7, et lorsque r1 et r2 sont chacun égaux ou supérieurs à 2, deux ou plusieurs substituants entre parenthèses sont identiques ou différents les uns des autres,
111 et 112 sont chacun un nombre entier compris entre 1 et 3, et lorsque 111 et 112 sont chacun égaux ou supérieurs à 2, deux ou plusieurs substituants entre parenthèses sont identiques ou différents les uns des autres,
f1 vaut de 0 au nombre maximal de substituants pouvant être liés à Ar1,
f2 vaut de 0 au nombre maximal de substituants pouvant être liés à Ar2,
f3 vaut de 0 au nombre maximal de substituants pouvant être liés à Ar3, et
f4 vaut de 0 au nombre maximal de substituants pouvant être liés à Ar4.

**2.** La composition d'encre selon la revendication 1, dans laquelle le groupe durcissable présente l'une quelconque des structures suivantes :

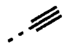 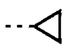 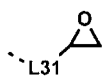 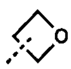 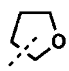 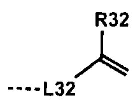 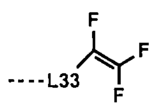

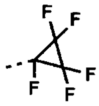 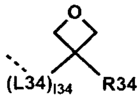 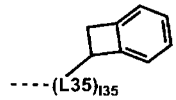 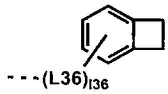 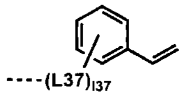

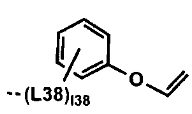 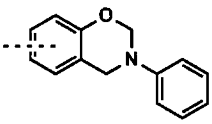 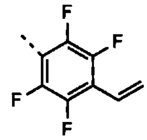 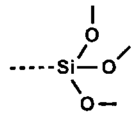

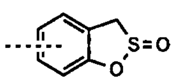 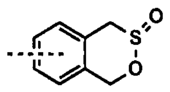

dans les structures,
R32 et R34 sont identiques ou différents l'un de l'autre, et représentent chacun indépendamment un atome d'hydrogène ; un atome de deutérium ; ou un groupe alkyle substitué ou non substitué,
L31 à L38 sont identiques ou différents les uns des autres, et représentent chacun indépendamment une liaison directe ; -O- ; un groupe alkylène substitué ou non substitué ; ou un groupe arylène substitué ou non substitué,
134 à 138 sont chacun un nombre entier compris entre 1 et 10, et lorsque 134 à 138 sont chacun égaux ou supérieurs à 2, deux substituants ou plus entre parenthèses sont identiques ou différents les uns des autres, et
- - - - - - est un groupement lié à la formule chimique 1.

**3.** La composition d'encre selon la revendication 1, dans laquelle la formule chimique 1 est représentée par la formule chimique 1-1 suivante :

[Formule chimique 1-1]

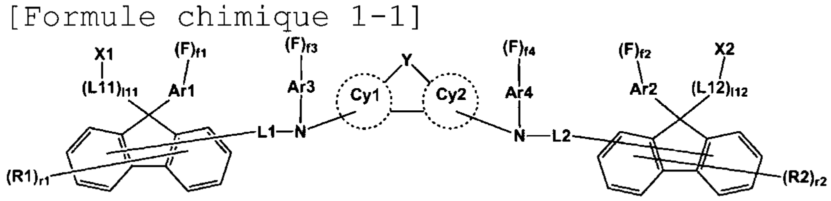

dans la formule chimique 1-1,
Cy1 et Cy2 sont identiques ou différents l'un de l'autre, et représentent chacun, indépendamment, un cycle aromatique substitué ou non substitué comportant de 6 à 20 atomes de carbone,
Y représente O, S ou SiRy1Ry2,
Ry1 et Ry2 sont identiques ou différents l'un de l'autre, et représentent chacun indépendamment un atome d'hydrogène ; un atome de deutérium ; un groupe alkyle substitué ou non substitué ; ou un groupe aryle substitué ou non substitué, et
L1, L2, L11, L12, Ar1 à Ar4, R1, R2, X1, X2, r1, r2, 111, 112 et f1 à f4 sont identiques à ceux définis dans la formule chimique 1.

**4.** La composition d'encre selon la revendication 1, dans laquelle le solvant représenté par la formule chimique A correspond à l'une quelconque des structures suivantes :

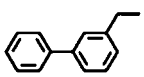 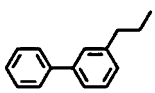 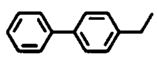

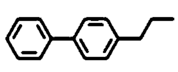 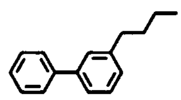 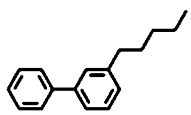 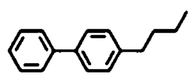

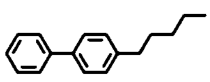 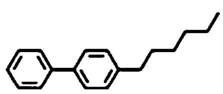 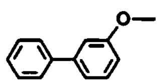 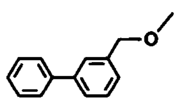

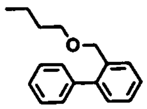 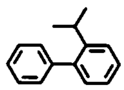 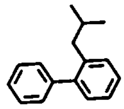 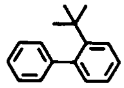

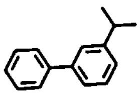 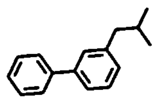 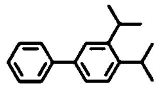 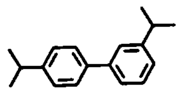

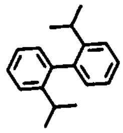 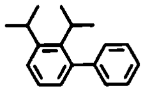 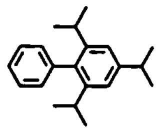 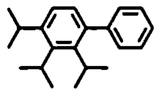

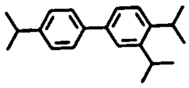 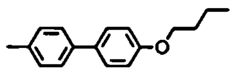

.

5. La composition d'encre selon la revendication 1, dans laquelle le composé représenté par la formule chimique 1 correspond à l'une des structures suivantes :

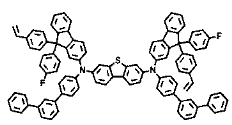 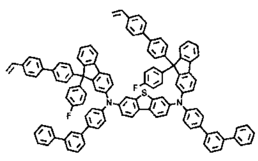 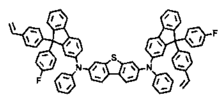 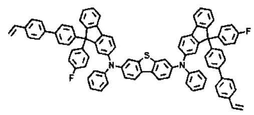

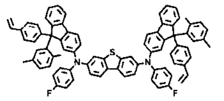 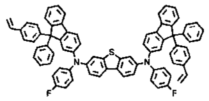 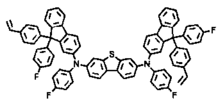 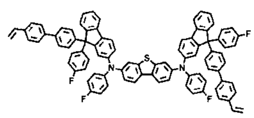

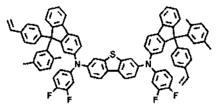 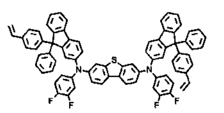 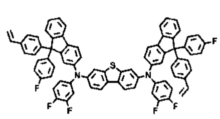 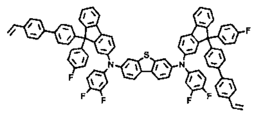

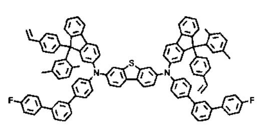 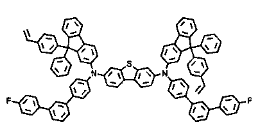 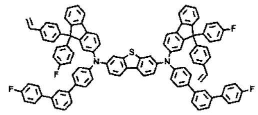 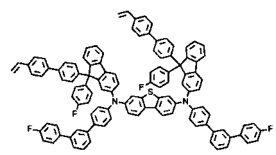

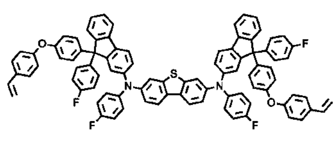 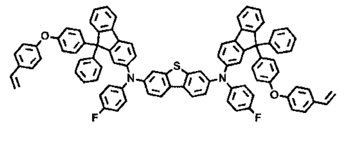 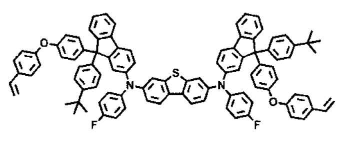

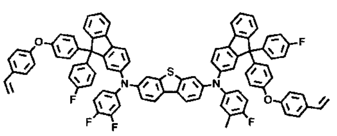 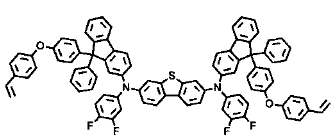 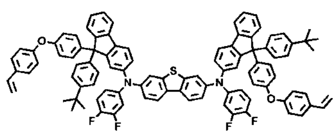

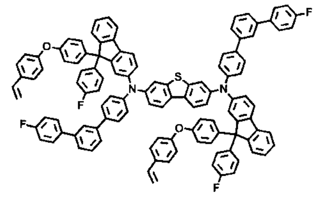
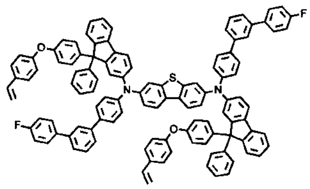
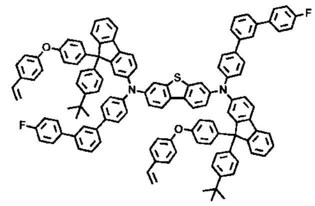

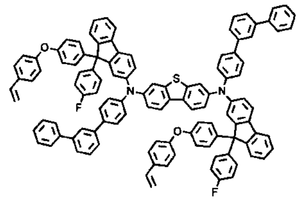
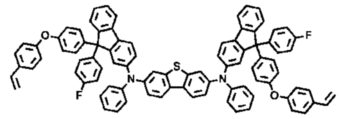

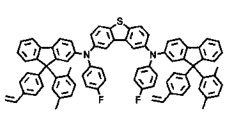
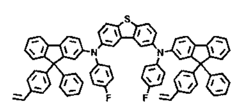
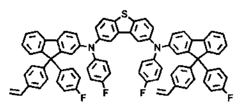
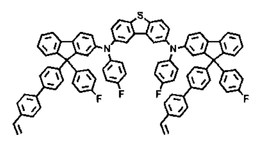

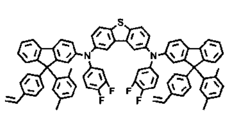
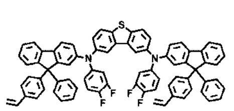
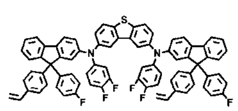
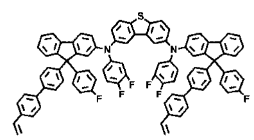

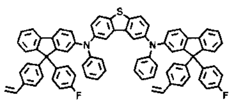
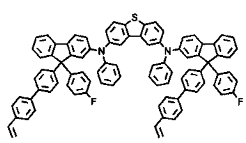
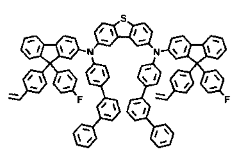
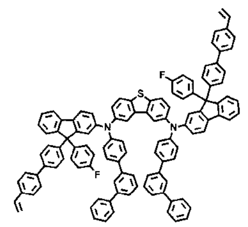

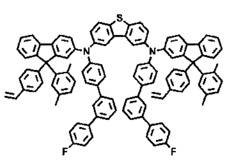
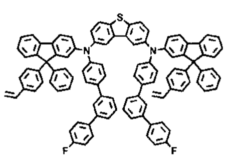
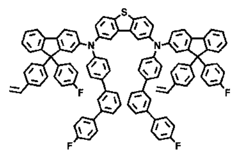
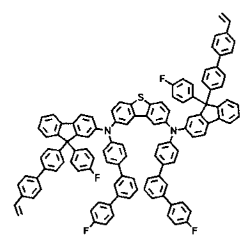

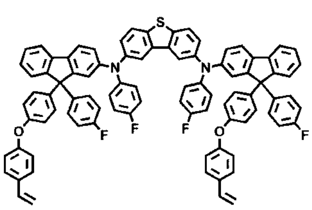
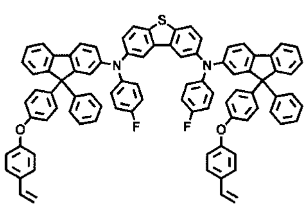
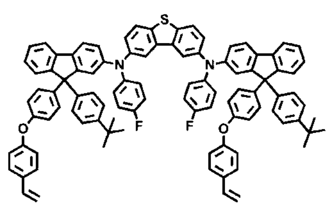

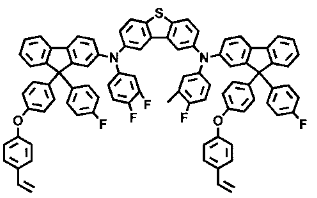
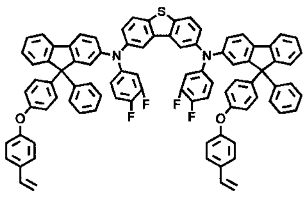
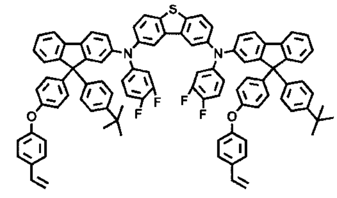

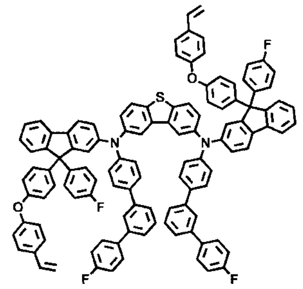
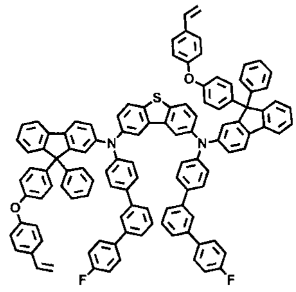
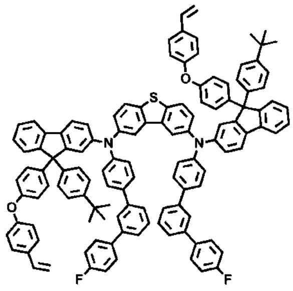

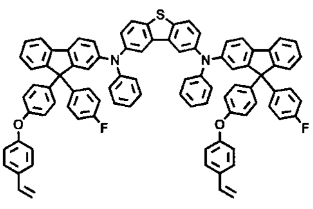
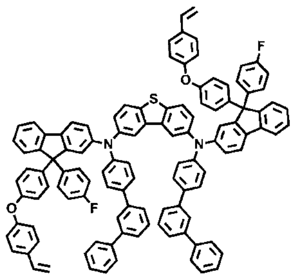

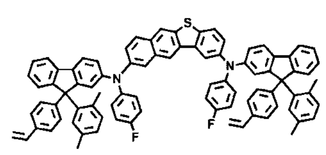
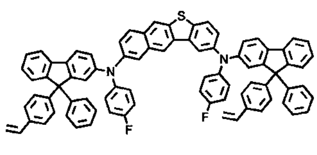
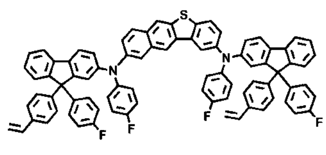

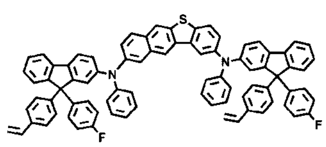
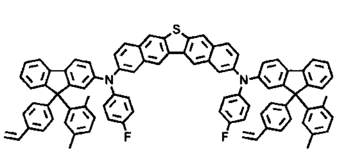
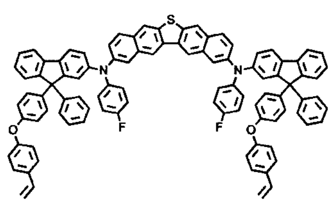

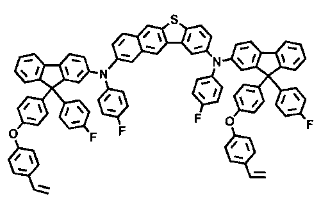
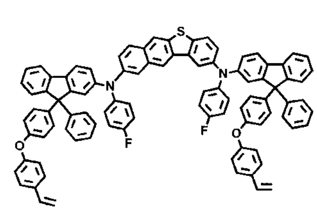
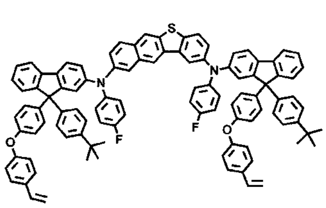

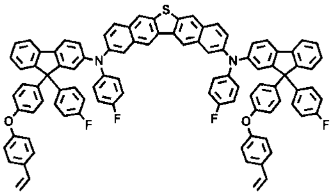
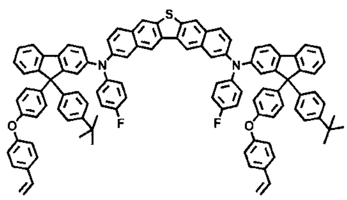
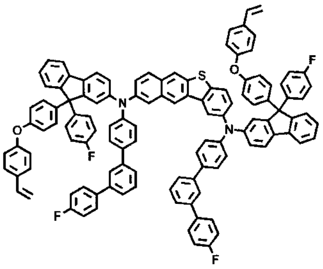

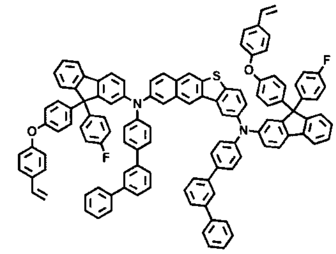

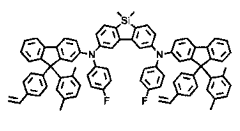
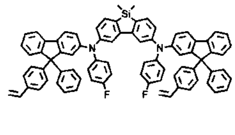
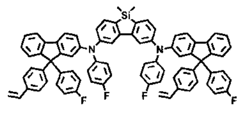
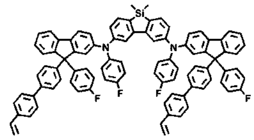

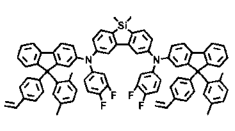
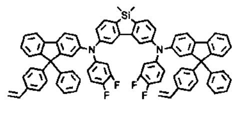
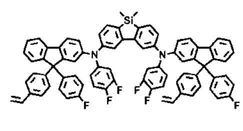
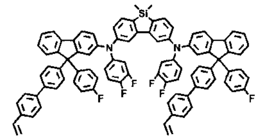

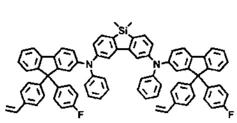
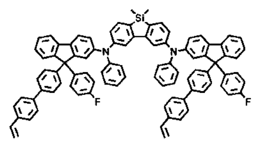
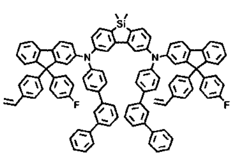
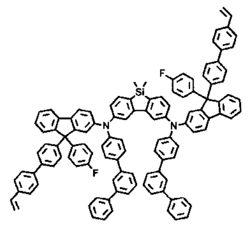

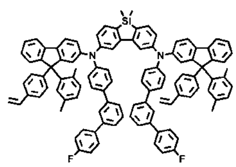
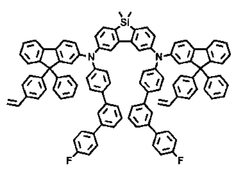
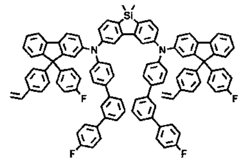
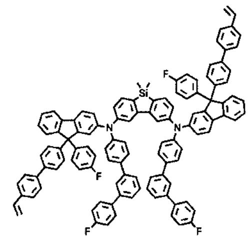

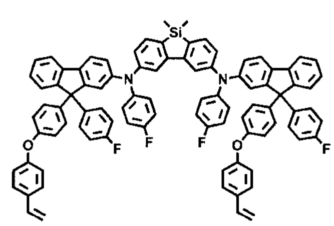
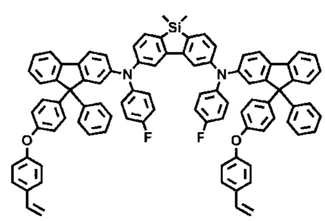
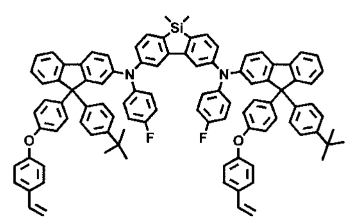

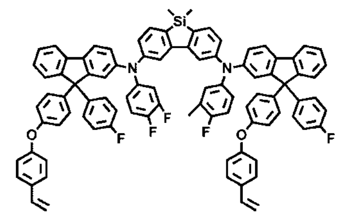
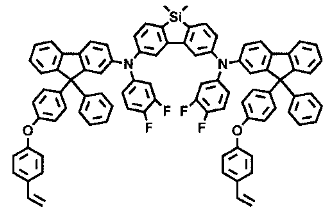
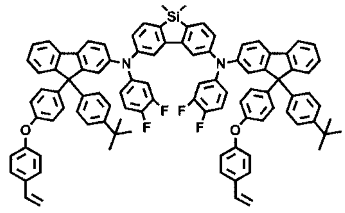

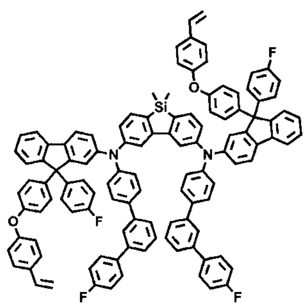
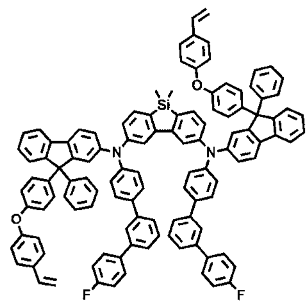
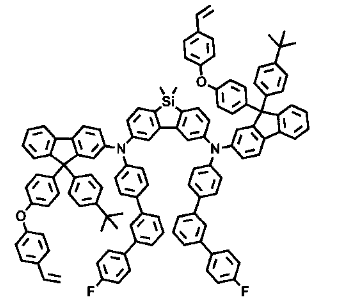

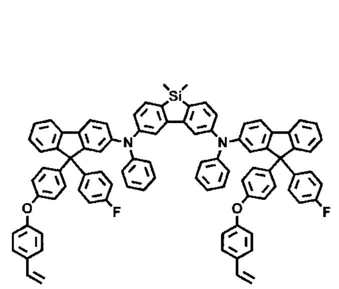
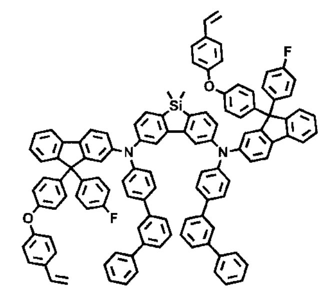

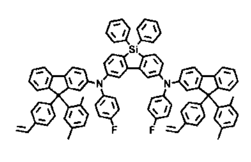
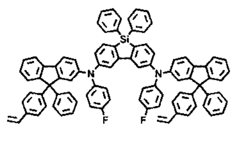
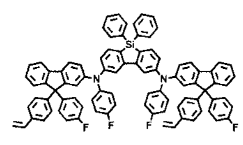
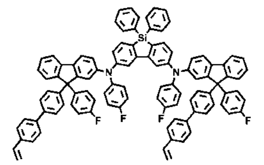

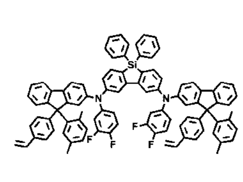
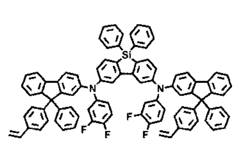
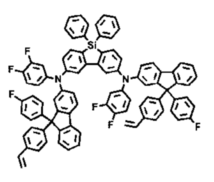
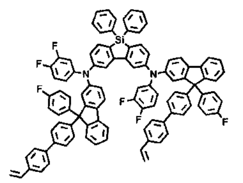

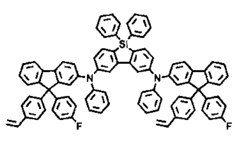
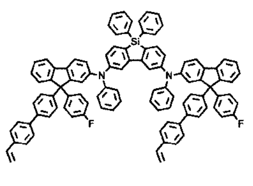
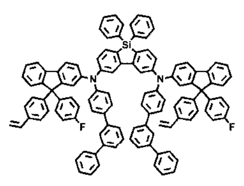
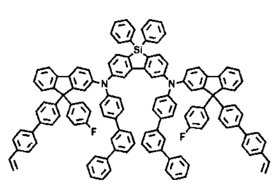

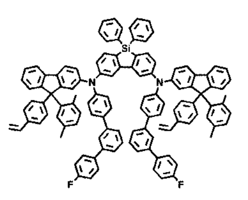
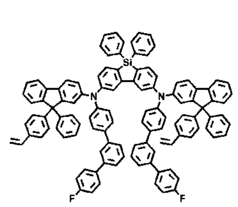
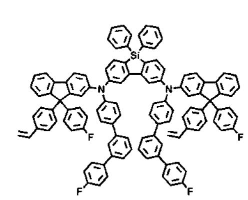
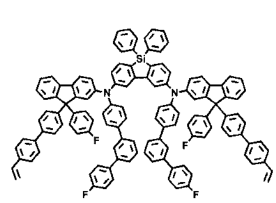

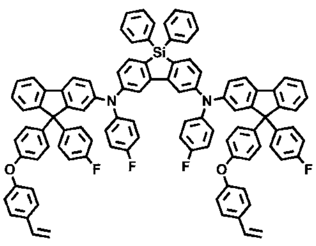
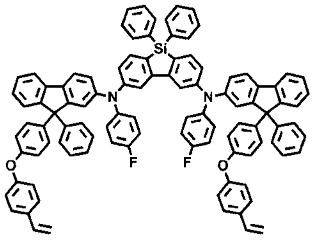
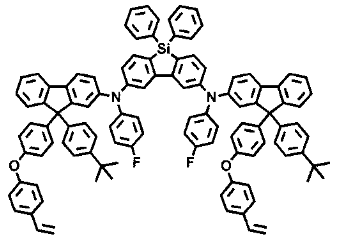

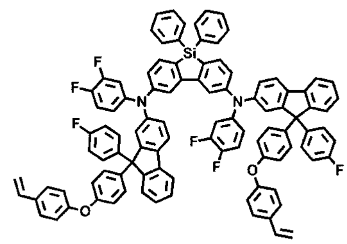
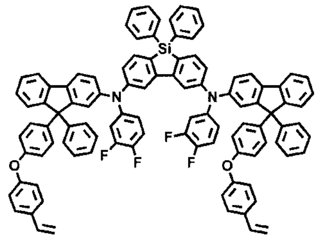
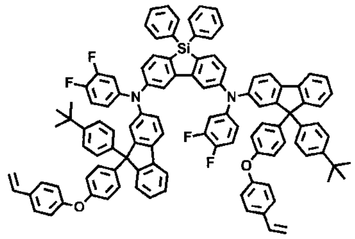

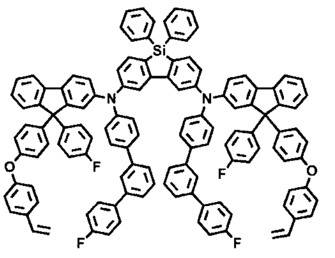
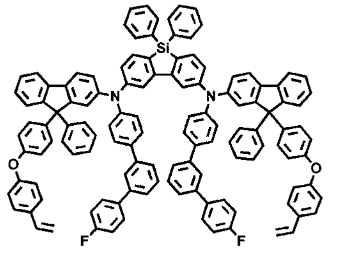
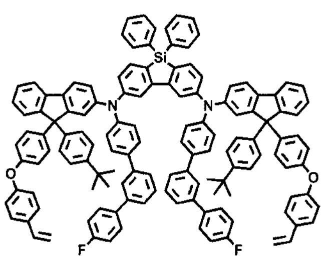

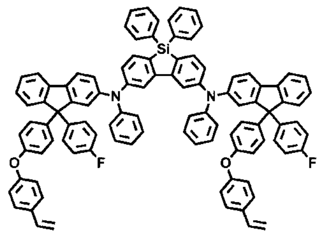
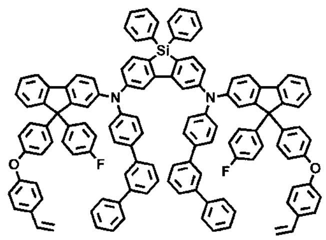

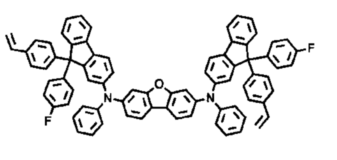
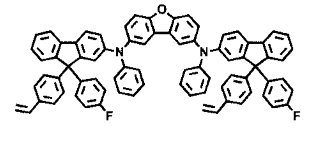
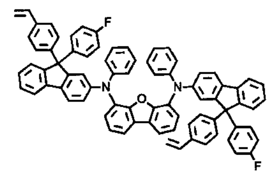

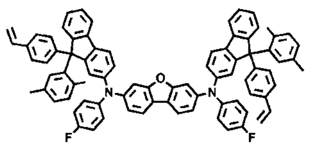
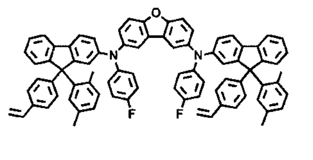
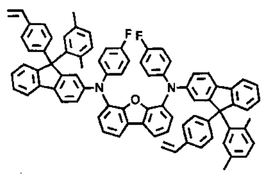

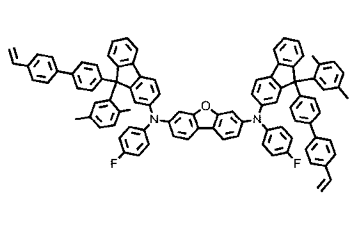
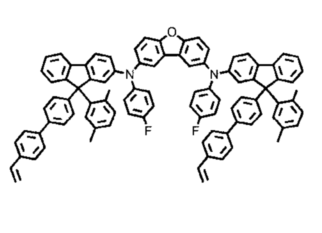
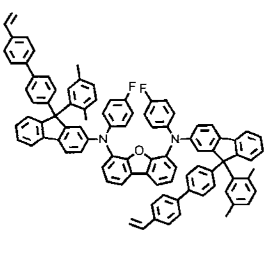

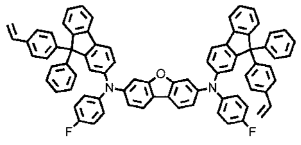
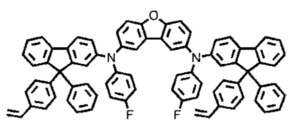
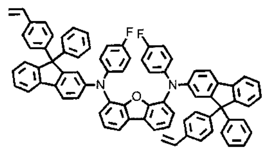

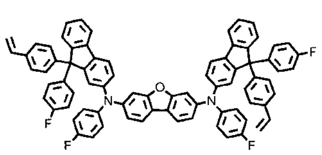
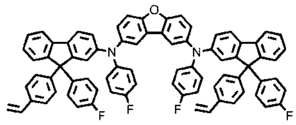
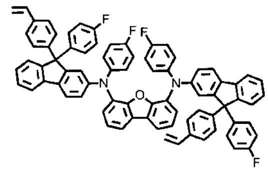

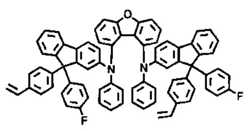
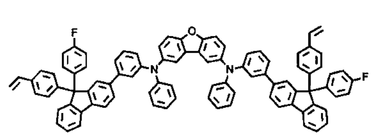
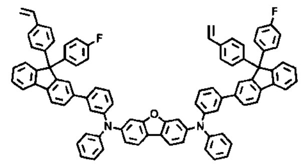

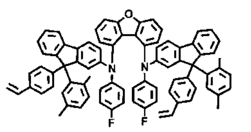
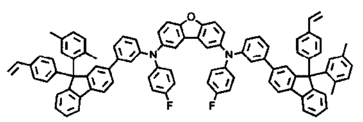
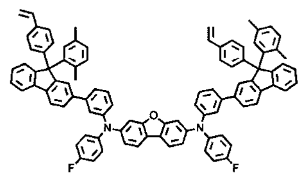

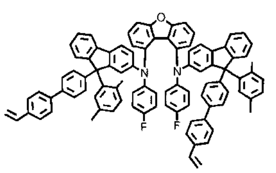
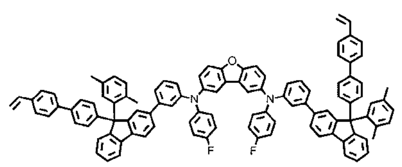
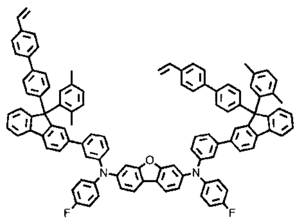

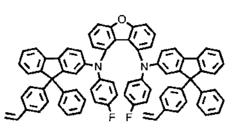
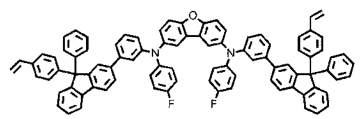
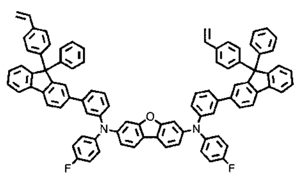

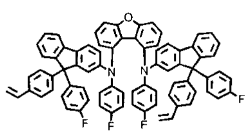
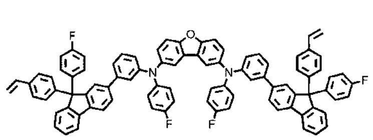
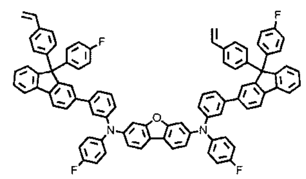

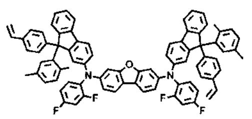
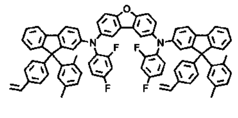
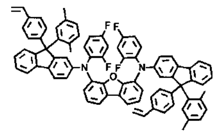
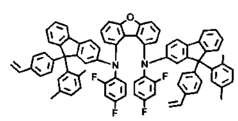

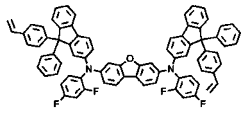
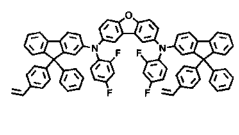
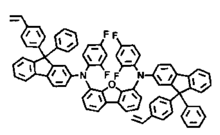
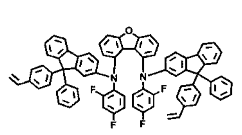
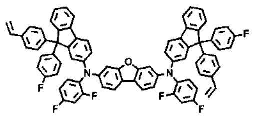
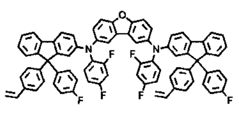
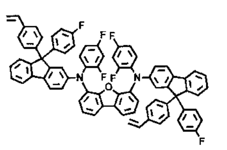
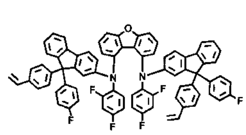
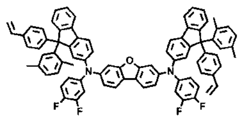
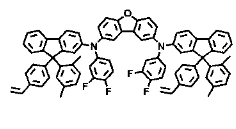
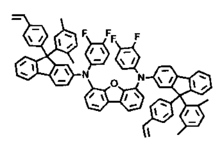
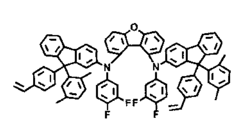
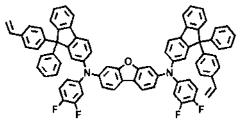
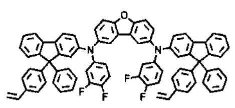
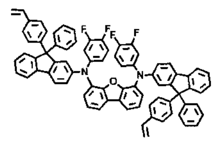
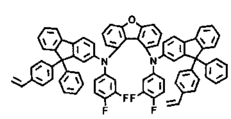
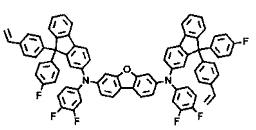
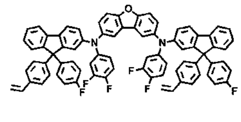
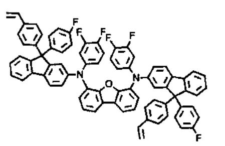
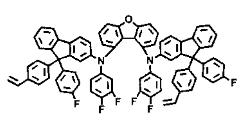
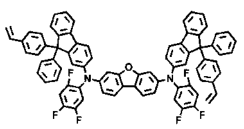
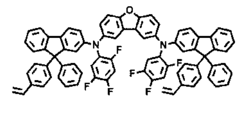
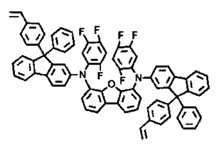
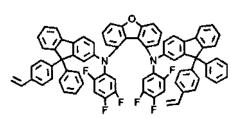
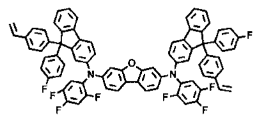
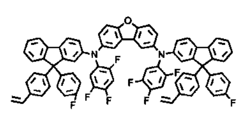
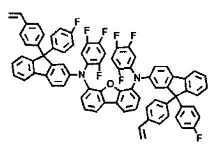
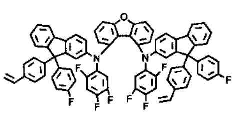
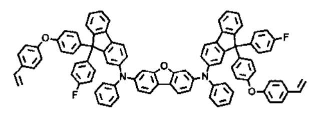
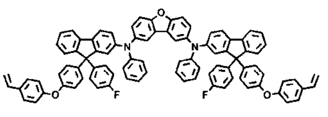
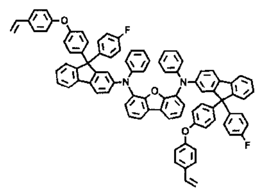
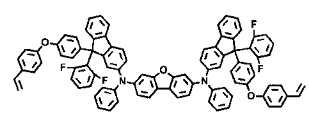
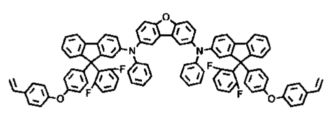
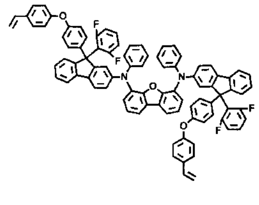

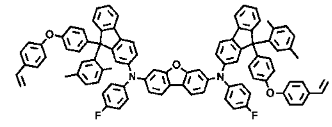
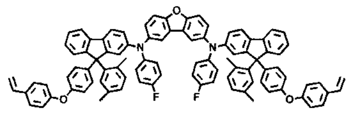
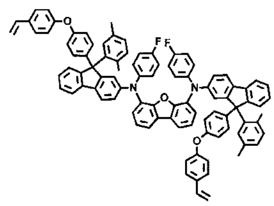

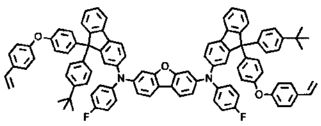
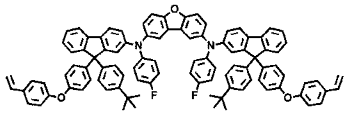
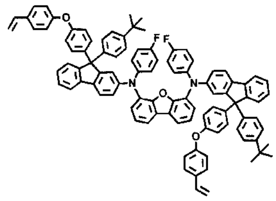

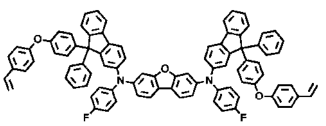
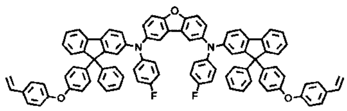
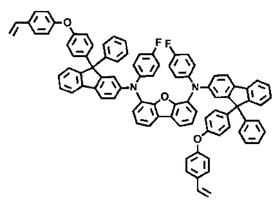

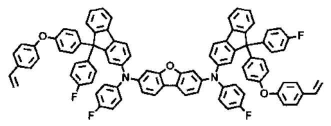
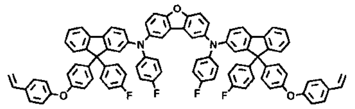
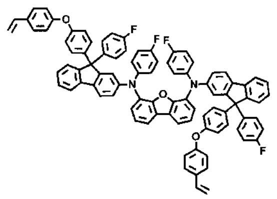

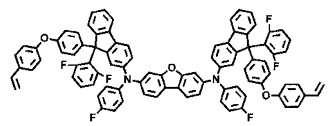
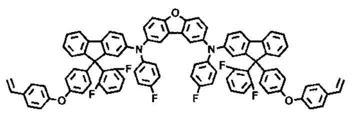
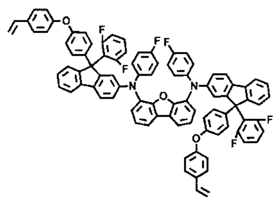

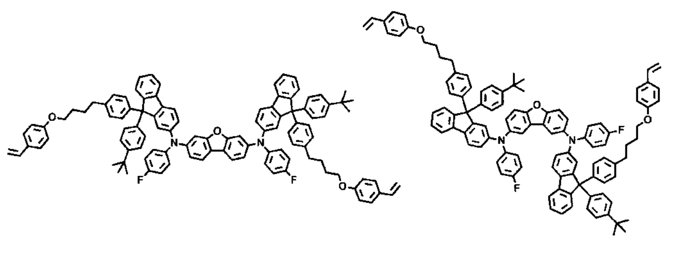
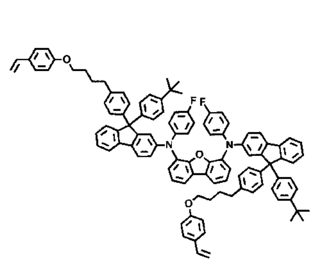

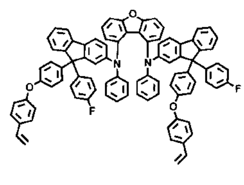
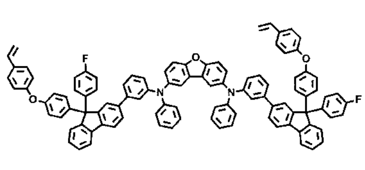
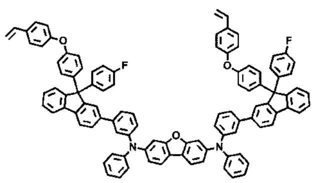

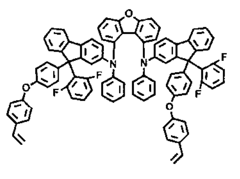
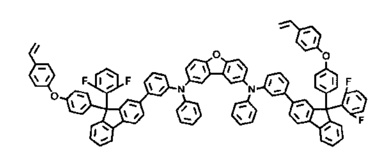
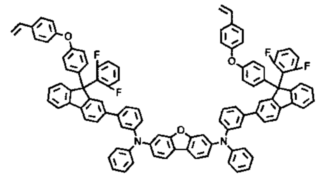

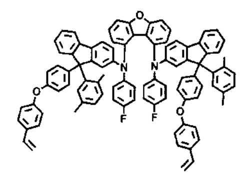
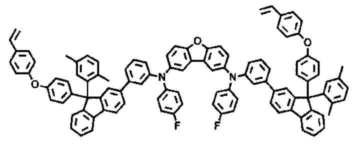
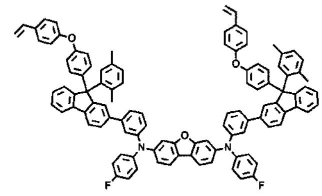

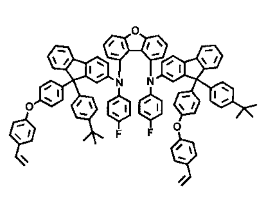
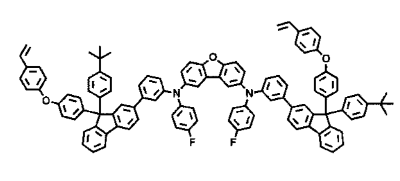
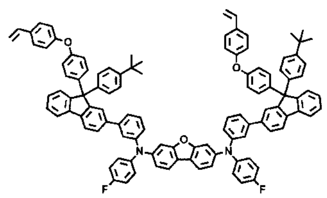

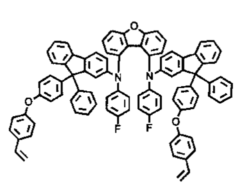
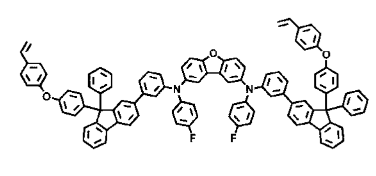
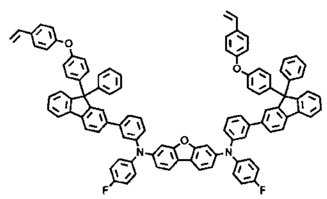

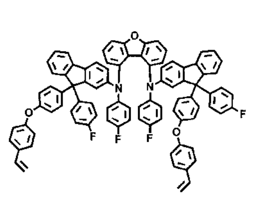
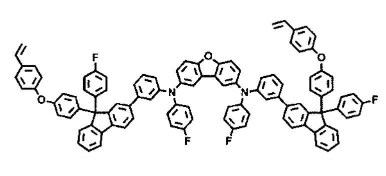
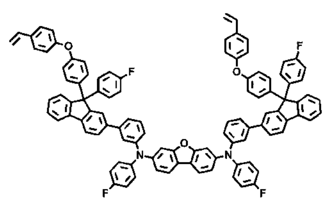

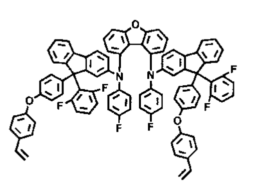
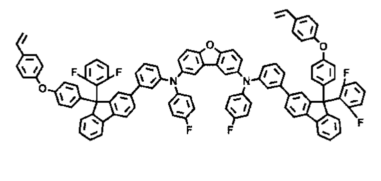
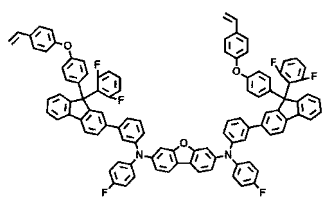

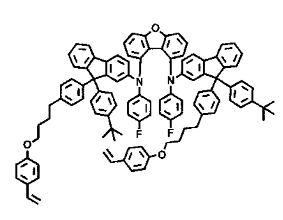
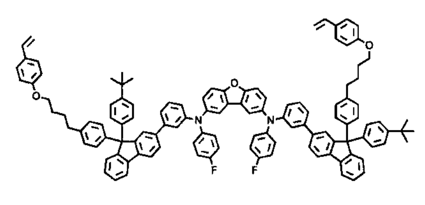
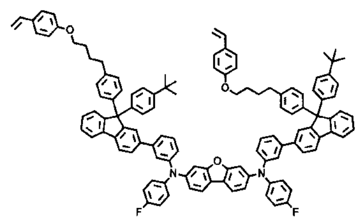

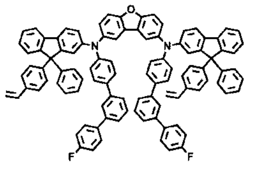
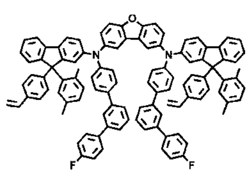
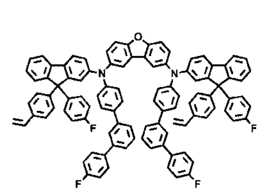

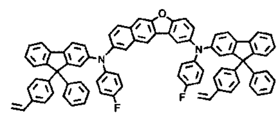
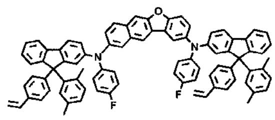
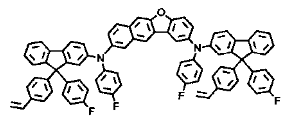

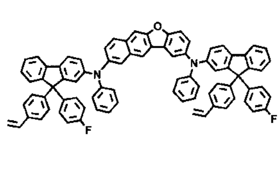
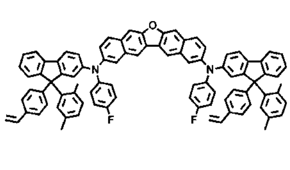
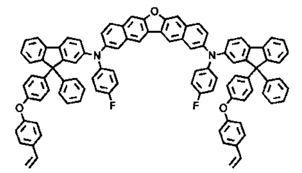

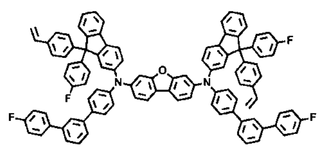
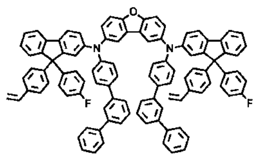
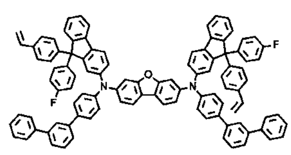

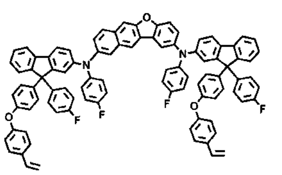
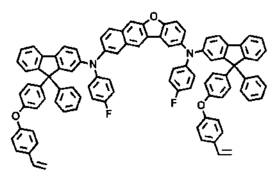
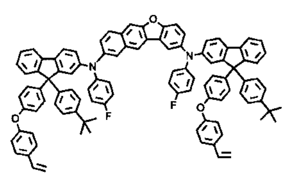

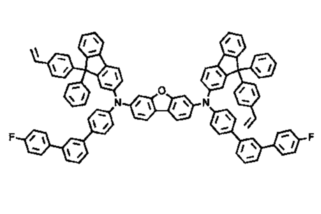
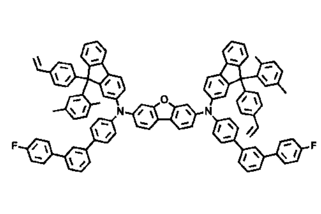
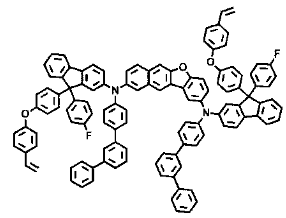

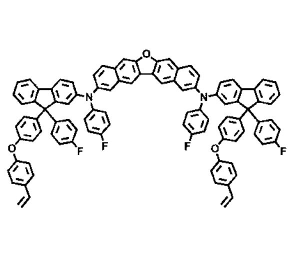
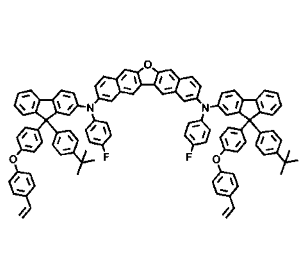
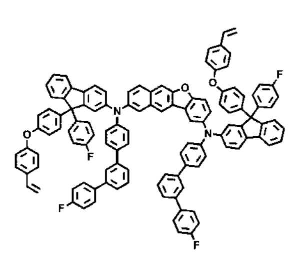

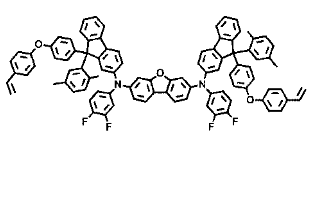
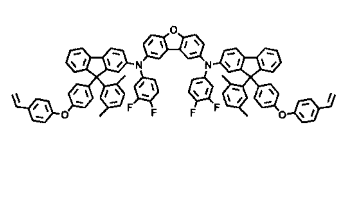
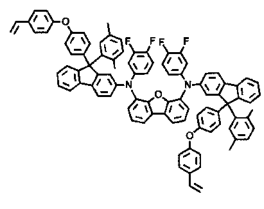

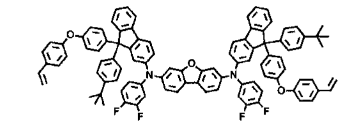
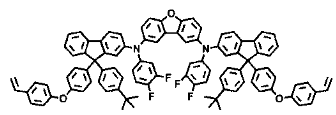
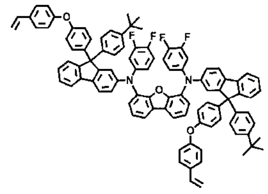

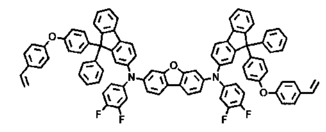
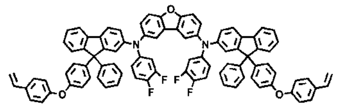
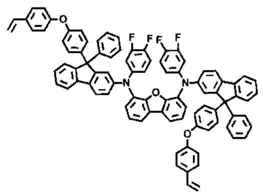

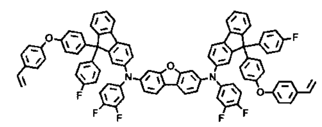
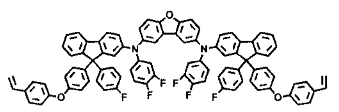
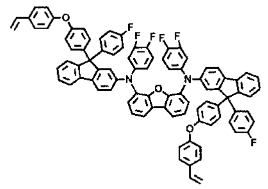

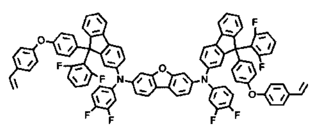
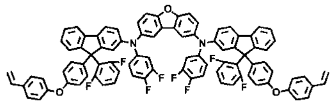
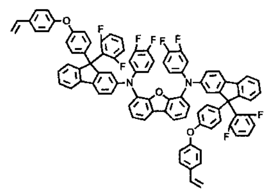

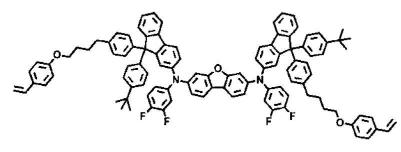
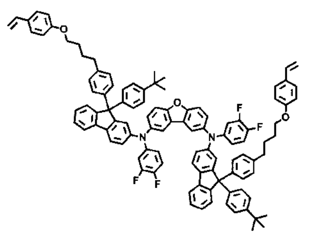
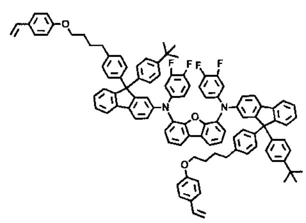

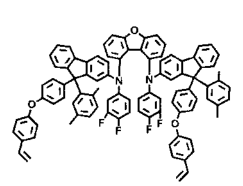
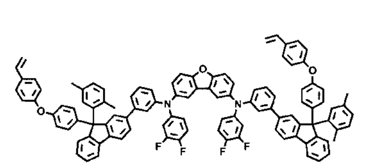
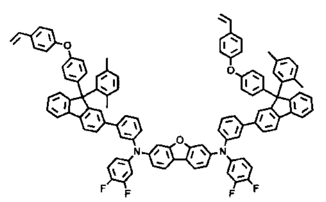

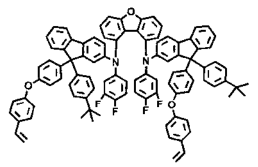
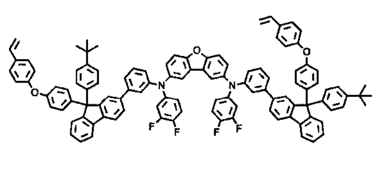
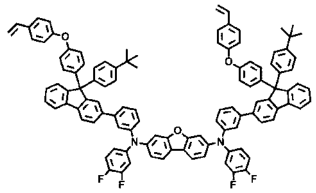

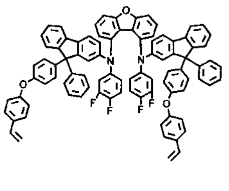
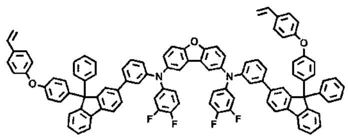
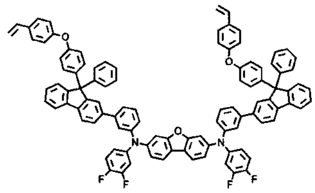
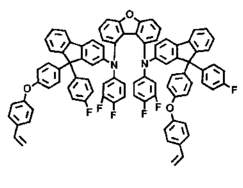
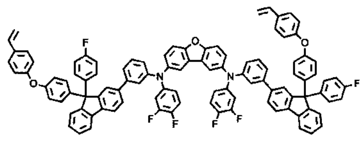
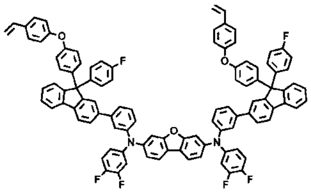
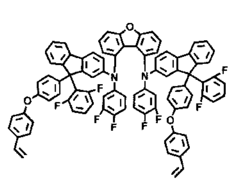
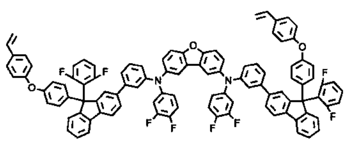
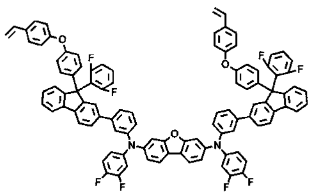
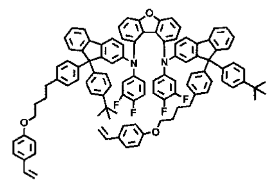
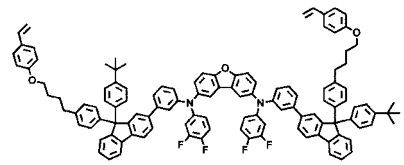
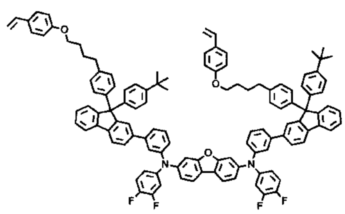
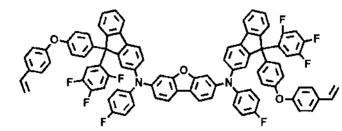
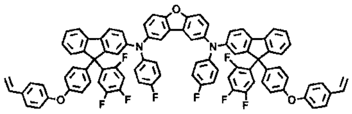
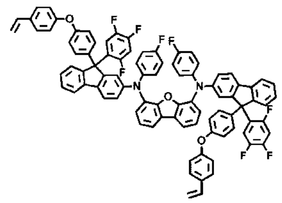
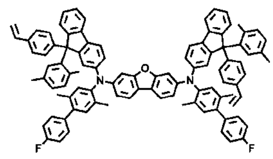
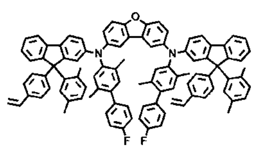
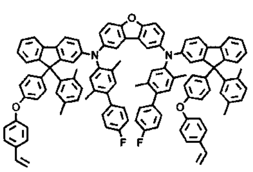
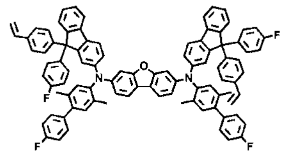
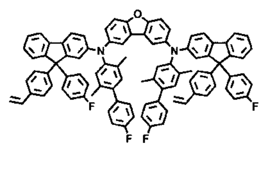
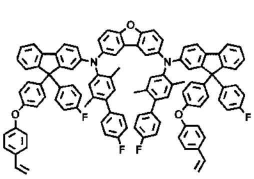
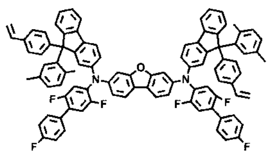
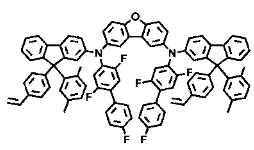
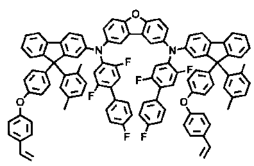

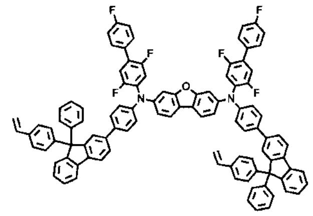
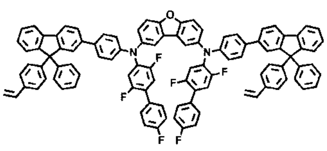
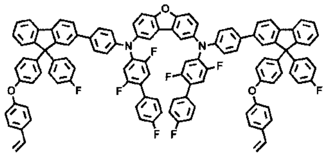

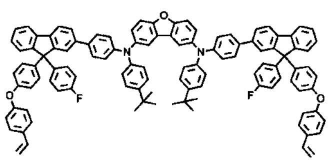

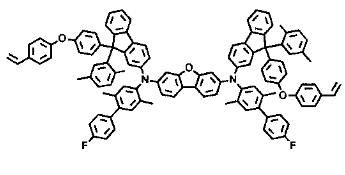
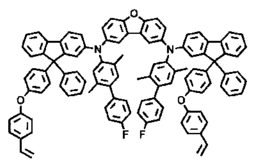
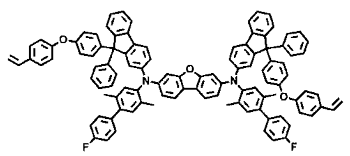

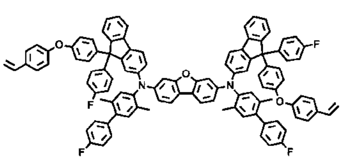
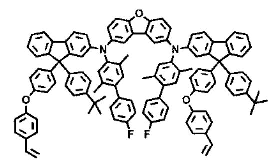
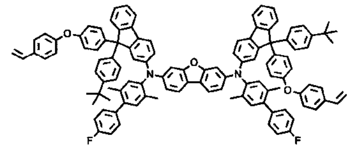

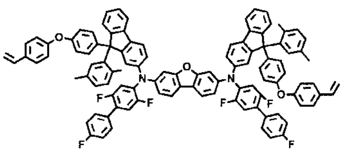
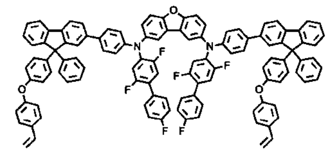
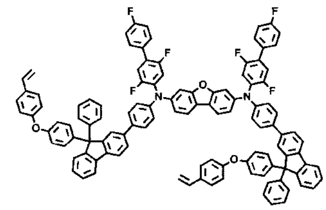

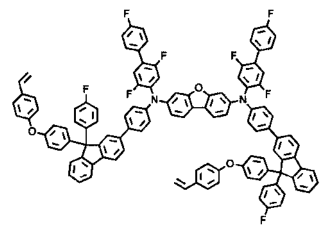
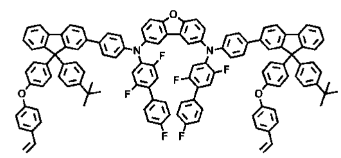
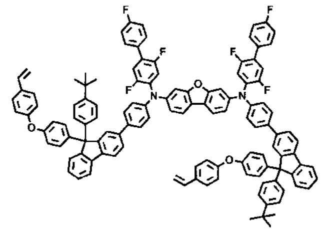

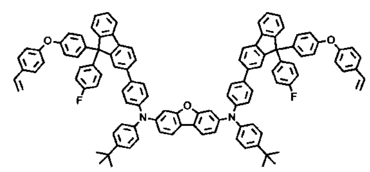

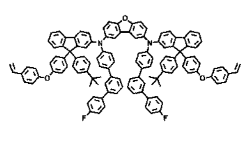
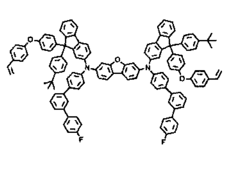
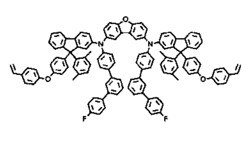
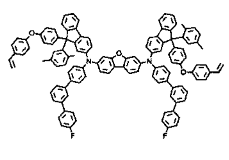

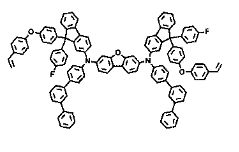
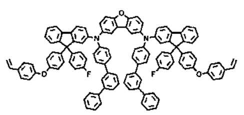
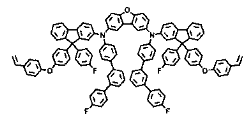
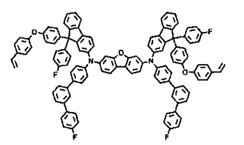
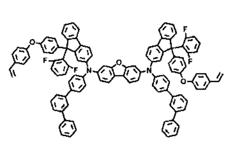
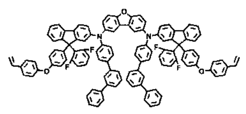
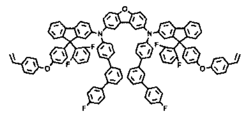
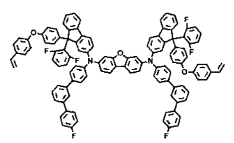
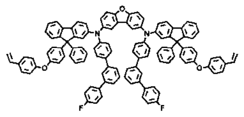
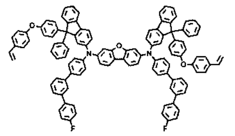
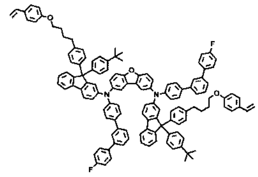
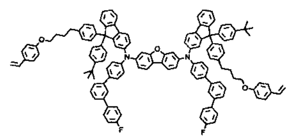
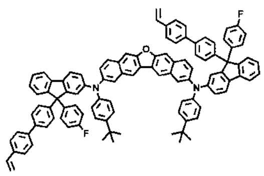
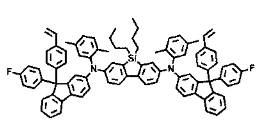
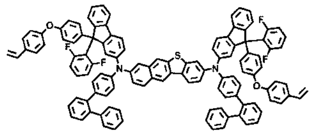
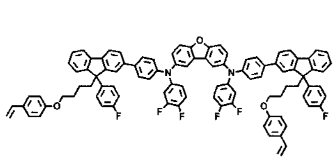
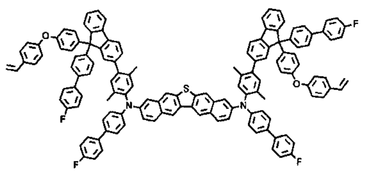
.

6. La composition d'encre selon la revendication 1, comprenant en outre un deuxième solvant, dans laquelle le deuxième solvant comprend un ou plusieurs solvants parmi ceux représentés par l'une quelconque des formules chimiques B à D suivantes, le méthoxytoluène et la tétraline :

[Formule chimique B]

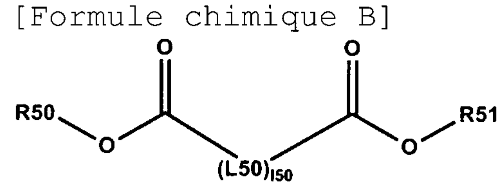

[Formule chimique C]

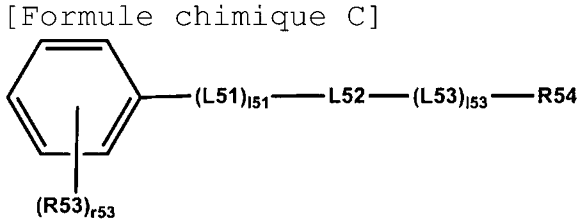

[Formule chimique D]

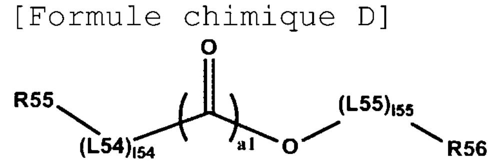

dans les formules chimiques B à D,

L50 représente une liaison directe ; ou un groupe alkylène,
L51 et L53 à L55 sont identiques ou différents les uns des autres, et représentent chacun indépendamment une liaison directe ; -O- ; ou un groupe alkylène substitué ou non substitué,
L52 est -COO-,
R50, R51 et R54 à R56 sont identiques ou différents les uns des autres, et sont chacun indépendamment un groupe alkyle substitué ou non substitué,
R53 est un atome d'hydrogène ; un atome de deutérium ; un groupe alcoxy ; ou un groupe alkyle substitué ou non substitué,
a1 vaut 0 ou 1,
r53 est un nombre entier compris entre 1 et 5, et lorsque r53 est égal à 2 ou plus, deux ou plusieurs R53 sont identiques ou différents les uns des autres, et
150, 151 et 153 à 155 sont chacun un nombre entier compris entre 1 et 10, et lorsque 150, 151 et 153 à 155 sont chacun égaux ou supérieurs à 2, deux ou plusieurs structures entre parenthèses sont identiques ou différentes les unes des autres.

**7.** La composition d'encre selon la revendication 6, dans laquelle le premier solvant a un point d'ébullition compris entre 250 °C et 350 °C,

le deuxième solvant a un point d'ébullition compris entre 180 °C et 280 °C, et
le point d'ébullition du premier solvant est supérieur au point d'ébullition du deuxième solvant.

**8.** La composition d'encre selon la revendication 1, comprenant en outre un composé ionique comprenant un groupe anionique représenté par la formule chimique 2 suivante :

[Formule chimique 2]

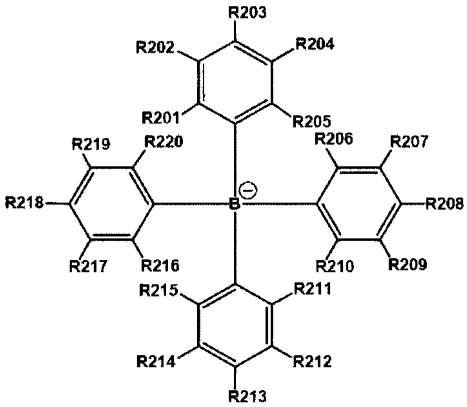

dans laquelle, dans la formule chimique 2,
au moins l'un des radicaux R201 à R220 est F ; un groupe cyano ; ou un groupe fluoroalkyle substitué ou non substitué,
au moins l'un des autres radicaux R201 à R220 est un groupe durcissable,
les autres radicaux R201 à R220 sont identiques ou différents les uns des autres, et représentent chacun indépendamment un atome d'hydrogène ; du deutérium ; un groupe halogène ; un groupe nitro ; un groupe cyano ; un groupe amino ; -OR221 ; -SR222 ; -SO3R223 ; -COOR224 ; - OC(O)R225 ; -C(O)NR226R227 ; -C(O)R228 ; un groupe alkyle substitué ou non substitué ; un groupe alcényle substitué ou non substitué ; un groupe alcynyle substitué ou non substitué ; un groupe amine substitué ou non substitué ; un groupe aryle substitué ou non substitué ; ou un groupe hétérocyclique substitué ou non substitué, et
R221 à R228 sont identiques ou différents les uns des autres, et représentent chacun indépendamment un atome d'hydrogène ; un atome de deutérium ; ou un groupe alkyle substitué ou non substitué.

**9.** La composition d'encre selon la revendication 8, dans laquelle la formule chimique 2 correspond à l'une quelconque des structures suivantes :

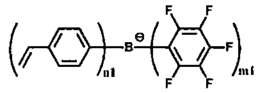
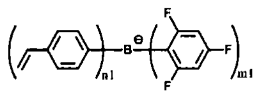
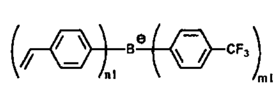

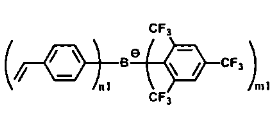
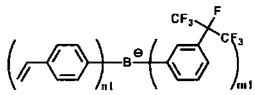
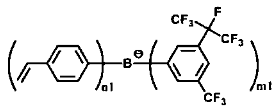

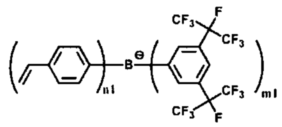
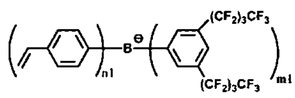
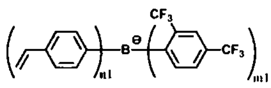

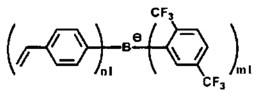
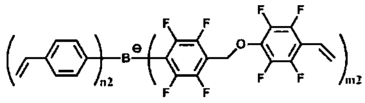

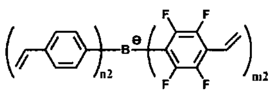
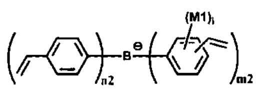
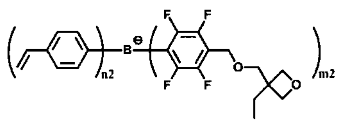

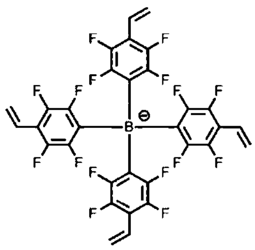
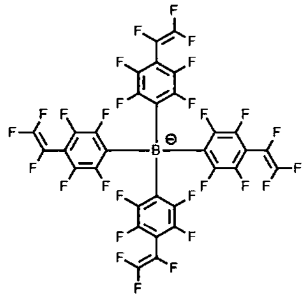
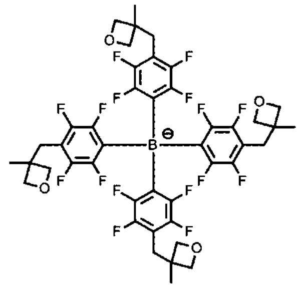

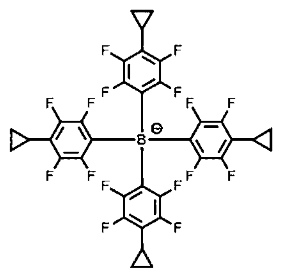
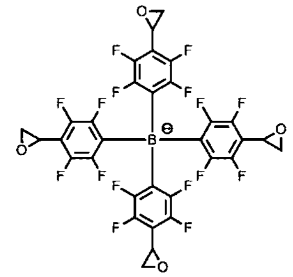

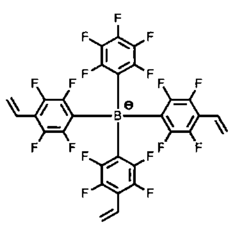
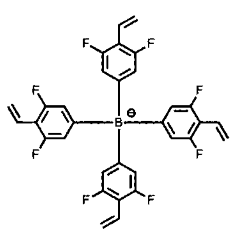
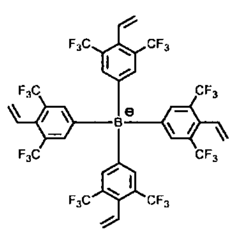

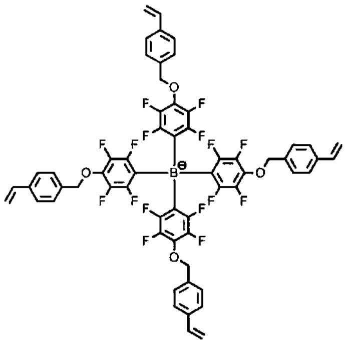 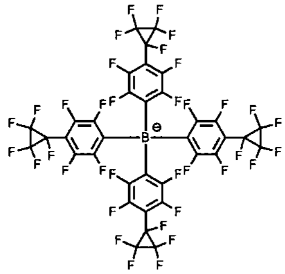 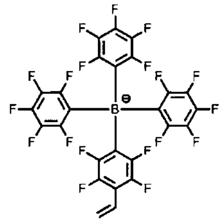

dans les structures,
n1 est un nombre entier compris entre 1 et 3, m1 est un nombre entier compris entre 1 et 3, et n1+m1=4,
n2 est un nombre entier compris entre 0 et 3, m2 est un nombre entier compris entre 1 et 4, et n2+m2=4,
M1 représente un atome de deutérium ; un groupe halogène ; un groupe nitro ; un groupe cyano ; un groupe amino ; -OR221 ; -SR222 ; -SO3R223 ; -COOR224 ; - OC(O)R225 ; -C(O)NR226R227 ; -C(O)R228 ; un groupe alkyle substitué ou non substitué ; un groupe alcényle substitué ou non substitué ; un groupe alcynyle substitué ou non substitué ; un groupe amine substitué ou non substitué ; un groupe aryle substitué ou non substitué ; ou un groupe hétérocyclique substitué ou non substitué,
R221 à R228 sont identiques ou différents les uns des autres, et représentent chacun indépendamment un atome d'hydrogène ; un atome de deutérium ; ou un groupe alkyle substitué ou non substitué, et
i est un nombre entier compris entre 1 et 4, et lorsque i est égal à 2 ou plus, deux ou plusieurs M1 sont identiques ou différents les uns des autres.

**10.** La composition d'encre selon la revendication 8, dans laquelle le composé ionique comprend en outre un groupe cationique, et le groupe cationique est un groupe cationique monovalent, un composé d'onium ou l'une quelconque des structures suivantes :

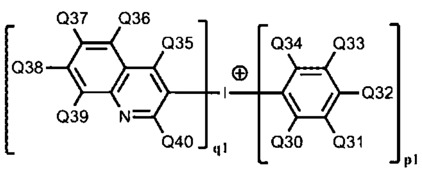 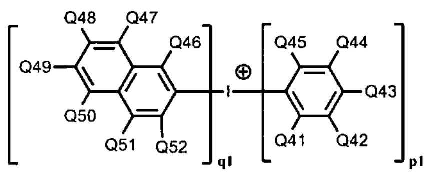

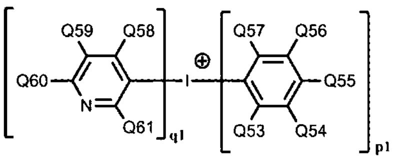 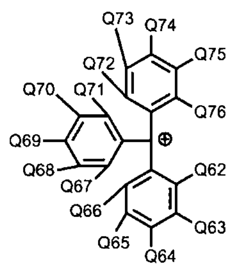 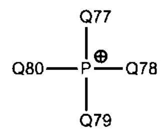

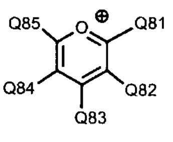 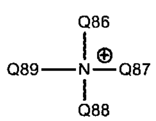 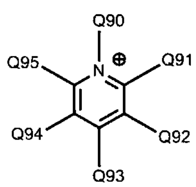 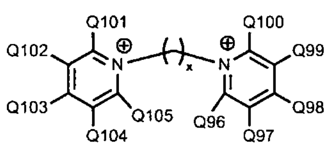

dans les structures,
Q30 à Q105 sont identiques ou différents les uns des autres, et représentent chacun indépendamment un atome d'hydrogène ; un atome de deutérium ; un groupe cyano ; un groupe nitro ; un atome d'halogène ; un groupe hydroxyle ; -COOR250 ; un groupe alkyle substitué ou non substitué ; un groupe alcoxy substitué ou non substitué ; un groupe aryloxy substitué ou non substitué ; un groupe cycloalkyle substitué ou non substitué ; un

groupe aryle substitué ou non substitué ; ou un groupe durcissable,
R250 représente un atome d'hydrogène ; un atome de deutérium ; ou un groupe alkyle substitué ou non substitué,
x est un nombre entier compris entre 0 et 10, et
p1 vaut 1 ou 2, q1 vaut 0 ou 1 et p1+q1=2.

**11.** La composition d'encre selon la revendication 8, dans laquelle le composé ionique est l'un quelconque des composés de formules chimiques D-1 à D-36 suivantes :

[Formule chimique D-1]

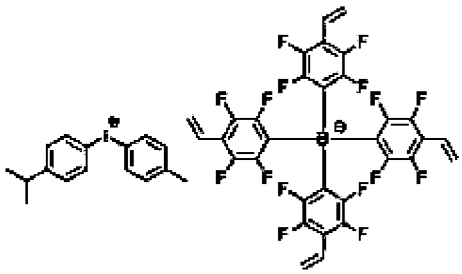

[Formule chimique D-2]

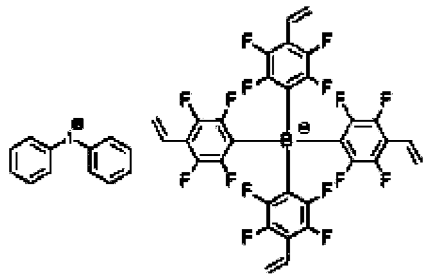

[Formule chimique D-3]

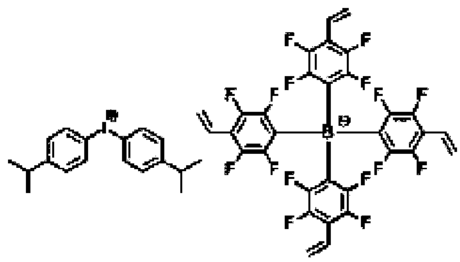

[Formule chimique D-4]

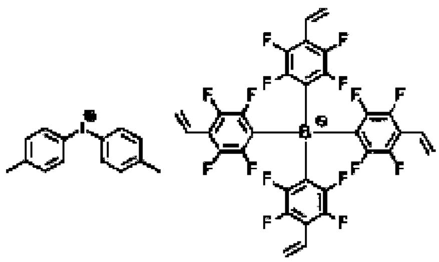

[Formule chimique D-5]

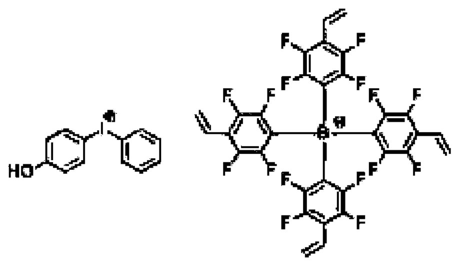

[Formule chimique D-6]

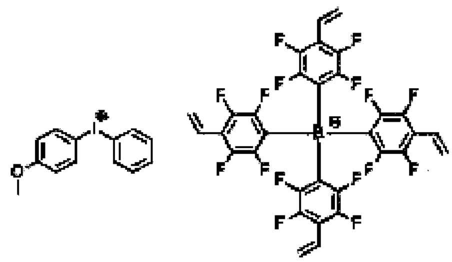

[Formule chimique D-7]

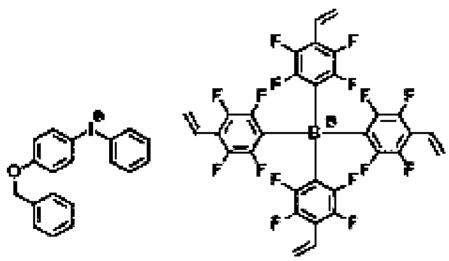

[Formule chimique D-8]

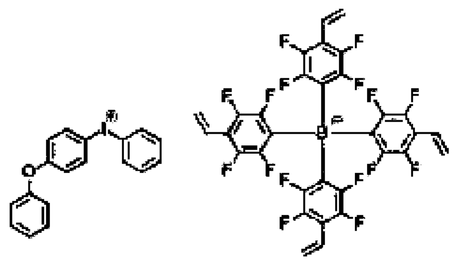

[Formule chimique D-9]

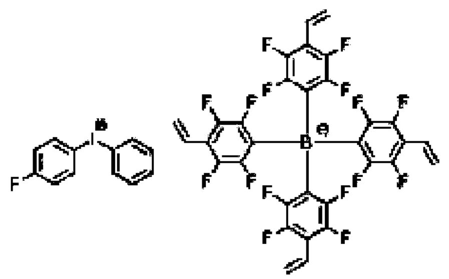

[Formule chimique D-10]

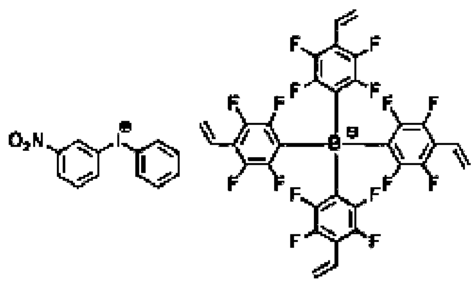

[Formule chimique D-11]

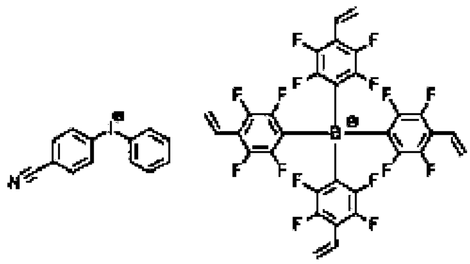

[Formule chimique D-12]

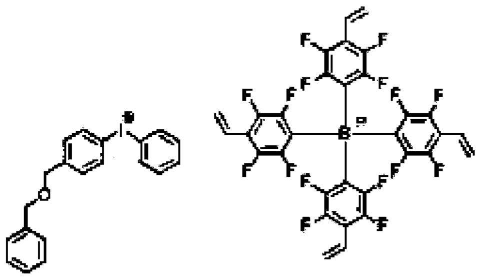

[Formule chimique D-13]

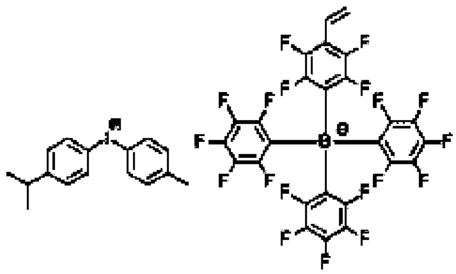

[Formule chimique D-14]

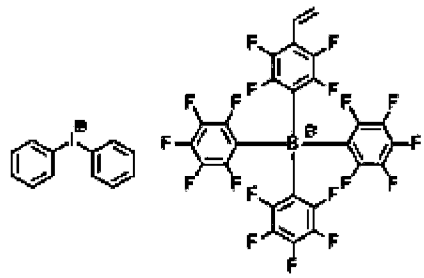

[Formule chimique D-15]

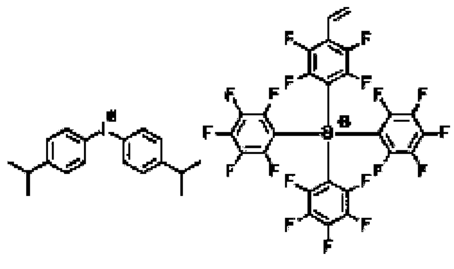

[Formule chimique D-16]

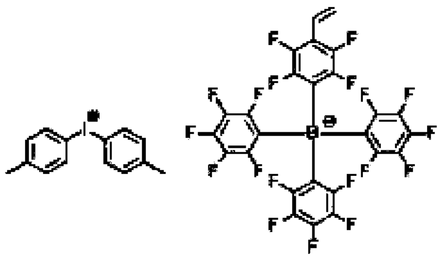

[Formule chimique D-17]

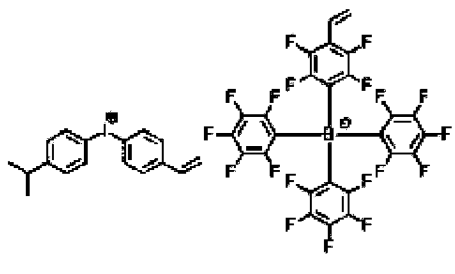

[Formule chimique D-18]

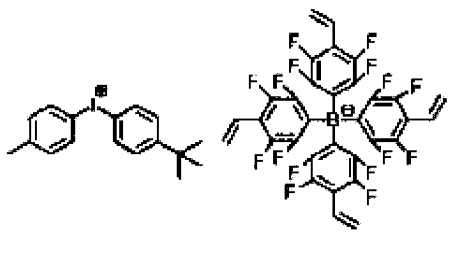

[Formule chimique D-19]

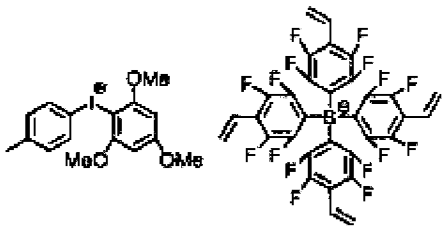

[Formule chimique D-20]

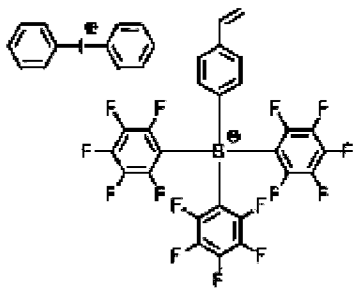

[Formule chimique D-21]

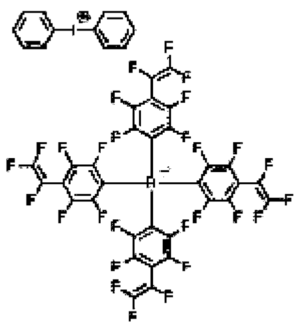

[Formule chimique D-22]

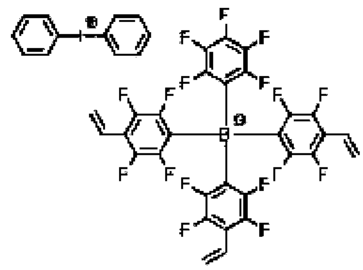

[Formule chimique D-23]

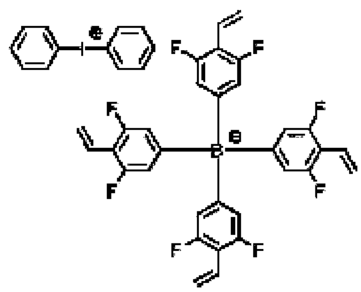

[Formule chimique D-24]

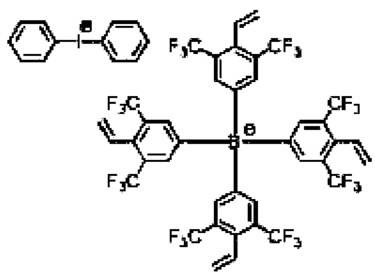

[Formule chimique D-25]

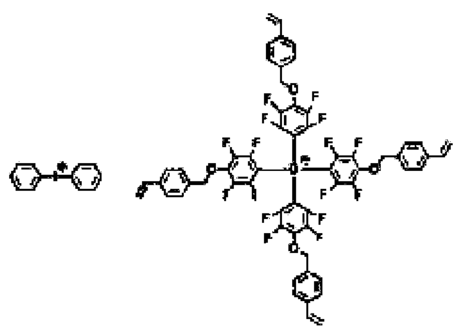

[Formule chimique D-26]

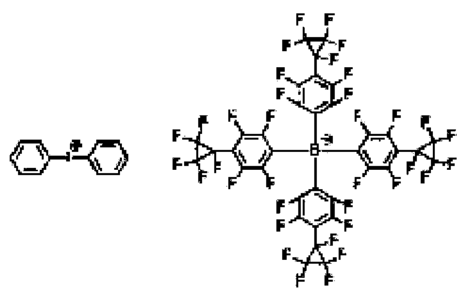

[Formule chimique D-27]

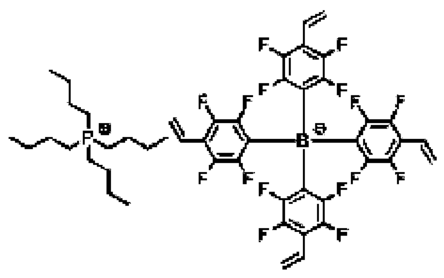

[Formule chimique D-28]

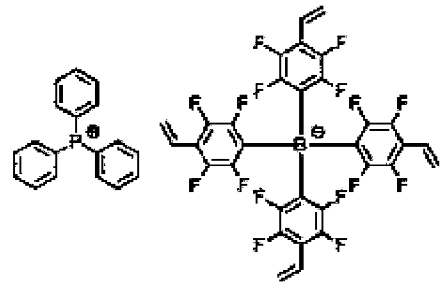

[Formule chimique D-29]

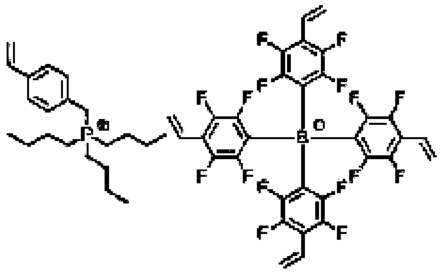

[Formule chimique D-30]

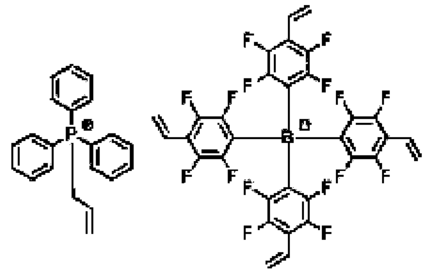

[Formule chimique D-31]

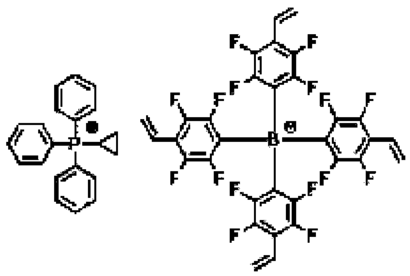

[Formule chimique D-32]

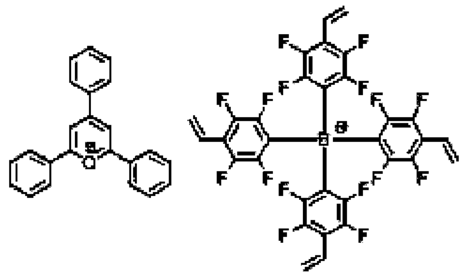

[Formule chimique D-33]

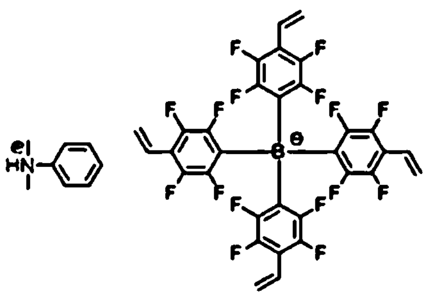

[Formule chimique D-34]

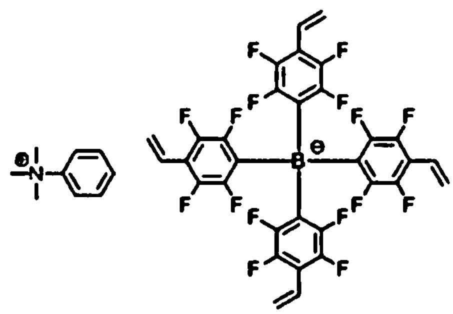

[Formule chimique D-35]

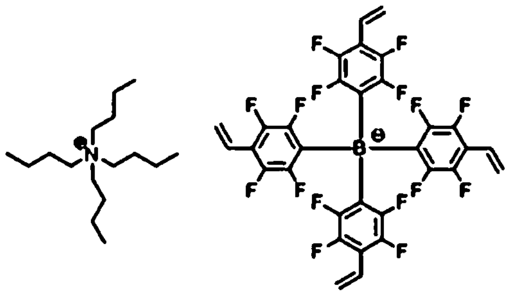

[Formule chimique D-36]

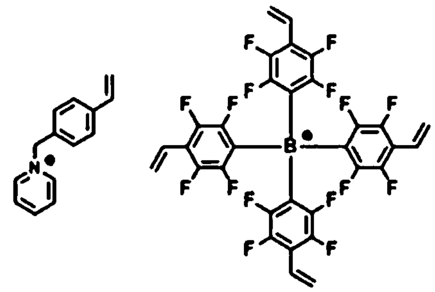

.

**12.** Pixel comprenant la composition d'encre selon l'une quelconque des revendications 1 à 11 ou un produit durci de celle-ci.

**13.** Couche de matériau organique comprenant le pixel selon la revendication 12.

**14.** Dispositif électroluminescent organique comprenant : une première électrode ;

une deuxième électrode ; et
une couche de matériau organique comportant une ou plusieurs couches disposées entre la première électrode et la deuxième électrode,
dans lequel une ou plusieurs couches de la couche de matériau organique correspondent à la couche de matériau organique de la revendication 13.

**15.** Le dispositif électroluminescent organique selon la revendication 14, dans lequel la couche de matériau organique comprend une ou plusieurs couches choisies parmi le groupe constitué d'une couche d'injection de trous, d'une couche de transport de trous, d'une couche d'injection et de transport de trous, et d'une couche de blocage d'électrons, et
la ou les couches choisies parmi le groupe constitué de la couche d'injection de trous, de la couche de transport de trous, de la couche d'injection et de transport de trous, et de la couche de blocage d'électrons comprennent la composition d'encre ou un produit durci de celle-ci.

[Figure 1]

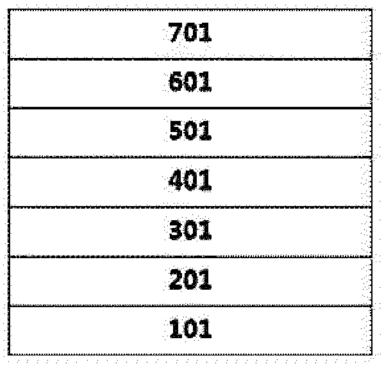


[Figure 2]

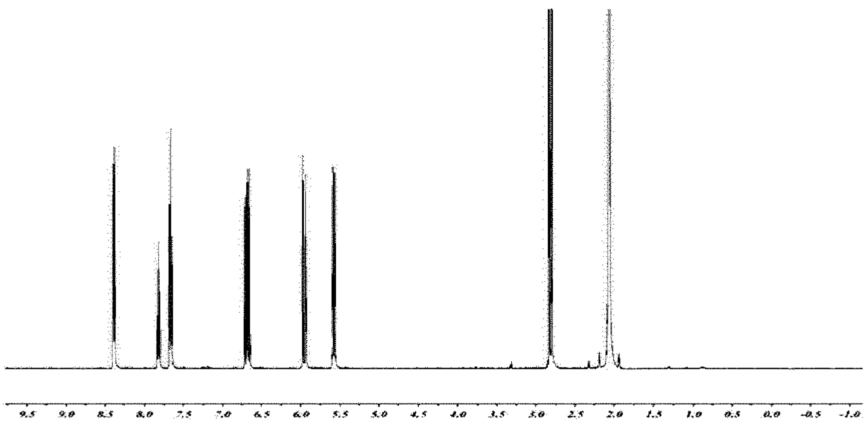


[Figure 3]

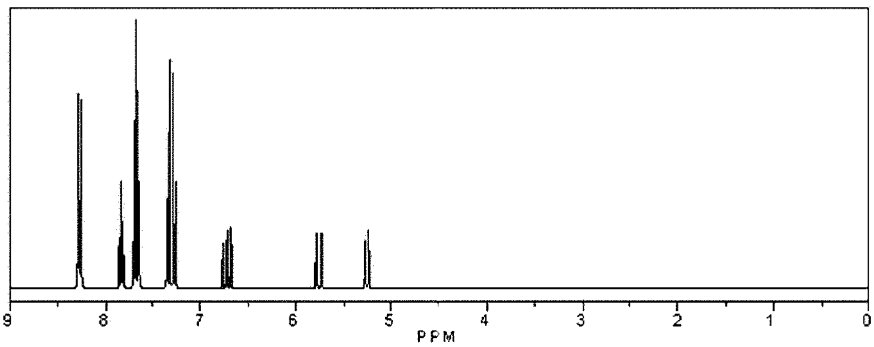


[Figure 4]

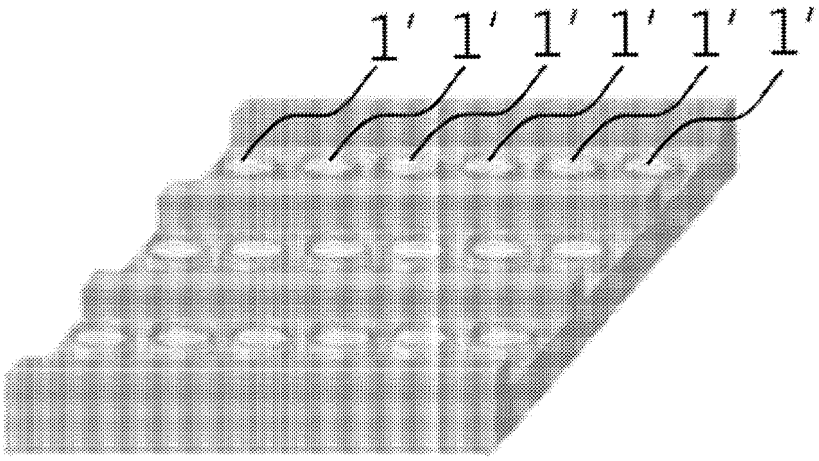


[Figure 5]

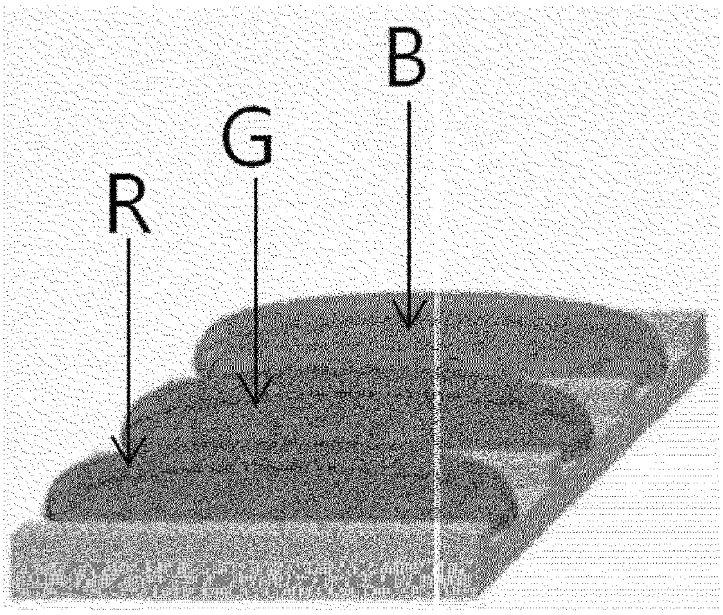


[Figure 6]

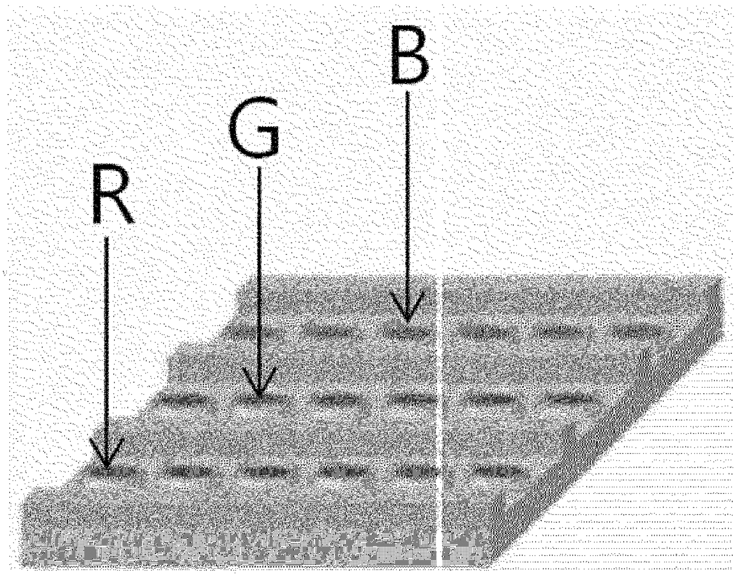


[Figure 7]

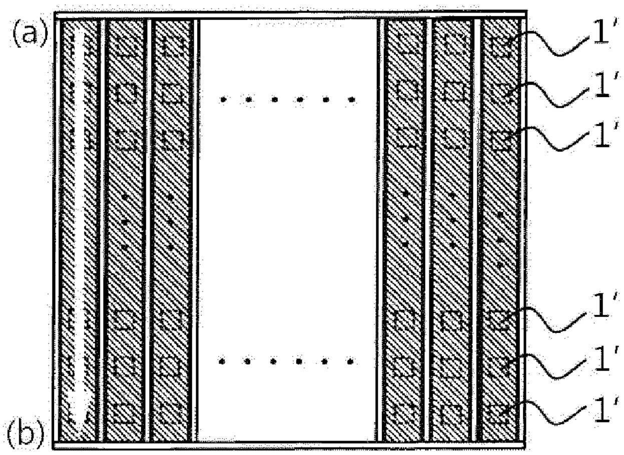


[Figure 8]

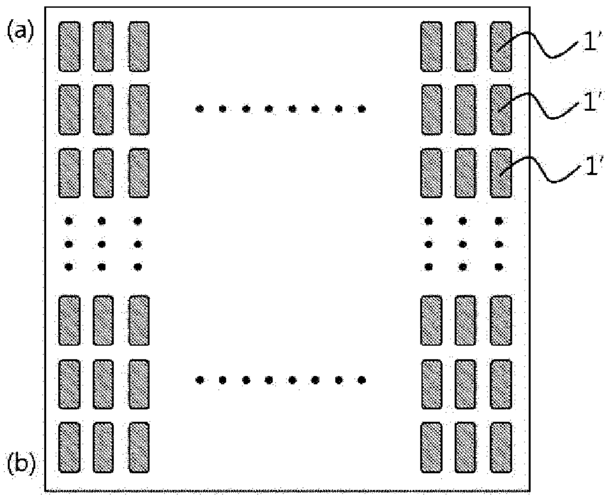


[Figure 9]

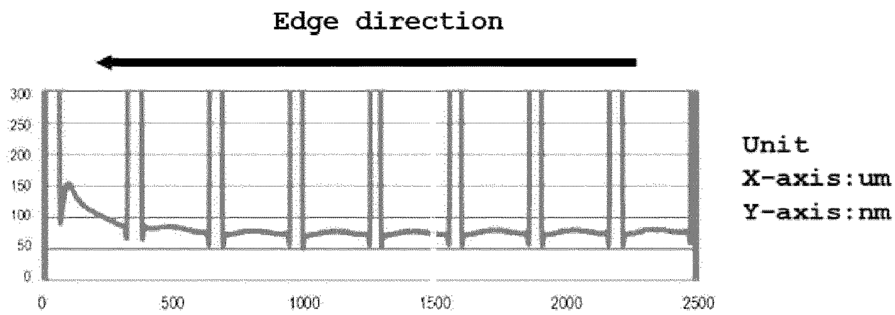


[Figure 10]

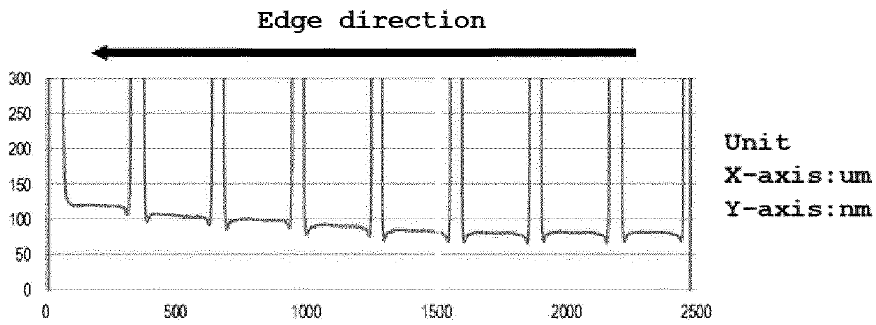

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- KR 1020220120824
- WO 2022035284 A1